# EUROPEAN PATENT APPLICATION

(11) **EP 4 333 602 A1**
(43) Date of publication of application: **06.03.2024**
(21) Application number: 23191907.7
(22) Date of filing: 17.08.2023
(51) Int. Cl.: H10K 71/00, H10K 59/80, H10K 77/10

(54) **DISPLAY DEVICE, METHOD FOR FABRICATING THE DISPLAY DEVICE, AND ELECTRONIC DEVICE INCLUDING THE DISPLAY DEVICE**

(30) Priority: 31.08.2022 KR 20220110379; 16.09.2022 KR 20220117467
(71) Applicant: Samsung Display Co., Ltd., Yongin-si, Gyeonggi-do 17113 (KR)
(72) Inventor: KIM, Wan Jung, Giheung-gu, Yongin-si, Gyeonggi-do (KR); KIM, Dong Jo, Giheung-gu, Yongin-si, Gyeonggi-do (KR); KIM, Sun Hwa, Giheung-gu, Yongin-si, Gyeonggi-do (KR); KIM, Young Ji, Giheung-gu, Yongin-si, Gyeonggi-do (KR); KIM, Chang Sik, Giheung-gu, Yongin-si, Gyeonggi-do (KR); NAM, Kyung Ah, Giheung-gu, Yongin-si, Gyeonggi-do (KR); MUN, Hyo Young, Giheung-gu, Yongin-si, Gyeonggi-do (KR); PARK, Yong Seung, Giheung-gu, Yongin-si, Gyeonggi-do (KR); UM, Yi Seul, Giheung-gu, Yongin-si, Gyeonggi-do (KR); YUN, Dae Sang, Giheung-gu, Yongin-si, Gyeonggi-do (KR); LEE, Kwan Hee, Giheung-gu, Yongin-si, Gyeonggi-do (KR); LEE, So Young, Giheung-gu, Yongin-si, Gyeonggi-do (KR); LEE, Young Hoon, Giheung-gu, Yongin-si, Gyeonggi-do (KR); CHOI, Young Seo, Giheung-gu, Yongin-si, Gyeonggi-do (KR); KIM, Sun Young, Giheung-gu, Yongin-si, Gyeonggi-do (KR); SOHN, Ji Won, Giheung-gu, Yongin-si, Gyeonggi-do (KR); LEE, Do Young, Giheung-gu, Yongin-si, Gyeonggi-do (KR); LEE, Seung Hoon, Giheung-gu, Yongin-si, Gyeonggi-do (KR)
(74) Representative: Dr. Weitzel & Partner

(57) **Abstract**

An electronic device includes a display device, which may be fabricated using a described method. The display device includes a glass substrate including a first surface, a second surface opposite the first surface, and a side surface between the first surface and the second surface, an outermost structure on the first surface of the glass substrate and located adjacent to an edge of one side of the glass substrate, and a display area including a plurality of light emitting areas on the first surface of the glass substrate and located farther from the edge of the one side of the glass substrate than the outermost structure is. A minimum distance from the side surface of the glass substrate to the outermost structure is equal to 130 µm or less.

## Description

### BACKGROUND

### 1. Field

The present invention relates to a display device, a method for fabricating the display device, and an electronic device including the display device.

### 2. Description of the Related Art

As the information society develops, the demand for a display device for displaying an image is increasing in various forms. The display device may be a flat panel display, such as a liquid crystal display, a field emission display, or a light emitting display panel.

The display device includes a display area for displaying an image and a non-display area arranged to surround a periphery of the display area, for example, the display area. Recently, a width of the non-display area is gradually decreasing in order to increase immersion in the display area and to increase aesthetics of the display device.

The display device may be formed by cutting a mother substrate along lines that define a plurality of display cells formed on the mother substrate including the plurality of display cells in the manufacturing process of the display device.

The non-display area may include a first non-display area in which lines and circuits for driving the display area are disposed, and a second non-display area corresponding to a margin for a cutting process in a manufacturing process. Because there is a limit to reducing lines and circuits in the first non-display area, a method for reducing a width of the second non-display area is being studied.

### SUMMARY

The present invention is defined by the features of the independent claims. Aspects and features of embodiments of the present invention provide a display device capable of reducing or minimizing a width of a non-display area, a method of manufacturing the display device, and an electronic device including the display device.

Other aspects and features of embodiments of the present invention provide a display device capable of improving mechanical strength of the display device, a method of manufacturing the display device, and an electronic device including the display device.

Other aspects and features of embodiments of the present invention provide a display device capable of cutting a substrate while reducing the thickness of the substrate, a method of manufacturing the display device, and an electronic device including the display device.

However, embodiments of the present invention are not limited to those set forth herein. The above and other embodiments of the present invention will become more apparent to one of ordinary skill in the art to which the present invention pertains by referencing the detailed description of the present invention given below.

According to one or more embodiments of the present invention, there is provided a display device including a glass substrate including a first surface, a second surface opposite the first surface, and a side surface between the first surface and the second surface, an outermost structure on the first surface of the glass substrate and located adjacent to an edge of one side of the glass substrate, and a display area including a plurality of light emitting areas on the first surface of the glass substrate and located farther from the edge of the one side of the glass substrate than the outermost structure is. A distance, which also may be termed as a minimum distance or minimum necessary distance that is determined by the manufacturing method of display device, from the side surface of the glass substrate to the outermost structure is equal to 130 µm or less.

According to an embodiment, wherein the first surface of the glass substrate includes a processing mark located closer than the outermost structure from the edge of the one side of the glass substrate, wherein a width of the processing mark is 50 µm or less.

According to an embodiment, wherein a minimum distance between the outermost structure and the processing mark is 30 µm or less.

According to an embodiment, wherein the glass substrate further comprises a first inclined surface between the side surface and the second surface, wherein an angle between the side surface and the first inclined surface and an angle between the first inclined surface and the second surface are obtuse angles.

According to an embodiment, wherein the outermost structure comprises a crack dam between one side and another side of the display area and extended along an edge of the glass substrate.

According to an embodiment, wherein the outermost structure comprises a display pad electrically connected to a circuit board through a conductive adhesive member.

According to an embodiment, further comprising an electrostatic protection line between the display pad and one edge of the glass substrate.

According to an embodiment, wherein the electrostatic protection line comprises, a main path area extending from the display pad to one edge of the glass substrate; and an auxiliary path area protruding from the main path area.

According to an embodiment, further comprising a dam intersecting the main path area.

According to an embodiment, wherein a distance from a sub-pixel closest to the side surface of the glass substrate, from among a plurality of sub-pixels, to the side surface of the glass substrate is 2.24 mm.

According to an embodiment, wherein a distance from a sub-pixel closest to the side surface of the glass substrate, from among a plurality of sub-pixels, to the side surface of the glass substrate is 1.8 mm.

According to an embodiment, wherein the side surface has a curved cross-section.

According to an embodiment, further comprising a heat dissipation layer on the first surface of the glass substrate and located closer to the edge of one side of the glass substrate than the outermost structure is.

According to an embodiment, wherein the first surface of the glass substrate further comprises a processing mark located closer to the edge of the one side of the glass substrate than the outermost structure is, wherein the heat dissipation layer overlaps the processing mark in a thickness direction of the glass substrate.

According to an embodiment, wherein a width of the heat dissipation layer is greater than a width of the processing mark.

According to an embodiment, wherein the heat dissipation layer comprises: a first heat dissipation layer comprising an organic material; and a second heat dissipation layer on the first heat dissipation layer.

According to one or more embodiments of the present invention, there is provided a display device including a glass substrate including a first surface, a second surface opposite the first surface, a side surface connected to the first surface, and a first inclined surface between the side surface and the second surface, and a display area including a plurality of light emitting areas on the first surface of the glass substrate. The side surface and the first inclined surface are formed by irradiating a laser to form first laser irradiation areas and then separating the first laser irradiation areas from a mother substrate through an etching process.

According to an embodiment, wherein the glass substrate further comprises a second inclined surface between the side surface and the first surface, wherein the second inclined surface is formed by a polishing process.

According to an embodiment, wherein an angle between the side surface and the first inclined surface and an angle between the side surface and the second inclined surface are obtuse angles.

According to an embodiment, wherein an angle between the side surface and the first inclined surface is greater than an angle between the side surface and the second inclined surface.

According to an embodiment, wherein an angle between the second surface and the first inclined surface is smaller than an angle between the first surface and the second inclined surface.

According to an embodiment, wherein a roughness of the first inclined surface is different from a roughness of the second inclined surface.

According to an embodiment, wherein a roughness of the side surface is different from a roughness of the first inclined surface.

According to an embodiment, wherein a difference between the roughness of the side surface and the roughness of the first inclined surface is approximately 1% to 20%.

According to one or more embodiments of the present invention, there is provided a display device including a glass substrate including a first surface, a second surface opposite the first surface, a side surface disposed between the first surface and the second surface, a through hole penetrating the first surface and the second surface, and a side surface of the through hole between the first surface and the second surface at an edge of the through hole, a first outermost structure on the first surface of the glass substrate and located adjacent to one edge of the glass substrate, and a second outermost structure on the first surface of the glass substrate and located adjacent to the edge of the through hole. A distance from the first outermost structure to the one edge of the glass substrate is smaller than a distance from the second outermost structure to the edge of the through hole.

According to an embodiment, wherein the glass substrate further comprises a first inclined surface between the side surface and the second surface, and a second inclined surface between the side surface of the through hole and the second surface.

According to an embodiment, wherein a length of the side surface is greater than a length of the side surface of the through hole.

According to an embodiment, wherein a length of the first inclined surface is smaller than a length of the second inclined surface.

According to an embodiment, wherein an angle between the side surface and the first inclined surface and an angle between the side surface of the through hole and the second inclined surface are obtuse angles.

According to an embodiment, wherein an angle between the side surface and the first inclined surface is greater than an angle between the side surface of the through hole and the second inclined surface.

According to an embodiment, wherein an angle between the second surface and the first inclined surface and an angle between the second surface and the second inclined surface are obtuse angles.

According to an embodiment, wherein an angle between the second surface and the first inclined surface is smaller than an angle between the second surface and the second inclined surface.

According to an embodiment, further comprising a heat dissipation layer on the first surface of the glass substrate and is closer to the edge of the through hole than the second outermost structure is.

According to an embodiment, wherein the first surface of the glass substrate further comprises a processing mark located closer to the edge of the through hole than the second outermost structure is, wherein the heat dissipation layer overlaps the processing mark in a thickness direction of the glass substrate.

According to an embodiment, wherein a width of the heat dissipation layer is greater than a width of the processing mark.

According to an embodiment, wherein the heat dissipation layer comprises: a first heat dissipation layer comprising an organic material; and a second heat dissipation layer on the first heat dissipation layer.

According to an embodiment, wherein the glass substrate is formed without a polishing process.

According to an embodiment, further comprising an organic planarization layer on the second outermost structure, wherein the glass substrate protrudes beyond the organic planarization layer in the through hole.

According to an embodiment, wherein a distance between the second outermost structure and an edge of the through hole is greater than a distance between the organic planarization layer and the edge of the through hole.

According to an embodiment, further comprising a plurality of light emitting elements comprisng a first electrode, a light emitting layer, and a second electrode on the first surface of the glass substrate in a display area around the through hole; a bank on the glass substrate in the display area and partitioning the plurality of light emitting elements; a touch electrode on the bank in the display area; and a touch insulating layer on the touch electrode, wherein the organic planarization layer includes a same material as the touch insulating layer.

According to an embodiment, wherein the organic planarization layer and the touch insulating layer are concurrently formed through a same process.

According to an embodiment, further comprising an organic planarization layer on the second outermost structure, wherein the organic planarization layer protrudes beyond the glass substrate.

According to an embodiment, wherein a distance between the second outermost structure and an edge of the through hole is smaller than a distance between the organic planarization layer and the edge of the through hole.

According to an embodiment, further comprising a plurality of light emitting elements comprising a first electrode, a light emitting layer, and a second electrode on the first surface of the glass substrate in a display area around the through hole; a bank on the glass substrate in the display area and partitioning the plurality of light emitting elements; a touch electrode on the bank in the display area; and a touch insulating layer on the touch electrode, wherein the organic planarization layer comprises a same material as the touch insulating layer.

According to an embodiment, wherein the organic planarization layer and the touch insulating layer are concurrently formed through a same process.

According to an embodiment, wherein a distance between the second outermost structure and the edge of the through hole is 300 µm or less.

According to one or more embodiments of the present invention, there is provided a display device including a first substrate including a glass and including a first surface, a second surface opposite the first surface, and a first side surface between the first surface and the second surface, a second substrate on the first substrate and including a flexible material, and a light emitting element layer including a plurality of light emitting areas on the second substrate. The first substrate further includes a side surface of a bending area between the first surface and the second surface at an edge of a bending area where the second substrate is bent. A cross-sectional shape of the first side surface and a cross-sectional shape of the bending area are different from each other.

According to an embodiment, wherein an angle between the first side surface and the first surface is greater than an angle between a side surface of the bending area and the first surface.

According to an embodiment, wherein an angle between a side surface of the bending area and the first surface is an acute angle.

According to an embodiment, wherein the first substrate further includes a first inclined surface between the first side surface and the second surface.

According to an embodiment, wherein the first substrate further comprises a through hole penetrating the first surface and the second surface, and a side surface of a through hole between the first surface and the second surface at an edge of the through hole.

According to an embodiment, wherein a cross-sectional shape of a side surface of the bending area and a cross-sectional shape of the side surface of the through hole are different from each other.

According to an embodiment, wherein an angle between the side surface of the through hole and the first surface is greater than an angle between the side surface of the bending area and the first surface.

According to an embodiment, wherein the cross-sectional shape of the side surface of the bending area and the cross-sectional shape of the side surface of the through hole are substantially the same.

According to an embodiment, wherein a length of the side surface of the bending area and a length of a side surface of the through hole are smaller than a length of the first side surface.

According to an embodiment, wherein the first substrate further comprises a first inclined surface between the first side surface and the second surface, a second inclined surface between a side surface of the through hole and the second surface, and a third inclined surface between the side surface of the bending area and the second surface.

According to an embodiment, wherein a length of the first inclined surface is smaller than a length of the second inclined surface and a length of the third inclined surface.

According to an embodiment, wherein an angle between the first side surface and the first inclined surface is greater than an angle between the side surface of the bending area and the third inclined surface.

According to an embodiment, wherein an angle between the second surface and the first inclined surface is smaller than an angle between the second surface and the third inclined surface.

According to an embodiment, wherein the first substrate is not located on a bending area where the second substrate is bent.

According to one or more embodiments of the present invention, there is provided a display device including a first substrate including glass and including a first surface, a second surface opposite the first surface, a first side surface between the first surface and the second surface, a through hole penetrating the first surface and the second surface, and a side surface of a through hole between the first surface and the second surface at an edge of the through hole, a second substrate on the first substrate and including a flexible material, and a light emitting element layer including a plurality of light emitting areas on the second substrate. The first substrate further includes a side surface of a bending area between the first surface and the second surface at an edge of the bending area where the second substrate is bent. A cross-sectional shape of the side surface of the through hole and a cross-sectional shape of the bending area are different from each other.

According to an embodiment, wherein an angle between the side surface of the through hole and the first surface is greater than an angle between a side surface of the bending area and the first surface.

According to an embodiment, wherein an angle between a side surface of the bending area and the first surface is an acute angle.

According to an embodiment, wherein a cross-sectional shape of a side surface of the bending area and a cross-sectional shape of the first side surface are different from each other.

According to an embodiment, wherein an angle between the first side surface and the first surface is greater than an angle between the side surface of the bending area and the first surface.

According to an embodiment, wherein a cross-sectional shape of a side surface of the bending area and a cross-sectional shape of the first side surface are substantially the same.

According to an embodiment, wherein a length of a side surface of the bending area and a length of the first side surface are greater than a length of a side surface of the through hole.

According to an embodiment, wherein the first substrate further includes a first inclined surface between the first side surface and the second surface, a second inclined surface between a side surface of the through hole and the second surface, and a third inclined surface between the side surface of the bending area and the second surface.

According to an embodiment, wherein a length of the first inclined surface and a length of the third inclined surface are smaller than a length of the second inclined surface.

According to an embodiment, wherein an angle between the side surface of the through hole and the second inclined surface is smaller than an angle between the side surface of the bending area and the third inclined surface.

According to an embodiment, wherein an angle between the second surface and the second inclined surface is greater than an angle between the second surface and the third inclined surface.

According to an embodiment, wherein the first substrate is not located in a bending area where the second substrate is bent.

According to one or more embodiments of the present invention, there is provided a method for fabricating a display device including forming a plurality of display cells on a first surface of a mother substrate, forming a plurality of first laser irradiation areas along edges of the plurality of display cells by irradiating a first laser on a second surface of the mother substrate opposite the first surface, and cutting the mother substrate along the plurality of first laser irradiation areas while reducing a thickness of the mother substrate by spraying an etchant on a second surface of the mother substrate without a mask.

According to an embodiment, wherein the plurality of first laser irradiation areas is 50 µm or larger.

According to an embodiment, further comprising radiating a second laser on the second surface of the mother substrate to form a plurality of second laser irradiation areas along an edge of a through hole of each of the plurality of display cells.

According to an embodiment, wherein a processing speed of the first laser is higher than a processing speed of the second laser.

According to an embodiment, wherein a repetition rate of the first laser is 10 kHz to 250 kHz, and a repetition rate of the second laser is 1 kHz to 50 kHz.

According to an embodiment, wherein a processing speed of the first laser ranges from 10 mm/s to 250 mm/s, and a processing speed of the second laser ranges from 1 mm/s to 50 mm/s.

According to an embodiment, wherein a pulse energy of the first laser and a pulse energy of the second laser are in a range of 10 µJ to 300 µJ.

According to an embodiment, wherein the cutting the mother substrate along the plurality of first laser irradiation areas while reducing the thickness of the mother substrate by spraying the etchant on the second surface of the mother substrate without the mask comprises cutting the mother substrate along the plurality of first laser irradiation areas and the second laser irradiation areas.

According to an embodiment, further comprising removing an organic planarization layer in an area where the through hole of each of the plurality of display cells is formed before irradiating the first laser on the second surface of the mother substrate.

According to an embodiment, further comprising removing an organic planarization layer in the through hole of each of the plurality of display cells after cutting the mother substrate.

According to an embodiment, wherein irradiating the second laser on the second surface of the mother substrate to form the plurality of second laser irradiation areas along the edge of the through hole of each of the plurality of display cells comprises forming the plurality of second laser irradiation areas along edges of bending areas as well as the edge of the through hole of each of the plurality of display cells.

According to an embodiment, further comprising, before irradiating the first laser on the second surface of the mother substrate, attaching a second protective film on the first surface of the mother substrate, attaching a third protective film on the second surface of the mother substrate, removing a portion of the third protective film in a bending area, spraying an etchant on the second surface of the mother substrate to remove a portion of the mother substrate in a bending area, and removing the third protective film from the second surface of the mother substrate.

According to an embodiment, wherein forming the plurality of first laser irradiation areas along the edges of the plurality of display cells by irradiating the first laser on the second surface of the mother substrate comprises forming the plurality of first laser irradiation areas along the edges of the plurality of display cells as well as edges of a bending area.

According to an embodiment, further comprising: attaching a plurality of first protective films to the plurality of display cells, respectively, before irradiating a first laser on the second surface of the mother substrate; and attaching the plurality of first protective films and a second protective film on a first surface of the mother substrate exposed and not covered by the plurality of first protective films before spraying an etchant on a second surface of the mother substrate.

According to one or more embodiments of the present invention, there is provided an electronic device including a display panel including a glass substrate having a through hole, and an optical device in the through hole. The display panel includes a first outermost structure on a first surface of the glass substrate and located adjacent to one edge of the glass substrate, and a second outermost structure on the first surface of the glass substrate and located adjacent to an edge of the through hole. A distance from the first outermost structure to the one edge of the glass substrate is smaller than a distance from the second outermost structure to the edge of the through hole.

According to an embodiment, further comprising a cover window on the display panel and comprising a black matrix, wherein a minimum distance between the optical device and the black matrix in a direction parallel to the first surface of the glass substrate is 50 µm.

According to an embodiment, further comprising: a polarizing film on the display panel; an upper optical cover above the optical device in the through hole; and a cover window on the polarizing film and the upper optical cover.

According to an embodiment, wherein a width of the upper optical cover increases from the optical device to the cover window.

According to an embodiment, wherein a maximum width of the upper optical cover is larger than a minimum width of the through hole, but is smaller than an upper width of the through hole and a lower width of the through hole.

According to an embodiment, wherein the upper optical cover has a variable height and width.

According to an embodiment, wherein the upper optical cover comprises: a first optical cover; a second optical cover inserted into the first optical cover in a contracted state and extracted from the first optical cover in an expanded state; and a third optical cover inserted into the second optical cover in a contracted state and extracted from the second optical cover in an expanded state.

According to one or more embodiments of the present invention, there is provided an electronic device including a plastic substrate including a bending area, and a first glass layer laminated on a first surface of the plastic substrate and including a first contact surface contacting the first surface of the plastic substrate and a first opposite surface parallel to the first contact surface, a second glass layer laminated on the first surface of the plastic substrate, facing the first glass layer, and including a second contact surface in contact with the first surface of the plastic substrate and a second opposite surface parallel to the second contact surface and being narrower than the second contact surface, a light emitting layer on a second surface of the plastic substrate parallel to and opposite to the first surface of the plastic substrate and overlapping the first glass layer in a thickness direction of the plastic substrate, and a passivation layer completely covering the light emitting layer.

According to an embodiment, wherein an area of the first opposite surface is smaller than an area of the first contact surface, and an area of the second opposite surface is smaller than an area of the second contact surface.

According to an embodiment, wherein an angle between a side surface of the first glass layer at an edge of the bending area and the first contact surface and an angle between a side surface of the second glass layer and the second contact surface are acute angles.

According to an embodiment, wherein an angle between a side surface of a first glass layer at an edge of the bending area and the first contact surface is smaller than an angle between a side surface of the first glass layer and the first contact surface at an edge of the plastic substrate.

According to an embodiment, wherein the first glass layer at an edge of the bending area further comprises an inclined surface between a side surface of the first glass layer and an opposite surface, wherein an angle between a side surface of the first glass layer at an edge of the bending area and the first contact surface is smaller than an angle between a side surface of the first glass layer at an edge of the bending area and the inclined surface.

According to an embodiment, wherein the first glass layer further includes a through hole.

According to an embodiment, wherein an angle between a side surface of the first glass layer and the first contact surface at an edge of the through hole is an acute angle.

According to an embodiment, further comprising an optical device at least partially inserted into the through hole.

According to one or more embodiments of the present invention, there is provided an electronic device including a first glass substrate, a second glass substrate facing the first glass substrate, and an organic layer on the first glass substrate and the second glass substrate, connecting the first glass substrate and the second glass substrate, and including a bending area. The first glass substrate includes a first contact surface contacting the organic layer and a first opposite surface parallel to the first contact surface. The second glass substrate includes a second contact surface contacting the organic layer and a second opposite surface parallel to the first contact surface. The electronic device further includes a light emitting layer on an organic layer located on the first glass substrate, and a protective film completely covering the light emitting layer.

According to an embodiment, wherein an angle between a side surface of the first glass substrate and the first contact surface and an angle between a side surface of the second glass substrate and the second contact surface at an edge of the bending area are acute angles.

According to an embodiment, wherein an angle between a side surface of the first glass substrate and the first contact surface at an edge of the bending area is smaller than an angle between the side surface of the first glass substrate and the first contact surface at an edge of the organic layer.

According to an embodiment, wherein the first glass substrate at an edge of the bending area further includes an inclined surface between a side surface of the first glass substrate and the opposite surface, and wherein an angle between the side surface of the first glass substrate at the edge of the bending area and the first contact surface is smaller than an angle between the side surface of the first glass substrate at the edge of the bending area and the inclined surface.

According to an embodiment, wherein the first glass substrate further includes a through hole.

According to an embodiment, wherein an angle between a side surface of the first glass substrate and the first contact surface at an edge of the through hole is an acute angle.

According to an embodiment, further comprising an optical device at least partially inserted into the through hole.

According to one or more embodiments of the present invention, there is provided an electronic device including a glass substrate having a through hole penetrating the glass substrate, a light emitting layer on a first surface of the glass substrate, an organic layer covering the light emitting layer, and a protective film covering the light emitting layer. The glass substrate includes a contact surface contacting the organic layer and an opposite surface. An angle between a side surface of the glass substrate and the contact surface at an edge of the glass substrate is the same as an angle between the side surface of the glass substrate and the contact surface at an edge of the through hole. The through hole and the edge of the glass substrate are processed by a laser.

According to an embodiment, further comprising an optical device at least partially inserted into the through hole.

According to an embodiment, wherein an angle between the side surface of the glass substrate and the contact surface at the edge of the glass substrate is greater than an angle between the side surface of the glass substrate and the opposing surface.

According to an embodiment, wherein the side surface of the glass substrate at the edge of the glass substrate is connected to the contact surface, and wherein the glass substrate further includes an inclined surface between a side surface and the opposing surface at the edge of the glass substrate.

According to the aforementioned and other embodiments of the present invention, a width of the non-display area may be reduced or minimized.

According to the aforementioned and other embodiments of the present invention, the mechanical strength of the display device may be improved.

According to the aforementioned and other embodiments of the present invention, it may be possible to cut the substrate while reducing the thickness of the substrate.

### BRIEF DESCRIPTION OF THE DRAWINGS

The above and other embodiments and features of the present invention will become more apparent by describing embodiments thereof with reference to the attached drawings, in which:
FIG. 1 is a perspective view illustrating a display device according to one or more embodiments;
FIG. 2 is a plan view illustrating a display panel and a driving IC according to one or more embodiments;
FIG. 3A is a block diagram illustrating a display device according to one or more embodiments;
FIG. 3B is a circuit diagram illustrating a pixel of a display device according to one or more embodiments;
FIG. 3C is a circuit diagram illustrating a pixel of a display device according to one or more embodiments;
FIG. 3D is a circuit diagram illustrating a pixel of a display device according to one or more embodiments;
FIG. 4 is a cross-sectional view illustrating an example of the display device taken along the line I-I' of FIG. 1;
FIG. 5 is a cross-sectional view illustrating an example of a display device in which the circuit board of FIG. 4 is bent;
FIG. 6 is a cross-sectional view illustrating an example of a display area of a display panel according to one or more embodiments;
FIG. 7 is a cross-sectional view illustrating an example of a display area of a display panel according to one or more embodiments;
FIG. 8 is a detailed cross-sectional view illustrating the light emitting diode element of FIG. 7;
FIG. 9 is a cross-sectional view illustrating an example of a display area of a display panel according to one or more embodiments;
FIG. 10 is a cross-sectional view illustrating an example of a display area of a display panel according to one or more embodiments;
FIG. 11 is a layout diagram illustrating an example of an area A of FIG. 2 in more detail;
FIG. 12 is a layout diagram illustrating an example of an area B of FIG. 2 in more detail;
FIG. 13 is a layout diagram illustrating an example of an area D of FIG. 2 in more detail;
FIG. 14 is a cross-sectional view illustrating an example of the display panel taken along the line II-II' of FIG. 11;
FIG. 15 is a cross-sectional view illustrating an example of the display panel taken along the line III-III' of FIG. 12;
FIG. 16 is an image illustrating a width of the first sub-edge area;
FIG. 17 is an image illustrating chipping of the second sub-edge area;
FIG. 18 is an image illustrating roughness of a first side surface, a first inclined surface, and a second inclined surface of a display panel according to one or more embodiments;
FIG. 19 is a cross-sectional view illustrating an example of the display panel taken along the line II-II' of FIG. 11;
FIG. 20 is a cross-sectional view illustrating an example of the display panel taken along the line III-III' of FIG. 12;
FIG. 21 is a cross-sectional view illustrating an example of the display panel taken along the line IV-IV' of FIG. 13;
FIG. 22 is an image illustrating a width of a processing mark of a display panel according to one or more embodiments;
FIG. 23 is an image illustrating roughness of a first side surface and a first inclined surface of a display panel according to one or more embodiments;
FIG. 24 is an enlarged cross-sectional view illustrating an example of an area E of FIG. 19 in more detail;
FIG. 25 is an enlarged cross-sectional view illustrating an example of an area F of FIG. 20 in more detail;
FIG. 26 is an enlarged cross-sectional view illustrating an example of an area G of FIG. 21 in more detail;
FIG. 27 is a graph illustrating a twist test result of a display panel according to one or more embodiments;
FIG. 28 is a graph illustrating a 4PB test result of a display panel according to one or more embodiments;
FIG. 29 is a layout diagram illustrating a cut area of a display panel according to one or more embodiments;
FIG. 30 is a table illustrating a distance between a display area and an edge of a display panel according to one or more embodiments;
FIG. 31 is a table illustrating a distance between a display area and an edge of a display panel according to one or more embodiments;
FIG. 32 is a cross-sectional view illustrating an example of the display panel taken along the line II-II' of FIG. 11;
FIG. 33 is a cross-sectional view illustrating an example of the display panel taken along the line II-II' of FIG. 11;
FIG. 34 is an example view illustrating laser irradiation areas formed by a laser to form the round side surface of FIG. 33;
FIG. 35 is a cross-sectional view illustrating an example of the display panel taken along the line II-II' of FIG. 11;
FIG. 36 is a cross-sectional view illustrating an example of an area H of FIG. 35 in more detail;
FIG. 37 is a cross-sectional view illustrating an example of the area H of FIG. 35 in more detail;
FIG. 38 is a cross-sectional view illustrating an example of the area H of FIG. 35 in more detail;
FIG. 39 is a cross-sectional view illustrating an example of the area H of FIG. 35 in more detail;
FIGS. 40A and 40B are layout views illustrating a display pad and an electrostatic protection line according to one or more embodiments;
FIG. 41 is a cross-sectional view illustrating an example of the display panel taken along the line V-V' of FIG. 40B;
FIGS. 42A and 42B are layout views illustrating a display pad and an electrostatic protection line according to one or more embodiments;
FIGS. 43A and 43B are layout views illustrating a display pad and an electrostatic protection line according to one or more embodiments;
FIGS. 44A and 44B are layout views illustrating a display pad and an electrostatic protection line according to one or more embodiments;
FIG. 45 is a cross-sectional view illustrating an example of the display panel taken along the line VI-VI' of FIG. 44B;
FIG. 46 is a flowchart illustrating a method of manufacturing a display device according to one or more embodiments;
FIGS. 47 to 51 are perspective views illustrating a method of manufacturing a display device according to one or more embodiments;
FIGS. 52 to 57 are cross-sectional views illustrating a method of manufacturing a display device according to one or more embodiments;
FIG. 58 is a flowchart illustrating a method of manufacturing a display device according to one or more embodiments;
FIGS. 59 to 63 are perspective views illustrating a method of manufacturing a display device according to one or more embodiments;
FIGS. 64 to 68 are cross-sectional views illustrating a method of manufacturing a display device according to one or more embodiments;
FIG. 69 is an example view illustrating a depth of a laser irradiation area formed by a laser according to one or more embodiments;
FIG. 70 is an image illustrating a bottom surface of a display device according to one or more embodiments;
FIG. 71 is a perspective view illustrating a display device according to one or more embodiments;
FIG. 72 is a plan view illustrating a display panel and a driving IC according to one or more embodiments;
FIG. 73 is a cross-sectional view illustrating an example of the display device taken along the line IX-IX' of FIG. 71;
FIG. 74 is a cross-sectional view illustrating an example of the display device in which the circuit board of FIG. 73 is bent;
FIG. 75 is a layout diagram illustrating an example of a through hole, an inorganic encapsulation area, a line area, and a display area of a display panel according to one or more embodiments;
FIG. 76 is a cross-sectional view illustrating an example of the display panel taken along the line X-X' of FIG. 75;
FIG. 77 is an enlarged cross-sectional view illustrating an example of an area K of FIG. 76 in more detail;
FIG. 78 is a cross-sectional view illustrating an example of the display panel taken along the line X-X' of FIG. 75;
FIG. 79 is an enlarged cross-sectional view illustrating an example of an area L of FIG. 78 in more detail;
FIG. 80 is a cross-sectional view illustrating an example of the display panel taken along the line X-X' of FIG. 75;
FIG. 81 is an enlarged cross-sectional view illustrating an example of an area M of FIG. 80 in more detail;
FIG. 82 is a cross-sectional view illustrating an example of the display panel taken along the line X-X' of FIG. 75;
FIG. 83 is an enlarged cross-sectional view illustrating an example of an area N of FIG. 82 in more detail;
FIG. 84 is an enlarged cross-sectional view illustrating an example of the area N of FIG. 82 in more detail;
FIG. 85 is an enlarged cross-sectional view illustrating an example of the area N of FIG. 82 in more detail;
FIG. 86 is a cross-sectional view illustrating an example of the display panel taken along the line X-X' of FIG. 75;
FIG. 87 is an example diagram illustrating a minimum distance between an optical device and a black matrix when a through hole is not formed in the display panel;
FIG. 88 is an example diagram illustrating a minimum distance between an optical device and a black matrix when a through hole is formed in a display panel;
FIG. 89 is a cross-sectional view illustrating an example of an electronic device including a display panel and an optical device disposed in a through hole according to one or more embodiments;
FIGS. 90 and 91 are cross-sectional views illustrating an example of an electronic device including a display panel and an optical device disposed in a through hole according to one or more embodiments;
FIG. 92 is a flowchart illustrating a method of manufacturing a display device according to one or more embodiments;
FIGS. 93 to 98 are perspective views illustrating a method of manufacturing a display device according to one or more embodiments;
FIGS. 99 to 103 are cross-sectional views illustrating a method of manufacturing a display device according to one or more embodiments;
FIG. 104 is a flowchart illustrating a method of manufacturing a display device according to one or more embodiments;
FIG. 105 is a cross-sectional view illustrating a method of manufacturing a display device according to one or more embodiments;
FIG. 106 is a flowchart illustrating a method of manufacturing a display device according to one or more embodiments;
FIG. 107 is a cross-sectional view illustrating a method of manufacturing a display device according to one or more embodiments;
FIG. 108 is a perspective view illustrating a display device according to one or more embodiments;
FIG. 109 is a plan view illustrating a display panel and a driving IC according to one or more embodiments;
FIG. 110 is a cross-sectional view illustrating an example of the display device taken along the lines XA-XA' and XB-XB' of FIG. 108;
FIG. 111 is a cross-sectional view illustrating an example of the display device in which the bending area of FIG. 110 is bent;
FIG. 112 is a cross-sectional view illustrating an example of the display device taken along the lines XA-XA' and XB-XB' of FIG. 108;
FIG. 113 is a cross-sectional view illustrating an example of the display device in which the bending area of FIG. 112 is bent;
FIG. 114 is a cross-sectional view illustrating an example of the display device taken along the lines XA-XA' and XB-XB' of FIG. 108;
FIG. 115 is a cross-sectional view illustrating an example of the display device in which the bending area of FIG. 114 is bent;
FIG. 116 is a cross-sectional view illustrating an example of the display device taken along the lines XA-XA' and XB-XB' of FIG. 108;
FIG. 117 is a cross-sectional view illustrating an example of the display device in which the bending area of FIG. 116 is bent;
FIG. 118 is a cross-sectional view illustrating an example of the display device taken along the lines XA-XA' and XB-XB' of FIG. 108;
FIG. 119 is a cross-sectional view illustrating an example of the display device in which the bending area of FIG. 118 is bent;
FIG. 120 is a cross-sectional view illustrating an example of the display device taken along the lines XA-XA' and XB-XB' of FIG. 108;
FIG. 121 is a cross-sectional view illustrating an example of the display device in which the bending area is bent in FIG. 120;
FIG. 122 is a cross-sectional view illustrating an example of the display device taken along the lines XA-XA' and XB-XB' of FIG. 108;
FIG. 123 is a cross-sectional view illustrating an example of the display device in which the bending area of FIG. 122 is bent;
FIG. 124A is a cross-sectional view illustrating an example of the display device taken along the lines XA-XA' and XB-XB' of FIG. 108;
FIG. 124B is a cross-sectional view illustrating an example of the display device in which the bending area of FIG. 124A is bent;
FIG. 125A is a cross-sectional view illustrating an example of the display device taken along the lines XA-XA' and XB-XB' of FIG. 108;
FIG. 125B is a cross-sectional view illustrating an example of the display device in which the bending area of FIG. 125A is bent;
FIG. 125C is a cross-sectional view illustrating an example of the display device taken along the lines XA-XA' and XB-XB' of FIG. 108;
FIG. 125D is a cross-sectional view illustrating an example of the display device in which the bending area of FIG. 125C is bent;
FIG. 125E is a cross-sectional view illustrating an example of the display device taken along the lines XA-XA' and XB-XB' of FIG. 108;

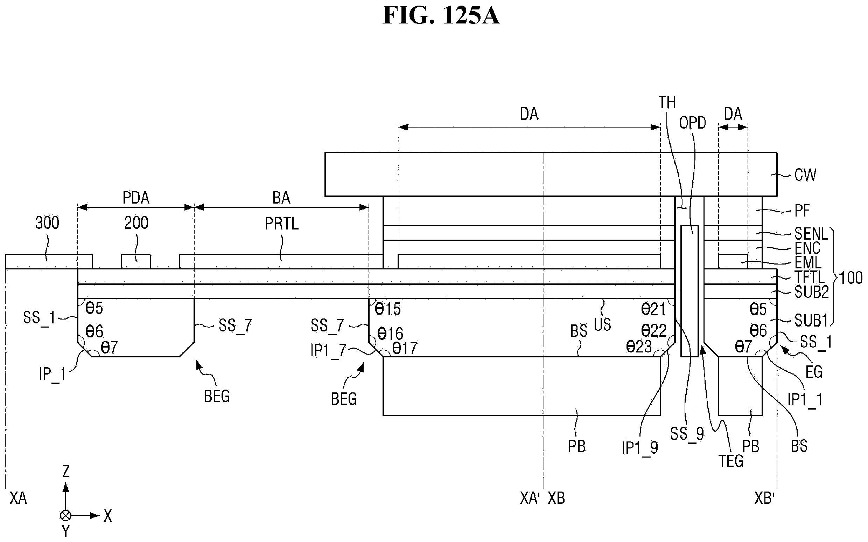

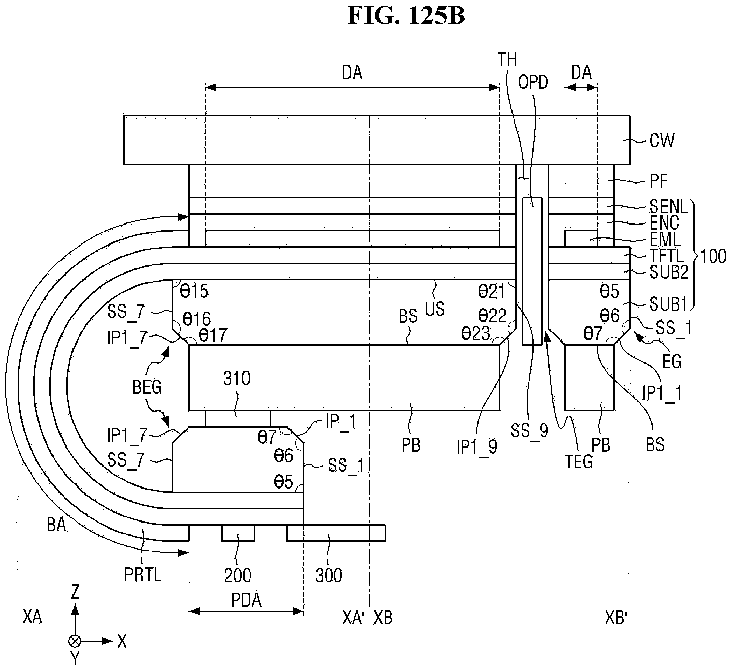

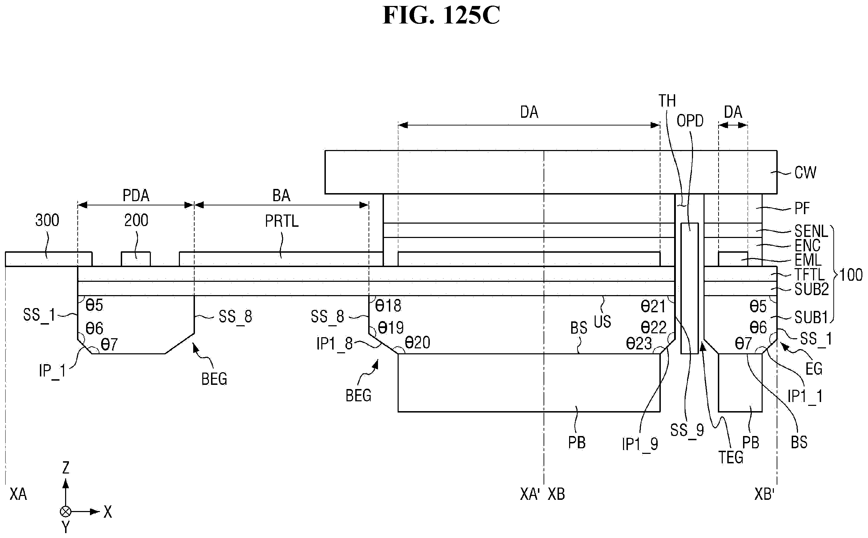

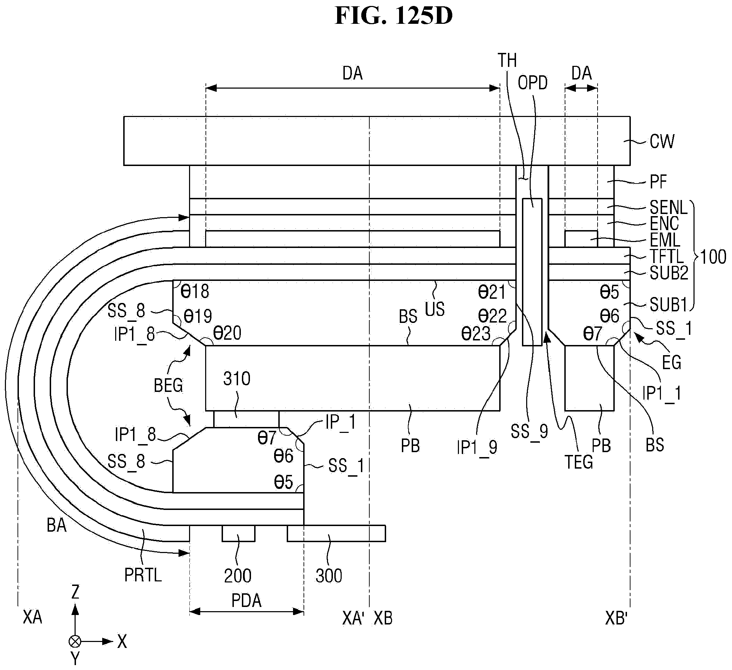

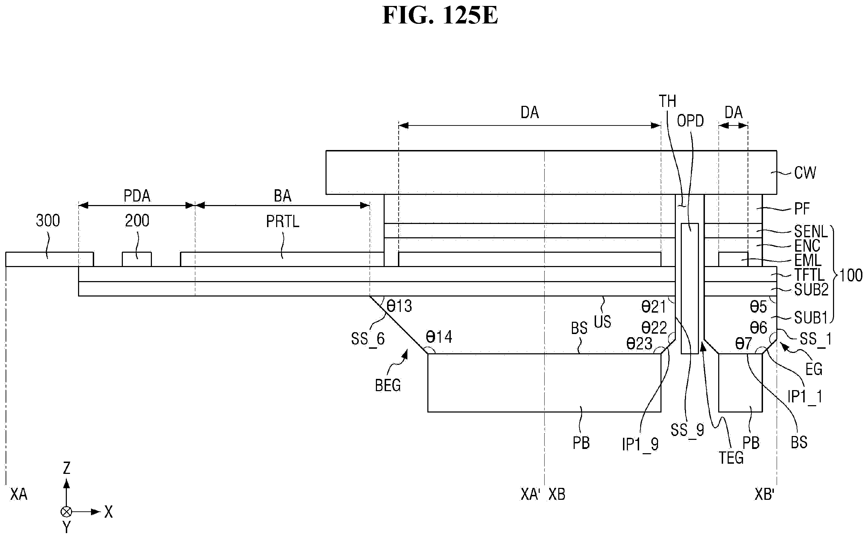

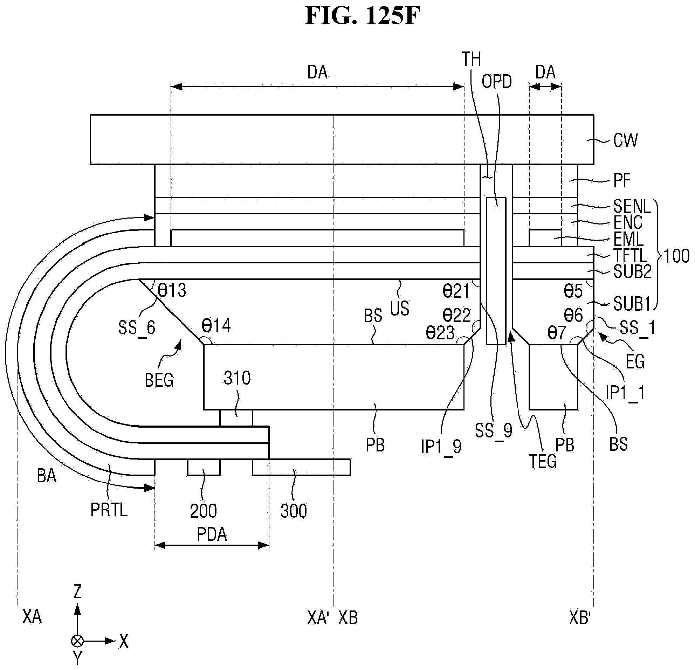

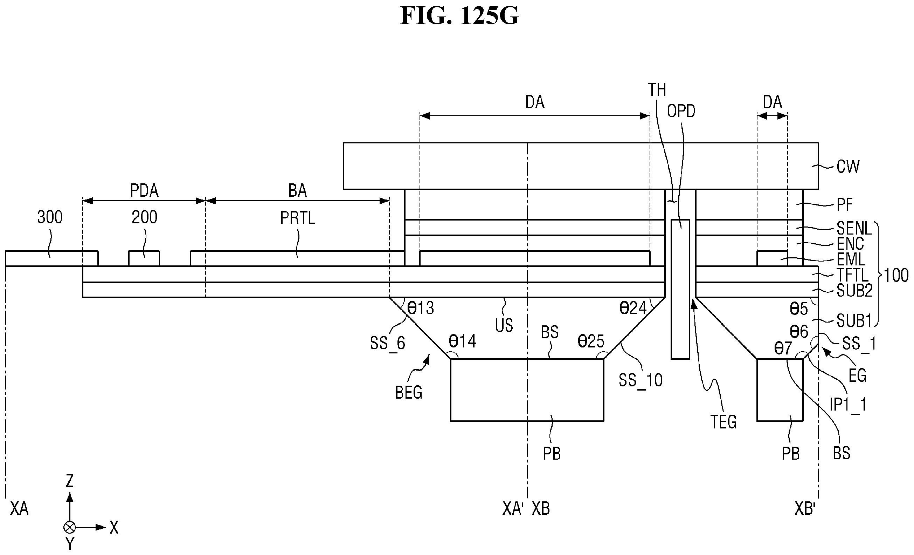

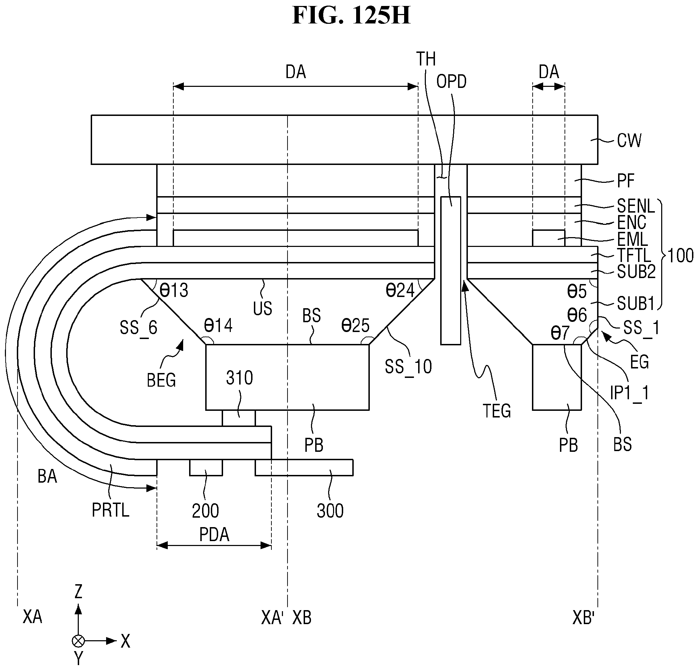

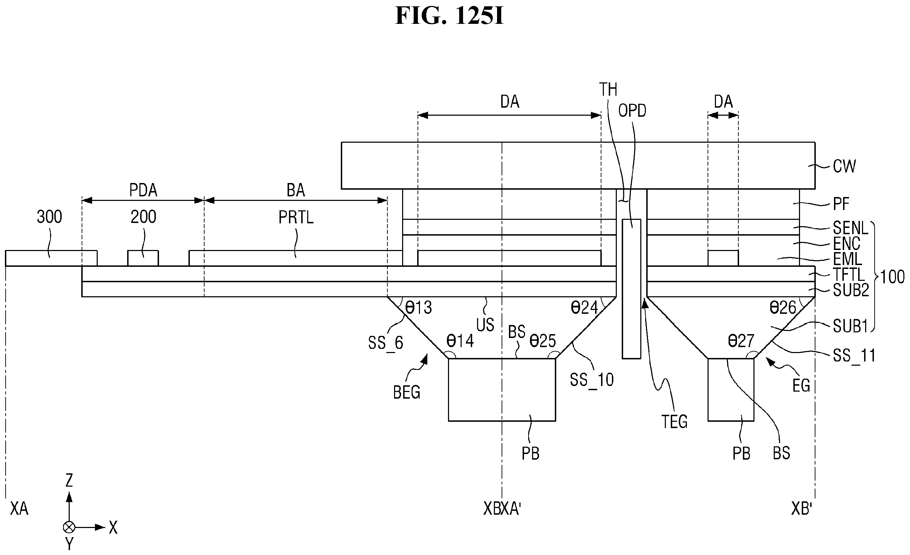

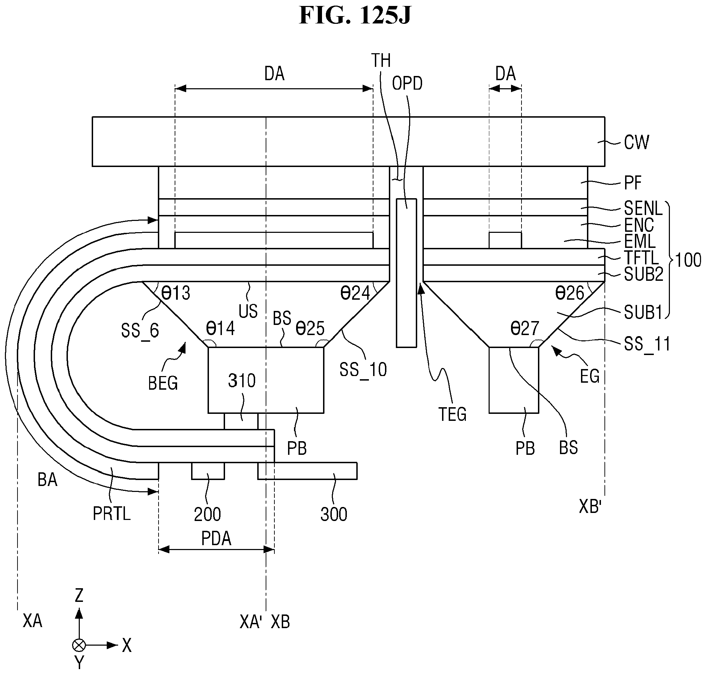

FIG. 125fFis a cross-sectional view illustrating an example of the display device in which the bending area of FIG. 125E is bent;

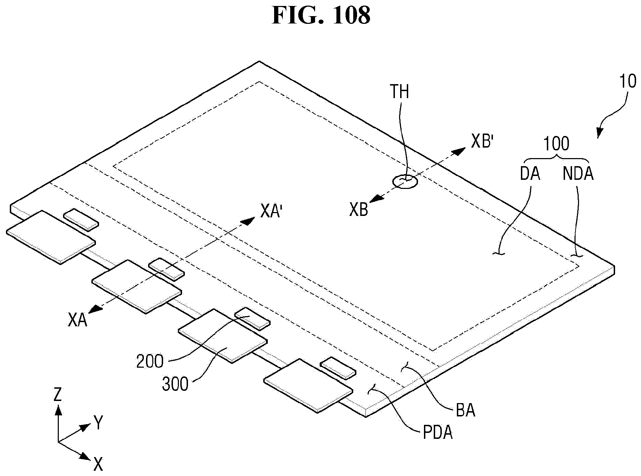

FIG. 125G is a cross-sectional view illustrating an example of the display device taken along the lines XA-XA' and XB-XB' of FIG. 108;
FIG. 125H is a cross-sectional view illustrating an example of the display device in which the bending area of FIG. 125G is bent;
FIG. 125I is a cross-sectional view illustrating an example of the display device taken along the lines XA-XA' and XB-XB' of FIG. 108;
FIG. 125J is a cross-sectional view illustrating an example of the display device in which the bending area of FIG. 125I is bent;

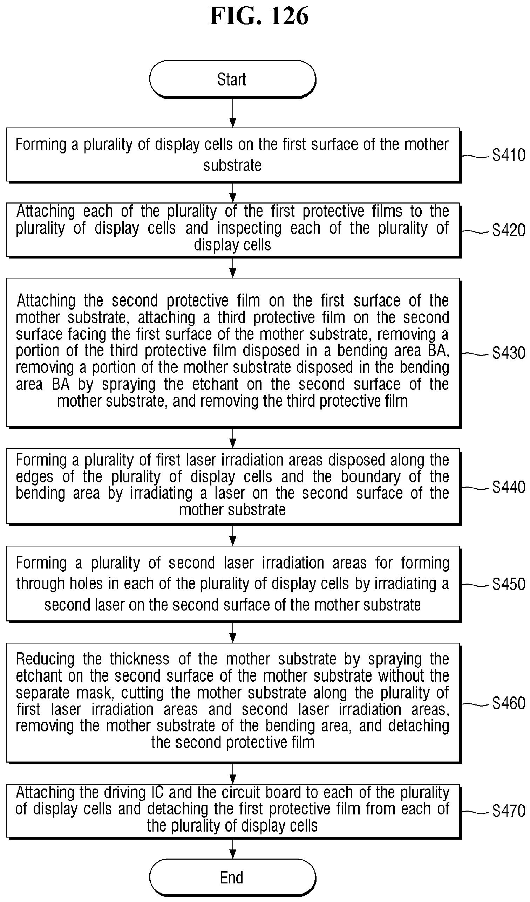

FIG. 126 is a flowchart illustrating a method of manufacturing a display device according to one or more embodiments;

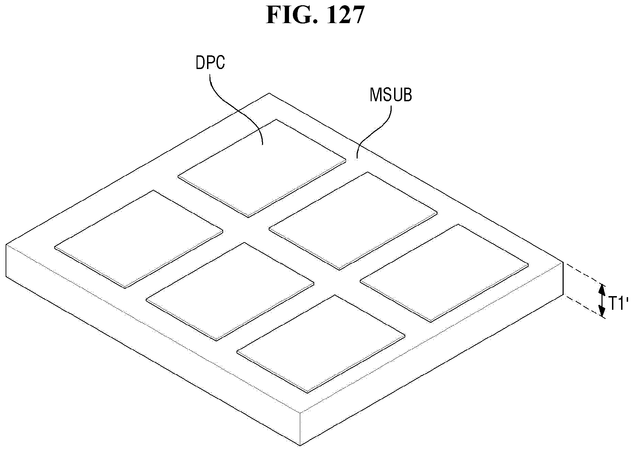

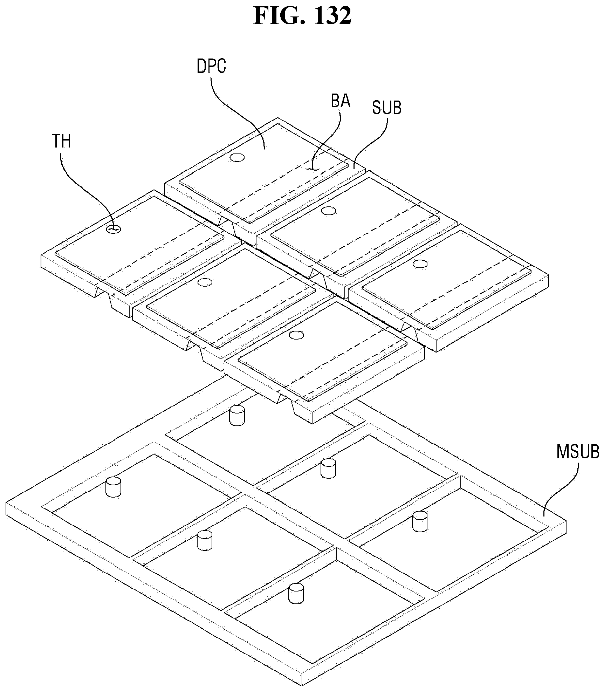

FIGS. 127 to 133 are perspective views illustrating a method of manufacturing a display device according to one or more embodiments;

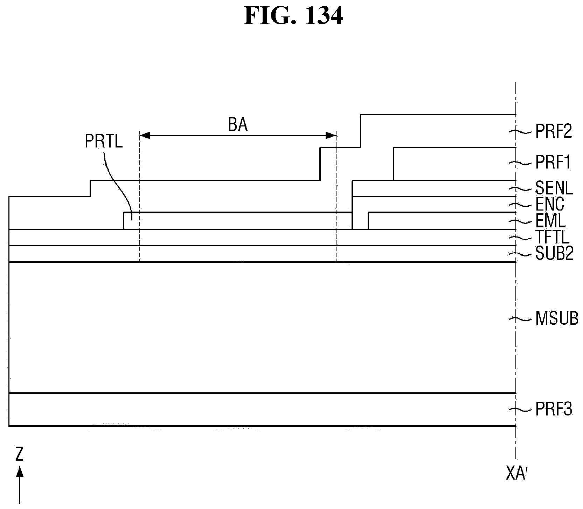

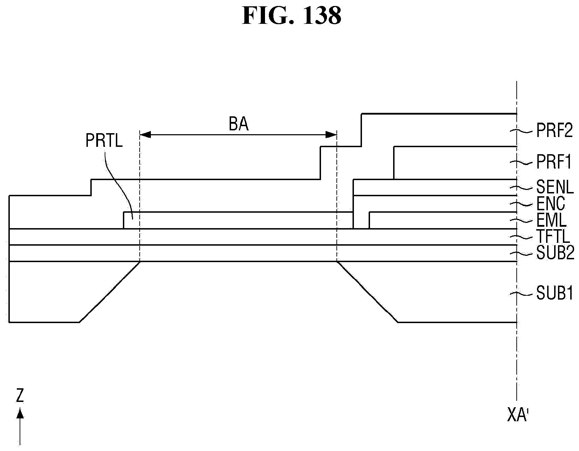

FIGS. 134 to 138 are cross-sectional views illustrating a method of manufacturing a display device according to one or more embodiments;

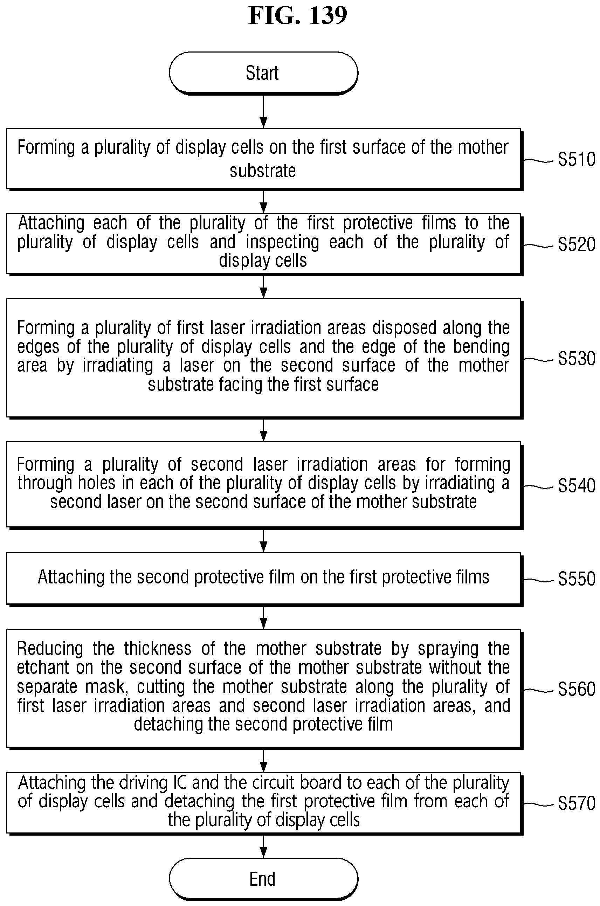

FIG. 139 is a flowchart illustrating a method of manufacturing a display device according to one or more embodiments;

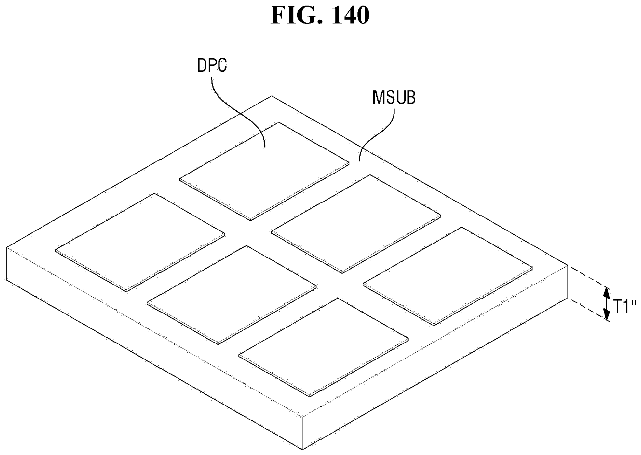

FIGS. 140 to 145 are perspective views illustrating a method of manufacturing a display device according to one or more embodiments;

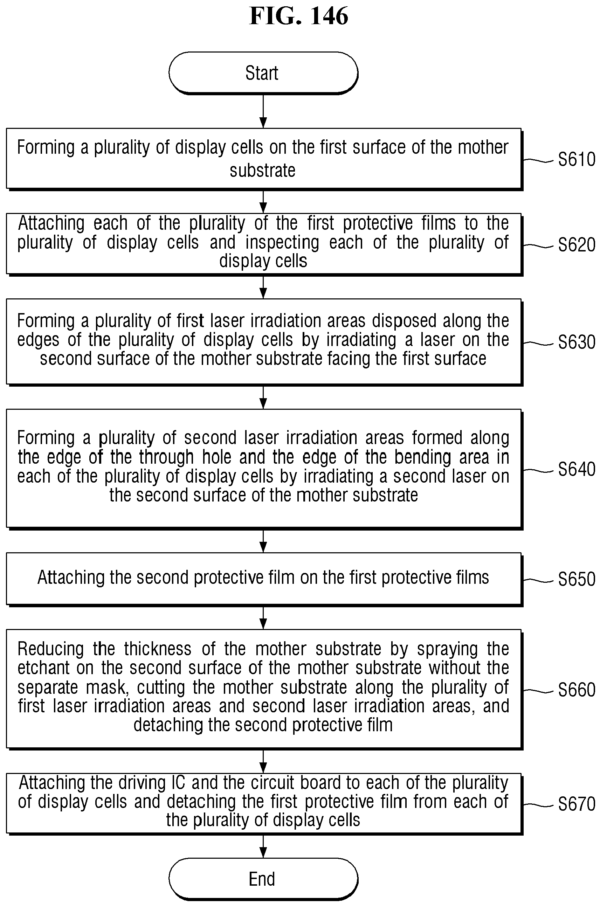

FIG. 146 is a flowchart illustrating a method of manufacturing a display device according to one or more embodiments;

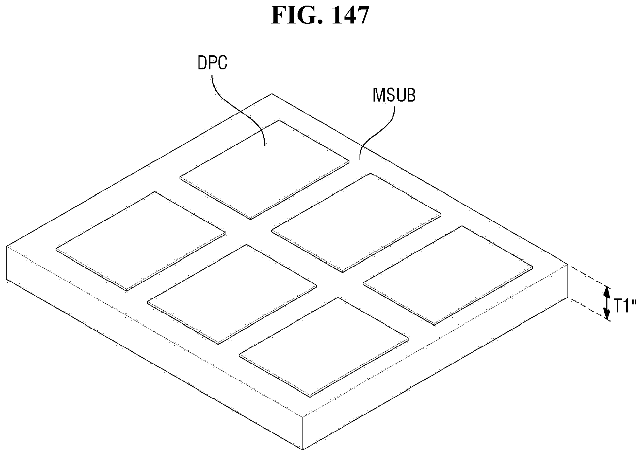

FIGS. 147 to 152 are perspective views illustrating a method of manufacturing a display device according to one or more embodiments;

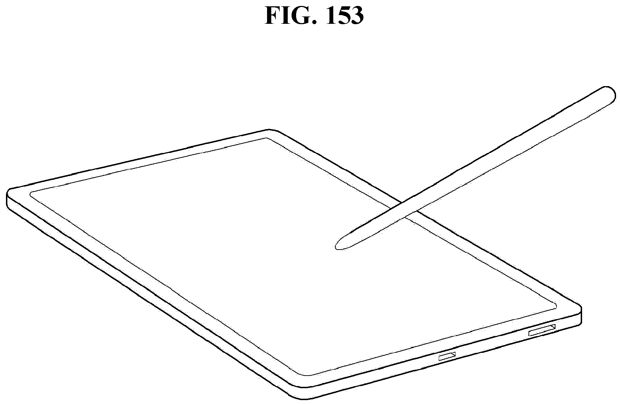

FIG. 153 is an example diagram illustrating an electronic device including a display device according to one or more embodiments;

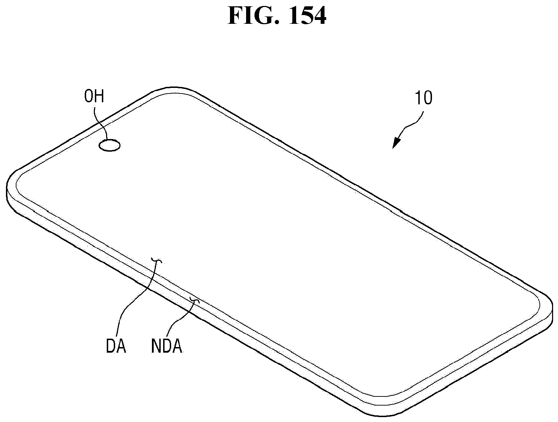

FIG. 154 is an example diagram illustrating an electronic device including a display device according to one or more embodiments;

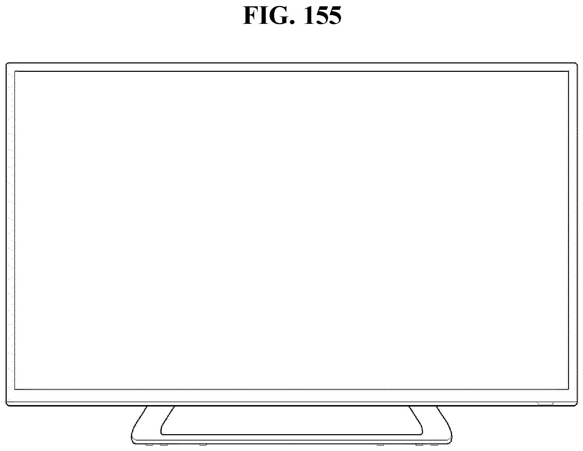

FIG. 155 is an example diagram illustrating an electronic device including a display device according to one or more embodiments;

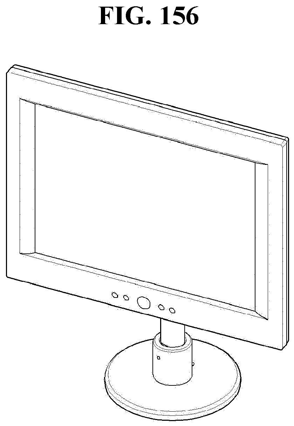

FIG. 156 is an example diagram illustrating an electronic device including a display device according to one or more embodiments;

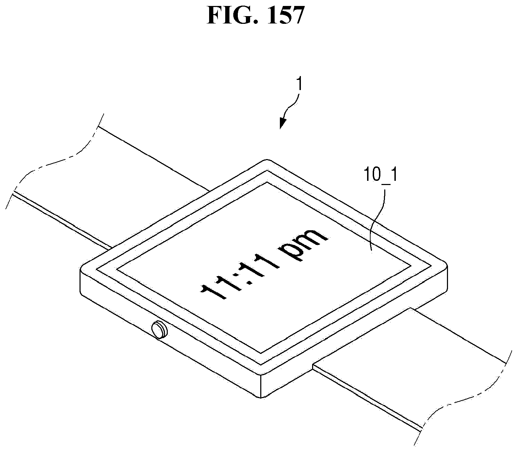

FIG. 157 is an example diagram illustrating an electronic device including a display device according to one or more embodiments;

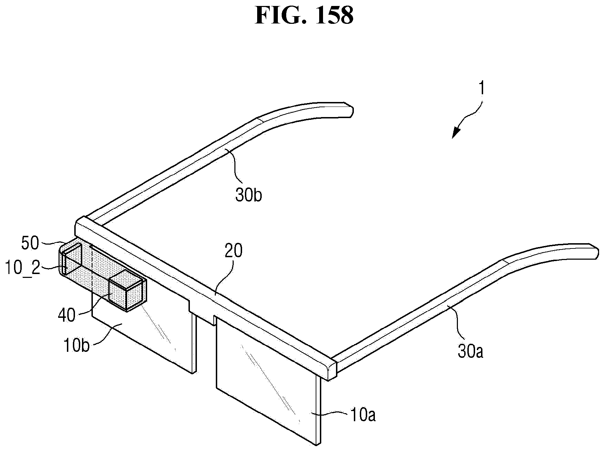

FIG. 158 is an example diagram illustrating an electronic device including a display device according to one or more embodiments;

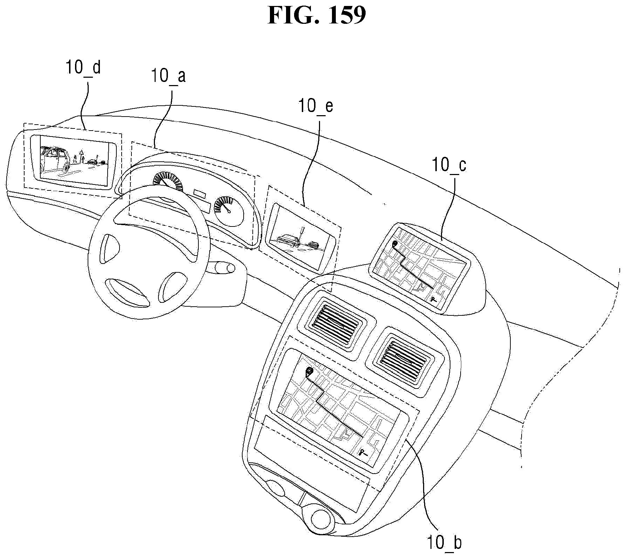

FIG. 159 is an example view illustrating a vehicle instrument panel and a center fascia to which an electronic device including a display device is applied, according to one or more embodiments; and

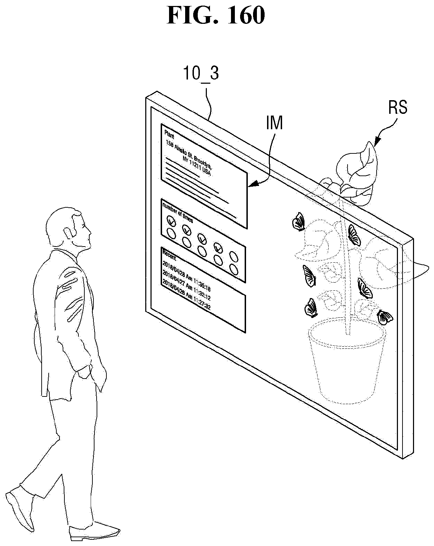

FIG. 160 is an example diagram illustrating an electronic device including a display device according to one or more embodiments.

### DETAILED DESCRIPTION

Aspects and features of embodiments of the present invention and methods of accomplishing the same may be understood more readily by reference to the detailed description of embodiments and the accompanying drawings. Hereinafter, embodiments will be described in more detail with reference to the accompanying drawings. The described embodiments, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present invention might not be described.

Unless otherwise noted, like reference numerals, characters, or combinations thereof denote like elements throughout the attached drawings and the written description, and thus, descriptions thereof will not be repeated. Further, parts not related to the description of one or more embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present invention. Thus, embodiments disclosed herein should not be construed as limited to the particular illustrated shapes of regions, but are to include deviations (or variations) in shapes that result from, for instance, manufacturing.

For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in the present disclosure, the phrase "on a plane," or "in plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled" refers to one component directly connecting or coupling another component without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," "at least one selected from among X, Y, and Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. Similarly, the expression such as "at least one of A and B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present disclosure refers to "one or more embodiments of the present disclosure".

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer, or section. Thus, a first element, component, region, layer, or section described below could be termed a second element, component, region, layer, or section, without departing from the scope of the present disclosure.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in the present disclosure, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

When one or more embodiments may be implemented differently, a specific process order may be performed differently from the described order. For example, two consecutively described processes may be performed substantially at the same time or performed in an order opposite to the described order.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in the present disclosure is intended to include all higher numerical limitations subsumed therein.

The electronic or electric devices and/or any other relevant devices or components according to embodiments of the present invention described herein may be implemented utilizing any suitable hardware, firmware (e.g., an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of embodiments of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning for example consistent with their meaning in the context of the relevant art and/or the present invention, and should not be interpreted in an idealized or overly formal sense, unless expressly so defined herein.

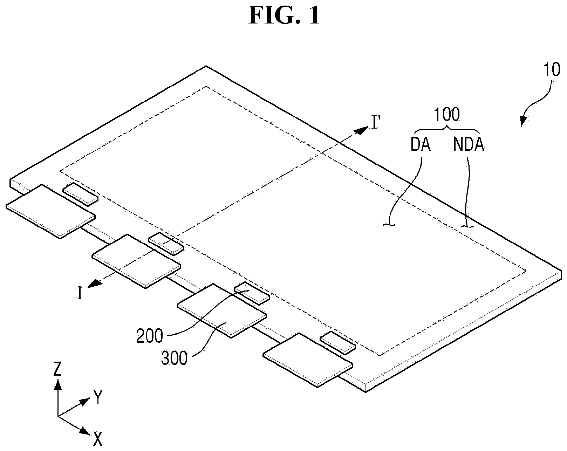

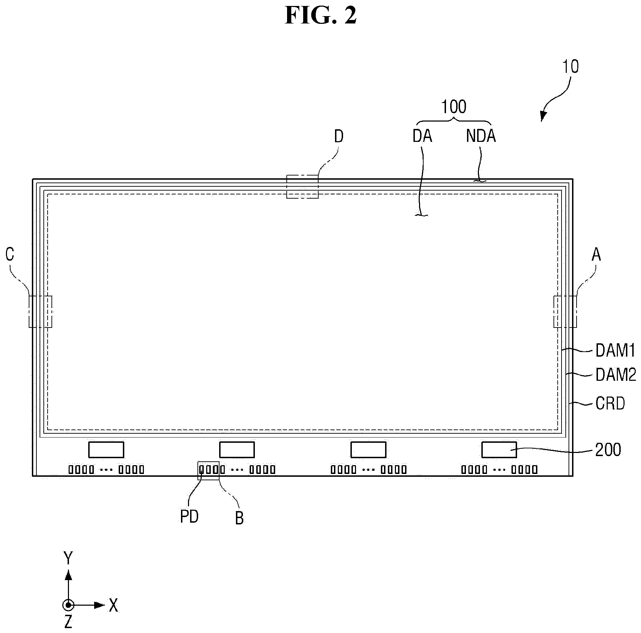

FIG. 1 is a perspective view illustrating a display device according to one or more embodiments. FIG. 2 is a plan view illustrating a display panel according to one or more embodiments.

Referring to FIGS. 1 and 2, a display device 10 is a device for displaying a moving image and/or a still image. The display device may be used as a display screen of various products such as televisions, laptop computers, monitors, billboards or the Internet of Things (IOT) as well as portable electronic devices such as mobile phones, smart phones, tablet personal computer (tablet PC), smart watches, watch phones, mobile communication terminals, electronic notebooks, electronic books, portable multimedia players (PMPs), navigation systems or ultra mobile PCs (UMPCs).

The display device 10 according to one or more embodiments may be a light emitting display device such as an organic light emitting display device using an organic light emitting diode, a quantum dot light emitting display including a quantum dot light emitting layer, an inorganic light emitting display device including an inorganic semiconductor, or a micro light emitting display device using a micro or nano light emitting diode (micro LED or nano LED). Hereinafter, the display device 10 will be primarly described as an organic light emitting display device, but the present invention is not limited thereto.

The display device 10 according to one or more embodiments includes a display panel 100, a driving integrated circuit (IC) 200, and a circuit board 300.

The display panel 100 may be formed in a rectangular plane having a long side in a first direction (X-axis direction) and a short side in a second direction (Y-axis direction) intersecting the first direction (X-axis direction). A corner where the long side of the first direction (X-axis direction) and the short side of the second direction (Y-axis direction) meet may be formed at a right angle or rounded to have a curvature. The flat shape of the display panel 100 is not limited to a quadrangle, and the display panel 100 may be formed in other polygonal, circular, or oval shapes.

The display panel 100 may be formed to be flat but is not limited thereto. For example, the display panel 100 may include curved portions (or bent portions) having a constant curvature or a varying curvature at left and right ends thereof. In addition, the display panel 100 may be flexibly formed to be bent, folded, or rolled.

The display panel 100 may include a display area DA for displaying an image and a non-display area NDA disposed around the display area DA.

The display area DA may occupy most of the area of the display panel 100. The display area DA may be disposed in the center of the display panel 100. Pixels each including a plurality of emission areas may be disposed in the display area DA to display an image.

The non-display area NDA may be disposed adjacent to the display area DA. The non-display area NDA may be an area outside the display area DA. The non-display area NDA may be disposed to surround the display area DA. The non-display area NDA may be an edge area of the display panel 100.

Display pads PD may be disposed in the non-display area NDA to be connected to circuit boards 300. The display pads PD may be disposed on one edge of the display panel 100. For example, the display pads PD may be disposed on the lower edge of the display panel 100.

The display pads PD may be an outermost structure disposed on the outermost side under the display panel 100. The outermost structure may be a structure disposed closest to the edge of the display panel 100. The outermost structure may be a structure for driving the display panel 100 or a structure for improving a function of the display panel 100.

The display panel 100 may include a first dam DAM1, a second dam DAM2, and a crack dam CRD.

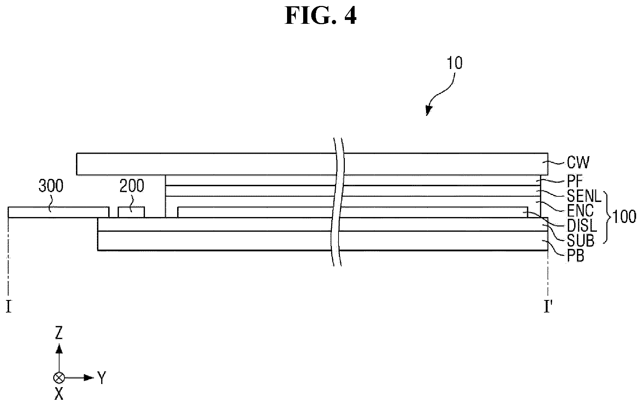

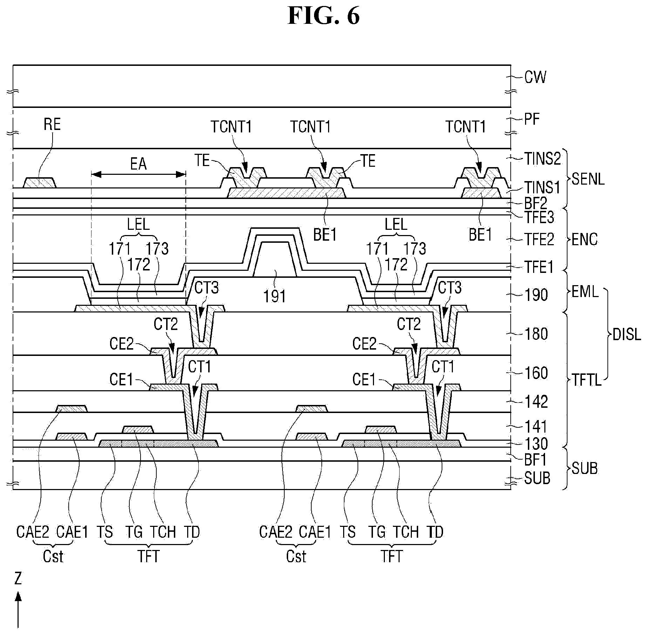

The first dam DAM1 and the second dam DAM2 may be structures for preventing the encapsulation organic layer (TFE2 of FIG. 6) of the encapsulation layer (ENC of FIG. 4) from overflowing. The first dam DAM1 may be disposed to surround the display area DA, and the second dam DAM2 may be disposed to surround the first dam DAM1.

The crack dam CRD may be a structure for preventing the propagation of cracks in the inorganic layers of an encapsulation layer ENC in the process of cutting a substrate SUB during the manufacturing process of the display device 10. The crack dam CRD may be disposed along left, upper, and right edges of the display panel 100. The crack dam CRD may not be disposed on the lower edge of the display panel 100. The crack dam CRD may be the outermost structure disposed at the outermost sides of the left, upper, and right sides of the display panel 100.

The driving integrated circuits IC 200 may generate data voltages, power supply voltages, scan timing signals, and/or the like. The driving ICs 200 may output data voltages, power supply voltages, scan timing signals, and/or the like.

The driving integrated circuits IC 200 may be disposed between the display pads PD and the display area DA in the non-display area NDA. Each of the driving ICs 200 may be attached to the non-display area NDA of the display panel 100 using a chip on glass (COG) method. Alternatively, each of the driving ICs 200 may be attached to the circuit board 300 using a chip on plastic (COP) method.

The circuit boards 300 may be disposed on the display pads PD disposed on one edge of the display panel 100. The circuit boards 300 may be attached to the display pads PD using an anisotropic conductive film and a conductive adhesive member such as an anisotropic conductive adhesive. Accordingly, the circuit boards 300 may be electrically connected to signal lines of the display panel 100. The circuit boards 300 may be a flexible film such as a flexible printed circuit board or a chip on film.

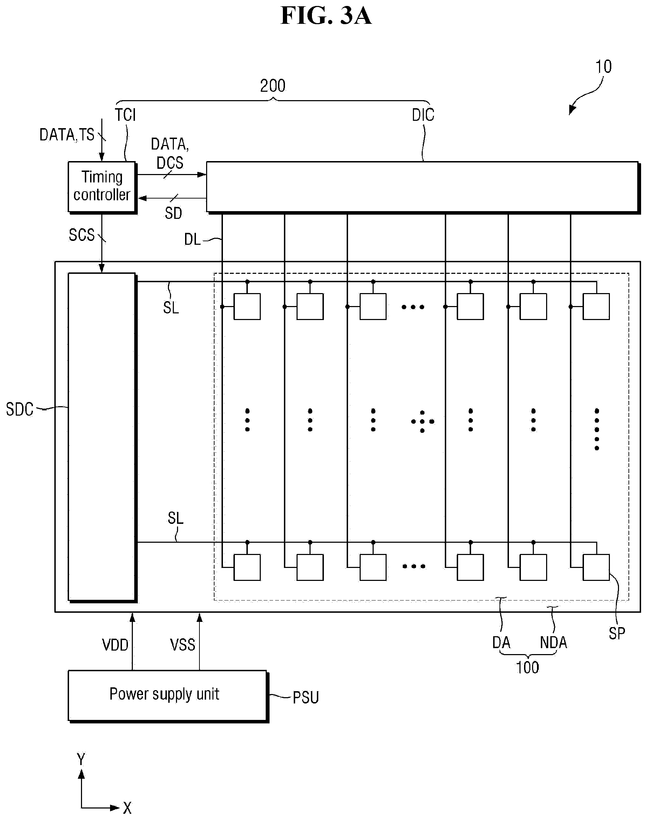

FIG. 3A is a block diagram illustrating a display device according to one or more embodiments.

Referring to FIG. 3A, the display device 10 according to one or more embodiments includes the display panel 100, a scan driving circuit unit SDC, a driving IC 200, and a power supply unit PSU.

The display panel 100 includes data lines DL, scan lines SL, and pixels PX. The scan lines SL may be extended in the first direction (X-axis direction) and may be spaced from each other along the second direction (Y-axis direction). The data lines DL may be extended in the second direction (Y-axis direction) and may be spaced from each other along the first direction (X-axis direction).

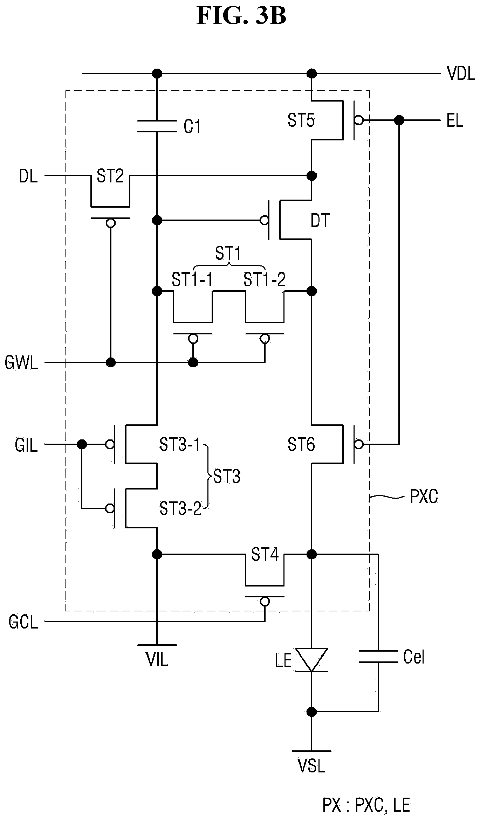

Each of the pixels PX may be connected to at least one of the data lines DL and at least one of the scan lines SL. Each of the pixels PX may include a light emitting element LE and a pixel circuit unit PXC including a plurality of transistors for supplying a driving current to the light emitting element LE as shown in FIGS. 3B to 3D. A detailed description of a pixel PX will be described later with reference to FIGS. 3B to 3D.

The scan driving circuit unit SDC and the driving IC 200 may be referred to as a display panel driving unit. The driving IC 200 may include a timing control circuit unit TIC and a data driving circuit unit DIC.

The scan driving circuit unit SDC is connected to the scan lines SL to apply scan signals. The scan driving circuit unit SDC may generate scan signals according to a scan timing control signal SCS input from the timing control circuit unit TIC and output the scan signals to the scan lines SL.

The scan driving circuit unit SDC may include the plurality of transistors. In this case, the scan driving circuit unit SDC may be disposed in the non-display area NDA disposed on the left and right sides of the display panel 100.

The data driving circuit unit DIC is connected to the data lines DL to supply data voltages. The data driving circuit unit DIC receives digital video data DATA and a data timing control signal DCS from the timing control circuit unit TIC. The data driving circuit unit DIC converts the digital video data DATA into data voltages according to the data timing control signal DCS and outputs the data voltages to the data lines DL.

The timing control circuit unit TIC receives digital video data DATA and timing signals TS. The timing signals TS may include a vertical sync signal, a horizontal sync signal, a data enable signal, and/or a clock signal such as a dot clock.

The timing control circuit unit TIC generates control signals for controlling operation timings of the data driving circuit unit DIC and the scan driving circuit unit SDC. The control signals may include the data timing control signal DCS for controlling the operation timing of the data driving circuit unit DIC and the scan timing control signal SCS for controlling the operation timing of the scan driving circuit unit SDC.

The timing control circuit unit TIC outputs the digital video data DATA and the data timing control signal DCS to the data driving circuit unit DIC, and outputs the scan timing control signal SCS to the scan driving circuit unit SDC.

The power supply unit PSU may generate a first power supply voltage VSS corresponding to a low potential voltage and a second power supply voltage VDD corresponding to a high potential voltage from the main power applied from the outside. Also, the power supply unit PSU may supply various driving voltages to the data driving circuit unit DIC, the scan driving circuit unit SDC, and the timing control circuit unit TIC.

FIG. 3B is a circuit diagram illustrating a pixel of a display device according to one or more embodiments.

Referring to FIG. 3B, the pixel PX according to one or more embodiments may include a pixel circuit unit PXC and the light emitting element LE.

The light emitting element LE emits light according to the driving current Ids. The amount of light emitted from the light emitting element LE may be proportional to the driving current Ids.

The light emitting element LE may be an organic light emitting element including an anode electrode, a cathode electrode, and an organic light emitting layer disposed between the anode electrode and the cathode electrode. Alternatively, the light emitting element LE may be an inorganic light emitting element including the anode electrode, the cathode electrode, and the inorganic semiconductor disposed between the anode electrode and the cathode electrode.

The anode electrode of the light emitting element LE may be connected to the first electrode of a fourth transistor ST4 and the second electrode of a sixth transistor ST6, and the cathode electrode may be connected to the first power supply line VSL. A parasitic capacitance Cel may be formed between the anode electrode and the cathode electrode of the light emitting element LE.

The pixel circuit unit PXC includes a driving transistor DT, switch elements, and a capacitor C1. The switch elements include first to the sixth transistors ST1, ST2, ST3, ST4, ST5, and ST6.

The driving transistor DT includes a gate electrode, a first electrode, and a second electrode. The driving transistor DT controls a drain-source current (Ids, hereinafter referred to as a "driving current") flowing between the first electrode and the second electrode according to the data voltage applied to the gate electrode.

The capacitor C1 is formed between the gate electrode of the driving transistor DT and the second power supply line VDL. One electrode of the capacitor C1 may be connected to the gate electrode of the driving transistor DT, and the other electrode may be connected to the second power supply line VDL.

When the first electrode of each of the first to sixth transistors ST1, ST2, ST3, ST4, ST5, and ST6, and the driving transistor DT is a source electrode, the second electrode may be a drain electrode. Alternatively, when the first electrode of each of the first to sixth transistors ST1, ST2, ST3, ST4, ST5, and ST6, and the driving transistor DT is the drain electrode, the second electrode may be the source electrode.

An active layer of each of the first to sixth transistors ST1, ST2, ST3, ST4, ST5, ST6, and the driving transistor DT may be formed of any one of polysilicon, amorphous silicon, or oxide semiconductor. When the semiconductor layers of the first to sixth transistors ST1, ST2, ST3, ST4, ST5, and ST6 and the driving transistor DT are each formed of polysilicon, a process for forming the same may be a Low Temperature Poly Silicon (LTPS) process.

In addition, in FIG. 3B, the first to sixth transistors ST1, ST2, ST3, ST4, ST5, ST6, and the driving transistor DT are mainly described with a P-type MOSFET (Metal Oxide Semiconductor Field Effect Transistor). However, the present invention is not limited thereto, and one or more of the first to sixth transistors ST1, ST2, ST3, ST4, ST5, ST6 and the driving transistor DT may be formed of an N-type MOSFET.

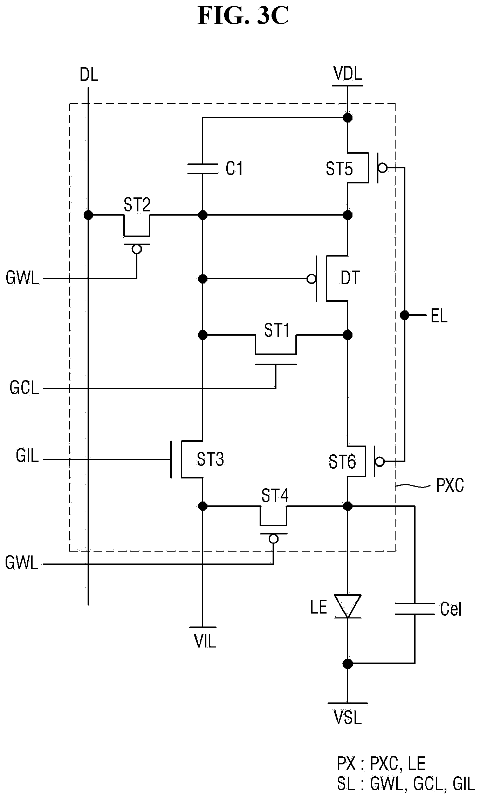

Further, the first power supply voltage VSS of the first power supply line VSL, the second power supply voltage VDD of the second power supply line VDL, and the third power supply voltage (or initialization voltage) of the third power supply line VIL may be set in consideration of the characteristics of the driving transistor DT and the characteristics of the light emitting element LE. In FIG. 3C, a first transistor ST1 (that includes transistors ST1-1 and ST1-2) is connected between the capacitor C1 and the driving transistor DT, and has a gate (gates of the transistors ST1-1 and ST1-2) connected to a write scan line GWL. A second transistors ST2 is connected between a data line DL and the driving transistor DT, and has a gate connected to the write scan line GWL. A third transistor ST3 (that includes transistors ST3-1 and ST3-2) is connected between the capacitor C1 or the gate electrode of the driving transistor DT and the third power supply line VIL, and has a gate (gates of the transistors ST3-1 and ST3-2) connected to an initialization scan line GIL. A fourth transistor AT4 is connected between the third power supply line VIL and the light emitting element LE, and has a gate connected to a control scan line GCL. A fifth transistor ST5 is connected between the second power supply line VDL and the driving transistor DT, and a sixth transistor is connected between the driving transistor DT and the light emitting element LE. The gates of the firth transistor ST5 and the sixth transistor ST6 is connected to a light emitting line EL.

FIG. 3C is a circuit diagram illustrating a pixel of a display device according to one or more embodiments.

The embodiment of FIG. 3C is different from the embodiment of FIG. 3B in that the driving transistor DT, the second transistor ST2, the fourth transistor ST4, the fifth transistor ST5, and the sixth transistor ST6 are formed of the P-type MOSFET, and the first transistor ST1 and the third transistor ST3 are formed of the N-type MOSFET.

Referring to FIG. 3C, each active layer of the driving transistor DT, the second transistor ST2, the fourth transistor ST4, the fifth transistor ST5, and the sixth transistor ST6 formed of the P-type MOSFET may be formed of polysilicon and each of the active layers of the first transistor ST1 and the third transistor ST3 formed of the N-type MOSFET may be formed of an oxide semiconductor.

The embodiment of FIG. 3C is different from the embodiment of FIG. 3B in that the gate electrode of the second transistor ST2 and the gate electrode of the fourth transistor ST4 are connected to the write scan line GWL and the gate electrode of the first transistor ST1 is connected to the control scan line GCL. Also, in FIG. 3C, because the first transistor ST1 and the third transistor ST3 are formed of the N-type MOSFET, a scan signal of a gate high voltage may be applied to the control scan line GCL and the initialization scan line GIL. In contrast, because the second transistor ST2, the fourth transistor ST4, the fifth transistor ST5, and the sixth transistor ST6 are formed of the P-type MOSFET, a scan signal of a gate low voltage may be applied to the write scan line GWL and the light emitting line EL.

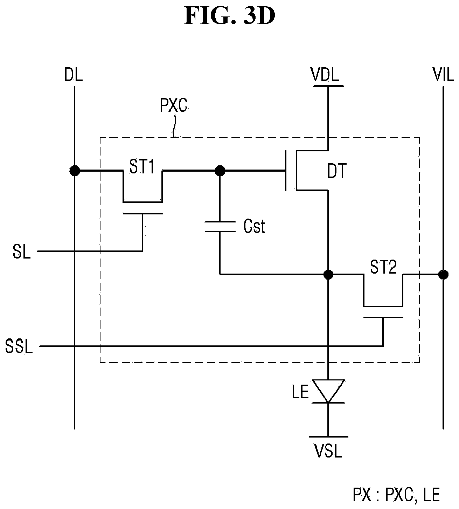

FIG. 3D is a circuit diagram illustrating a pixel of a display device according to one or more embodiments.

Referring to FIG. 3D, the light emitting element LE emits light according to the driving current Ids. The amount of light emitted from the light emitting element LE may be proportional to the driving current Ids. The anode electrode of the light emitting element LE is connected to the source electrode of the driving transistor DT, and the cathode electrode may be connected to the first power supply line VSL to which the first power supply voltage VSS lower than the second power supply voltage VDD is supplied.

The driving transistor DT adjusts a current flowing from the second power supply line VDL to which the second power supply voltage VDD is supplied to the light emitting element LE according to a voltage difference between the gate electrode and the source electrode. The gate electrode of the driving transistor DT may be connected to the first electrode of the first transistor ST1, the source electrode may be connected to the anode electrode of the light emitting element LE, and the drain electrode may be connected to the second power supply line VDL.

The first transistor ST1 is turned-on by the scan signal of the scan line SL to connect the data line DL to the gate electrode of the driving transistor DT. The gate electrode of the first transistor ST1 may be connected to the scan line SL, the first electrode may be connected to the gate electrode of the driving transistor DT, and the second electrode may be connected to the data line DL.

The second transistor ST2 is turned-on by a sensing signal of a sensing signal line SSL to connect an initialization voltage line VIL to the source electrode of the driving transistor DT. The gate electrode of the second transistor ST2 may be connected to the sensing signal line SSL, the first electrode may be connected to the initialization voltage line VIL, and the second electrode may be connected to the source electrode of the driving transistor DT.

The first electrode of each of the first and second transistors ST1 and ST2 may be the source electrode, and the second electrode may be the drain electrode, but it should be noted that the present disclousre is not limited thereto. That is, the first electrode of each of the first and second transistors ST1 and ST2 may be the drain electrode, and the second electrode may be the source electrode.

The capacitor Cst is formed between the gate electrode and the source electrode of the driving transistor DT. The capacitor Cst stores a difference voltage between the gate voltage and the source voltage of the driving transistor DT.

In FIG. 3D, the driving transistor DT and the first and second transistors ST1 and ST2 have been mainly described as being formed of the N-type MOSFET (Metal Oxide Semiconductor Field Effect Transistor), but it should be noted that the present invention is not limited thereto. The driving transistor DT and the first and second transistors ST1 and ST2 may be formed of the P-type MOSFET.

It should be noted that the pixel PX according to one or more embodiments of the present invention is not limited to those illustrated in FIGS. 3B to 3D. The pixel PX according to one or more embodiments of the present invention may be formed in other known circuit structures employable by those skilled in the art in addition to the embodiments illustrated in FIGS. 3B to 3D.

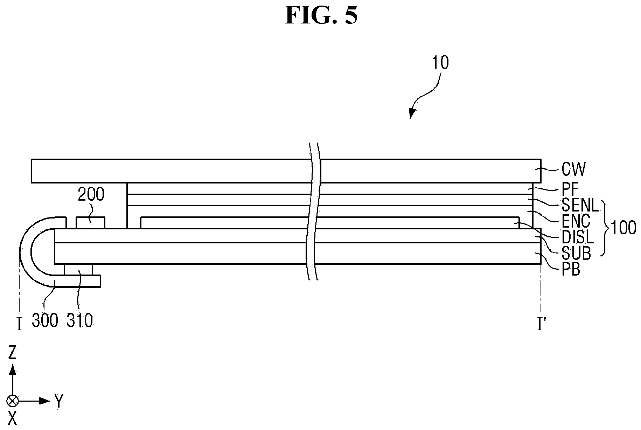

FIG. 4 is a cross-sectional view illustrating an example of the display device taken along the line I-I' of FIG. 1. FIG. 5 is a cross-sectional view illustrating an example of a display device in which the circuit board is bent in FIG. 4.

Referring to FIGS. 4 and 5, the display device 10 according to one or more embodiments may include the display panel 100, a polarizing film PF, a cover window CW, and a panel bottom cover PB. The display panel 100 may include the substrate SUB, a display layer DISL, the encapsulation layer ENC, and a sensor electrode layer SENL.

The substrate SUB may include (or be made of) a rigid material. For example, the substrate SUB may be made of glass. For example, the substrate SUB may be made of ultra thin glass (UTG) having a thickness of about 200 µm or less.

The display layer DISL may be disposed on the first surface of the substrate SUB. The display layer DISL may be a layer that displays an image. The display layer DISL may include a thin film transistor layer TFTL in which thin film transistors are formed and a light emitting element layer EML in which light emitting elements for emitting light are disposed in light emitting areas.

In the display area DA of the display layer DISL, scan lines, data lines, power lines, etc. for the light-emitting areas to emit light may be disposed. In the non-display area NDA of the display layer DISL, the scan driving circuit unit for outputting scan signals to the scan lines, and fan-out lines connecting the data lines and the driving IC 200 may be disposed.

The encapsulation layer ENC may be a layer for encapsulating the light emitting element layer EML of the display layer DISL to prevent oxygen or moisture from penetrating into the light emitting element layer EML of the display layer DISL. The encapsulation layer ENC may be disposed on the display layer DISL. The encapsulation layer ENC may be disposed on the top surface and side surfaces of the display layer DISL. The encapsulation layer ENC may be disposed to cover the display layer DISL.

The sensor electrode layer SENL may be disposed on the display layer DISL. The sensor electrode layer SENL may include sensor electrodes. The sensor electrode layer SENL may sense a user's touch using sensor electrodes.

The polarizing film PF may be disposed on the display panel 100 to reduce reflection of external light. The polarizing film PF may include a first base member, a linear polarizing plate, a phase delay film such as a λ/4 plate (quarter-wave plate), and a second base member. The first base member, the phase delay film, the linear linear polarizing plate, and the second base member of the polarizing film PF may be sequentially stacked on the display panel 100.

The cover window CW may be disposed on the polarizing film PF. The cover window CW may be attached to the polarizing film PF by a transparent adhesive member such as an optically clear adhesive (OCA) film.

The panel bottom cover PB may be disposed on the second surface of the substrate SUB of the display panel 100. The second surface of the substrate SUB may be opposite to the first surface. The panel bottom cover PB may be attached to the second surface of the substrate SUB of the display panel 100 through an adhesive member. The adhesive member may be a pressure sensitive adhesive (PSA).

The panel bottom cover PB may include at least one selected from among a light blocking member for absorbing light incident from the outside, a buffer member for absorbing an impact from the outside, and a heat dissipation member for efficiently dissipating heat of the display panel 100.

The light blocking member may be disposed under the display panel 100. The light blocking member blocks light transmission to prevent components disposed under the light blocking member, for example, the circuit board 300, from being viewed from above the display panel 100. The light blocking member may include a light absorbing material such as a black pigment or a black dye.

The buffer member may be disposed under the light blocking member. The buffer member may absorb an external shock to prevent or protect the display panel 100 from being damaged. The buffer member may be formed of a single layer or a plurality of layers. For example, the buffer member may be formed of a polymer resin such as polyurethane, polycarbonate, polypropylene, polyethylene, or the like, or may include a material having elasticity, such as rubber, a urethane-based material, or a sponge formed by foam molding an acrylic-based material.

The heat dissipation member may be disposed under the buffer member. The heat dissipation member may include a first heat dissipation layer including graphite or carbon nanotubes, and a second heat dissipation layer formed of a thin metal film such as copper, nickel, ferrite, or silver, which may shield electromagnetic waves and has excellent thermal conductivity.

The circuit board 300 may be bent downward of the display panel 100 as shown in FIG. 5. The circuit board 300 may be attached to the bottom surface of the panel bottom cover PB by an adhesive member 310. The adhesive member 310 may be a pressure-sensitive adhesive (PSA).

FIG. 6 is a cross-sectional view illustrating an example of a display area of a display panel according to one or more embodiments.

Referring to FIG. 6, the display panel 100 according to one or more embodiments may be an organic light emitting display panel including a light emitting element LEL including an organic light emitting layer 172.

The display layer DISL may include the thin film transistor layer TFTL including a plurality of thin film transistors and a light emitting element layer EML including a plurality of light emitting elements.

A first buffer layer BF1 may be disposed on the substrate SUB. The first buffer layer BF1 may be formed of an inorganic material such as a silicon nitride layer, a silicon oxynitride layer, a silicon oxide layer, a titanium oxide layer, or an aluminum oxide layer. Alternatively, the first buffer layer BF1 may be formed as a multilayer in which one or more layers of a silicon nitride layer, a silicon oxynitride layer, a silicon oxide layer, a titanium oxide layer, and/or an aluminum oxide layer are alternately stacked.

An active layer including a channel area TCH, a source area TS, and a drain area TD of the thin film transistor TFT may be disposed on the first buffer layer BF1. The active layer may be formed of polycrystalline silicon, single crystal silicon, low temperature polycrystalline silicon, amorphous silicon, or the oxide semiconductor material. When the active layer includes polycrystalline silicon or the oxide semiconductor material, the source area TS and the drain area TD in the active layer may be conductive areas doped with ions or impurities to have conductivity.

A gate insulating layer 130 may be disposed on the active layer of the thin film transistor TFT. The gate insulating layer 130 may be formed of an inorganic layer, for example, a silicon nitride layer, a silicon oxynitride layer, a silicon oxide layer, a titanium oxide layer, or an aluminum oxide layer.

A first gate metal layer including a gate electrode TG of the thin film transistor TFT, a first capacitor electrode CAE1 of the capacitor Cst, and scan lines may be disposed on the gate insulating layer 130. The gate electrode TG of the thin film transistor TFT may overlap the channel area TCH in the third direction (Z-axis direction). The first gate metal layer may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

A first interlayer insulating layer 141 may be disposed on the first gate metal layer. The first interlayer insulating layer 141 may be formed of the inorganic layer, for example, the silicon nitride layer, the silicon oxynitride layer, the silicon oxide layer, the titanium oxide layer, or the aluminum oxide layer. The first interlayer insulating layer 141 may include a plurality of inorganic layers.

A second gate metal layer including a second capacitor electrode CAE2 of the capacitor Cst may be disposed on the first interlayer insulating layer 141. The second capacitor electrode CAE2 may overlap the first capacitor electrode CAE1 in the third direction (Z-axis direction). Therefore, the capacitor Cst may be formed by the first capacitor electrode CAE1, the second capacitor electrode CAE2, and an inorganic insulating dielectric layer disposed therebetween and serving as a dielectric layer. The second gate metal layer may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

A second interlayer insulating layer 142 may be disposed on the second gate metal layer. The second interlayer insulating layer 142 may be formed of the inorganic layer, for example, the silicon nitride layer, the silicon oxynitride layer, the silicon oxide layer, the titanium oxide layer, or the aluminum oxide layer. The second interlayer insulating layer 142 may include a plurality of inorganic layers.

A first data metal layer including a first connection electrode CE1 and data lines may be disposed on the second interlayer insulating layer 142. The first connection electrode CE1 may be connected to the drain area TD through a first contact hole CT1 penetrating the gate insulating layer 130, the first interlayer insulating layer 141, and the second interlayer insulating layer 142. The first data metal layer may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

A first organic layer 160 for flattening a step difference due to a thin film transistors TFT may be disposed on the first connection electrode CE1. The first organic layer 160 may be formed of an organic layer such as an acryl resin, an epoxy resin, a phenolic resin, a polyamide resin, or a polyimide resin, etc.

A second data metal layer including a second connection electrode CE2 may be disposed on the first organic layer 160. The second data metal layer may be connected to the first connection electrode CE1 through a second contact hole CT2 penetrating the first organic layer 160. The second data metal layer may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

A second organic layer 180 may be disposed on the second connection electrode CE2. The second organic layer 180 may be formed of the organic layer such as the acryl resin, the epoxy resin, the phenolic resin, the polyamide resin, or the polyimide resin, etc.

In one or more embodiments, the second data metal layer including the second connection electrode CE2 and the second organic layer 180 may be omitted.

The light emitting element layer EML is disposed on the thin film transistor layer TFTL. The light emitting element layer EML may include light emitting elements LEL and a bank 190.

Each of the light emitting elements LEL may include a pixel electrode 171, a light emitting layer 172, and a common electrode 173. Each of the emission areas EA represents an emission area where holes from the pixel electrode 171 and electrons from the common electrode 173 are combined with each other in the light emitting layer 172 to emit light by sequentially stacking the pixel electrode 171, the light emitting layer 172, and the common electrode 173. In one or more embodiments, the pixel electrode 171 may be an anode electrode, and the common electrode 173 may be a cathode electrode.

A pixel electrode layer including the pixel electrode 171 may be formed on the second organic layer 180. The pixel electrode 171 may be connected to the second connection electrode CE2 through a third contact hole CT3 penetrating the second organic layer 180. The pixel electrode layer may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

In a top emission structure that emits light in the direction of the common electrode 173 based on the light emitting layer 172, the pixel electrode 171 may be formed of a single layer of molybdenum (Mo), titanium (Ti), copper (Cu), or aluminum (Al) or a stacked structure of aluminum and titanium (Ti/Al/Ti), a stacked structure of aluminum and ITO (ITO/AI/ITO), APC alloy, or a stacked structure of APC alloy and ITO (ITO/APC/ITO) to increase reflectivity. The APC alloy is an alloy of silver (Ag), palladium (Pd), and copper (Cu).

The bank 190 serves to define the emission areas EA of the pixels. To this end, the bank 190 may be formed to expose a partial area of the pixel electrode 171 on the second organic layer 180. The bank 190 may cover the edge of the pixel electrode 171. The bank 190 may be disposed in the third contact hole CT3. That is, the third contact hole CT3 may be filled by the bank 190. The bank 190 may be formed of the organic layer such the acrylic resin, the epoxy resin, the phenolic resin, the polyamide resin, or the polyimide resin.

A spacer 191 may be disposed on the bank 190. The spacer 191 may serve to support a mask during the process of manufacturing an emission layer 172. The spacer 191 may be formed of the organic layer such as the acrylic resin, the epoxy resin, the phenolic resin, the polyamide resin, or the polyimide resin, etc.

The emission layer 172 is formed on the pixel electrode 171. The emission layer 172 may include an organic material to emit a desired color (e.g., a predetermined color). For example, the emission layer 172 may include a hole transporting layer, an organic material layer, and an electron transporting layer. The organic material layer may include a host and a dopant. The organic material layer may include a material for emitting desired light (e.g., predetermined light) and may be formed using a phosphorescent material or a fluorescent material.

The common electrode 173 is formed on the emission layer 172. The common electrode 173 may be formed to cover the emission layer 172. The common electrode 173 may be a common layer commonly formed in the light emitting areas EA1, EA2, EA3, and EA4. A capping layer may be formed on the common electrode 173.

In the upper emission structure, the common electrode 173 may be formed of a transparent conductive material (TCO) such as ITO or IZO that may transmit light, or a semi-transmissive conductive material such as magnesium (Mg), silver (Ag), or an alloy of magnesium (Mg) and silver (Ag). When the common electrode 173 is formed of a transflective metal material, light output efficiency may be increased by a micro cavity.

The encapsulation layer ENC may be formed on the light emitting element layer EML. The encapsulation layer ENC may include at least one inorganic layer TFE1 to prevent oxygen or moisture from penetrating into the light emitting element layer EML. Also, the encapsulation layer ENC may include at least one organic layer TFE2 to protect the light emitting element layer EML from foreign substances such as dust. For example, the encapsulation layer ENC may include a first encapsulation inorganic layer TFE1, an encapsulation organic layer TFE2, and a second encapsulation inorganic layer TFE3.

The first encapsulation inorganic layer TFE1 may be disposed on the common electrode 173, the encapsulation organic layer TFE2 may be disposed on the first encapsulation inorganic layer TFE1, and the second encapsulation inorganic layer TFE3 may be disposed on the encapsulation organic layer TFE2. The first encapsulation inorganic layer TFE1 and the second encapsulation inorganic layer TFE3 may be formed as a multilayer in which one or more inorganic layers selected from among a silicon nitride layer, a silicon oxynitride layer, a silicon oxide layer, a titanium oxide layer, and an aluminum oxide layer are alternately stacked. The encapsulation organic layer TFE2 may be an organic film such as an acrylic resin, an epoxy resin, a phenolic resin, a polyamide resin, or a polyimide resin.

The sensor electrode layer SENL is disposed on the encapsulation layer ENC. The sensor electrode layer SENL may include sensor electrodes TE and RE.

A second buffer layer BF2 may be disposed on the encapsulation layer ENC. The second buffer layer BF2 may include at least one inorganic layer. For example, the second buffer layer BF2 may be formed as a multilayer in which one or more inorganic layers selected from among a silicon nitride layer, a silicon oxynitride layer, a silicon oxide layer, a titanium oxide layer, and an aluminum oxide layer are alternately stacked. The second buffer layer BF2 may be omitted.

A first connection parts BE1 may be disposed on the second buffer layer BF2. The first connection parts BE1 may be formed of a single layer of molybdenum (Mo), titanium (Ti), copper (Cu), or aluminum (Al) or a stacked structure of aluminum and titanium (Ti/Al/Ti), a stacked structure of aluminum and ITO (ITO/AI/ITO), APC alloy, or a stacked structure of APC alloy and ITO (ITO/APC/ITO).

A first sensor insulating layer TINS1 may be disposed on the first connection parts BE1. The first sensor insulating layer TINS1 may be formed of the inorganic layer, for example, the silicon nitride layer, the silicon oxynitride layer, the silicon oxide layer, the titanium oxide layer, or the aluminum oxide layer.

The sensor electrodes, that is, a driving electrodes TE and sensing electrodes RE, may be disposed on the first sensor insulating layer TINS1. In addition, dummy patterns may be disposed on the first sensor insulating layer TINS1. The driving electrodes TE, the sensing electrodes RE, and the dummy patterns do not overlap the emission areas EA. The driving electrodes TE, the sensing electrodes RE, and the dummy patterns may be formed of a single layer of molybdenum (Mo), titanium (Ti), copper (Cu), or aluminum (Al), or a stacked structure of aluminum and titanium (Ti/Al/Ti), a stacked structure of aluminum and ITO (ITO/AI/ITO), APC alloy, or a stacked structure of APC alloy and ITO (ITO/APC/ITO).

A second sensor insulating layer TINS2 may be disposed on the driving electrodes TE, the sensing electrodes RE, and the dummy patterns. The second sensor insulating layer TINS2 may include at least one selected from among an inorganic layer and an organic layer. The inorganic layer may be a silicon nitride layer, a silicon oxynitride layer, a silicon oxide layer, a titanium oxide layer, or an aluminum oxide layer. The organic layer may be the acrylic resin, the epoxy resin, the phenolic resin, the polyamide resin, or the polyimide resin.

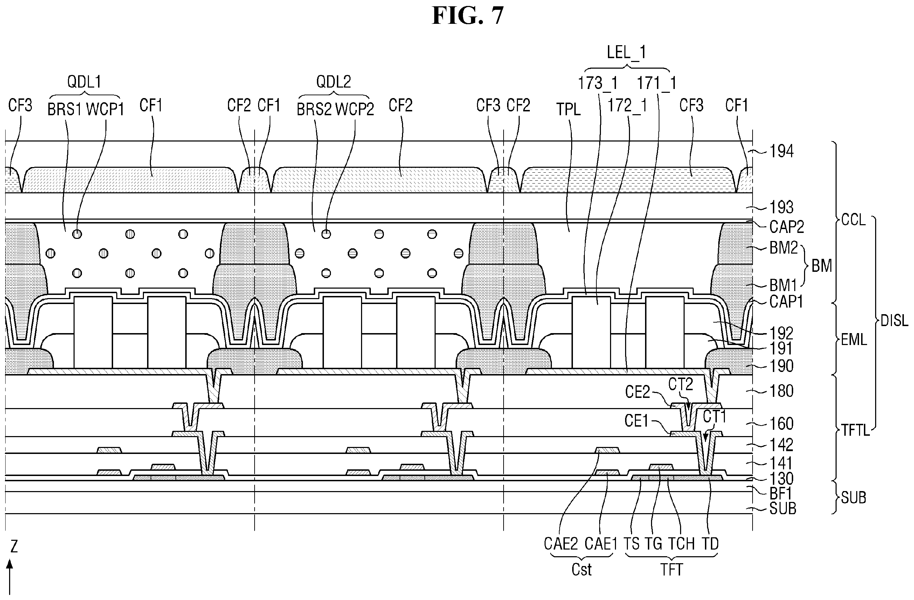

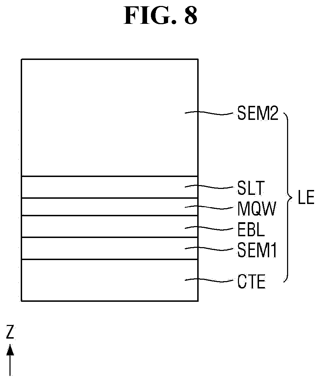

FIG. 7 is a cross-sectional view illustrating an example of a display area of a display panel according to one or more embodiments. FIG. 8 is a detailed cross-sectional view illustrating the light emitting diode element of FIG. 7.

Referring to FIG. 7, the display panel 100 according to one or more embodiments may be a light emitting diode display panel including a light emitting element LEL_1 including a light emitting diode element 172_1 extending in the third direction (Z-axis direction). The light emitting diode element 172_1 has a length or size in micrometers and may be a micro light emitting diode made of an inorganic material. In this case, the display panel 100 according to one or more embodiments may be a micro light emitting diode display panel.

Because the display panel 100 according to one or more embodiments includes the light emitting diode element 172_1 made of an inorganic material, an encapsulation structure may not be required. Therefore, the display panel 100 according to one or more embodiments may not include the encapsulation layer ENC.

In addition, when the light emitting diode element 172_1 of the display panel 100 according to one or more embodiments emits the same light, a color control layer CCL may be included. When the light emitting diode element 172_1 of the display panel 100 according to one or more embodiments is classified as an element for emitting lights having a plurality of colors, the color control layer CCL may be omitted.

Furthermore, in FIG. 7, the polarizing film PF and the cover window CW are omitted for convenience of description. The polarizing film PF may be disposed on the color control layer CCL, and the cover window CW may be disposed on the polarizing film PF.

The display layer DISL of the display panel 100 according to one or more embodiments includes the thin film transistor layer TFTL, the light emitting element layer EML, and the color control layer CCL. Because the thin film transistor layer TFTL shown in FIG. 7 is substantially the same as the thin film transistor layer TFTL described with reference to FIG. 6, a description of the thin film transistor TFTL is omitted in FIG. 7.

The light emitting element layer EML may include light emitting elements LEL_1, the bank 190, a third organic layer 191, and a fourth organic layer 192.

Each of the light emitting elements LEL_1 may include a pixel electrode 171_1, a light emitting diode element 172_1, and a common electrode 173_1. Because the pixel electrode 171_1 is substantially the same as the pixel electrode 171 described with reference to FIG. 6, a description of the pixel electrode 171_1 is omitted in reference to FIG. 7.

The bank 190 may be disposed to cover an edge of the pixel electrode 171_1. The bank 190 may be formed of the organic layer such as the acrylic resin, the epoxy resin, the phenolic resin, the polyamide resin, or the polyimide resin, etc. The bank 190 may include a light blocking material to prevent light from the light emitting diode element 172_1 of one sub-pixel from propagating to a sub-pixel adjacent thereto. For example, the bank 190 may include an inorganic black pigment such as carbon black or an organic black pigment.

The plurality of light emitting diode elements 172_1 may be disposed on the exposed pixel electrode 171_1 without being covered by the bank 190. According to one or more example embodiments, each of the plurality of light emitting diode elements 172_1 is a vertical micro LED extending in the third direction DR3. In this case, each of the plurality of light emitting diode elements 172_1 may have a rectangular or reverse tapered cross-sectional shape. However, each of the plurality of light emitting diode elements 172_1 is not limited to being a vertical-type micro LED and may be a flip-type micro LED.

Each of the plurality of light emitting diode elements 172_1 may be formed of an inorganic material such as GaN. Each of the plurality of light emitting diode elements 172_1 may have a length in the first direction (X-axis direction), a length in the second direction (Y-axis direction), and a length in the third direction (Z-axis direction) of several to several hundred µm, respectively. For example, each of the plurality of light emitting diode elements 172_1 may have a length in the first direction (X-axis direction), a length in the second direction (Y-axis direction), and a length in the third direction (Z-axis direction) of about 100 µm or less, respectively.

Each of the plurality of light emitting diode elements 172_1 may be formed by growing on a semiconductor substrate such as a silicon wafer. Each of the plurality of light emitting diode elements 172_1 may be directly transferred from the silicon wafer onto the pixel electrode 171_1 of the substrate SUB. Alternatively, each of the plurality of light emitting diode elements 172_1 may be transferred on the pixel electrodes 171_1 of the substrate SUB through an electrostatic method using an electrostatic head or a stamp method using an elastic polymer material such as PDMS or silicon as a transfer substrate.

The light emitting diode element 172_1 may have a length or size of micrometers and may be an inorganic light emitting diode made of an inorganic material. The light emitting diode element 172_1 may have a shape extending in one direction. Each of the plurality of light emitting diode elements 172_1 may have a shape such as a cylinder, a rod, a wire, or a tube. However, the shape of the light emitting diode element 172_1 is not limited thereto and may have a polygonal prism shape such as a cube, a cuboid, or a hexagonal prism, or may have a shape extending in one direction and having a partially inclined outer surface.

Each of the plurality of light emitting diode elements 172_1 may include a contact electrode CTE, a first semiconductor layer SEM1, an electron blocking layer EBL, an active layer MQW, a superlattice layer SLT, and a second semiconductor layer SEM2 as shown in FIG. 8. The description of the contact electrode CTE, the first semiconductor layer SEM1, the electron blocking layer EBL, the active layer MQW, the superlattice layer SLT, and the second semiconductor layer SEM2 of each of the plurality of light emitting diode elements 172_will be provided below in reference to FIG. 8.

The contact electrode CTE may be disposed on the pixel electrode 171_1. The contact electrode CTE and the pixel electrode 171_1 may be melt-bonded by heat and pressure. Alternatively, the contact electrode CTE and the pixel electrode 171_1 may be bonded to each other through the conductive adhesive member such as the anisotropic conductive film or the anisotropic conductive adhesive. Alternatively, the contact electrode CTE and the pixel electrode 171_1 may be bonded to each other through a soldering process. For example, the contact electrode CTE may include at least one selected from among gold (Au), copper (Cu), aluminum (Al), and tin (Sn).

The first semiconductor layer SEM1 may be disposed on the contact electrode CTE. The first semiconductor layer SEM1 may be formed of GaN doped with a p-type dopant such as Mg, Zn, Ca, Se, or Ba.

The electron blocking layer EBL may be disposed on the first semiconductor layer SEM. The electron blocking layer EBL may be a layer for suppressing or preventing too many electrons from flowing into the active layer MQW. For example, the electron blocking layer EBL may be p-AlGaN doped with p-type Mg. In one or more embodiments, the electron blocking layer EBL may be omitted.

The active layer MQW may be disposed on the electron blocking layer EBL. The active layer MQW may emit light by combining electron-hole pairs according to an electric signal applied through the first semiconductor layer SEM1 and the second semiconductor layer SEM2.

The active layer MQW may include a material having a single or multiple quantum well structure. When the active layer MQW includes a material having a multi-quantum well structure, a plurality of well layers and barrier layers may be alternately stacked. In this case, the well layer may be formed of InGaN and the barrier layer may be formed of GaN or AlGaN, but is not limited thereto. Alternatively, the active layer MQW may have a structure in which a type of semiconductor material having a large band gap energy and a semiconductor material having a small band gap energy are alternately stacked with each other. In addition, the active layer MQW may include other Group III to Group V semiconductor materials depending on the wavelength band of the emitted light.

When the active layer MQW includes InGaN, the color of emitted light may vary according to the content of indium (In). For example, as the content of indium (In) increases, the wavelength band of light emitted by the active layer may move to a red wavelength band, and as the content of indium (In) decreases, the wavelength band of light emitted by the active layer may move to a blue wavelength band. For example, the content of indium (In) in the active layer MQW of the light emitting diode element 172_1 emitting light of the blue wavelength band may be approximately 10 wt% to 20 wt%.

The superlattice layer SLT may be disposed on the active layer MQW. The superlattice layer SLT may be a layer to relieve stress between the second semiconductor layer SEM2 and the active layer MQW. For example, the superlattice layer SLT may be formed of InGaN or GaN. In or more more embodiments, the superlattice layer SLT may be omitted.

The second semiconductor layer SEM2 may be disposed on the superlattice layer SLT. The second semiconductor layer SEM2 may be doped with a second conductivity type dopant such as Si, Ge, or Sn. For example, the second semiconductor layer SEM2 may be n-GaN doped with n-type Si.

Referring back to FIG. 7, the third organic layer 191 may be disposed on the pixel electrode 171_1 not covered by the bank 190 and the plurality of light emitting diode elelemts 172_1. The third organic layer 191 may be disposed to cover the side surface and a portion of the top surface of the bank 190. The height of the third organic layer 191 may be greater than the height of the bank 190. The third organic layer 191 may be disposed on a portion of the side surface of each of the plurality of light emitting diode elements 172_1. The height of the third organic layer 191 may be smaller than the height of each of the plurality of light emitting diode elements 172_1. The third organic layer 191 may be formed of the organic film such as the acrylic resin, the epoxy resin, the phenolic resin, the polyamide resin, or the polyimide resin.

The fourth organic layer 192 may be disposed on the third organic layer 191. The fourth organic layer 192 may be disposed on a portion of the side surface of each of the plurality of light emitting diode elements 172_1. The sum of the height of the third organic layer 191 and the height of the fourth organic layer 192 may be smaller than the height of each of the plurality of light emitting diodes 172_1. The fourth organic layer 192 may be formed of the organic layer such as the acrylic resin, the epoxy resin, the phenolic resin, the polyamide resin, or the polyimide resin, etc.

The third organic layer 191 and the fourth organic layer 192 are layers for planarizing a step caused by the plurality of light emitting diode elements 172_1. When the height of each of the plurality of light emitting diode elements 172_1 is similar to that of the third organic layer 191, the fourth organic layer 192 may be omitted.

The common electrode 173_1 may be disposed on the top surface of each of the plurality of light emitting diode elements 172_1 and the top surface of the fourth organic layer 192. The common electrode 173_1 may be disposed on the exposed bank 190 without being covered by the third organic layer 191 and the fourth organic layer 192. The common electrode 173_1 may be a common layer commonly formed in a first sub-pixel SPX1, a second sub-pixel SPX2, and a third sub-pixel SPX3. The common electrode 173_1 may be formed of ITO (Indium Tin Oxide) that may transmit light and a transparent metal material (TCO, Transparent Conductive Material) such as Indium Zinc Oxide (IZO).

The color control layer CCL may include a first capping layer CAP1, a light blocking layer BM, a first light conversion layer QDL1, a second light conversion layer QDL2, a light transmission layer TPL, a second capping layer CAP2, a fifth organic layer 193, a plurality of color filters (CF1, CF2, and CF3), and a sixth organic layer 194.

The first capping layer CAP1 may be disposed on the common electrode 173_1. The first capping layer CAP1 may be formed of the inorganic layer, for example, the silicon nitride layer, the silicon oxynitride layer, the silicon oxide layer, the titanium oxide layer, or the aluminum oxide layer.

The light blocking layer BM, the first light conversion layer QDL1, the second light conversion layer QDL2, and the light transmission layer TPL may be disposed on the first capping layer CAP1. The first light conversion layer QDL1, the second light conversion layer QDL2, and the light transmission layer TPL may be formed by partitioning the light blocking layer BM. Therefore, the first light conversion layer QDL1 is disposed on the first capping layer CAP1 in the first sub-pixel that outputs the first light, the second light conversion layer QDL2 is disposed on the first capping layer CAP1 in the second sub-pixel that outputs the second light, and a light transmission layer TPL may be disposed on the first capping layer CAP1 in the third sub-pixel that outputs the third light. The light blocking layer BM may overlap the bank 190 in the third direction DR3 and may not overlap the plurality of light emitting diode elements 172_1.

The first light conversion layer QDL1 may convert a portion of light of the blue wavelength band incident from a light emitting diode element 172_1 to light of the red wavelength band. The first light conversion layer QDL1 may include a first base resin BRS1 and first wavelength conversion particles WCP1. The first base resin BRS1 may include a light-transmitting organic material. For example, the first base resin BRS1 may include an epoxy-based resin, an acrylic resin, a cardo-based resin, or an imide-based resin. The first wavelength conversion particle WCP1 may convert a portion of the light of the blue wavelength band incident from the light emitting diode element 172_1 to light of the red wavelength band. The first wavelength conversion particle WCP1 may be a quantum dot (QD), a quantum bar, a fluorescent material, or a phosphorescent material.

The second light conversion layer QDL2 may convert a portion of light of the blue wavelength band incident from the light emitting diode element 172_1 to light of a green wavelength band. The second light conversion layer QDL2 may include the second base resin BRS2 and the second wavelength conversion particles WCP2. The second base resin BRS2 may include a light-transmitting organic material. For example, the second base resin BRS2 may include the epoxy-based resin, the acrylic resin, the cardo-based resin, or the imide-based resin. The second wavelength conversion particle WCP2 may convert a portion of light of the blue wavelength band incident from the light emitting diode element 172_1 to light of the green wavelength band. The second wavelength conversion particle WCP2 may be the quantum dot (QD), the quantum bar, the fluorescent material, or the phosphorescent material.

The light transmission layer TPL may include a light transmitting organic material. For example, the light transmission layer TPL may include the epoxy-based resin, the acrylic resin, the cardo-based resin, or the imide-based resin.

The light blocking layer BM may include a first light blocking layer BM1 and a second light blocking layer BM2 that are sequentially stacked. The length of the first light blocking layer BM1 in the first direction (X-axis direction) or the length in the second direction (Y-axis direction) may be greater than the length of the second light blocking layer BM2 in the first direction (X-axis direction) or the length in the second direction (Y-axis direction). The first light blocking layer BM1 and the second light blocking layer BM2 may be formed as the organic layer such as the acryl resin, the epoxy resin, the phenolic resin, the polyamide resin, or the polyimide resin, etc. The first light blocking layer BM1 and the second light blocking layer BM2 may include a light blocking material to prevent the light from the light emitting diode element 172_1 of one sub-pixel from propagating to the sub-pixel adjacent thereto. For example, the first light blocking layer BM1 and the second light blocking layer BM2 may include an inorganic black pigment such as carbon black or an organic black pigment.

A second capping layer CAP2 may be disposed on the light blocking layer BM, the first light conversion layer QDL1, the second light conversion layer QDL2, and the light transmission layer TPL. The second capping layer CAP2 may be formed of the inorganic layer, for example, the silicon nitride layer, the silicon oxynitride layer, the silicon oxide layer, the titanium oxide layer, or the aluminum oxide layer. The light blocking layer BM, the first light conversion layer QDL1, the second light conversion layer QDL2, and the light transmission layer TPL may be encapsulated by the first capping layer CA
P1 and the second capping layer CAP2.

The fifth organic layer 193 may be disposed on the second capping layer CAP2. The fifth organic layer 193 may be formed of the acrylic resin, the epoxy resin, the phenolic resin, the polyamide resin, the polyimide resin, or the like.

A plurality of color filters CF1, CF2, and CF3 may be disposed on the fifth organic layer 193. The plurality of color filters CF1, CF2, and CF3 may include first color filters CF1, second color filters CF2, and third color filters CF3.

Each of the first color filters CF1 disposed in the first sub-pixel SPX1 may transmit light of the red wavelength band and may absorb or block light of the blue wavelength band. Therefore, each of the first color filters CF1 transmits the light of the red wavelength band converted by the first light conversion layer QDL1 among the light of the blue wavelength band emitted from the light emitting diode element 172_1, and may absorb or block light of the blue wavelength band that is not converted by the first light conversion layer QDL1. Accordingly, the first sub-pixel SPX1 may emit light of the red wavelength band.

Each of the second color filters CF2 disposed in the second sub-pixel SPX2 may transmit light of the green wavelength band and may absorb or block light of the blue wavelength band. Therefore, each of the second color filters CF2 transmits the light of the green wavelength band converted by the first light conversion layer QDL1 among the light of the blue wavelength band emitted from the light emitting diode element 172_1 and may absorb or block light of the blue wavelength band that is not converted by the first light conversion layer QDL1. Accordingly, the second sub-pixel SPX2 may emit light of the green wavelength band.

Each of the third color filters CF3 disposed in the third sub-pixel SPX3 may transmit light of the blue wavelength band. Therefore, each of the third color filters CF3 may transmit light of the blue wavelength band emitted from the light emitting diode element 172_1 passing through the light transmitting layer TPL. Accordingly, the third sub-pixel SPX3 may emit light of the blue wavelength band.

The sixth organic layer 194 for planarization may be disposed on the plurality of color filters CF1, CF2, and CF3. The sixth organic layer 194 may be formed of the acrylic resin, the epoxy resin, the phenolic resin, the polyamide resin, the polyimide resin, or the like.

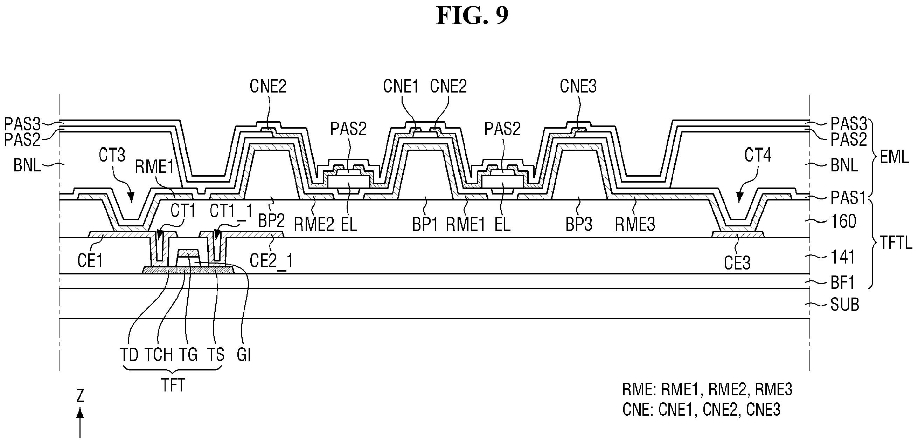

FIG. 9 is a cross-sectional view illustrating an example of a display area of a display panel according to one or more embodiments.

Referring to FIG. 9, the display panel 100 according to one or more embodiments may be a light emitting diode display panel including a light emitting element LEL_1 including the light emitting diode element 172_1 extending in a horizontal direction such as the first direction (X-axis direction) and/or the second direction (Y-axis direction). The light emitting diode element 172_1 has a length or size in nanometers and may be a nano light emitting diode made of an inorganic material. In this case, the display panel 100 according to one or more embodiments may be a nano light emitting diode display panel.

Because the display panel 100 according to one or more embodiments includes the light emitting diode element 172_1 made of an inorganic material, an encapsulation structure may not be required. Therefore, the display panel 100 according to one or more embodiments may not include the encapsulation layer ENC.

In addition, when the light emitting diode element 172_1 of the display panel 100 according to one or more embodiments emits the same light, the color control layer CCL may be included. In FIG. 9, the color control layer CCL is omitted for convenience of description. Also, when the light emitting diode element 172_1 of the display panel 100 according to one or more embodiments is classified as an element for emitting a plurality of colors, the color control layer CCL may be omitted.

Furthermore, in FIG. 9, the polarizing film PF and the cover window CW are omitted for convenience of description. The polarizing film PF may be disposed on the color control layer CCL disposed on an emission layer EML, and the cover window CW may be disposed on the polarizing film PF.

The display layer DISL of the display panel 100 according to one or more embodiments includes the thin film transistor layer TFTL and the light emitting element layer EML.

The thin film transistor layer TFTL shown in FIG. 9 will be described mainly for differences from the thin film transistor layer TFTL shown in FIG. 6, and repeated descriptions may be omitted.

In FIG. 9, the second gate metal layer, the second interlayer insulating layer 142, the second data metal layer, and the second organic layer 180 are omitted. Also, in FIG. 9, the capacitor Cst is omitted for convenience of description.

As shown in FIG. 9, the first data metal layer including a first connection electrode CE1, a second connection electrode CE2_1, and a third connection electrode CE3 may be disposed on the first interlayer insulating layer 141. The first connection electrode CE1 may be connected to the drain area TD through the first contact hole CT1 penetrating the first interlayer insulating layer 141. The second connection electrode CE2 may be connected to the source area TS through a second contact hole CT2_1 penetrating the first interlayer insulating layer 141.

The light emitting element layer EML may include the first to third bank patterns BP1, BP2, and BP3, an alignment electrode RME, a connection electrode CNE, and the light emitting diode element 172_1.

The first bank pattern BP1 may be disposed between the second bank pattern BP2 and the third bank pattern BP3. That is, the second bank pattern BP2 may be disposed on one side of the first bank pattern BP1, and the third bank pattern BP3 may be disposed on the other side of the first bank pattern BP1.

The plurality of light emitting diode elements 172_1 may be disposed between the first and second bank patterns BP1 and BP2 and between the first and third bank patterns BP1 and BP3. The first to third bank patterns BP1, BP2, and BP3 may be arranged in an island-shaped pattern.

The first to third bank patterns BP1, BP2, and BP3 may be disposed on the first organic layer 160. Each of the first to third bank patterns BP1, BP2, and BP3 may protrude in the third direction (Z-axis direction) on the first organic layer 160. Each of the first to third bank patterns BP1, BP2, and BP3 may have an inclined side surface (or inclined side surfaces).

The first alignment electrode RME1 may be disposed between the second alignment electrode RME2 and a third alignment electrode RME3. The first alignment electrode RME1 may cover an upper surface and the inclined side surface of the first bank pattern BP1. Accordingly, the first alignment electrode RME1 may reflect the light emitted from the plurality of light emitting diode elements 172_1 in the third direction (Z-axis direction).

The second alignment electrode RME2 may be disposed on one side of the first alignment electrode RME1. The second alignment electrode RME2 may cover an upper surface and the inclined side surface of the second bank pattern BP2. Accordingly, the second alignment electrode RME2 may reflect the light emitted from the plurality of light emitting diode elements 172_1 disposed between the first and second bank patterns BP1 and BP2 in an upward direction (Z-axis direction).

The third alignment electrode RME3 may be disposed on the other side of the first alignment electrode RME1. The third alignment electrode RME3 may cover an upper surface and the inclined side surface of the third bank pattern BP3. Accordingly, the third alignment electrode RME3 may reflect the light emitted from the plurality of light emitting diode elements 172_1 disposed between the first and third bank patterns BP1 and BP3 in the upper direction (Z-axis direction).

The first to third alignment electrodes RME1, RME2, and RME3 may be disposed on the first organic layer 160 and the first to third bank patterns BP1, BP2, and BP3.

The first alignment electrode RME1 may be connected to the first connection electrode CE1 through the third contact hole CT3, and thus may be electrically connected to the thin film transistor TFT.

The third alignment electrode RME3 may be connected to the third connection electrode CE3 through a fourth contact hole CT4. Because the third connection electrode CE3 is electrically connected to the first power supply line, the first power supply voltage of the first power supply line may be applied to the third connection electrode CE3.

The first to third alignment electrodes RME1, RME2, and RME3 are electrically connected to the light emitting diode element 172_1 and the light emitted from the plurality of light emitting diode elements 172_1 may be reflected in the upper direction of the substrate SUB. To this end, the first to third alignment electrodes RME1, RME2, and RME3 may include a conductive material having high reflectance. For example, the first to third alignment electrodes RME1, RME2, and RME3 may include a metal such as silver (Ag), copper (Cu), or aluminum (Al), or may have alloys including aluminum (Al), nickel (Ni), lanthanum (La), and/or the like or a structure in which a metal layer such as titanium (Ti), molybdenum (Mo), and/or niobium (Nb) and the alloy are laminated. In some embodiments, the first to third alignment electrodes RME1, RME2, and RME3 may be formed of an alloy including aluminum (Al) and a double layer or multilayer in which at least one metal layer made of titanium (Ti), molybdenum (Mo), and/or niobium (Nb) is stacked.

Alternatively, the first to third alignment electrodes RME1, RME2, and RME3 may further include the transparent conductive material. For example, the first to third alignment electrodes RME1, RME2, and RME3 may include a material such as ITO, IZO, or ITZO. In some embodiments, each electrode RME may have a structure in which a transparent conductive material and a metal layer having high reflectivity are stacked in one or more layers or may be formed as one layer including these. For example, the first to third alignment electrodes RME1, RME2, and RME3 may have a stacked structure such as ITO/Ag/ITO/, ITO/Ag/IZO, or ITO/Ag/ITZO/IZO.

Each of the plurality of light emitting diode elements 172_1 may include the contact electrode CTE, the first semiconductor layer SEM1, the electron blocking layer EBL, the active layer MQW, the superlattice layer SLT, and the second semiconductor layer SEM2 as shown in FIG. 8.

The plurality of light emitting diode elements 172_1 may be aligned between the first alignment electrode RME1 and the second alignment electrode RME2 or between the first alignment electrode RME1 and the third alignment electrode RME3. A first insulating layer PAS1 may cover the first to third alignment electrodes RME1, RME2, and RME3. The plurality of light emitting diode elements 172_1 may be insulated from the first to third alignment electrodes RME1, RME2, and RME3 by the first insulating layer PAS1. Before the first to third alignment electrodes RME1, RME2, and RME3 are separated by a separation unit ROP, each of the first to third alignment electrodes RME1, RME2, and RME3 may receive an alignment signal. Thereby, an electric field may be formed between the first to third alignment electrodes RME1, RME2, and RME3. For example, the plurality of light emitting diode elements 172_1 may be sprayed onto the first to third alignment electrodes RME1, RME2, and RME3 through an inkjet printing process, and the plurality of light emitting diode elements 172_1 dispersed in ink may be aligned by receiving a dielectrophoresis force by the electric field formed between the first to third alignment electrodes RME1, RME2, and RME3. Accordingly, the plurality of light emitting diode elements 172_1 may be arranged between the first alignment electrode RME1 and the second alignment electrode RME2 and between the second alignment electrode RME2 and the third alignment electrode RME3 in the second direction (Y-axial direction).

The first insulating layer PAS1 may be disposed on the first organic layer 160 and the first to third alignment electrodes RME1, RME2, and RME3. The first insulating layer PAS1 may include an insulating material to protect the first to third alignment electrodes RME1, RME2, and RME3. As the first insulating layer PAS1 is disposed to cover the first to third alignment electrodes RME1, RME2, and RME3 before the bank layer BNL is formed, damage to the first to third alignment electrodes RME1, RME2, and RME3 may be prevented in the process of forming the bank layer BNL. Also, the first insulating layer PAS1 may prevent or protect the plurality of light emitting diode elements 172_1 from being damaged by direct contact with other members.

The first to third contact electrodes CNE1, CNE2, and CNE3 may be disposed on the first to third alignment electrodes RME1, RME2, and RME3. A second insulating layer PAS2 may be disposed on the central part of each of the bank layer BNL, the first insulating layer PAS1, and the plurality of light emitting diode elements 172_1. A third insulating layer PAS3 may cover the second insulating layer PAS2 and the first to third connection electrodes CNE1, CNE2, and CNE3. The second and third insulating layers PAS2 and PAS3 may insulate each of the first to third connection electrodes CNE1, CNE2, and CNE3.

The first connection electrode CNE1 may be disposed on the first alignment electrode RME1 and may be connected to the first alignment electrode RME1 through a contact hole penetrating the first insulating layer PAS1. The first connection electrode CNE1 may connect one end of the light emitting diode elements 172_1 disposed between the first bank pattern BP1 and the second bank pattern BP2 to the first alignment electrode RME1.

The second connection electrode CNE2 may be disposed on the first and second alignment electrodes RME1 and RME2 and may be insulated from the first and second alignment electrodes RME1 and RME2. The first part of the second connection electrode CNE2 may be disposed on the second alignment electrode RME2 and may be extended in the second direction (the Y-axis direction). A second part of the second connection electrode CNE2 may be bent from a bottom side of the first part to be extended in the first direction (X-axis direction). The third part of the second connection electrode CNE2 may be bent from the right side of the second part to be extended in the second direction (Y-axis direction) and may be disposed on the first alignment electrode RME1. The second connection electrode CNE2 may connect the other end of the light emitting diode elements 172_1 disposed between the first bank pattern BP1 and the second bank pattern BP2 to one end of the light emitting diode elements 172_1 disposed between the second bank pattern BP2 and the third bank pattern BP3.

The third connection electrode CNE3 may be disposed on the third alignment electrode RME3 and may be connected to the third alignment electrode RME3 through the second contact hole CT2 penetrating the first insulating layer PAS1. The third connection electrode CNE3 may connect the other end of the light emitting diode elements 172_1 disposed between the second bank pattern BP2 and the third bank pattern BP3 to the third alignment electrode RME3.

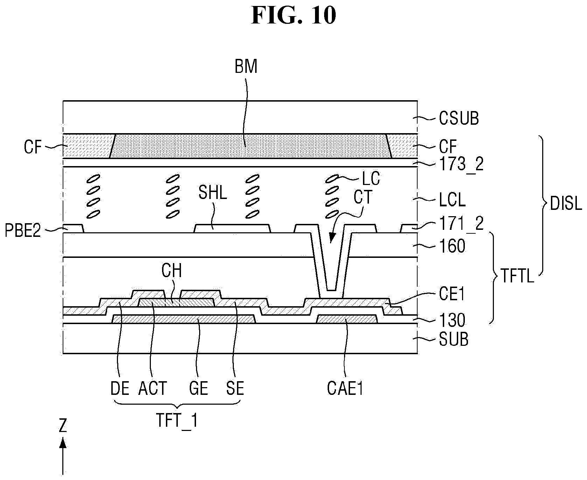

FIG. 10 is a cross-sectional view illustrating an example of a display area of a display panel according to one or more embodiments.

Referring to FIG. 10, the display panel 100 according to one or more embodiments may be a liquid crystal display panel including a liquid crystal layer LCL including liquid crystal LC.

The gate metal layer including the scan line, the first capacitor electrode CAE1, and a gate electrode GE may be disposed on the substrate SUB. The gate metal layer may include one or more selected from among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu), or an alloy thereof. Alternatively, a first conductive layer may have a two-layer structure of molybdenum/aluminum-neodymium, molybdenum/aluminum, or copper/titanium.

The gate insulating layer 130 may be disposed on the gate metal layer. The gate insulating layer 130 may include silicon oxide, silicon nitride, silicon oxynitride, aluminum oxide, tantalum oxide, hafnium oxide, zirconium oxide, titanium oxide, or a combination thereof.

An active layer ACT may be disposed on the gate insulating layer GI. The active layer ACT may include a channel area CH disposed between the source electrode SE and the drain electrode DE in the first direction (X-axis direction). The channel area CH may overlap the gate electrode GE.

The active layer ACT may include a silicon-based semiconductor material such as amorphous silicon, polycrystalline silicon, or single crystal silicon. Alternatively, the active layer ACT may include the oxide semiconductor.

An ohmic contact layer may be disposed on the active layer ACT. For example, the ohmic contact layer may be disposed between the source electrode SE and the active layer ACT and between the drain electrode DE and the active layer ACT. The ohmic contact layer may lower a contact resistance by lowering a Schottky barrier between metal and silicon, that is, a work function. The ohmic contact layer may be formed of amorphous silicon doped with n-type impurities in a high concentration.

The data metal layer including the data line, the source electrode SE, the drain electrode DE, and the first connection electrode CE1 may be disposed on the gate insulating layer 130. The source electrode SE and the drain electrode DE may be disposed on the active layer ACT. The source electrode SE and the first connection electrode CE1 may be integrally formed. The data metal layer may include one or more selected from among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu), or an alloy thereof. Alternatively, the data metal layer may have the two-layer structure of molybdenum/aluminum-neodymium, molybdenum/aluminum, or copper/titanium, or a three-layer structure of molybdenum/titanium/molybdenum or molybdenum/aluminum/molybdenum.

The first organic layer 160 may be disposed on the data metal layer. The first organic layer 160 may include an organic insulating material or an inorganic insulating material. For example, the first organic layer 160 may be an overcoat layer made of the organic insulating material.

The pixel electrode layer including a pixel electrode 171_2 may be disposed on the first organic layer 160. The pixel electrode 171_2 may be connected to the first connection electrode CE1 through the contact hole CT penetrating the first organic layer 160. The pixel electrode layer may be formed of a transparent material through which light may pass. For example, the pixel electrode layer may be made of indium tin oxide (ITO), indium zinc oxide (IZO), or indium tin zinc oxide (ITZO), but is not limited thereto. Any transparent and conductive material can be used.

A color filter substrate CSUB facing the substrate SUB may be a transparent insulating substrate similar to the substrate SUB. For example, the color filter substrate CSUB may be made of glass.

A light blocking member BM may be disposed on one surface of the color filter substrate CSUB facing the substrate SUB. The light blocking member BM may overlap the thin film transistor TFT and the contact hole CT. The light blocking member BM may include a light blocking pigment such as carbon black or an opaque metal material such as chromium (Cr). Alternatively, the light blocking member BM may include a photosensitive organic material. The light blocking member BM may be disposed on the substrate SUB.

The common electrode 173_2 may be disposed on one surface of the light blocking member BM facing the substrate SUB. The common electrode 173_2 may be made of the transparent conductive material such as indium tin oxide (ITO), indium zinc oxide (IZO), or indium tin zinc oxide (ITZO). The common electrode 173_2 may be formed entirely over the entire surface of the color filter substrate CSUB.

The liquid crystal layer LCL may be disposed between the substrate SUB and the color filter substrate CSUB. The liquid crystal layer LCL may include liquid crystals LC having dielectric anisotropy. When a data voltage is applied to the pixel electrode 171_2 and a common voltage is applied to the common electrode 173_2, the electric field may be formed between the pixel electrode 171_2 and the common electrode 173_2. The arrangement of the liquid crystals LC of the liquid crystal layer LCL may be changed according to the electric field between the pixel electrode 171_2 and the common electrode 173_2, whereby transmittance of light passing through the liquid crystal layer LCL may be controlled.

For example, when the electric field is formed between the pixel electrode 171_2 and the common electrode 173_2, the liquid crystals LC may rotate in a specific direction to adjust a phase delay value of light passing through the liquid crystal layer LCL. The amount of light passing through a lower polarizing film disposed on the bottom surface of the substrate SUB may be different from the amount of light passing through the upper polarizing film disposed on the upper surface of the color filter substrate CSUB. Therefore, the transmittance of light passing through the liquid crystal layer LCL may be controlled.

As shown in FIGS. 6 to 10, the display panel 100 according to one or more embodiments may be an organic light emitting diode display panel, the micro light emitting diode display panel, the nano light emitting diode display panel, or the liquid crystal display panel. Alternatively, the display panel 100 according to one or more embodiments may be an electroluminescent display panel using an electroluminescent element or an electrochromic display panel using an electrochromic element. Hereinafter, for convenience of description, the display panel 100 according to one or more embodiments will be mainly described as the organic light emitting display panel.

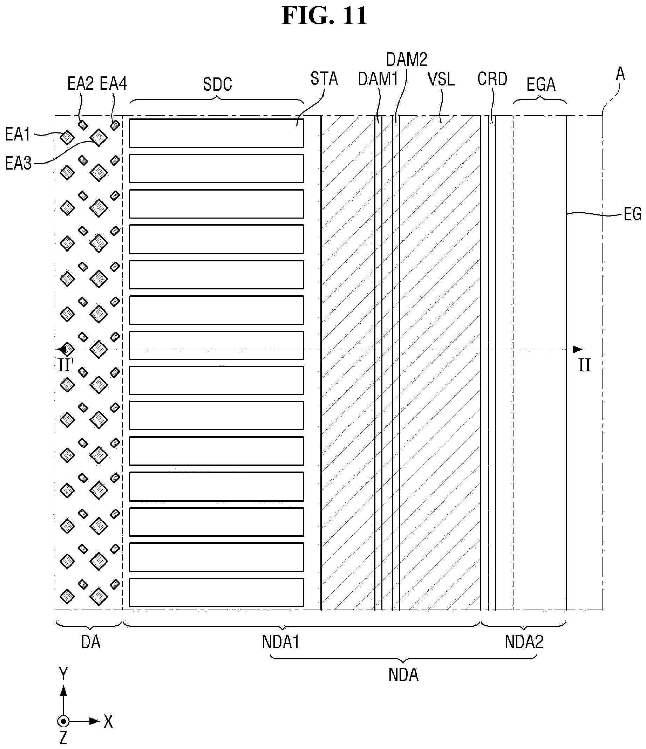

FIG. 11 is a layout diagram illustrating an example of an area A of FIG. 2 in more detail. FIG. 11 is a layout diagram illustrating a display area DA and a non-display area NDA disposed on the right side of the display panel 100 according to one or more embodiments.

Referring to FIG. 11, the display area DA may include a plurality of light emitting areas EA1, EA2, EA3, and EA4. The plurality of light emitting areas EA1, EA2, EA3, and EA4 include a first light emitting area EA1 for emitting light of a first color, a second light emitting area EA2 and a fourth light emitting area for emitting light of a second color, and a third light emitting area EA3 for emitting light of a third color. For example, the light of the first color is light in a red wavelength band of approximately 600 nm to 750 nm, the light of the second color is light in a green wavelength band of approximately 480 nm to 560 nm, and the light of the light of third color is light in a blue wavelength band of approximately 370 nm to 460 nm, but embodiments of the present specification are not limited thereto.

FIG. 11 illustrates that the second light emitting area EA2 and the fourth light emitting area EA4 emit light of the same color, that is, light of the second color, but embodiments of the present invention are not limited thereto. The second light emitting area EA2 and the fourth light emitting area EA4 may emit light of different colors. For example, the second light emitting area EA2 may emit light of a second color, and the fourth light emitting area EA4 may emit light of a fourth color.

In addition, although FIG. 11 illustrated that each of the first light emitting areas EA1, the second light emitting areas EA2, the third light emitting areas EA3, and the fourth light emitting areas EA4 has a rectangular planar shape, embodiments of the present invention are not limited thereto. Each of the first light emitting areas EA1, the second light emitting areas EA2, the third light emitting areas EA3, and the fourth light emitting areas EA4 may have a polygonal, circular, elliptical, or any other suitable shape other than a quadrangle.

In addition, as shown in FIG. 11, the area of the third light emitting area EA3 may be the largest, and the area of the second light emitting area EA2 and the area of the fourth light emitting area EA4 may be the smallest. The area of the second light emitting area EA2 and the area of the fourth light emitting area EA4 may be the same.

The second light emitting areas EA2 and the fourth light emitting areas EA4 may be alternately arranged in the first direction (X-axis direction). The second light emitting areas EA2 may be arranged (e.g., aligned) along the second direction (Y-axis direction). The fourth light emitting areas EA4 may be arranged (e.g., aligned) along the second direction (Y-axis direction). Each of the fourth light emitting areas EA4 has a long side in the first diagonal direction DD1 and a short side in the second diagonal direction DD2, while each of the second light emitting areas EA2 may have a long side in the second diagonal direction DD2 and a short side in the first diagonal direction DD2. The first diagonal direction DD1 indicates a diagonal direction between the first direction (X-axis direction) and the second direction (Y-axis direction), and the second diagonal direction DD2 may be orthogonal to the first diagonal direction DD1.

The first light emitting areas EA1 and the third light emitting areas EA3 may be alternately arranged along the first direction (X-axis direction). The first light emitting areas EA1 may be arranged (e.g., aligned) along the second direction (Y-axis direction). The third light emitting areas EA3 may be arranged (e.g., aligned) along the second direction (Y-axis direction). Each of the first light emitting areas EA1 and the third light emitting areas EA3 may have a square planar shape, but embodiments of the present invention are not limited thereto. In this case, each of the first light emitting areas EA1 and the third light emitting areas EA3 may include two sides parallel to each other in the first diagonal direction DD1 and two sides parallel to each other in the second diagonal direction DD2.

The non-display area NDA includes a first non-display area NDA1 and a second non-display area NDA2. The first non-display area NDA1 may be an area in which structures for driving pixels of the display area DA are disposed. The second non-display area NDA2 may be disposed outside the first non-display area NDA1. The second non-display area NDA2 may be an edge area of the non-display area NDA. Also, the second non-display area NDA2 may be an edge area of the display panel 100.

The first non-display area NDA1 may include a scan driving circuit unit SDC, a first power supply line VSL, a first dam DAM1 and a second dam DAM2.

The scan driving circuit unit SDC may include a plurality of stages STA. The plurality of stages STA may be respectively connected to the scan lines SL of the display area DA extending in the first direction (X-axis direction). That is, the plurality of stages STA may be one-to-one connected to the scan lines SL of the display area DA extending in the first direction (X-axis direction). The plurality of stages STA may sequentially apply scan signals to the plurality of scan lines SL.

The first power supply line VSL may be disposed outside the scan driving circuit unit SDC. That is, the first power supply line VSL may be disposed closer to an edge EG of the display panel 100 than the scan driving circuit unit SDC is. In one or more embodiments, the first power supply line VSL may be extended in the second direction (Y-axis direction) in the non-display area NDA on the left side of the display panel 100.

The first power supply line VSL may be electrically connected to the common electrode 173 (e.g., see FIG. 6), so that the common electrode 173 may receive the first power supply voltage from the first power supply line VSL.

The first dam DAM1 and the second dam DAM2 are structures for preventing the encapsulation organic layer TFE2 of the encapsulating layer ENC from overflowing to the edge EG of the display panel 100. The first dam DAM1 and the second dam DAM2 may be extended in the second direction (Y-axis direction) in the non-display area NDA on the left side of the display panel 100. The second dam DAM2 may be disposed outside the first dam DAM1. The first dam DAM1 may be disposed closer to the scan driving circuit unit SDC than the second dam DAM2, and the second dam DAM2 may be disposed closer to the edge EG of the display panel 100 than the first dam DAM1.

FIG. 11 illustrates that the first dam DAM1 and the second dam DAM2 are disposed on the first power supply line VSL, but embodiments of the present invention are not limited thereto. For example, any one of the first dam DAM1 or the second dam DAM2 may not be disposed on the first power supply line VSL. Alternatively, neither the first dam DAM1 nor the second dam DAM2 may be disposed on the first power supply line VSL. In this case, the first dam DAM1 and the second dam DAM2 may be disposed outside the first power supply line VSL1.

Although FIG. 11 illustrates that the display panel 100 includes two dams DAM1 and DAM2 according to one or more embodiments, embodiments of the present invention are not limited thereto. That is, the display panel 100 according to one or more embodiments may include three or more dams.

The second non-display area NDA2 may include a crack dam CRD and an edge area EGA.

The crack dam CRD may be extended in the second direction (Y-axis direction) in the non-display area NDA on the left side of the display panel 100. The width of the crack dam CRD may be about 30 µm or less.

The edge area EGA may be disposed along the edge EG of the display panel 100. The edge area EGA may be an area in which processing marks generated in the process of cutting the substrate SUB are generated.

Because an area C of FIG. 2 is substantially the same as that of the area A illustrated in FIG. 10 symmetrical, the description of the area C of FIG. 2 will be omitted.

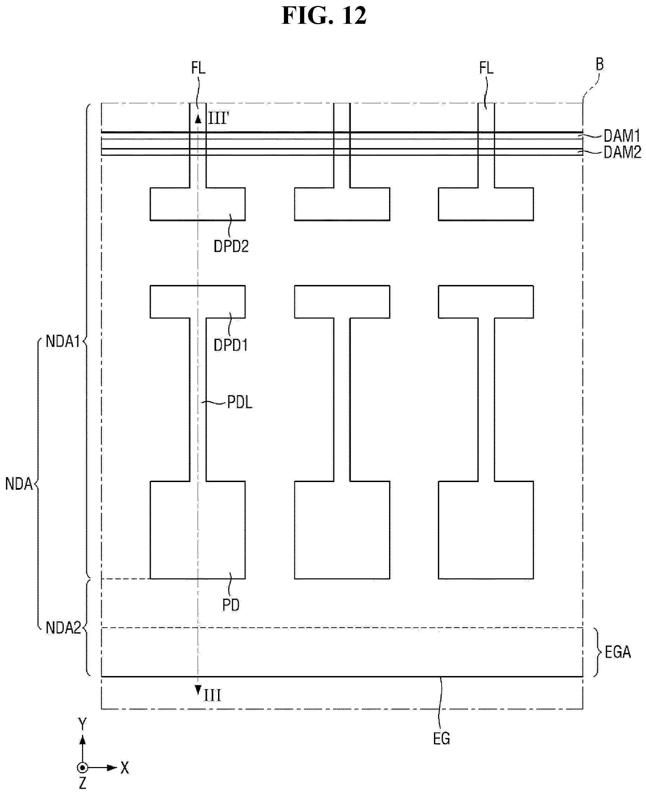

FIG. 12 is a layout diagram illustrating an example of an area B of FIG. 2 in more detail. FIG. 12 is a layout diagram illustrating a non-display area NDA disposed under the display panel 100 according to one or more embodiments.

Referring to FIG. 12, the first non-display area NDA1 may include a plurality of display pads PD, a plurality of first driving pads DPD1, a plurality of second driving pads DPD2, and a plurality of pad lines, a plurality of fan-out lines, the first dam DAM1, and the second dam DAM2.

The plurality of display pads PD may be electrically connected to the circuit board 300 through the conductive adhesive member such as the anisotropic conductive film or the anisotropic conductive adhesive. Each of the plurality of display pads PD may be connected to the pad line PDL. The pad line PDL may connect the display pad PD and a first driving pad DPD1.

The plurality of first driving pads DPD1 and the plurality of second driving pads DPD2 may be electrically connected to the driving IC 200 through the conductive adhesive member such as the anisotropic conductive film or the anisotropic conductive adhesive. The plurality of first driving pads DPD1 may be input pads for the driving IC 200 to receive signals (eg, digital video data, data timing control signal, etc.) of the circuit board 300. The plurality of second driving pads DPD2 may be output pads for outputting signals (eg, data voltages) of the driving IC 200. Each of the plurality of second driving pads DPD2 may be connected to the fan-out line FL. The fan-out line FL may connect the second driving pad DPD2 and the data line of the display area DA.

Each of the plurality of first driving pads DPD1 may be disposed closer to the display area DA in the second direction (Y-axis direction) than the display pad PD connected thereto is. That is, among the display pad PD and the first driving pad DPD1 that are connected to each other, the display pad PD may be disposed closer to the edge EG of the display panel 100 in the second direction (Y-axis direction) than the first driving pad DPD1 is.

Each of the plurality of second driving pads DPD2 may be disposed closer to the display area DA in the second direction (Y-axis direction) than any one of the plurality of first driving pads DPD1. That is, the first driving pad DPD1 may be disposed closer to the edge EG of the display panel 100 in the second direction (Y-axis direction) than any one of the second driving pads DPD2 from among the plurality of second driving pads DPD is.

The first dam DAM1 and the second dam DAM2 may cross the fan-out line FL. The first dam DAM1 and the second dam DAM2 may be extended in the first direction (X-axis direction) in the non-display area NDA under the display panel 100. The second dam DAM2 may be disposed outside the first dam DAM1. The first dam DAM1 may be disposed closer to a display area DA than the second dam DAM2 is, and the second dam DAM2 may be disposed closer to the edge EG of the display panel 100 than the first dam DAM1 is.

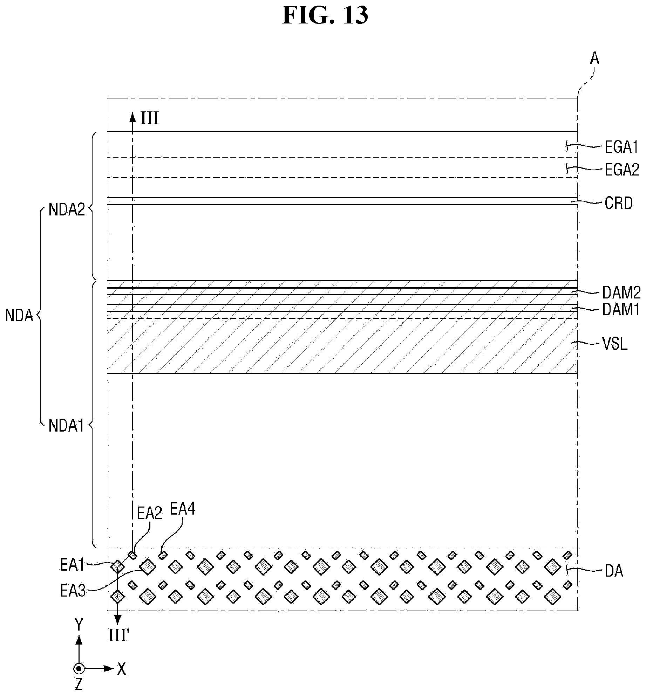

FIG. 13 is a layout diagram illustrating an example of an area D of FIG. 2 in more detail. FIG. 13 is a layout diagram illustrating a display area DA and a non-display area NDA disposed above the display panel 100 according to one or more embodiments.

Referring to FIG. 13, the first non-display area NDA1 may include the first power supply line VSL, the first dam DAM1 and the second dam DAM2. The first non-display area NDA1 may not include the scan driving circuit unit SDC.

The first power supply line VSL may be extended in the first direction (X-axis direction) in the non-display area NDA on the upper side of the display panel 100. The first power supply line VSL may be electrically connected to the common electrode 173 (e.g., see FIG. 6), so that the common electrode 173 may receive the first power supply voltage from the first power supply line VSL.

The first dam DAM1 and the second dam DAM2 may be extended in the first direction (X-axis direction) in the non-display area NDA on the upper side of the display panel 100. The second dam DAM2 may be disposed outside the first dam DAM1. The first dam DAM1 may be disposed closer to the display area DA than the second dam DAM2 is, and the second dam DAM2 may be disposed closer to the edge EG of the display panel 100 than the first dam DAM1 is.

FIG. 13 illustrates that the first dam DAM1 and the second dam DAM2 are disposed on the first power supply line VSL, but embodiments of the present invention are not limited thereto. For example, any one of the first dam DAM1 or the second dam DAM2 may not be disposed on the first power supply line VSL. Alternatively, neither the first dam DAM1 nor the second dam DAM2 may be disposed on the first power supply line VSL. In this case, the first dam DAM1 and the second dam DAM2 may be disposed outside the first power supply line VSL1.

The second non-display area NDA2 may include the crack dam CRD and the edge area EGA.

The crack dam CRD may be the outermost structure disposed on the outermost side of the display panel 100. The crack dam CRD may be extended in the first direction (X-axis direction) in the non-display area NDA on the upper side of the display panel 100.

The edge area EGA may be disposed along the edge EG of the display panel 100. The edge area EGA may be an area in which processing marks generated in the process of cutting the substrate SUB are generated.

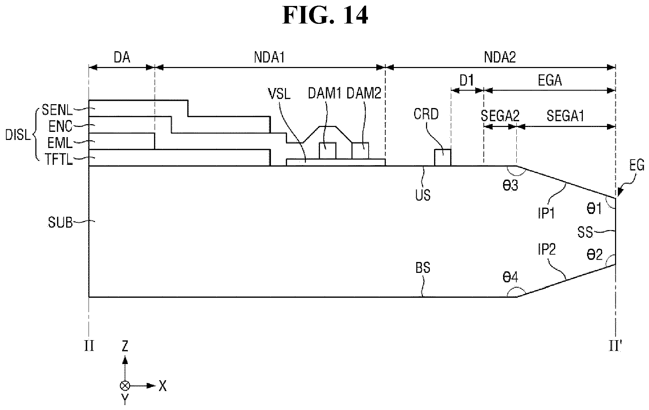

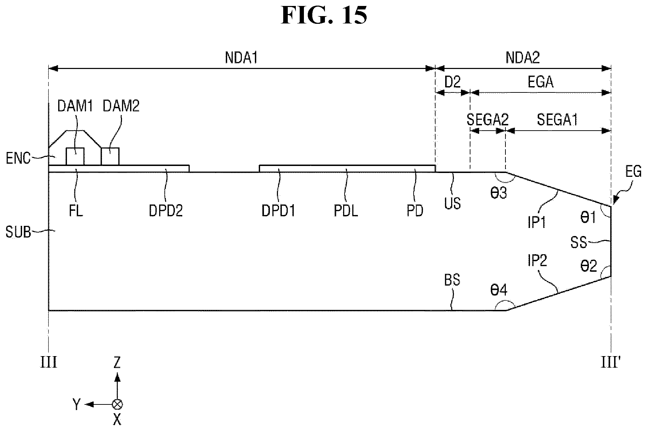

FIG. 14 is a cross-sectional view illustrating an example of the display panel taken along the line II-II' of FIG. 11. FIG. 15 is a cross-sectional view illustrating an example of the display panel taken along the line III-III' of FIG. 12.

In FIGS. 14 and 15, when the substrate SUB is cut with a cutting member such as a cutting wheel during the manufacturing process of the display panel 100 and then a polishing process is performed, a cross-section of the edge EG of the display panel 100 is shown.

Referring to FIGS.14 and 15, the edge area EGA may include a first sub-edge area SEGA1 and a second sub-edge area SEGA2.

The first sub-edge area SEGA1 may be an area in which processing marks are formed on the substrate SUB by the polishing process performed after cutting the substrate SUB with the cutting member. That is, the first sub-edge area SEGA1 may include a first inclined surface IP1 and a second inclined surface IP2 formed by the polishing process.

An angle θ1 between a side surface SS and the first inclined surface IP1 and an angle θ3 between the first inclined surface IP1 and the upper surface US may be an obtuse angle. An angle θ2 between the side surface SS and the second inclined surface IP2 and an angle θ4 between the second inclined surface IP2 and the bottom surface BS may be obtuse angles.

FIG. 14 illustrates that the length in the inclination direction of the first inclined surface IP1 is longer than the length in the inclination direction of the second inclined surface IP2 (Please check, cannot be seen in FIG. 14). In this case, the angle θ1 between the side surface SS and the first inclined surface IP1 may be greater than the angle θ2 between the side surface SS and the second inclined surface IP2. Also, the angle θ4 between the second inclined surface IP2 and the bottom surface BS may be greater than the angle θ2 between the first inclined surface IP1 and the upper surface US.

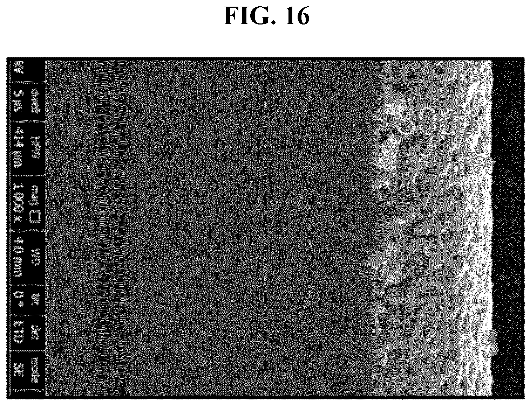

The width of the first sub-edge area SEGA1 may be within about 150 µm. For example, the width of the first sub-edge area SEGA1 may be greater than about 80 µm as shown in FIG. 16.

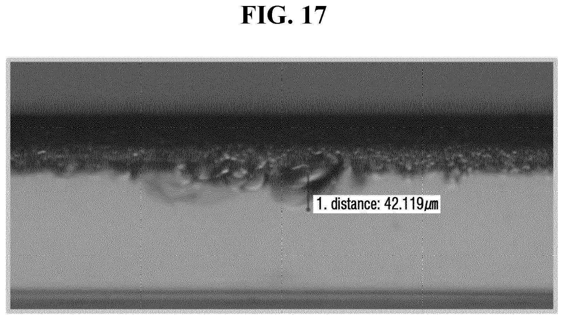

A second sub edge area SEGA2 may be an area in which processing marks such as chipping are formed on the upper surface of the substrate SUB as shown in FIG. 17 by the polishing process. The width of the second sub-edge area EGA2 may be within about 50 µm.

The crack dam CRD may be a structure for preventing cracks from occurring in the process of cutting the substrate SUB during the manufacturing process of the display device 10. The crack dam CRD may be the outermost structure disposed on the outermost side of the left side of the display panel 100.

A distance D1 between the crack dam CRD and the edge area EGA may be set in consideration of a manufacturing tolerance of the crack dam CRD. For example, the distance D1 between the crack dam CRD and the edge area EGA may be about 30 µm or less. The distance D1 between the crack dam CRD and the edge area EGA may be 0 µm.

The minimum (necessary) distance from the crack dam CRD, which may be the outermost structure, to the edge EG of the display panel 100 may be the sum of the width of the first sub-edge area SEGA1, the width of the second sub-edge area SEGA2, and the minimum distance D1 from the crack dam CRD to the edge area EGA. For example, the minimum (necessary) distance from the crack dam CRD, which is the outermost structure, to the edge EG of the display panel 100 may be about 230 µm or less.

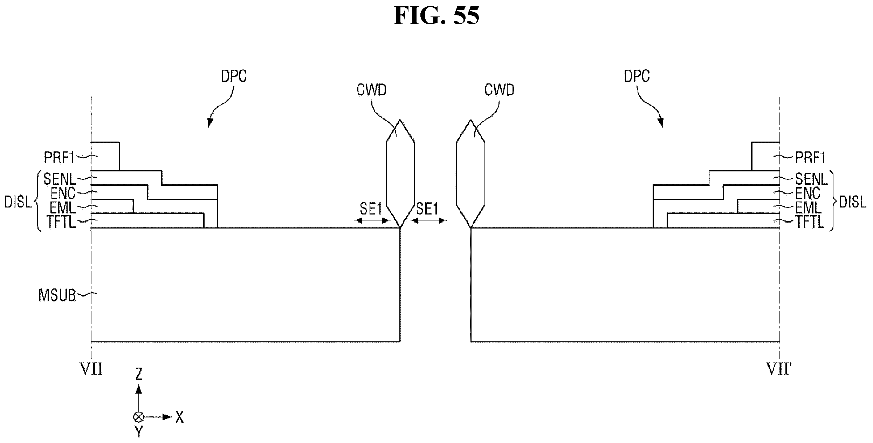

However, when the substrate SUB is cut with the cutting member, the minimum (necessary) distance from the crack dam CRD to the edge EG of the display panel 100 may vary according to the tolerance of one side of the cutting member. In this case, the minimum distance from the crack dam CRD to the edge EG of the display panel 100 may be the sum of the width of the first sub-edge area SEGA1, the width of the second sub-edge area SEGA2, the minimum distance D1 from the crack dam CRD to the edge area EGA, and the one-sided tolerance of the cutting member. For example, the minimum distance from the crack dam CRD, which is the outermost structure, to the edge EG of the display panel 100 may be approximately 130 µm to 330 µm. That is, the minimum distance from the crack dam CRD, which is the outermost structure, to the edge EG of the display panel 100 may be greater than about 130 µm. The description of the distance between the crack dam CRD and the edge EG of the display panel 100 according to the tolerance on one side of the cutting member will be described later with reference to FIG. 55.

The display pad PD may be the outermost structure disposed on the outermost side under the display panel 100. The distance D2 between the display pad PD and the edge area EGA may be set in consideration of the manufacturing tolerance of the display pad PD. For example, the distance D2 between the display pad PD and the edge area EGA may be about 30 µm or less. The distance D2 between the display pad PD and the edge area EGA may be 0 µm.

The minimum (necessary) distance from the display pad PD to the edge EG of the display panel 100 may be the sum of the width of the first sub-edge area SEGA1, the width of the second sub-edge area SEGA2, and the minimum (necessary) distance D2 from the display pad PD to the edge area EGA. For example, the minimum distance from the crack dam CRD, which is the outermost structure, to the edge EG of the display panel 100 may be approximately 230 µm.

However, when the substrate SUB is cut with the cutting member, the minimum distance from the display pad PD to the edge EG of the display panel 100 may vary depending on the tolerance of one side of the cutting member. In this case, the minimum distance from the crack dam CRD to the edge EG of the display panel 100 may be the sum of the width of the first sub-edge area SEGA1, the width of the second sub-edge area SEGA2, the minimum distance D1 from the crack dam CRD to the edge area EGA, and the one-sided tolerance of the cutting member. For example, when the tolerance on one side of the cutting member is approximately 100 µm, the minimum distance from the display pad PD to the edge EG of the display panel 100 may be 130 µm to 330 µm or less. That is, when the substrate SUB is cut with the cutting member, the minimum distance from the display pad PD to the edge EG of the display panel 100 may be greater than 130 µm.

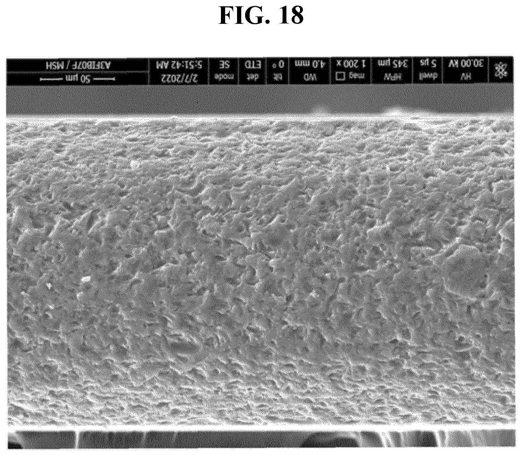

In addition, when the substrate SUB is cut with the cutting member during the manufacturing process of the display panel 100 and then the polishing process is performed, the side surface SS, the first inclined surface IP1, and the second inclined surface IP2 of the display panel 100 may be polished by a polishing apparatus. In this case, the roughness of the side surface SS, the first inclined surface IP1, and the second inclined surface IP2 of the display panel 100 may be about 1 µm as shown in FIG. 18.

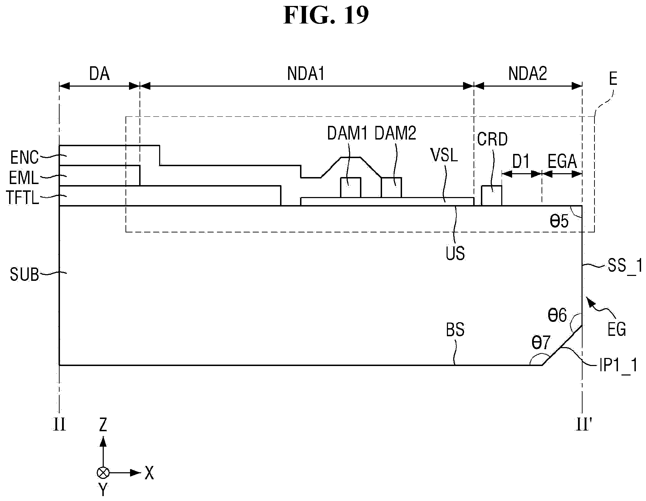

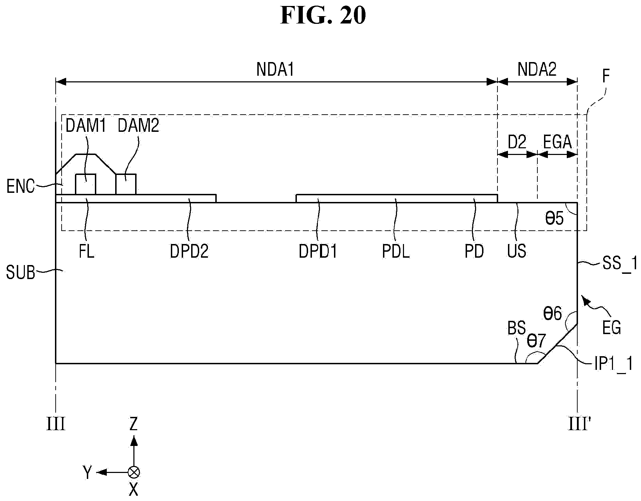

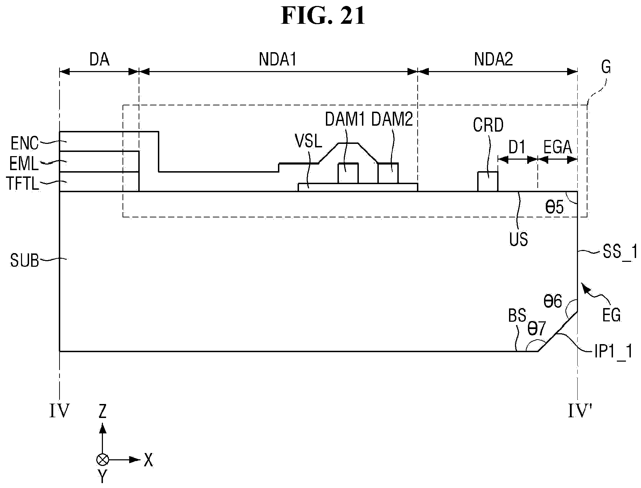

FIG. 19 is a cross-sectional view illustrating an example of the display panel taken along the line II-II' of FIG. 11. FIG. 20 is a cross-sectional view illustrating an example of the display panel taken along the line III-III' of FIG. 12. FIG. 21 is a cross-sectional view illustrating an example of the display panel taken along the line IV-IV' of FIG. 13.

FIGS. 19 to 21 illustrate cross-sections of the edge EG of the display panel 100 when the substrate SUB of the display panel 100 is cut by irradiating a laser and then spraying an etchant. The side surface of the substrate SUB disposed on the left side of the display panel 100 shown in FIG. 19 may be the first side surface or the left side surface of the substrate SUB. The side surface of the substrate SUB disposed below the display panel 100 shown in FIG. 20 may be the second side surface or the bottom side surface of the substrate SUB. The side surface of the substrate SUB disposed below the display panel 100 shown in FIG. 21 may be the third side surface or the upper side surface of the substrate SUB. The side surface of the substrate SUB disposed on the right side of the display panel 100 may be the fourth side surface or the right side surface of the substrate SUB.

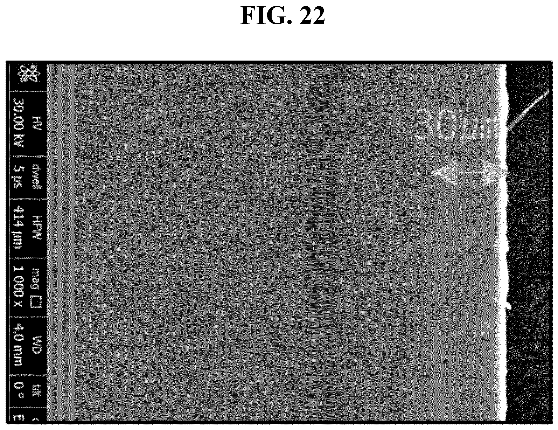

Referring to FIGS. 19 to 21, the edge area EGA may be an area in which a processing mark is formed on an upper surface US of the substrate SUB by an etchant when cutting the substrate SUB by spraying the etchant after irradiating the laser. The edge area EGA may be within about 30 µm as shown in FIG. 22.

The edge area EGA may include a first inclined surface IP1_1 formed by spraying the etchant after irradiating the laser. An angle θ5 between a side surface SS_1 and an upper surface US may be about 90 degrees. That is, the angle between the side surface SS_1 and the upper surface US may be substantially close to ortogonal (perpendicular). An angle θ6 between the side surface SS_1 and the first inclined surface IP1_1 and an angle θ7 between the first inclined surface IP1_1 and the bottom surface BS may be obtuse angles. The processing mark formed on the upper surface US of the substrate SUB may overlap the first inclined surface IP1_1 in the third direction (Z-axis direction).

Whereas the processing mark is a trace formed by the penetration of the etchant penetrating between an acid-resistant film and the upper surface of the substrate SUB in the manufacturing process, the first inclined surface IP1_1 is the inclined surface directly formed by the etchant. Accordingly, the width of the edge area EGA in which the processing mark is formed may be smaller than the width of the first inclined surface IP1_1. The width of the edge area EGA indicates a length of the edge area EGA in the first direction (X-axis direction) or in the second direction (Y-axis direction). The width of the first inclined surface IP1_1 indicates the length of the first inclined surface IP1_1 in the first direction (X-axis direction) or in the second direction (Y-axis direction).

The crack dam CRD may be a structure for preventing cracks from occurring in the process of cutting the substrate SUB during the manufacturing process of the display device 10. The crack dam CRD may be an outermost structure disposed on the outermost side of the left side of the display panel 100. A distance D1 between the crack dam CRD and the edge area EGA may be about 30µm or less. In one or more embodiments, the distance D1 between the crack dam CRD and the edge area EGA may be 0 µm.

The minimum (necessary) distance from the crack dam CRD to the edge EG of the display panel 100 may be the sum of the width of the edge area EGA and the minimum (necessary) distance D1 from the crack dam CRD to the edge area EGA. For example, the minimum distance D1 from the outermost structure of the crack dam CRD to the edge area EGA may be about 30 µm or less.

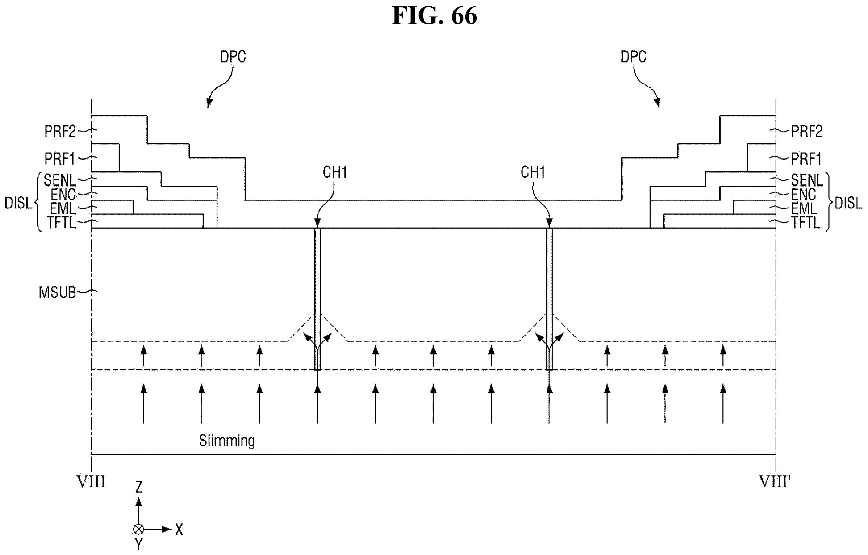

At this time, when the substrate SUB is cut by spraying the etchant after laser irradiation, the minimum (necessary) distance between the crack dam CRD and the edge EG of the display panel 100 may vary depending on the one-sided tolerance of the laser. In this case, the minimum distance from the crack dam CRD, which is the outermost structure, to the edge EG of the display panel 100 may be the sum of the width of the edge area EGA, the minimum distance D1 from the crack dam CRD to the edge area EGA, and the one-sided tolerance of the laser. For example, when the one-sided tolerance of the laser is 50 µm, the minimum distance D1 from the crack dam CRD, which is the outermost structure, to the edge area EGA may be about 80 µm or less. In addition, when the laser one-sided tolerance is 50 µm, the minimum distance from the crack dam CRD, which is the outermost structure, to the edge EG of the display panel 100 may be about 130 µm or less. The description of the distance between the crack dam CRD and the edge area EGA due to the one-sided tolerance of the laser will be described later with reference to FIG. 66.

The minimum (necessary) distance from the display pad PD to the edge EG of the display panel 100 may be the sum of the width of the edge area EGA and the minimum (necessary) distance D2 from the display pad PD to the edge area EGA. For example, the minimum distance from the display pad PD, which is the outermost structure, to the edge EG of the display panel 100 may be about 80 µm or less.

When the substrate SUB is cut by spraying the etchant after laser irradiation, the minimum (necessary) distance from the display pad PD to the edge EG of the display panel 100 may vary depending on the tolerance of one side of the laser. The minimum distance from the display pad PD, which is the outermost structure, to the edge EG of the display panel 100 may be the sum of the width of the edge area EGA, the minimum distance D2 from the display pad PD to the edge area EGA, and the one-sided tolerance of the laser. For example, when the laser one-sided tolerance is 50 µm, the minimum distance from the display pad PD to the edge EG of the display panel 100 may be about 130 µm or less.

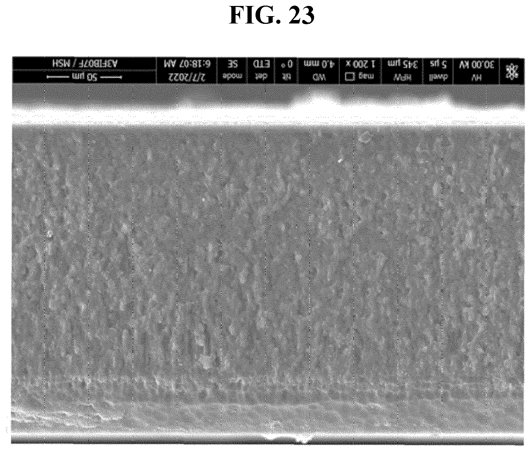

In addition, when the substrate SUB of the display panel 100 is cut by irradiating the laser during the manufacturing process of the display panel 100 and then spraying the etchant, the side surface SS_1 and the first inclined surface IP1_1 of the display panel 100 may be etched by the etchant. In this case, the roughness of the side surface SS_1 and the first inclined surface IP1_1 of the display panel 100 may be about 0.5 µm or less as shown in FIG. 23.

When the substrate SUB of the display panel 100 is cut by spraying the etchant after irradiating the laser, the roughness of the side surface SS_1 and the first inclined surface IP1_1 of the display panel 100 may be smaller than the roughness of the side surface SS_1, the first inclined surface IP1_1, and the second inclined surface IP2_1 of the display panel 100 when the polishing process is performed after cutting the substrate SUB with the cutting member.

In addition, the side surface SS_1 of the display panel 100 is formed by the laser and the etchant while the first inclined surface IP1_1 is formed by the etchant. Accordingly, the roughness of the side surface SS of the display panel 100 may be different from the roughness of the first inclined surface IP1. For example, a difference between the roughness of the side surface SS_1 of the display panel 100 and the roughness of the first inclined surface IP1_1 may vary by approximately 1% to 20%.

The first power supply line VSL may be a first outer structure disposed in the first non-display area NDA1. The first outer structure may be disposed farther away from the edge EG of the display panel 100 than the outermost structure. That is, the distance from the first power supply line VSL as the first outer structure to the edge EG of the display panel 100 may be greater than the distance from the crack dam CRD, which is the outermost structure, to the edge EG of the display panel 100.

The distance from the first power supply line VSL to the crack dam CRD on the left side of the display panel 100 may be smaller than the distance from the first power supply line VSL to the crack dam CRD on the upper side of the display panel 100. Therefore, the distance from the first power supply line VSL on the left side of the display panel 100 to the edge EG of the display panel 100 may be smaller than the distance from the first power supply line VSL on the upper side of the display panel 100 to the edge EG of the display panel 100. For example, the distance from the first power supply line VSL on the left side of the display panel 100 to the edge EG of the display panel 100 may be about 160 µm or less. Also, the distance from the first power supply line VSL to the edge EG of the display panel 100 on the upper side of the display panel 100 may be about 445 µm or less.

The second dam DAM2 may be a second outer structure disposed in the first non-display area NDA1. The second outer structure may be disposed farther away from the edge EG of the display panel 100 than the first outer structure. That is, the distance from the second dam DAM2 as the second outer structure to the edge EG of the display panel 100 may be greater than the distance from the first power supply line VSL, which is the first outer structure, to the edge EG of the display panel 100.

The distance from the second dam DAM2 to the crack dam CRD on the left side of the display panel 100 may be smaller than the distance from the second dam DAM2 to the crack dam CRD on the upper side of the display panel 100. Therefore, the distance from the second dam DAM2 on the left side of the display panel 100 to the edge EG of the display panel 100 may be smaller than the distance from the second dam DAM2 on the upper side of the display panel 100 to the edge EG of the display panel 100. For example, the distance from the second dam DAM2 on the left side of the display panel 100 to the edge EG of the display panel 100 may be about 220 µm or less. Also, the distance from the second dam DAM2 on the upper side of the display panel 100 to the edge EG of the display panel 100 may be about 445 µm or less.

As described above, when the substrate SUB of the display panel 100 is cut by spraying the etchant after irradiating the laser, the minimum (necessary) distance from the crack dam CRD to the edge EG of the display panel 100 may be at least about 170 µm less than the minimum distance from the crack dam CRD to the edge EG of the display panel 100 when the polishing process is performed after the substrate SUB is cut with the cutting member. Therefore, when the substrate SUB of the display panel 100 is cut by spraying the etchant after irradiating the laser, the width of the second non-display area NDA2 may be greatly reduced compared to the case where the polishing process is performed after cutting the substrate SUB with the cutting member. That is, the width of the non-display area NDA may be reduced or minimized.

In FIGS. 19 to 21, the crack dam CRD is provided as an example of the outermost structure on the left, upper, and right sides of the display panel 100, and the display pad PD is provided as an example of the outermost structure on the bottom side of the display panel 100, but embodiments of the present invention are not limited thereto. The outermost structure is a structure disposed closest to the edge EG of the display panel 100 and may be a structure for driving the display panel 100 or a structure for improving a function of the display panel 100. When the crack dam CRD is omitted or deleted, the outermost structure may be a power supply line (e.g., the first power supply line VSL) for driving the display panel 100. Alternatively, when the crack dam CRD is omitted or deleted, the outermost structure may be a signal line. The signal line may be a signal line for driving the scan driving circuit unit SDC. Alternatively, it may be a line or an organic layer structure (e.g., the first dam DAM1 and the second dam DAM2) for improving the function of the display panel 100.

In addition, the outermost structure may not be a structure disposed at or near the edge EG of the display panel 100 but may be a structure disposed apart (or spaced) from the edge EG of the display panel 100. Also, the outermost structure may be a structure that does not overlap the processing mark of the display panel 100. That is, the structure overlapping the processing mark of the display panel 100 or disposed on the edge EG of the display panel 100 corresponds to a structure that is used to improve the manufacturing process of the display panel 100 but is not removed and remains in the display panel 100 rather than a structure for driving the display panel 100 or a structure for improving the function of the display panel 100. Therefore, a heat dissipation layer IRL and a plurality of electrostatic protection lines ESL1 and ESL2, which will be described later, are not outermost structures defined in the present invention.

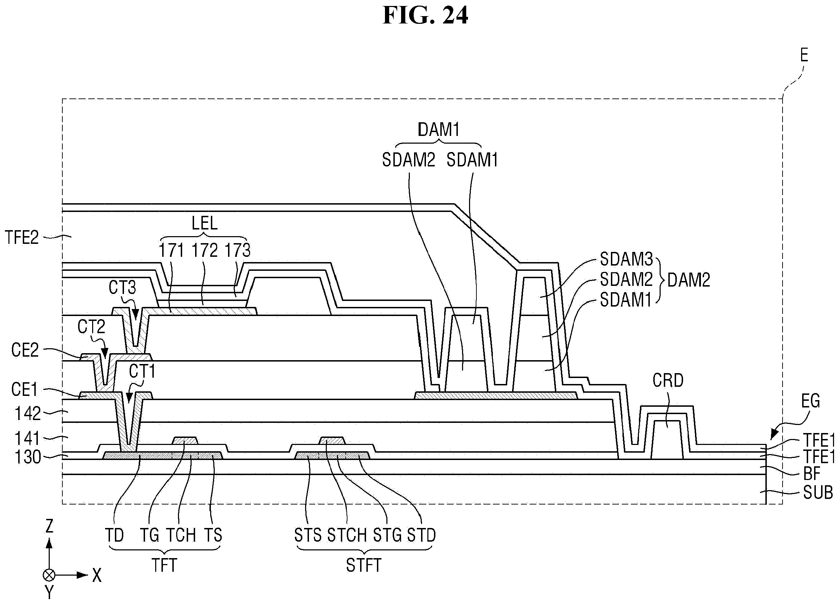

FIG. 24 is an enlarged cross-sectional view illustrating an example of an area E of FIG. 19 in more detail.

Referring to FIG. 24, the crack dam CRD may include the same material as the first organic layer 160 and may be disposed on (or at) the same layer as the first organic layer 160. In FIG. 24, the crack dam CRD is shown as being disposed on a buffer layer BF. In one or more embodiments, the crack dam CRD may be disposed on the second interlayer insulating layer 142 or on any other suitable layer. The crack dam CRD may be formed of the organic film such as acryl resin, epoxy resin, phenolic resin, polyamide resin, or polyimide resin, etc.

FIG. 24 illustrates that the crack dam CRD includes one organic layer, but embodiments of the present invention are not limited thereto. For example, the crack dam CRD may further include another organic layer including the same material as the second organic layer 180. Alternatively, the crack dam CRD may further include another organic layer including the same material as the bank 190. Alternatively, the crack dam CRD may further include another organic layer including the same material as the spacer 191.

The first power supply line VSL may include the same material as the first data metal layer including the first connection electrode CE1 and the data lines and may be disposed on (or at) the same layer as the first data metal layer. The first power supply line VSL may be disposed on the second interlayer insulating layer 142. The first power supply line VSL may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

The first dam DAM and the second dam DAM2 may be disposed on the first power supply line VSL. The first dam DAM1 may include a first sub-dam SDAM1 and a second sub-dam SDAM2, and the second dam DAM2 may include the first sub-dam SDAM1, the second sub-dam SDAM2, and a third sub-dam SDAM3. The first sub-dam SDAM1 may include the same material as the first organic layer 160 and may be disposed on (or at) the same layer as the first organic layer 160. The second sub-dam SDAM2 may include the same material as the second organic layer 180 and may be disposed on (or at) the same layer as the second organic layer 180. The third sub-dam SDAM3 may include the same material as the bank 190 and may be disposed on (or at) the same layer as the bank 190.

The height of the first dam DAM1 may be lower than the height of the second dam DAM2, but embodiments of the present invention are not limited thereto. The height of the first dam DAM1 may be substantially the same as the height of the second dam DAM2 or may be higher than the height of the second dam DAM2.

The common electrode 173 may be connected to the first organic layer 160, the second organic layer 180, and the first power supply line VSL that is not covered by the first dam DAM1 and is exposed. Accordingly, the common electrode 173 may receive the first power supply voltage of the first power supply line VSL.

In one or more embodiments, the first encapsulation inorganic layer TFE1 may cover the first dam DAM1, the second dam DAM2, and the crack dam CRD in the non-display area NDA on the left side of the display panel 100. The first encapsulation inorganic layer TFE1 may be extended to the edge EG of the display panel 100 in the non-display area NDA under the display panel 100.

The encapsulation organic layer TFE2 may be disposed to cover the upper surface of the first dam DAM1 and not to cover the upper surface of the second dam DAM2. However, embodiments of the present invention are not limited thereto. The encapsulation organic layer TFE2 may not cover both the upper surface of the first dam DAM1 and the upper surface of the second dam DAM2. The encapsulation organic layer TFE2 may not overflow to the edge EG of the display panel 100 due to the first dam DAM1 and the second dam DAM2.

The second encapsulation inorganic layer TFE3 may cover the first dam DAM1, the second dam DAM2, and the crack dam CRD in the non-display area NDA under the display panel 100. The second encapsulation inorganic layer TFE3 may be extended to the edge EG of the display panel 100 in the non-display area NDA under the display panel 100.

An inorganic encapsulation area in which the first encapsulation inorganic layer TFE1 and the second encapsulation inorganic layer TFE3 contact each other may be formed from the second dam DAM2 to the edge EG of the display panel 100. The inorganic encapsulation area may be disposed to surround the second dam DAM2.

In addition, FIG. 24 illustrates as an example the scan thin film transistor STFT of the scan driving circuit unit SDC. Because the scan thin film transistor STFT is substantially the same as the thin film transistor TFT described with reference to FIG. 7, the description of the scan thin film transistor STFT will be omitted.

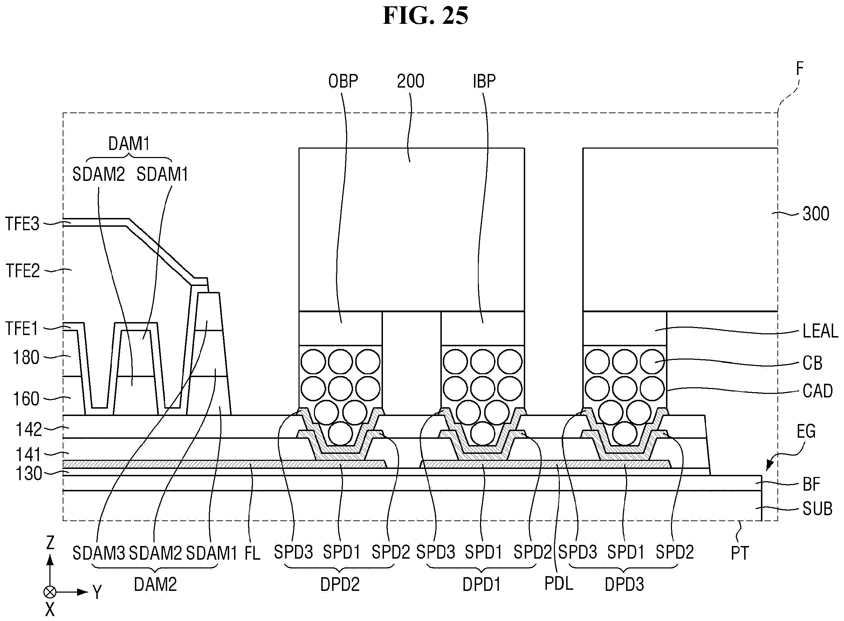

FIG. 25 is an enlarged cross-sectional view illustrating an example of an area F of FIG. 20 in more detail.

Referring to FIG. 25, each of the display pad PD (e.g., see FIG. 20), i.e., the first driving pad DPD1 and the second driving pad DPD2, may include a first sub pad SPD1, a second sub pad SPD2, and a third sub pad SPD3.

The first sub pad SPD1 may include the same material as the first gate metal layer including the gate electrode TG, the first capacitor electrode CAE1 of the capacitor Cst, and the scan lines and may be disposed on (or at) the same layer as the first gate metal layer. The first sub pad SPD1 may be disposed on the gate insulating layer 130. The first sub pad SPD1 may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

The second sub pad SPD2 may include the same material as the second gate metal layer including the second capacitor electrode CAE2 and may be disposed on (or at) the same layer as the second gate metal layer. The second sub pad SPD2 may be disposed on the first interlayer insulating layer 141. The second sub pad SPD2 may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

The third sub pad SPD3 may include the same material as the first data metal layer including the first connection electrode CE1 and the data lines and may be disposed on (or at) the same layer as the first data metal layer. The third sub pad SPD3 may be disposed on the second interlayer insulating layer 142. The third sub pad SPD3 may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

The third sub pad SPD3 of the display pad PD may be electrically connected to a lead line LEAL of the circuit board 300 through a conductive adhesive member CAD such as the anisotropic conductive film or the anisotropic conductive adhesive. The third sub pad SPD3 of the first driving pad DPD1 may be electrically connected to an input bump IBP of the driving IC 200 through the conductive adhesive member CAD such as the anisotropic conductive film or the anisotropic conductive adhesive. The third sub pad SPD3 of the second driving pad DPD2 may be electrically connected to an output bump OBP of the driving IC 200 through the conductive adhesive member CAD such as the anisotropic conductive film or the anisotropic conductive adhesive.

The first encapsulation inorganic layer TFE1 and the second encapsulation inorganic layer TFE3 may be disposed to cover the first dam DAM1 and partially cover the second dam DAM2. For example, the first encapsulation inorganic layer TFE1 and the second encapsulation inorganic layer TFE3 may be disposed not to cover a portion of the upper surface of the second dam DAM2. Alternatively, the first encapsulation inorganic layer TFE1 and the second encapsulation inorganic layer TFE3 may be covered, but in this case, the third sub pad SPD3 of the second driving pad DPD2 may not be covered. That is, the first encapsulation inorganic layer TFE1 and the second encapsulation inorganic layer TFE3 may not be extended to the display pad PD, the first driving pad DPD1, and the second driving pad DPD2 adjacent the edge EG of the display panel 100.

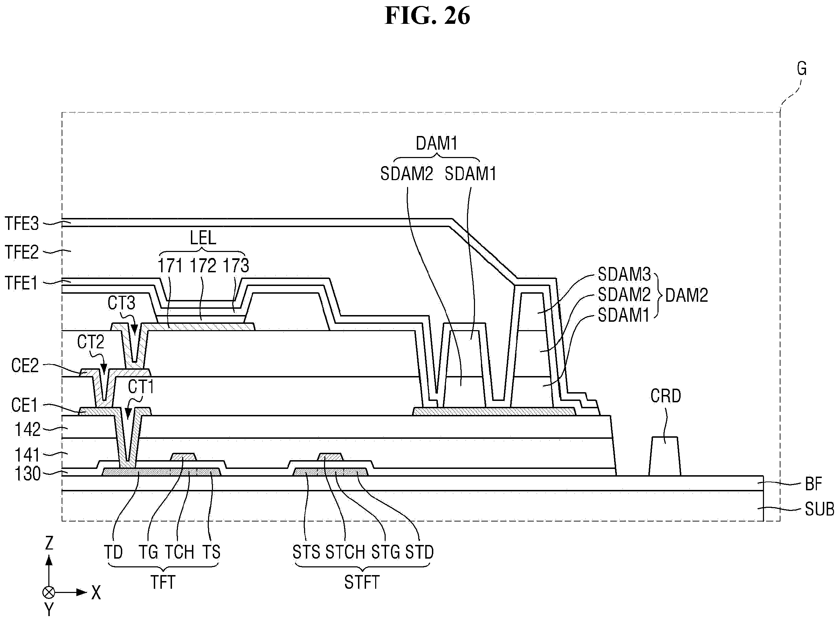

FIG. 26 is an enlarged cross-sectional view illustrating an example of an area G of FIG. 21 in more detail.

Referring to FIG. 26, the first encapsulation inorganic layer TFE1 and the second encapsulation inorganic layer TFE3 may be disposed so as not to cover the crack dam CRD in the non-display area NDA on the upper side of the display panel 100. That is, in the non-display area NDA of the upper side of the display panel 100, the first encapsulation inorganic layer TFE1 and the second encapsulation inorganic layer TFE3 may not be extended to the edge EG of the display panel 100.

In addition, in the non-display area NDA on the upper side of the display panel 100 and the non-display area NDA on the left and right sides of the display panel 100, the first encapsulation inorganic layer TFE1 and the second encapsulation inorganic layer TFE3 may be disposed not to cover the crack dam CRD. That is, in the non-display area NDA on the upper side of the display panel 100 as well as the non-display area NDA on the left and right sides of the display panel 100, the first encapsulation inorganic layer TFE1 and the second encapsulation inorganic layer TFE3 may not be extended to the edge EG of the display panel 100.

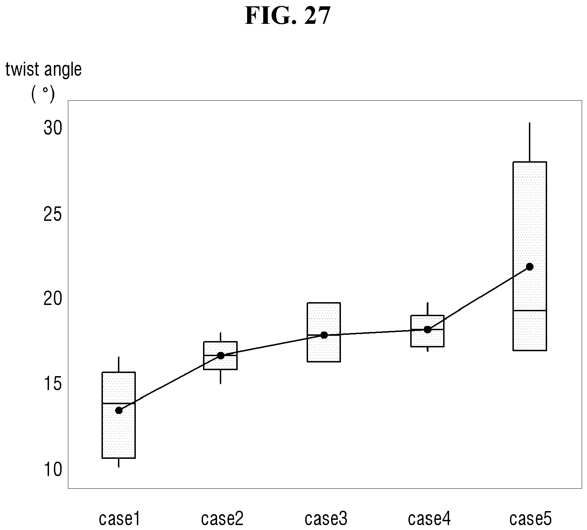

FIG. 27 is a graph illustrating a twist test result of a display panel according to one or more embodiments.

FIG. 27 shows a twist angle obtained after a twist test in a case where the polishing process is not performed after cutting the substrate SUB of the display panel 100 with the cutting member (case 1), the polishing process is performed after the substrate SUB of the display panel 100 is cut with the cutting member (case 2), the polishing process is not performed after cutting the substrate SUB of the display panel 100 with the laser (case 3), the substrate SUB of the display panel 100 is cut with the laser and then the polishing process is performed (case 4), and the substrate SUB of the display panel 100 is cut by spraying the etchant after irradiating the laser (case 5). The twist angle refers to an angle generated when the display panel 100 is twisted after fixing any one side, corner, or corner of the display panel 100 and may be measured by a known method.

Referring to FIG. 27, according to the result of the twist experiment of the display panel 100, the distortion of the display panel 100 may be desirable when the substrate SUB of the display panel 100 is cut by irradiating the laser and then spraying the etchant (case 5). Because the torsion angle was measured higher than the other cases (case 1, case 2, case 3, case 4).

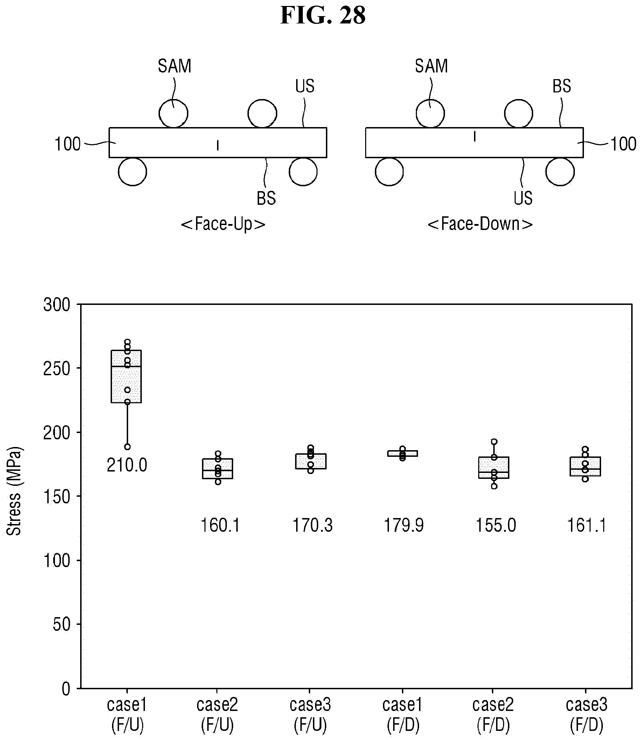

FIG. 28 is a graph illustrating a 4PB test result of a display panel according to one or more embodiments.

FIG. 28 shows the stress intensity (unit: MPa) in a case where the polishing process is performed after the substrate SUB of the display panel 100 is cut with the cutting wheel (case 2), the polishing process is performed after cutting the substrate SUB of the display panel 100 with the laser (case 3), and the substrate SUB of the display panel 100 is cut by irradiating the laser and then spraying the etchant (case 1).

Referring to FIG. 28, the 4PB test result may be measured by applying stress to the bottom surface BS of the display panel 100 using four support members SAM in a state in which the upper surface US of the display panel 100 faces up (face-up) and a state in which the upper surface US of the display panel 100 faces down (face-down). For example, the stress of the display panel 100 is measured in a state where the display panel 100 is supported by the two supporting members SAM disposed under the display panel 100 when the two support members SAM disposed on the display panel 100 press the display panel 100. As a result of the 4PB experiment, because the strength to withstand stress was measured to be high when the substrate SUB of the display panel 100 was cut by irradiating the laser and then spraying the etchant (case 1) in both a state in which the upper surface US of the display panel 100 faces up (face-up) and a state in which the upper surface US of the display panel 100 faces down (face-down) than in other cases (case 2, case 3), it may be desirable when considering the stress of the display panel 100.

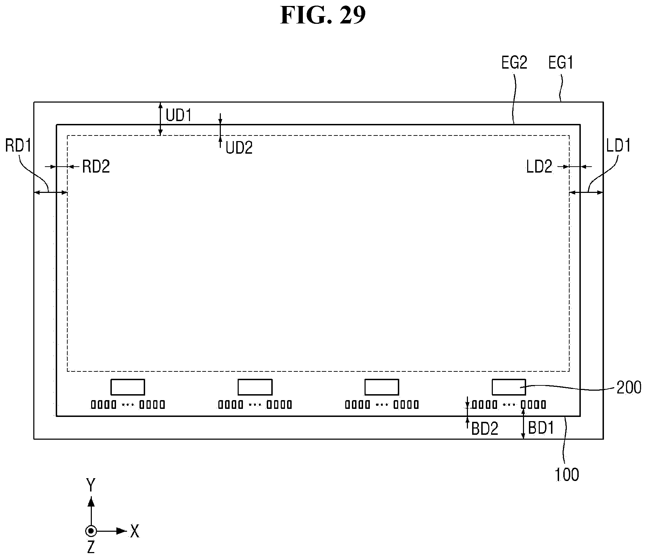

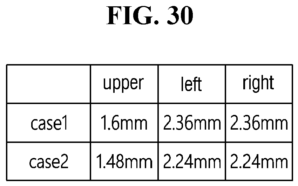

FIG. 29 is a layout diagram illustrating a cut area of a display panel according to one or more embodiments. FIG. 30 is a table illustrating a distance between a display area and an edge of a display panel according to one or more embodiments.

FIG. 29 shows a first edge EG1 corresponding to the edge of the display panel 100 when the polishing process is performed after the substrate SUB is cut with the cutting member, a second edge EG2 corresponding to the edge EG2 of the display panel 100 when the substrate SUB is cut by spraying the etching solution after irradiating the laser, and the display area DA. FIG. 29 shows distances LD1, RD1, and UD1 between the display area DA and the first edge EG1 and distances LD2, RD2, and UD2 between the display area DA and the second edge EG2 on the left, right, and upper sides of the display panel 100 when the size of the display panel 100 is 15.6 inches. Also, FIG. 29 shows a distance BD1 between a display pad PD and the first edge EG1 and the distance between the display pad PD and the second edge EG2 under the display panel 100 when the size of the display panel 100 is 15.6 inches.

Referring to FIGS. 29 and 30, a distance LD1 (case1, left) between the display area DA and the first edge EG1 on the left side of the display panel 100 and a distance RD1 (case1, right) between the display area DA and the first edge EG1 on the right side of the display panel 100 may be approximately 2.36 mm. A distance LD2 (case2, left) between the display area DA and the second edge EG2 on the left side of the display panel 100 and a distance RD2 (case2, right) between the display area DA and the second edge EG2 on the right side of the display panel 100 may be approximately 2.24 mm. That is, the distances LD2 and RD2 between the display area DA and the second edge EG2 in each of the left and right sides of the display panel 100 may be smaller than the distances LD1 and RD1 between the display area DA and the first edge EG1.

In addition, a distance UD1 (case1, upper) between the display area DA and the first edge EG1 on the upper side of the display panel 100 may be about 1.6 mm. A distance UD2 (case2, upper) between the display area DA and the second edge EG2 on the upper side of the display panel 100 may be about 1.48 mm. That is, the distance UD2 between the display area DA and the second edge EG2 on the upper side of the display panel 100 may be smaller than the distance UD1 between the display area DA and the first edge EG1.

In addition, the distance BD1 between the display pad PD and the first edge EG1 on the bottom side of the display panel 100 may be approximately 270 µm. The distance BD2 between the display pad PD and the second edge EG2 on the bottom side of the display panel 100 may be approximately 100 µm. That is, the distance BD2 between the display pad PD and the second edge EG2 on the bottom side of the display panel 100 may be smaller than the distance BD1 between the display pad PD and the first edge EG1.

As described above, when the substrate SUB of the display panel 100 is cut by spraying the etchant after irradiating the laser, the distance between the display area DA and the edge EG2 of the display panel 100 may be smaller than the distance between the display area DA and the edge EG1 of the display panel 100 when the polishing process is performed after the substrate SUB is cut with the cutting member. That is, when the substrate SUB of the display panel 100 is cut by spraying the etchant after irradiating the laser, the width of the non-display area NDA may be significantly reduced compared to a case in which the polishing process is performed after the substrate SUB is cut with the cutting member.

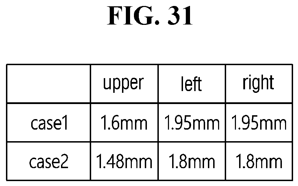

FIG. 31 is a table illustrating a distance between a display area and an edge of a display panel according to one or more embodiments.

FIG. 31 shows distances LD1 (case1, left), RD1 (case1, right), and UD1 (case1, upper) between the display area DA and the first edge EG1 and distances LD2 (case2, left), RD2 (case2, right), and UD2 (case2, upper) between the display area DA and the second edge EG2 on the left, right, and upper sides of the display panel 100 when the size of the display panel 100 is 16 inches.

Referring to FIGS. 29 and 31, the distance LD1 (case1, left) between the display area DA and the first edge EG1 on the left side of the display panel 100 and the distance RD1 (case1, right) between the display area DA and the first edge EG1 on the right side of the display panel 100 may be approximately 1.95 mm. The distance LD2 (case2, left) between the display area DA and the second edge EG2 on the left side of the display panel 100 and the distance RD2 (case2, right) between the display area DA and the second edge EG2 on the right side of the display panel 100 may be approximately 1.8 mm. That is, the distances LD2 and RD2 between the display area DA and the second edge EG2 in each of the left and right sides of the display panel 100 may be smaller than the distances LD1 and RD1 between the display area DA and the first edge EG1.

In addition, the distance UD1 (case1, upper) between the display area DA and the first edge EG1 on the upper side of the display panel 100 may be about 1.6 mm. The distance UD2 (case2, upper) between the display area DA and the second edge EG2 on the upper side of the display panel 100 may be about 1.48 mm. That is, the distance UD2 between the display area DA and the second edge EG2 on the upper side of the display panel 100 may be smaller than the distance UD1 between the display area DA and the first edge EG1.

In addition, the distance BD1 between the display pad PD and the first edge EG1 on the bottom side of the display panel 100 may be approximately 270 µm. The distance BD2 between the display pad PD and the second edge EG2 on the bottom side of the display panel 100 may be approximately 100 µm. That is, the distance BD2 between the display pad PD and the second edge EG2 on the bottom side of the display panel 100 may be smaller than the distance BD1 between the display pad PD and the first edge EG1.

As described above, when the substrate SUB of the display panel 100 is cut by spraying the etchant after irradiating the laser, the distance between the display area DA and the edge EG2 of the display panel 100 may be smaller than the distance between the display area DA and the edge EG1 of the display panel 100 when the polishing process is performed after the substrate SUB is cut with the cutting member. That is, when the substrate SUB of the display panel 100 is cut by spraying the etchant after irradiating the laser, the width of the non-display area NDA may be significantly reduced compared to a case in which the polishing process is performed after the substrate SUB is cut with the cutting member.

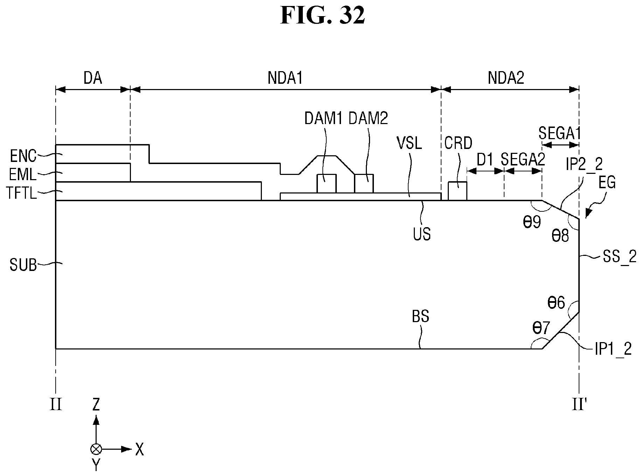

FIG. 32 is a cross-sectional view illustrating an example of the display panel taken along the line II-II' of FIG. 11.

Referring to FIG. 32, the edge area EGA may include a first sub-edge area SEGA1 and a second sub-edge area SEGA2.

The first sub-edge area SEGA1 may be an area in which processing marks are formed on the substrate SUB by the polishing process performed after irradiating the laser and then spraying the etchant on the substrate SUB. The width of the first sub-edge area SEGA1 may be within about 30 µm.

The second sub edge area SEGA2 may be an area in which processing marks such as chipping are formed on the upper surface of the substrate SUB as shown in FIG. 17 by the polishing process. The width of the second edge area EGA2 may be within about 50 µm.

The first sub-edge area SEGA1 may include a first inclined surface IP1_2 formed by spraying the etchant after irradiating the laser and a second inclined surface IP2_2 formed by the polishing process. The first inclined surface IP1_2 and the second inclined surface IP2_2 may overlap each other in the third direction (Z-axis direction).

The roughness of the side surface SS_2 and the roughness of the first inclined surface IP1_2 may be different from the roughness of the second inclined surface IP2_2 because the side surface SS_2 and the first inclined surface IP1_2 are formed by etchant after laser irradiation and the second inclined surface IP2_2 is formed by the polishing process. The roughness of the side surface SS_2 and the roughness of the first inclined surface IP1_2 may be 0.5 µm or less, as shown in FIG. 23, the roughness of the first inclined surface IP1_2 may be about 1 µm as shown in FIG. 18.

An angle θ6 between the side surface SS_2 and the first inclined surface IP1_2 and the angle θ7 between the first inclined surface IP1_2 and the bottom surface BS may be obtuse angles. An angle θ8 between the side surface SS_2 and the second inclined surface IP2_2 and an angle θ9 between the second inclined surface IP2_2 and the upper surface US may be obtuse angles. The angle θ6 between the side surface SS_2 and the first inclined surface IP1_2 may be greater than the angle θ8 between the side surface SS_2 and the second inclined surface IP2_2. Also, the angle θ9 between the second inclined surface IP2_2 and the upper surface US may be greater than the angle θ7 between the first inclined surface IP1_2 and the bottom surface BS.

In addition, a length in an inclined direction of the first inclined surface IP1_2 may be longer than a length in an inclined direction of the second inclined surface IP2_2. The length of the first inclined surface IP1_2 in the inclined direction may be defined as the minimum distance from the edge where the first inclined surface IP1_2 and the side surface SS_2 are in contact to the edge where the first inclined surface IP1_2 and the bottom surface BS are in contact. Also, the length of the second inclined surface IP2_2 in the inclined direction may be defined as the minimum distance from the edge where the second inclined surface IP2_2 and the side surface SS_2 are in contact to the edge where the second inclined surface IP2_2 and the upper surface US are in contact.

In addition, the thickness of the first inclined surface IP1_2 may be greater than the thickness of the second inclined surface IP2_2. The thickness of the first inclined surface IP1_2 may be defined as the maximum length in the third direction (Z-axis direction) of the first inclined surface IP1_2, and the thickness of the second inclined surface IP2_2 may be defined as the maximum length of the second inclined surface IP2_2 in the third direction (Z-axis direction).

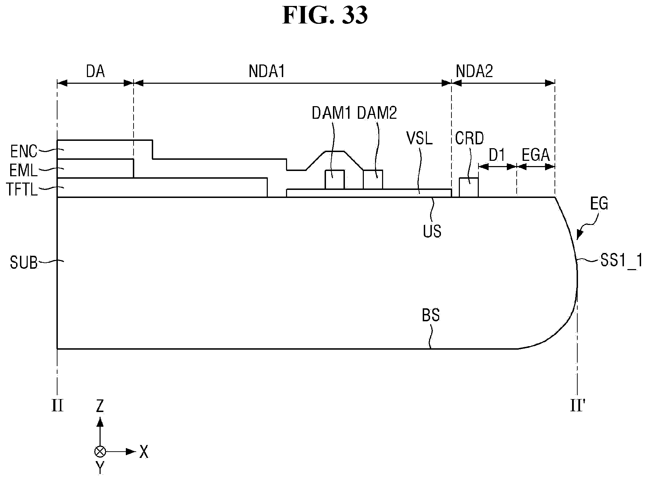

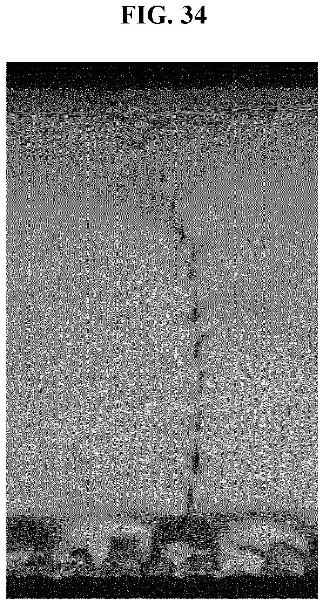

FIG. 33 is a cross-sectional view illustrating an example of the display panel taken along the line II-II' of FIG. 11. FIG. 34 is an example view illustrating laser irradiation areas formed by a laser to form the round side surface of FIG. 33.

Referring to FIG. 33, the side surface SS1_1 of the substrate SUB may have a round cross-section. The side surface SS1_1 of the substrate SUB may be disposed to have the curvature.

Referring to FIG. 34, when the substrate SUB is cut by irradiating the laser and then spraying the etchant to have the side surface SS1_1 of the substrate SUB has the round cross-section, the laser irradiation position and an irradiation depth may be adjusted. In this case, a plurality of laser irradiation areas CH may be formed according to the laser irradiation position and the irradiation depth. The interval in the first direction (X-axis direction) or the interval in the second direction (Y-axis direction) of the laser irradiation areas CH adjacent to each other among the plurality of laser irradiation areas CH may be approximately 0.1 µm to 10 µm. Depths of the plurality of laser irradiation areas CH may be 30 µm or less.

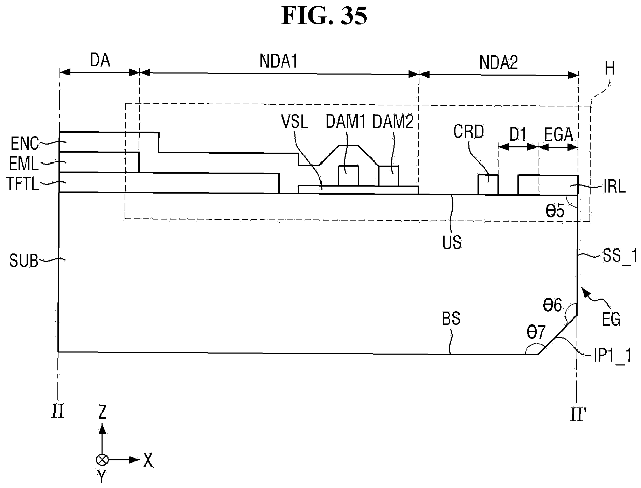

FIG. 35 is a cross-sectional view illustrating an example of the display panel taken along the line II-II' of FIG. 11.

Referring to FIG. 35, the display panel 100 according to one or more embodiments may include the heat dissipation layer IRL disposed in the edge area EGA. The heat dissipation layer IRL may include a metal material having high thermal conductivity to dissipate heat generated when laser irradiation areas are formed with the laser in the cutting process. In addition, the heat dissipation layer IRL may include a material having a high infrared absorption rate to reduce or minimize the influence of the display panel 100 by the laser in the cutting process by increasing the infrared absorption rate. For example, the heat dissipation layer IRL may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

A length of the heat dissipation layer IRL in the first direction (X-axis direction) may be longer than the length of the edge area EGA in the first direction (X-axis direction). For example, the length of the heat dissipation layer IRL in the X-axis direction may be 50 µm or more and 300 µm or less.

The heat dissipation layer IRL may not contact the crack dam CRD as shown in FIG. 35. For example, the length of the heat dissipation layer IRL in the first direction (X-axis direction) may be smaller than the distance between the crack dam CRD and the edge EG of the display panel 100. However, embodiments of the present invention are not limited thereto. The heat dissipation layer IRL may completely cover the crack dam CRD or at least a portion of the crack dam CRD. For example, the length of the heat dissipation layer IRL in the first direction (X-axis direction) may be greater than the distance between the crack dam CRD and the edge EG of the display panel 100.

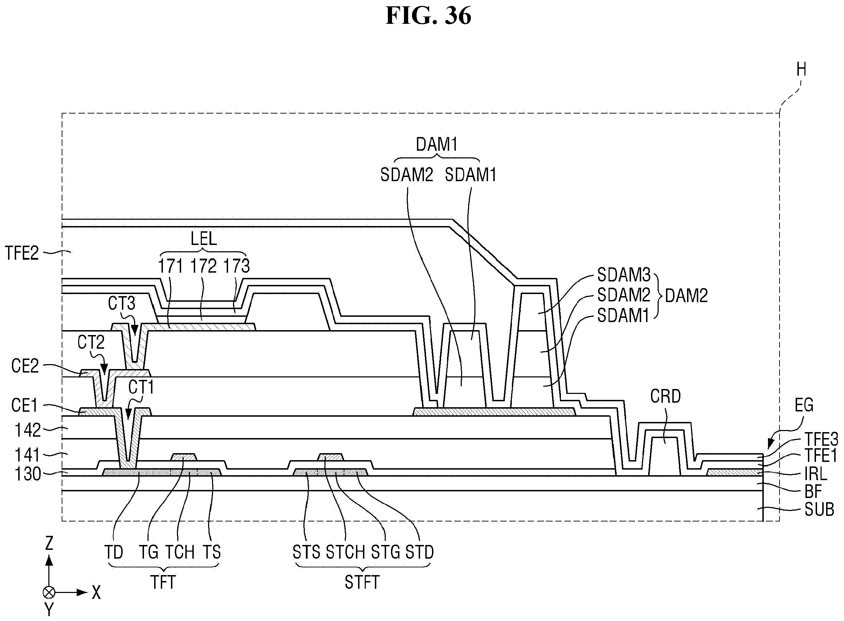

FIG. 36 is a cross-sectional view illustrating an example of an area H of FIG. 35 in more detail.

Referring to FIG. 36, the heat dissipation layer IRL may include a first heat dissipation layer IRL1 and a second heat dissipation layer IRL2.

The first heat dissipation layer IRL1 may be disposed on the second interlayer insulating layer 142. The first heat dissipation layer IRL1 may be formed of the organic film such as acryl resin, epoxy resin, phenolic resin, polyamide resin, or polyimide resin, etc.

The first heat dissipation layer IRL1 may include the material different from that of the crack dam CRD. Therefore, although both the first heat dissipation layer IRL1 and the crack dam CRD are formed of the organic layer, the cross-sectional shape of the first heat dissipation layer IRL1 may be different from the cross-sectional shape of the crack dam CRD. For example, the crack dam CRD may have a trapezoidal cross-section, but the first heat dissipation layer IRL1 may have a sector-shaped cross-section.

The second heat dissipation layer IRL2 may include the same material as the first data metal layer including the first connection electrode CE1 and the data lines and may be disposed on (or at) the same layer as the first data metal layer. The second heat dissipation layer IRL2 may be disposed on the second interlayer insulating layer 142. The second heat dissipation layer IRL2 may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

Because the second heat dissipation layer IRL2 covers the first heat dissipation layer IRL1, the length of the second heat dissipation layer IRL2 in the first direction (X-axis direction) may be longer than the length of the first heat dissipation layer IRL1 in the first direction (X-axis direction).

The first heat dissipation layer IRL1 and the second heat dissipation layer IRL2 may overlap the processing mark disposed on the upper surface of the substrate SUB in the edge area EGA.

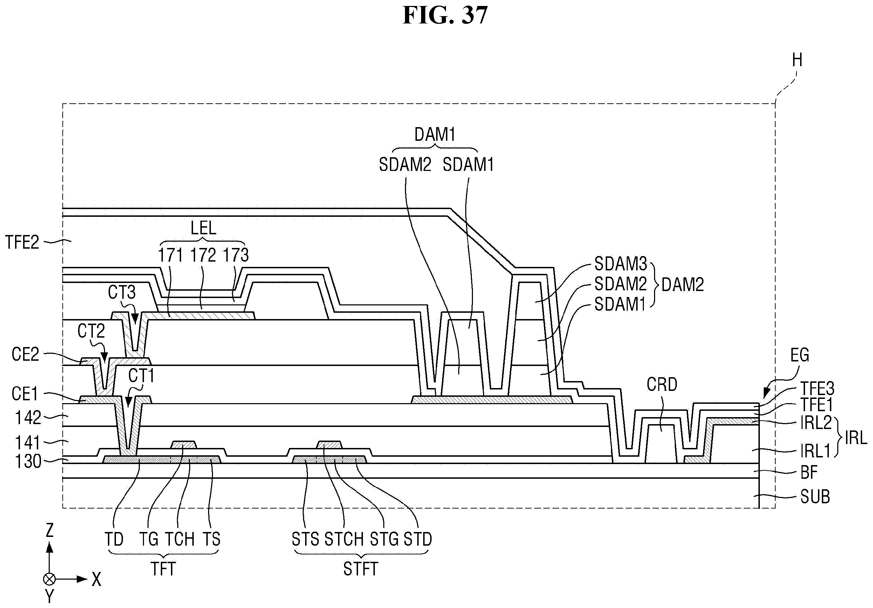

FIG. 37 is a cross-sectional view illustrating an example of the area H of FIG. 35 in more detail.

Referring to FIG. 37, the first heat dissipation layer IRL1 may include the same material as the crack dam CRD and the first organic layer 160 and may be disposed on (or at) the same layer as the crack dam CRD and/or the first organic layer 160. The first heat dissipation layer IRL1 may be disposed on the buffer layer BF. In one or more other embodiments, the first heat dissipation layer IRL1 may be disposed on the second interlayer insulating layer 142. The first heat dissipation layer IRL1 may be formed of the organic film such as acryl resin, epoxy resin, phenolic resin, polyamide resin, or polyimide resin, etc.

Because the first heat dissipation layer IRL1 and the crack dam CRD are formed of the same organic material, the cross-sectional shape of the first heat dissipation layer IRL1 and the cross-sectional shape of the crack dam CRD may be substantially the same. For example, the first heat dissipation layer IRL1 and the crack dam CRD may have trapezoidal cross-sections.

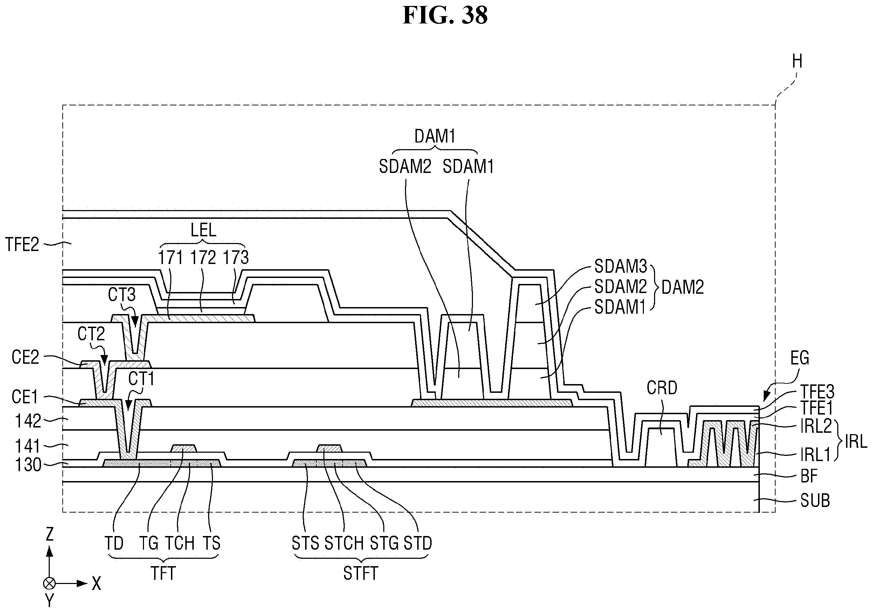

FIG. 38 is a cross-sectional view illustrating an example of the area H of FIG. 35 in more detail.

Referring to FIG. 38, the heat dissipation layer IRL may include a plurality of first heat dissipation layers IRL1 and a second heat dissipation layer IRL2.

The plurality of first heat dissipation layers IRL1 may be disposed to be spaced from each other in the first direction (X-axis direction). The width in the first direction (X-axis direction) of each of the plurality of first heat dissipation layers IRL1 may be smaller than that of the crack dam CRD.

The plurality of first heat dissipation layers IRL1 may include the same material as the crack dam CRD and the first organic layer 160 and may be disposed on (or at) the same layer as the crack dam CRD and/or the first organic layer 160. The plurality of first heat dissipation layers IRL1 may be disposed on the buffer layer BF. In one or more other embodiments, the plurality of first heat dissipation layers IRL1 may be disposed on the second interlayer insulating layer 142. The plurality of first heat dissipation layers IRL1 may be formed of the organic film such as acryl resin, epoxy resin, phenolic resin, polyamide resin, or polyimide resin, etc.

Because the plurality of first heat dissipation layers IRL1 and the crack dam CRD are formed of the same organic material, the cross-sectional shape of each of the plurality of first heat dissipation layers IRL1 and the cross-sectional shape of the crack dam CRD are substantially may be the same. For example, the plurality of first heat dissipation layers IRL1 and the crack dam CRD may have a trapezoidal cross section.

However, a portion of the first heat dissipation layer IRL1 closest to the edge EG of the display panel 100 may be cut by the laser process in the cutting process of the substrate SUB. Therefore, the first heat dissipation layer IRL1 closest to the edge EG of the display panel 100 may have a cross section in which a portion of the trapezoid is cut off.

The second heat dissipation layer IRL2 may cover the plurality of first heat dissipation layers IRL1. Therefore, the length of the second heat dissipation layer IRL2 in the first direction (X-axis direction) may be longer than the length of the plurality of first heat dissipation layers IRL1 in the first direction (X-axis direction). The second heat dissipation layer IRL2 may also be disposed on the upper surface of the buffer layer BF exposed between the plurality of first heat dissipation layers IRL1. An area of the second heat dissipation layer IRL2 may increase due to the plurality of first heat dissipation layers IRL1, and thus a heat dissipation effect may be increased.

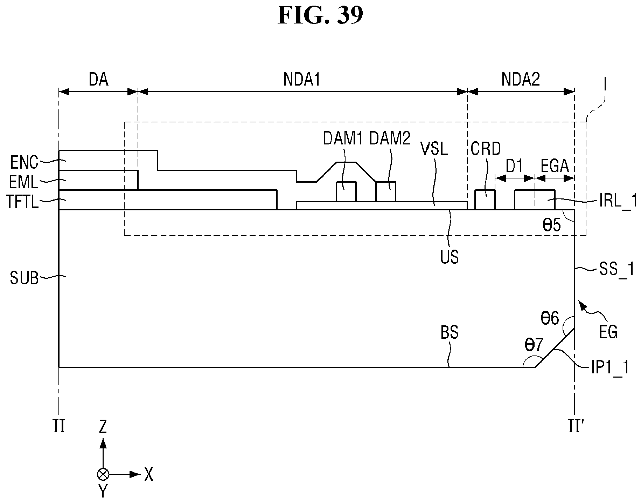

FIG. 39 is a cross-sectional view illustrating an example of the area H of FIG. 35 in more detail.

Referring to FIG. 39, the heat dissipation layer IRL_1 may be disposed apart (or spaced) from the edge EG of the display panel 100 in the first direction (X-axis direction). That is, the heat dissipation layer IRL_1 may be disposed while avoiding an area to which the laser is directly irradiated. To this end, the heat dissipation layer IRL may be disposed approximately 1 µm to 50 µm apart (or spaced) from the edge EG of the display panel 100.

The heat dissipation layer IRL shown in FIG. 39 may be implemented in substantially the same manner as described with reference to FIGS. 35 to 38, so an enlarged cross-sectional view of an area I of FIG. 39 will be omitted.

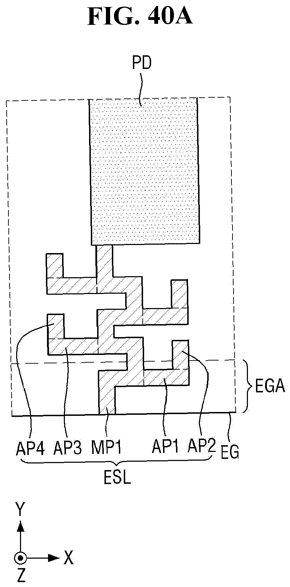

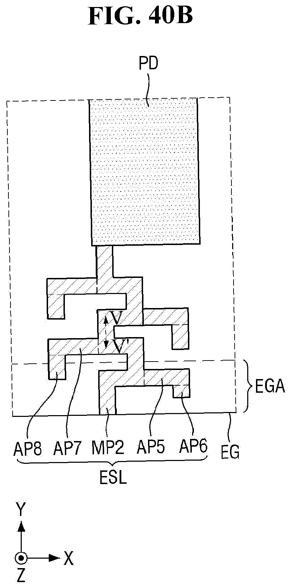

FIGS. 40A and 40B are layout views illustrating a display pad and electrostatic protection line according to one or more embodiments.

Referring to FIGS. 40A and 40B, an electrostatic protection line ESL may be disposed from one side of the display pad PD to the edge EG of the display panel 100.

The electrostatic protection line ESL may be connected to the display pad PD. A plurality of electrostatic protection lines ESL may be connected to the plurality of display pads PD in one way.

Referring to FIG. 40A, the electrostatic protection line ESL may include a first main path area MP1, at least one first auxiliary path area AP1, at least one second auxiliary path area AP2, at least one third auxiliary path area AP3, and at least one fourth auxiliary path area AP4.

The first main path area MP1 may have a zigzag or serpentine shape. For example, the first main path area MP1 may have a shape in which a shape extending in the second direction (Y-axis direction), extending in the first direction (X-axis direction), extending in the second direction (Y-axis direction), and extending in a direction opposite to the first direction (X-axis direction) is repeated.

The first auxiliary path area AP1 may be an area protruding from the first main path area MP1 in the first direction (X-axis direction). The second auxiliary path area AP2 may be an area protruding from the end of the first auxiliary path area AP1 in the second direction (Y-axis direction).

The third auxiliary path area AP3 may be an area protruding from the first main path area MP1 in the direction opposite to the first direction (X-axis direction). The fourth auxiliary path area AP4 may be an area protruding in the second direction (Y-axis direction) from the end of the third auxiliary path area AP3.

Referring to FIG. 40B, the electrostatic protection line ESL includes a second main path area MP2, at least one fifth auxiliary path area AP5, at least one sixth auxiliary path area AP6, at least one seventh auxiliary path area AP7, and at least one eighth auxiliary path area AP8.

The second main path area MP2 may have the zigzag or serpentine shape. The planar shape of the second main path area MP2 may be substantially the same as the shape of the first main path area MP1.

The fifth auxiliary path area AP5 may be an area protruding from the second main path area MP2 in the first direction (X-axis direction). The sixth auxiliary path area AP6 may be an area protruding from the end of the fifth auxiliary path area AP5 in the direction opposite to the second direction (Y-axis direction).

The seventh auxiliary path area AP7 may be an area protruding from the second main path area MP2 in the direction opposite to the first direction (X-axis direction). The eighth auxiliary path area AP8 may be an area protruding from the end of the seventh auxiliary path area AP7 in the direction opposite to the second direction (Y-axis direction).

When the electrostatic protection line ESL is disposed from one side of each of the plurality of display pads PD to the edge EG of the display panel 100, the electrostatic protection line ESL may be exposed to the outside at the edge EG of the display panel 100. Therefore, when the substrate SUB of the display panel 100 is cut by spraying the etchant after irradiating the laser, the etchant may penetrate into the display pad PD through the electrostatic protection line ESL.

As shown in FIGS. 40A and 40B, the plurality of electrostatic protection lines ESL may include a plurality of auxiliary path areas AP1, AP2, AP3, AP4, AP5, AP6, AP7, and AP8 for dispersing the etchant protruding and penetrating from the main path area MP1/MP2 in addition to the main path aeras MP1/MP2 extending from one side of the plurality of display pads PD to the edge EG of the display panel 100. Therefore, it is possible to prevent the etchant from penetrating into the plurality of display pads PD through the plurality of electrostatic protection lines ESL1 and ESL2.

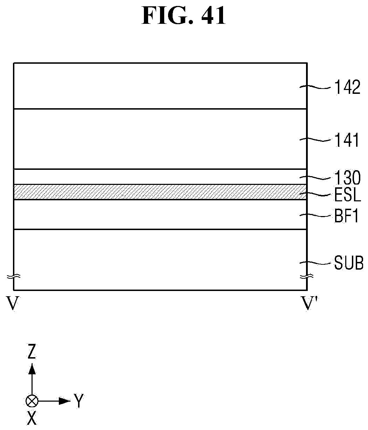

FIG. 41 is a cross-sectional view illustrating an example of the display panel taken along the line V-V' of FIG. 40B.

Referring to FIG. 41, the electrostatic protection line ESL includes the same material as the active layer including the channel area TCH, the source aera TS, and the drain area TD of the thin film transistor TFT and may be disposed on (or at) the same layer as the active layer. For example, the electrostatic protection line ESL may be disposed on the buffer layer BF1. The electrostatic protection line ESL may be formed of polycrystalline silicon, single crystal silicon, low-temperature polycrystalline silicon, amorphous silicon, or an oxide semiconductor material.

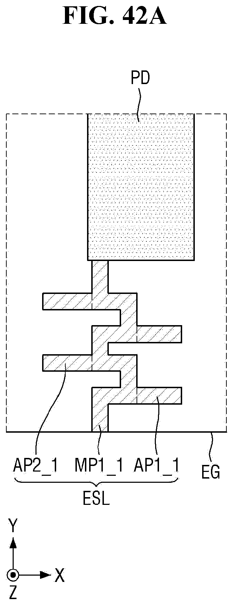

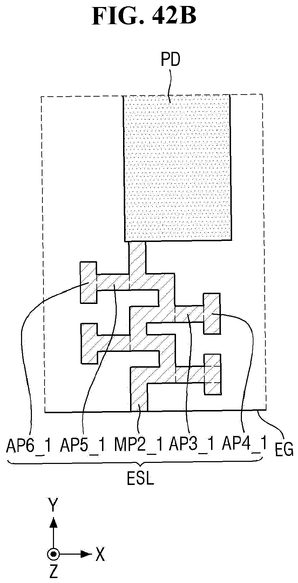

FIGS. 42A and 42B are layout views illustrating a display pad and electrostatic protection line according to one or more embodiments.

Referring to FIG. 42A, the electrostatic protection line ESL1_1 (shown as ESL) includes a first main path area MP1_1, at least one first auxiliary path area AP1_1, and at least one second auxiliary path area AP2_1.

The first main path area MP1_1 may have the zigzag or serpentine shape. The first auxiliary path area AP1_1 may be an area protruding from the first main path area MP1_1 in the first direction (X-axis direction). The second auxiliary path area AP2_1 may be an area protruding from the first main path area MP1_1 in the direction opposite to the first direction (X-axis direction).

Referring to FIG. 42B, the electrostatic protection line ESL2_1 (shown as ESL) includes a second main path area MP2_1, at least one third auxiliary path area AP3_1, at least one fourth auxiliary path area AP4_1, at least one fifth auxiliary path area AP5_1, and at least one sixth auxiliary path area AP6_1.

The second main path area MP2_1 may have the zigzag or serpentine shape. The planar shape of the second main path area MP2_1 may be substantially the same as a shape of the first main path area MP1_1.

The third auxiliary path area AP3_1 may be an area protruding from the second main path area MP2_1 in the first direction (X-axis direction). The fourth auxiliary path area AP4_1 may be extended in the second direction (Y-axis direction), and a central area of the fourth auxiliary path area AP4_1 may be connected to the end of the third auxiliary path area AP3_1.

The fifth auxiliary path area AP5_1 may be an area protruding from the second main path area MP2_1 in the direction opposite to the first direction (X-axis direction). The sixth auxiliary path area AP6_1 may be extended in the second direction (Y-axis direction), and a central area of the sixth auxiliary path area AP6_1 may be connected to the end of the fifth auxiliary path area AP5_1.

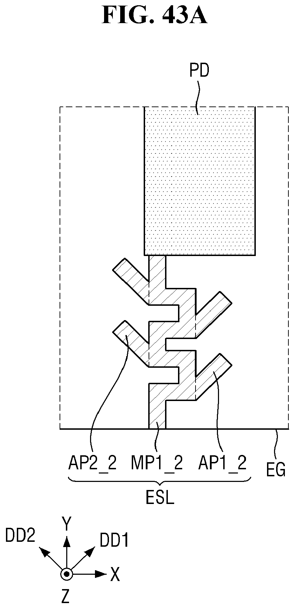

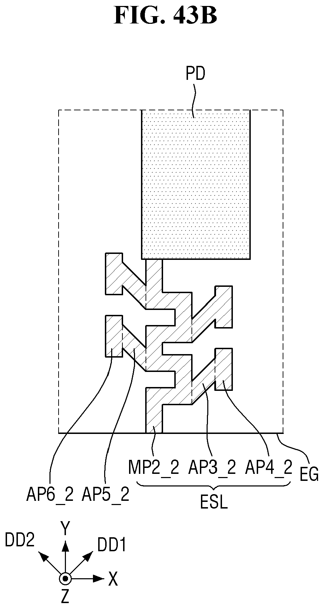

FIGS. 43A and 43B are layout views illustrating a display pad and electrostatic protection line according to one or more embodiments.

Referring to FIG. 43A, the electrostatic protection line ESL1_2 (shown as ESL) includes a first main path area MP1_2, at least one first auxiliary path area AP1_2, and at least one second auxiliary path area AP2_2.

The first main path area MP1_2 may have the zigzag or serpentine shape. The first auxiliary path area AP1_2 may be an area protruding from the first main path area MP1_2 in the first diagonal direction DD1. The second auxiliary path area AP2_2 may be an area protruding from the first main path area MP1_2 in the second diagonal direction DD2. The first diagonal direction DD1 indicates a diagonal direction between the first direction (X-axis direction) and the second direction (Y-axis direction). The second diagonal direction DD2 may be a direction perpendicular to the first diagonal direction DD1.

Referring to FIG. 43B, the electrostatic protection line ESL2_2 (shown as ESL) includes a second main path area MP2_2, at least one third auxiliary path area AP3_2, at least one fourth auxiliary path area AP4_2, at least one fifth auxiliary path area AP5_2, and at least one sixth auxiliary path area AP6_2.

The second main path area MP2_2 may be extended in the second direction (Y-axis direction). The planar shape of the second main path area MP2_2 may be different from a shape of the first main path area MP1_2.

The third auxiliary path area AP3_2 may be an area protruding from the second main path area MP2_2 in the first diagonal direction DD1. The fourth auxiliary path area AP4_2 may be extended in the second direction (Y-axis direction), and a central area of the fourth auxiliary path area AP4_2 may be connected to the end of the third auxiliary path area AP3_2.

The fifth auxiliary path area AP5_2 may be an area protruding from the second main path area MP2_2 in the second diagonal direction DD2. The sixth auxiliary path area AP6_2 may be extended in the second direction (Y-axis direction), and a central area of the sixth auxiliary path area AP6_2 may be connected to the end of the fifth auxiliary path area AP5_2.

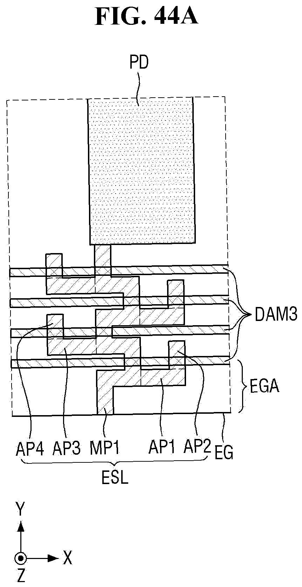

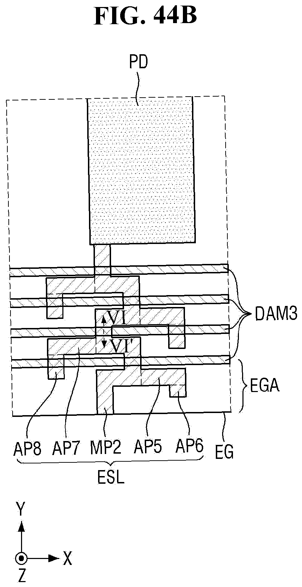

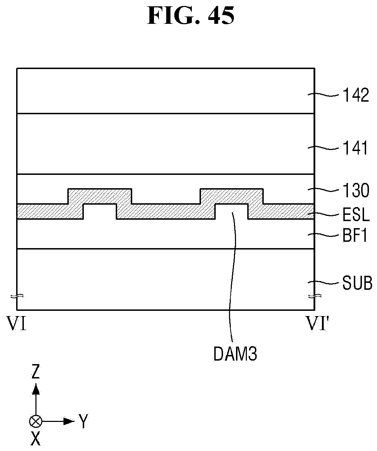

FIGS. 44A and 44B are layout views illustrating a display pad and an electrostatic protection line according to one or more embodiments. FIG. 45 is a cross-sectional view illustrating an example of the display panel taken along the line VI-VI' of FIG. 44B.

Referring to FIGS. 44A, 44B, and 45, the display panel 100 according to one or more embodiments may include at least one third dam DAM3 extending in the first direction (X-axis direction).

At least one or more third dams DAM3 may be disposed on the buffer layer BF1. At least one or more third dams DAM3 may include the same material as the buffer layer BF1. Alternatively, when the buffer layer BF1 has a structure in which different inorganic layers are alternately stacked, at least one or more third dams DAM3 may include the same material as the uppermost layer of the buffer layer BF1. At least one or more third dams DAM3 may be formed of the inorganic material such as one or more selected from among the silicon nitride layer, the silicon oxynitride layer, the silicon oxide layer, the titanium oxide layer, and the aluminum oxide layer.

The electrostatic protection line ESL may cross at least one or more third dams DAM3. For example, a main path area of the electrostatic protection line ESL may cross at least one or more third dams DAM3. The electrostatic protection line ESL may be disposed on the at least one third dam DAM3. Because the at least one third dam DAM3 acts as a threshold, the etchant penetrating through the electrostatic protection line ESL may not exceed the at least one third dam DAM3. Therefore, it may be possible to prevent the etchant from penetrating into the display pad PD through the electrostatic protection line ESL.

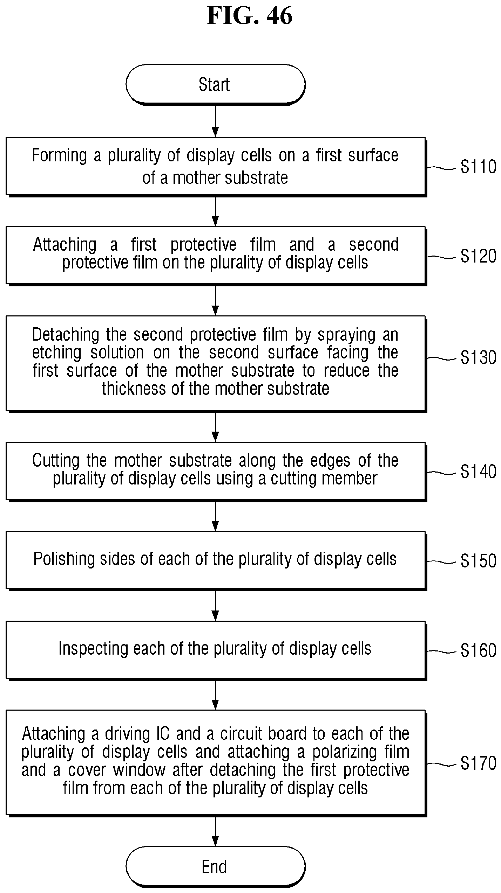

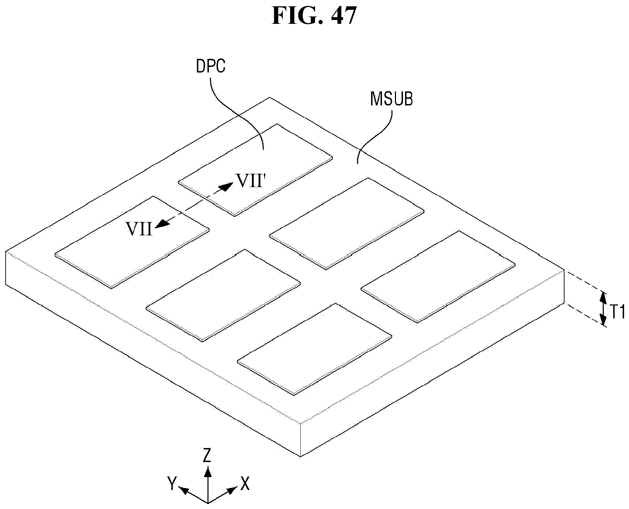

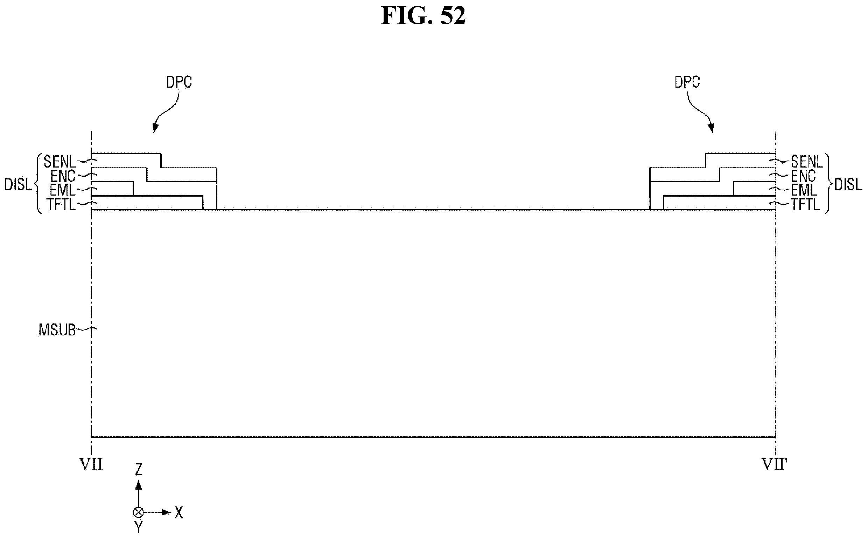

FIG. 46 is a flowchart illustrating a method of manufacturing a display device according to one or more embodiments. FIGS. 47 to 51 are perspective views illustrating a method of manufacturing a display device according to one or more embodiments. FIGS. 52 to 57 are cross-sectional views illustrating a method of manufacturing a display device according to one or more embodiments.

FIGS. 47 to 51 are perspective views of a mother substrate MSUB and a plurality of display cells DPC disposed on the mother substrate MSUB. FIGS. 52 to 57 show cross-sections of the mother substrate MSUB and the plurality of display cells DPC taken along the lines VII-VII' in FIGS. 47 to 51.

First, as shown in FIGS. 47 and 52, the plurality of display cells DPC is formed on the first surface of the mother substrate MSUB. (S110 in FIG. 46)

The display layer DISL of each of the plurality of display cells DPC is formed on the first surface of the mother substrate MSUB. The display layer DISL includes the thin film transistor layer TFTL, the light emitting element layer EML, the encapsulation layer ENC, and the sensor electrode layer SENL.

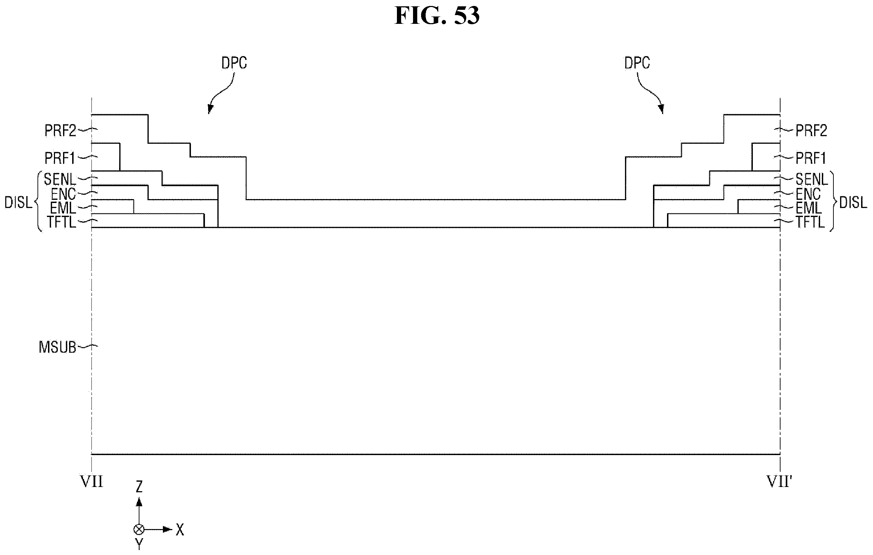

Second, as shown in FIG. 53, a plurality of first protective films PRF1 and a second protective film PRF2 are attached on the plurality of display cells DPC. (S120 in FIG. 46)

First of all, a first protective film layer is attached to cover the plurality of display cells DPC and the mother substrate SUB disposed between the plurality of display cells DPC. Then, the plurality of first protective films PRF1 may be respectively disposed on the plurality of display cells DPC by removing a portion of the first protective film layer disposed on the mother substrate SUB. That is, a portion of the first protective film layer may be removed, and the remaining portions may be the plurality of first protective films PRF1. Therefore, the plurality of first protective films PRF1 may be respectively disposed on the plurality of display cells DPC. That is, the plurality of first protective films PRF1 may be disposed to correspond to the plurality of display cells DPC on a one-to-one basis.

Each of the plurality of first protective films PRF1 may be a buffer film for protecting the plurality of display cells DPC from external impact. The plurality of first protective films PRF1 may be made of the transparent material.

The second protective film PRF2 may be attached on the exposed mother substrate MSUB without being covered by the plurality of first protective films PRF1. The second protective film PRF2 may be the acid-resistant film for protecting the plurality of display cells DPC from the etchant in the etching process of the mother substrate MSUB to be performed in the next step.

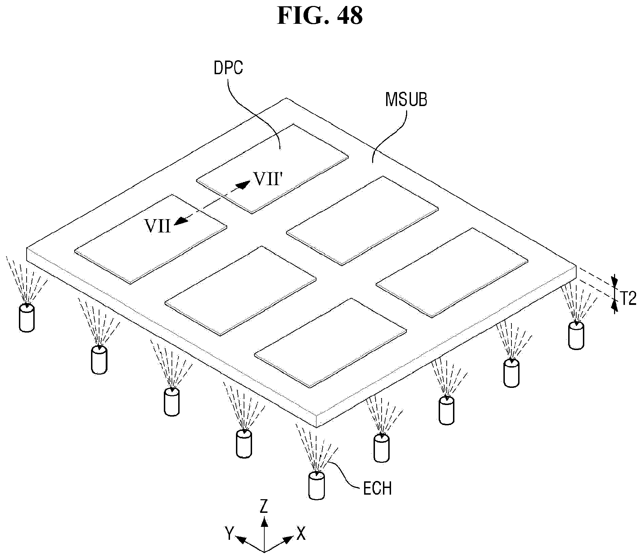

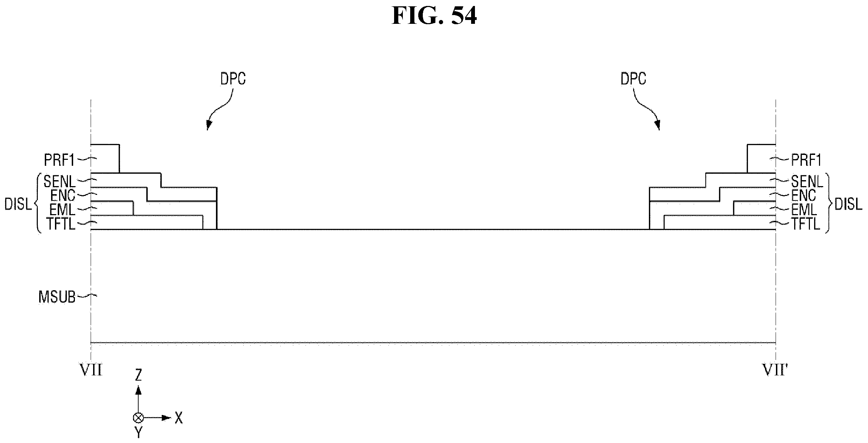

Third, as shown in FIGS. 48 and 54, a slimming process for reducing the thickness of the mother substrate MSUB is performed by spraying the etchant ECH on the second surface opposite the first surface of the mother substrate MSUB without the separate mask. Then, the second protective film PRF2 is detached. (S130 in FIG. 46)

The thickness of the mother substrate MSUB may be reduced by spraying the etchant ECH on the second surface of the mother substrate MSUB. For example, the thickness of the mother substrate MSUB may be reduced from the first thickness T1 to the second thickness T2. For example, the second thickness T2 may differ from the first thickness T1 by about 50 µm or more.

The second protective film PRF2 may be detached after reducing the thickness of the mother substrate MSUB.

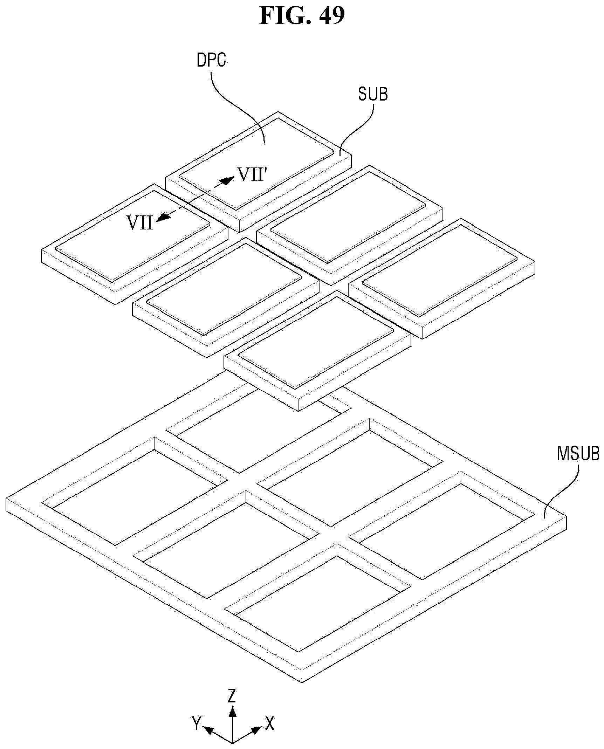

Fourth, as shown in FIGS. 49 and 55, the mother substrate MSUB is cut along the edges of the plurality of display cells DPC using a cutting member CWD such as the cutting wheel. (S140 in FIG. 46)

The cutting member CWD cuts the mother substrate MSUB along edges of the plurality of display cells DPC. Accordingly, the plurality of display cells DPC may be separated from the mother substrate MSUB.

A one-sided tolerance SE1 on one side of the cutting member CWD may be about 100 µm or less. The one-sided tolerance SE1 of the cutting member may be a cutting error in one direction (eg, the X-axis direction) when cutting with the cutting member.

The distance from the crack dam CRD to the edge EG of the display panel 100 may be affected by the one-sided tolerance SE1 of the cutting member CWD. When the cutting member CWD is properly cut at the position where it should be cut, the distance from the crack dam CRD to the cutting surface CSS is defined as "DCS".

When the cutting member CWD cuts from the left side by the maximum value of the one-sided tolerance on one side of the cutting member CWD, the distance from the crack dam CRD to the cutting surface CSS may be "DCS-SE1". When the cutting member CWD cuts from the right side by the maximum value of the one-sided tolerance on one side of the cutting member CWD, the distance from the crack dam CRD to the cutting surface CSS may be "DCS+SE1".

Because the cut surface CSS corresponds to the edge EG of the display panel 100 after the substrate SUB of the display cell DPC is separated from the mother substrate MSUB, the distance from the crack dam CRD to the cut surface CSS may be substantially the same as the minimum distance from the crack dam CRD to the edge EG of the display panel 100 in the display panel 100 illustrated in FIG. 13. Accordingly, the minimum distance from the crack dam CRD in the display panel 100 to the edge EG of the display panel 100 may differ by 200 µm, which is a distance corresponding to "one-sided tolerance×2" (or "double-sided tolerance") of the cutting member CWD in some cases.

That is, the minimum distance from the crack dam CRD to the edge EG of the display panel 100 may be "DCS-SE1" to "DCS+SE1" in the display panel 100 illustrated in FIG. 13. When the distance DCS1 from the crack dam CRD to the cut surface CSS is 230 µm and the one-sided tolerance of the cutting member CWD is 100 µm, the minimum distance from the crack dam CRD to the edge EG of the display panel 100 may be 330 µm or less in the display panel 100 illustrated in FIG. 18.

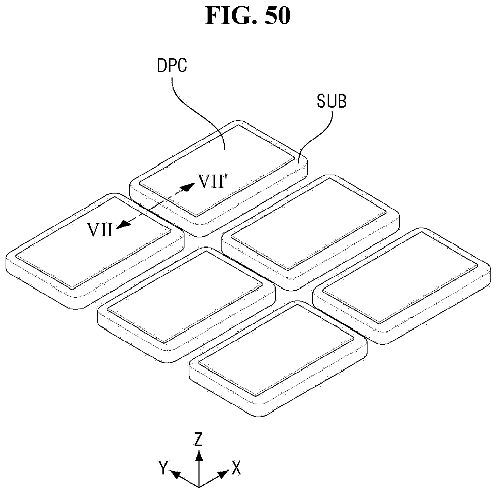

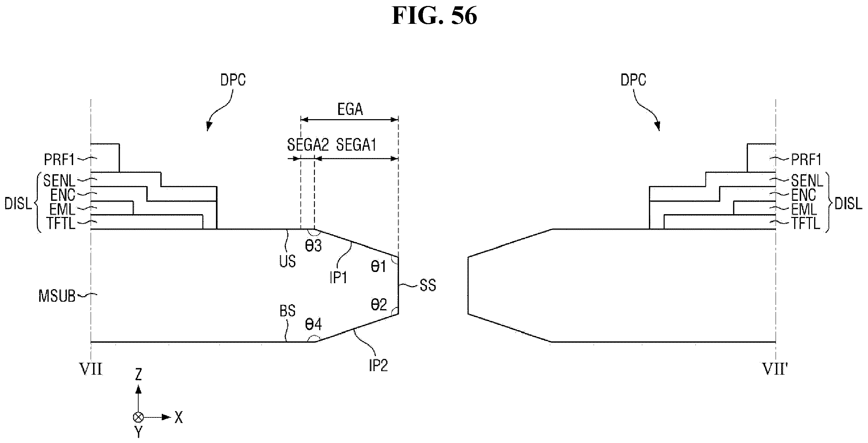

Fifth, as shown in FIGS. 50 and 56, sides of each of the plurality of display cells DPC are polished using a CNC (computer numerical control) polishing apparatus. (S150 in FIG. 46)

The cutting member CWD such as the cutting wheel may cut the mother substrate MSUB in a straight line when viewed from a plane. Accordingly, when the corners of each of the plurality of display cells DPC have a rounded shape to have the curvature, each of the corners of the plurality of display cells DPC may be machined to have the curvature using the polishing apparatus.

As shown in FIG. 56, the first sub-edge area SEGA1 including the inclined surface and the second sub-edge area SEGA2 including the processing marks such as chipping may be formed by the polishing process using the polishing apparatus. The width of the first sub-edge area SEGA1 may be within approximately 150 µm, and the width of the second sub-edge area SEGA2 may be within approximately 50 µm.

Sixth, the plurality of display cells DPC is inspected using the inspection apparatus. (S160 in FIG. 46)

After a probe is connected to a plurality of inspection pads provided in each of the plurality of display cells DPC, a lighting inspection of each of the plurality of display cells DPC may be performed. After completion of the inspection, the plurality of inspection pads may be cut from each of the plurality of display cells DPC.

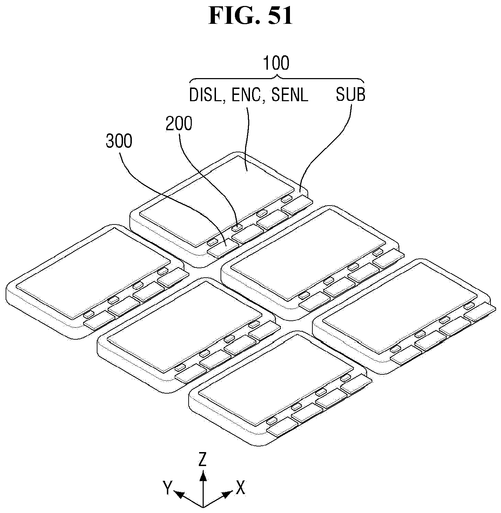

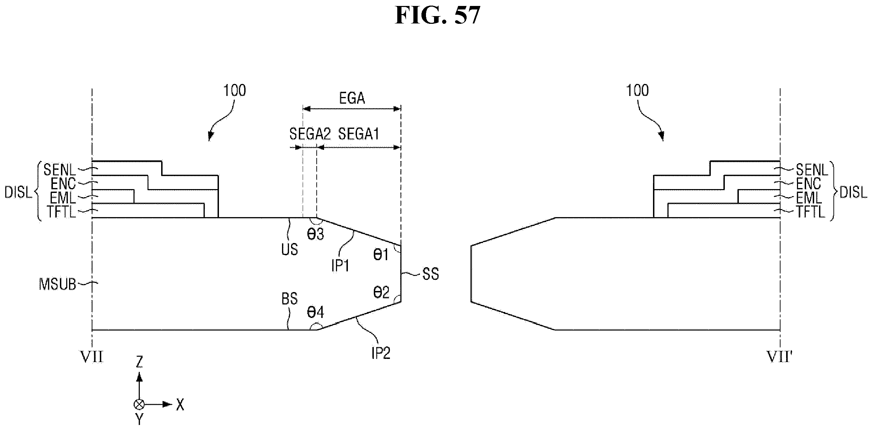

Seventh, the driving IC 200 and the circuit board 300 are attached to each of the plurality of display cells DPC as shown in FIGS. 51 and 57, and the first protective film PRF1 is detached from each of the plurality of display cells DPC. (S170 in FIG. 46)

The driving IC 200 is attached to the non-display area NDA disposed under each of the plurality of display cells DPC. The driving IC 200 may be attached on the first driving pads DPD1 and the second driving pads DPD2 of each of the plurality of display cells DPC using the conductive adhesive member such as the anisotropic conductive film or the anisotropic conductive adhesive.

In addition, the circuit board 300 is attached to the non-display area NDA of the lower edge of each of the plurality of display cells DPC. The circuit board 300 may be attached on the display pads PD of each of the plurality of display cells DPC using the conductive adhesive member such as the anisotropic conductive film or the anisotropic conductive adhesive.

Then, the first protective film PRF1 is detached from the display cell DPC. Then, the polarizing film PF is attached on the display cell DPC using the transparent adhesive member. Then, the display panel 100 may be completed by attaching the cover window CW on the polarizing film PF using the transparent adhesive member.

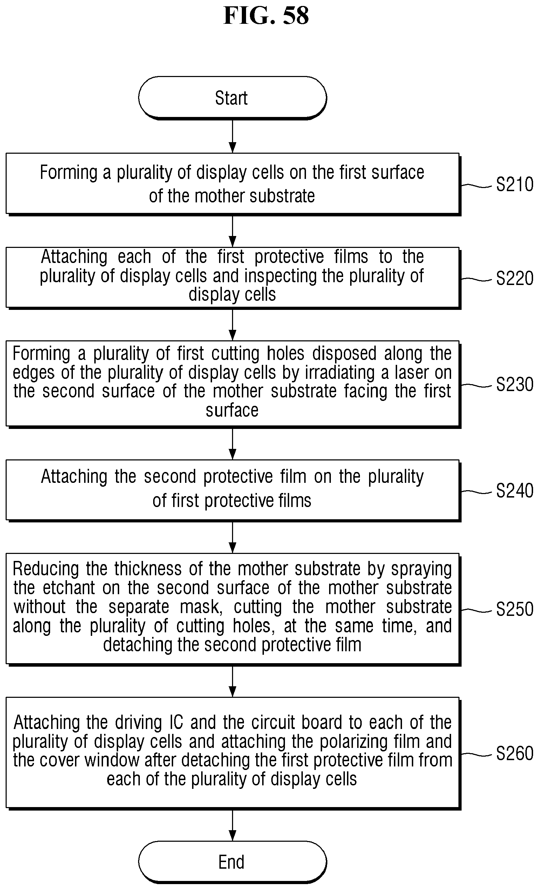

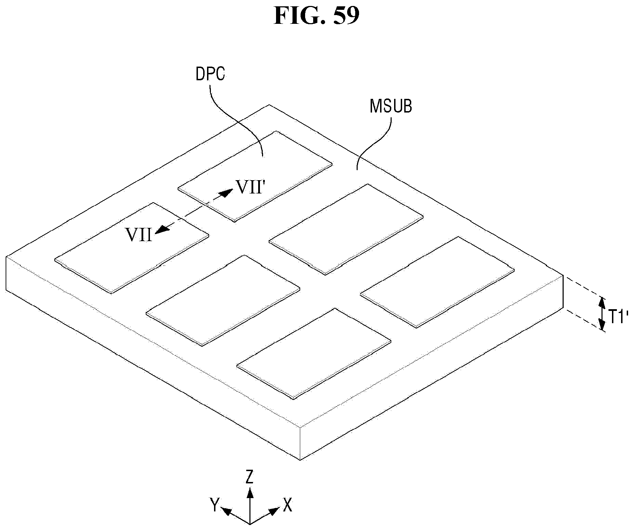

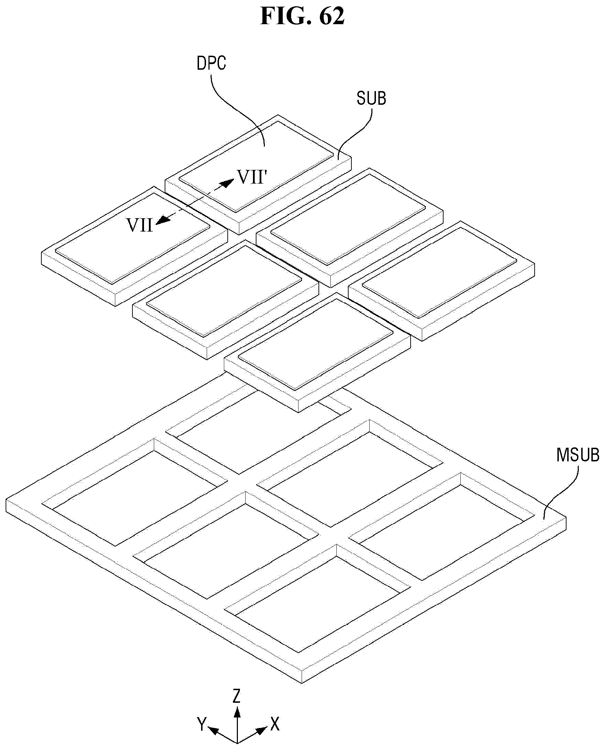

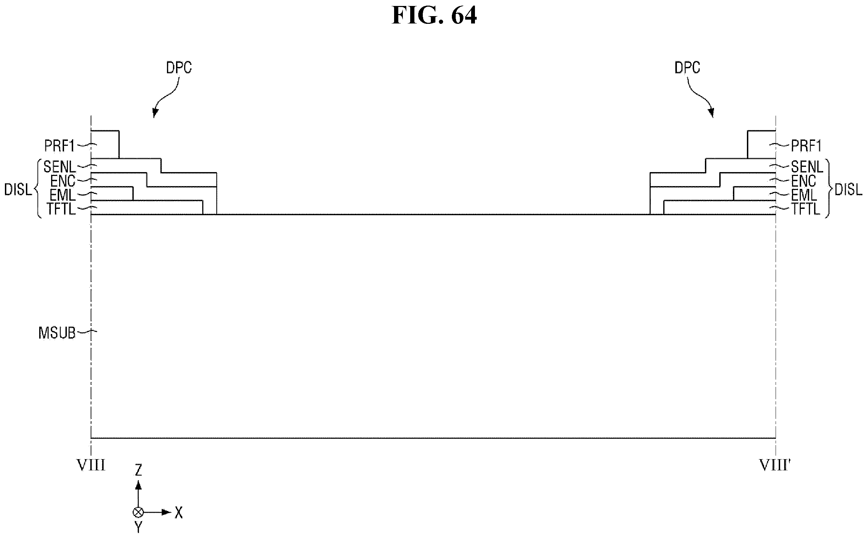

FIG. 58 is a flowchart illustrating a method of manufacturing a display device according to one or more embodiments. FIGS. 59 to 63 are perspective views illustrating a method of manufacturing a display device according to one or more embodiments. FIGS. 64 to 68 are cross-sectional views illustrating a method of manufacturing a display device according to one or more embodiments.

FIGS. 59 to 63 are perspective views of the mother substrate MSUB and the plurality of display cells DPC disposed on the mother substrate MSUB. FIGS. 64 to 68 show cross-sections of the mother substrate MSUB and the plurality of display cells DPC, taken along the lines VIII-VIII' in FIGS. 59 to 64.

First, as shown in FIGS. 59 and 64, the plurality of display cells DPC are formed on the first surface of the mother substrate MSUB. (S210 in FIG. 58)

Second, as shown in FIG. 64, the plurality of first protective films PRF1 are attached on the plurality of display cells DPC, and the plurality of display cells DPC is inspected. (S220 in FIG. 58)

First of all, the first protective film layer is attached to cover the plurality of display cells DPC and the mother substrate SUB disposed between the plurality of display cells DPC. Then, the plurality of first protective films PRF1 may be respectively disposed on the plurality of display cells DPC by removing a portion of the first protective film layer disposed on the mother substrate SUB. That is, a portion of the first protective film layer may be removed, and the remaining portions may be the plurality of first protective films PRF1. Therefore, the plurality of first protective films PRF1 may be respectively disposed on the plurality of display cells DPC. That is, the plurality of first protective films PRF1 may be disposed to correspond to the plurality of display cells DPC on a one-to-one basis.

Each of the plurality of first protective films PRF1 may be the buffer film for protecting the plurality of display cells DPC from external impact. The plurality of first protective films PRF1 may be made of the transparent material.

Then, the plurality of display cells DPC are inspected using the inspection apparatus. After the probe is connected to the plurality of inspection pads provided in each of the plurality of display cells DPC, the lighting inspection of each of the plurality of display cells DPC may be performed.

When the lighting inspection is performed after the plurality of display cells DPC are separated from the mother substrate MSUB by the cutting process, an additional process for removing the plurality of inspection pads is required after the lighting inspection is completed. On the other hand, when the lighting inspection is performed on the mother substrate MSUB, the plurality of inspection pads is later removed when the plurality of display cells DPC is separated from the mother substrate MSUB through laser irradiation and etching. Therefore, when the lighting inspection is performed on the mother substrate MSUB, a separate additional process for removing the plurality of inspection pads may not be required.

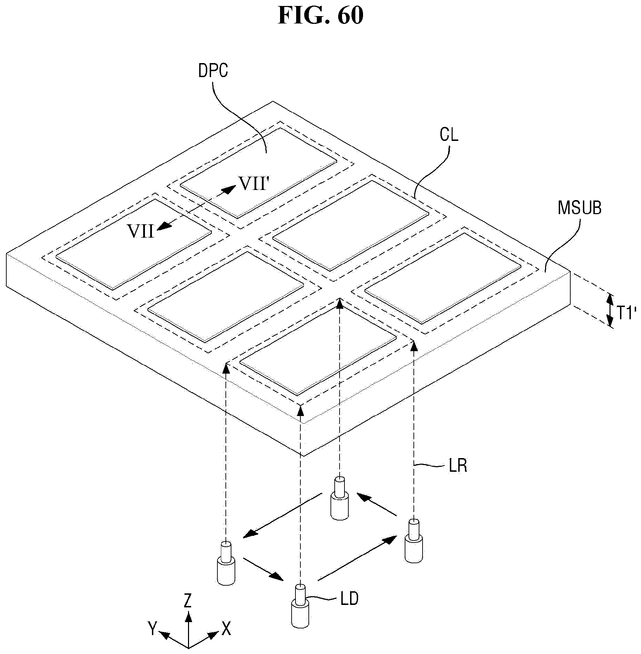

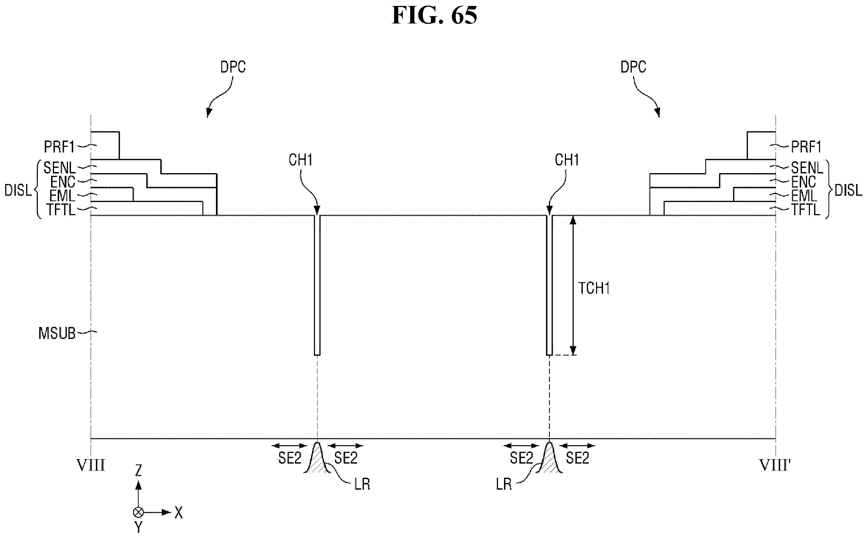

Third, as shown in FIGS. 60 and 65, a plurality of first laser irradiation areas CH1 are formed along edges of the plurality of display cells DPC by irradiating the laser LR from a laser device LD on the second surface opposite the first surface of the mother substrate MSUB. (S230 in FIG. 58)

Various lasers may be used as the laser device LD according to one or more embodiments, but in the present invention, the laser LR may be an infrared Bessel beam having the wavelength of approximately 1030 nm.

As shown in FIG. 65, the laser LR may be irradiated on the second surface of the mother substrate MSUB. However, embodiments of the present invention are not limited thereto. The laser LR may be irradiated on the first surface of the mother substrate MSUB.

The cutting line CL may be defined as a virtual line connecting the plurality of first laser irradiation areas CH1. The cutting line CL may be formed by irradiating the laser LR to form the plurality of first laser irradiation areas CH1 along the edges of the plurality of display cells DPC.

A one-sided tolerance SE2 on one side of the laser LR may be within about 50 µm, and the double-sided tolerance of the laser LR may be within about 100 µm. The one-sided tolerance SE2 of the laser LR may be a cutting error in one direction (eg, the X-axis direction) when the plurality of first laser irradiation areas CH1 is formed with the laser LR.

The distance from the crack dam CRD to the edge EG of the display panel 100 may vary according to the one-sided tolerance SE2 of one side of the laser LR. When the laser LR is correctly irradiated to a position to be irradiated, the distance from the crack dam CRD to the first laser irradiation area CH1 is defined as "DCH".

When the laser LR is irradiated to the left by the maximum value of the one-sided tolerance SE2 of the laser LR, the distance from the crack dam CRD to the first laser irradiation area CH1 may be "DCH-SE2". On the other hand, when the laser LR is irradiated to the right by the maximum value of the one-sided tolerance SE2 of the laser LR, the distance from the crack dam CRD to the first laser irradiation area CH1 may be "DCH+SE2".

Because the substrate SUB of the display cell DPC is separated from the mother substrate MSUB based on the first laser irradiation area CH1 in the etching process, which is the next step, the distance from the crack dam CRD to the first laser irradiation area CH1 may be substantially the same as the minimum distance from the crack dam CRD to the edge EG of the display panel 100 in the display panel 100 as shown in FIG. 18. Accordingly, the minimum distance from the crack dam CRD to the edge EG of the display panel 100 in the display panel 100 may be different by 100 µm, which is a distance corresponding to "one-sided tolerance SE2×2" (or "double-sided tolerance") of the laser LR.

That is, the minimum distance from the crack dam CRD to the edge EG of the display panel 100 in the display panel 100 illustrated in FIG. 18 may be "DCH-SE2" to "DCH+SE2". For example, when the distance from the crack dam CRD to the first laser irradiation area CH1 is 80 µm and the one-sided tolerance SE2 of the laser LR is 50 µm, the minimum distance from the crack dam CRD to the edge EG of the display panel 100 may be 130 µm or less in the display panel 100 illustrated in FIG. 18.

As described above, the one-sided tolerance SE2 of the laser LR is 50 µm, but the one-sided tolerance SE1 of the cutting member CWD such as the cutting wheel is 100 µm. That is, because the one-sided tolerance SE2 of the laser LR is smaller than the one-sided tolerance SE1 of the cutting member CWD such as the cutting wheel, the distance from the crack dam CRD to the edge EG of the display panel 100 may be reduced compared to the case of cutting using the cutting member CWD such as the cutting wheel when cutting using the laser LR.

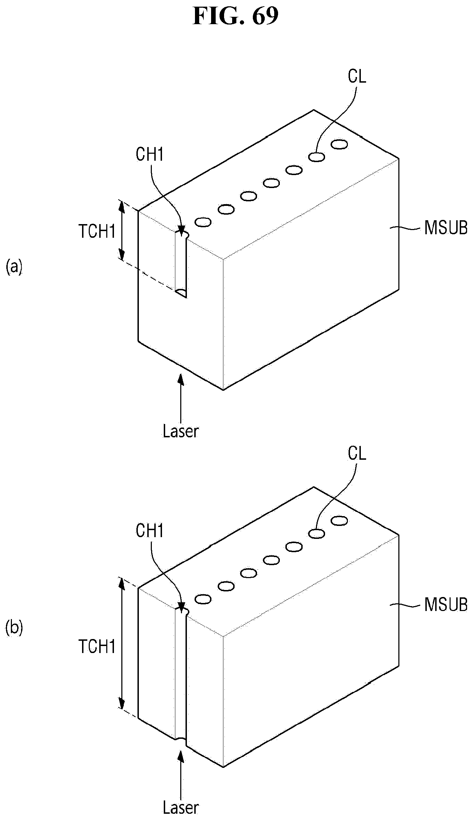

When the laser LR is irradiated on the second surface of the mother substrate MSUB, the depth (or sketch length) TCH1 of each of the plurality of first laser irradiation areas CH1 may be adjusted according to a repetition rate, a processing speed, and/or a pulse energy as shown in FIG. 69. For example, a depth TCH1 of each of the plurality of first laser irradiation areas CH1 may be approximately 50 µm from the first surface of the mother substrate MSUB as shown in FIG. 69Aa. In addition, because the thickness of the mother substrate MSUB is approximately 500 µm, the depth TCH1 of each of the plurality of first laser irradiation areas CH1 may be up to 500 µm as shown in FIG. 69 (b). That is, the depth TCH1 of each of the plurality of first laser irradiation areas CH1 may be approximately 50 µm to 500 µm from the first surface of the mother substrate MSUB.

The laser LR for forming the first laser irradiation areas CH1 may be irradiated with the repetition rate of 10 kHz to 250 kHz, the processing speed of 10 mm/s to 250 mm/s, and/or the pulse energy of 10 µJ to 300 µJ. However, it is desirable to irradiate with the repetition rate of approximately 17.5 kHz to 125 kHz, the processing speed of 17.5 mm/s to 125 mm/s, and the pulse energy of 25 µJ to 178 µJ in order for the laser LR to have a depth of approximately 225 µm from the first surface of the mother substrate MSUB.

Fourth, as shown in FIG. 66, the second protective film PRF2 is attached on the plurality of first protective films PRF1. (S240 in FIG. 58)

The second protective film PRF2 may be attached on the exposed mother substrate MSUB without being covered by the plurality of first protective films PRF1 and the plurality of first protective films PRF1. The second protective film PRF2 may cover the first laser irradiation areas CH1. The second protective film PRF2 may be the acid-resistant film for protecting the plurality of display cells DPC from the etchant in the etching process of the mother substrate MSUB to be performed in the next step.

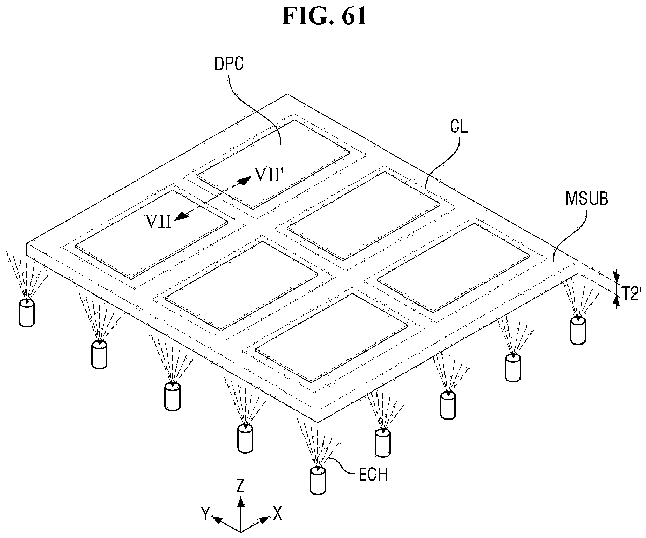

Fifth, as shown in FIGS. 61, 62, 66, and 67, the thickness of the mother substrate MSUB is reduced by spraying the etchant on the second surface of the mother substrate MSUB without the separate mask, the mother substrate is cut along the plurality of first laser irradiation areas CH1 at the same time, and the second protective film PRF2 is detached. (S250 in FIG. 58)

When the etchant is sprayed on the second surface of the mother substrate MSUB, the mother substrate MSUB may be reduced from the first thickness T1' to the second thickness T2'. Because the mother substrate MSUB is etched without the separate mask, isotropic etching may be performed in which all areas of the second surface of the mother substrate MSUB are uniformly etched up to the area in which the first laser irradiation areas CH1 are formed.

Each of the plurality of first laser irradiation areas CH1 may include a physical hole formed by the laser and an area in which physical properties are changed by the laser as the periphery of the physical hole. Alternatively, each of the plurality of first laser irradiation areas CH1 may be an area in which physical properties are changed by the laser without the physical hole. For this reason, the etch rate in each of the plurality of first laser irradiation areas CH1 by the etchant may be higher than the etch rate in other areas of the mother substrate MSUB to which the laser is not irradiated.

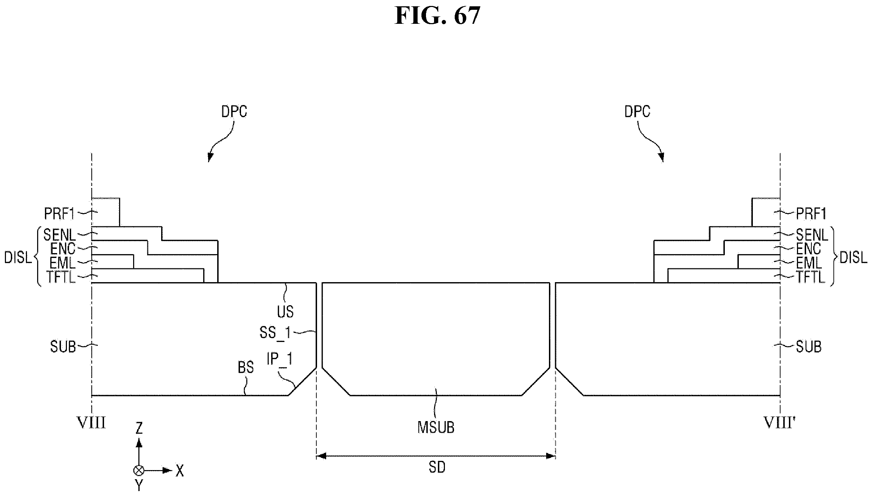

When the thickness of the mother substrate MSUB is reduced by the etchant and the etchant penetrates into the plurality of first laser irradiation areas CH1 formed by the laser LR, a difference in etching rate may occur in an aera in which the first laser irradiation areas CH1 are formed and in an area in which the first laser irradiation areas CH1 are not formed due to the plurality of first laser irradiation areas CH1. That is, the mother substrate MSUB may be anisotropically etched in which the etching rate in the area in which the first laser irradiation areas CH1 is formed is faster than the etching rate in the area in which the first laser irradiation areas CH1 are not formed. Accordingly, as shown in FIG. 67, the substrate SUB separated from the mother substrate SUB may include an inclined surface IP_1 disposed between the side surface SS_1 and the bottom surface BS.

In addition, as the etchant penetrates into the plurality of first laser irradiation areas CH1 formed by the laser LR, the mother substrate MUSB may be separated along the cutting line CL. That is, each of the plurality of display cells DPC may be separated from the mother substrate MSUB.

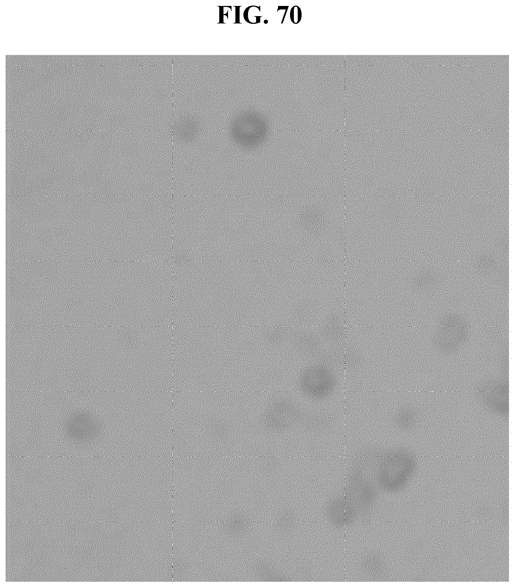

Because the etchant does not penetrate the first surface of the substrate SUB separated from the mother substrate MSUB by the second protective film, while the second surface of the substrate SUB is etched by the etchant. Therefore, differences may occur between the first surface and the second surface of the substrate SUB in roughness, hardness, light transmittance, light reflectance, local density, surface chemical structure, and the like. For example, dimples due to the etchant may occur on the second surface of the substrate MSUB as shown in FIG. 70. The dimple indicates that a minor defect such as a scratch existing on the second surface of the substrate SUB is enlarged by reacting with the etchant.

In FIGS. 66 and 67, the laser one-sided tolerance is approximately 50 µm, and the width of the first laser irradiation area CH1 formed by the laser LR may be expanded by approximately 40 µm by the etchant. Therefore, a separation distance SD between adjacent display cells DPC may be about 280 µm in consideration of the double-sided tolerance of the laser of each of the display cells DPC and the width of the first laser irradiation area CH1 extended by the etchant.

After the etching process is completed, the second protective film PRF2 may be detached.

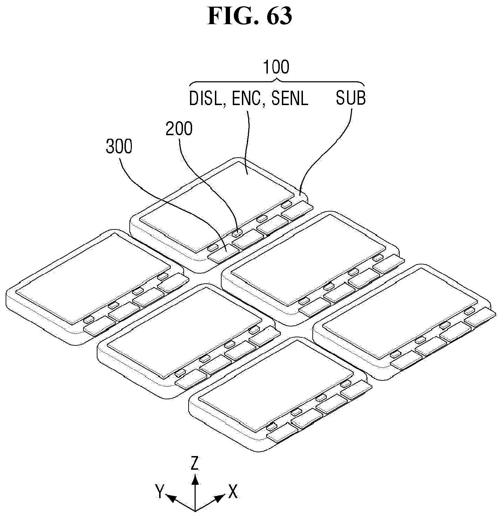

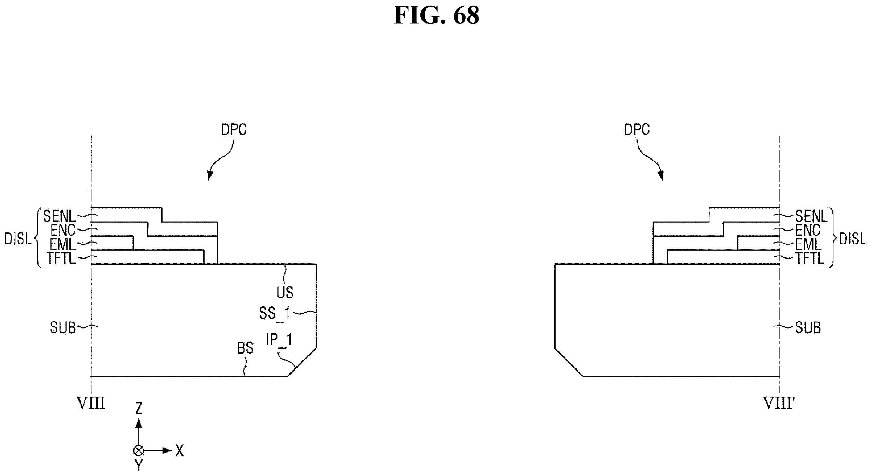

Sixth, the driving IC 200 and the circuit board 300 are attached to each of the plurality of display cells DPC as shown in FIGS. 63 and 68, and the polarizing film PF and the cover window CW are attached after detaching the first protective film PRF1 from each of the plurality of display cells DPC. (S260 in FIG. 58)

As described above, the thickness of the mother substrate SUB may be reduced by using the etching process, and the substrate SUB of each of the plurality of display cells DPC may be separated from the mother substrate MSUB. Therefore, the efficiency of the manufacturing process may be improved.

In addition, the laser LR may be applied such that the plurality of first laser irradiation areas CH1 are arranged along a curve by adjusting the repetition rate, the processing speed, and the pulse energy when viewed from a flat surface. Therefore, the corners of each of the plurality of display cells DPC may be formed in a round shape having the curvature by spraying the etchant along the plurality of first laser irradiation areas CH1 and etching after forming the plurality of first laser irradiation areas CH1 in a curve. That is, because the corners of each of the plurality of display cells DPC may be formed in the round shape without the separate polishing process, the efficiency of the manufacturing process may be increased.

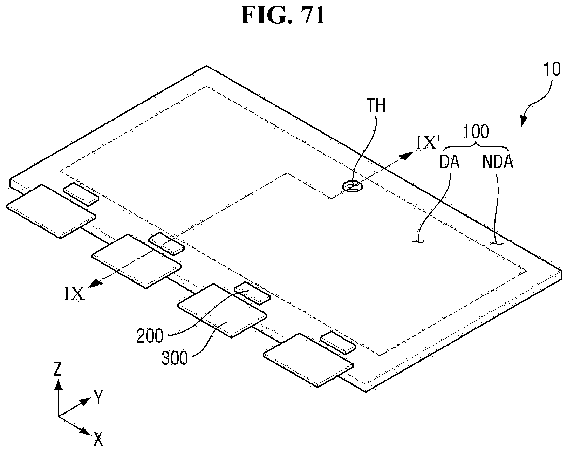

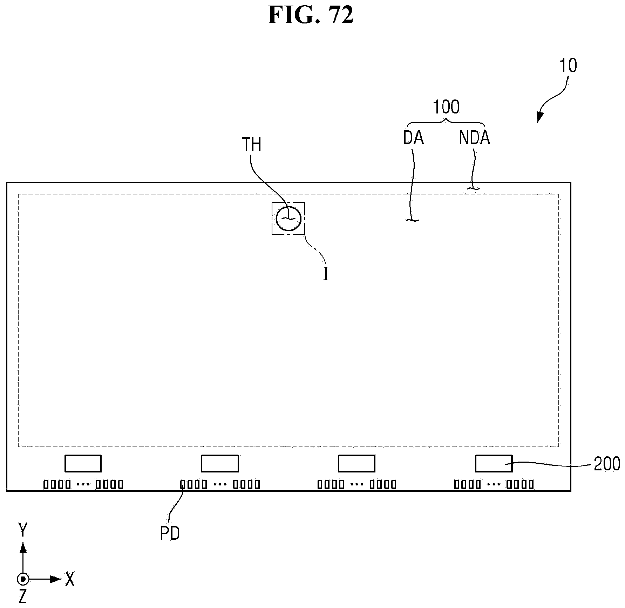

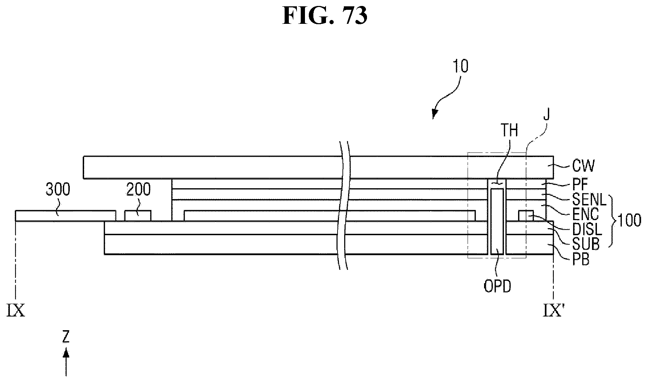

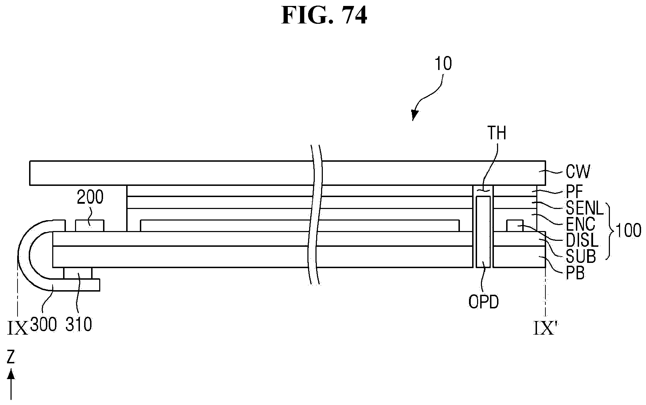

FIG. 71 is a perspective view illustrating a display device according to one or more embodiments. FIG. 72 is a plan view illustrating a display panel and a driving IC according to one or more embodiments. FIG. 73 is a cross-sectional view illustrating an example of the display device taken along the line IX-IX' of FIG. 71. FIG. 74 is a cross-sectional view illustrating an example of the display device in which the circuit board of FIG. 73 is bent.

Referring to FIGS. 71 to 74, a through hole TH may be formed in the display device 10 according to one or more embodiments. The through hole TH is a hole that allows light to pass through and may be a physical hole penetrating through the panel bottom cover PB and the polarizing film PF as well as the display panel 100. However, embodiment of the present invention are not limited thereto. The through hole TH may pass through the panel bottom cover PB, but may not pass through the display panel 100 and the polarizing film PF. The cover window CW may be disposed to cover the through hole TH.

The through hole TH may pass through the substrate SUB, the thin film transistor layer TFTL, the encapsulation layer ENC, and the sensor electrode layer SENL of the display panel 100.

The electronic device including the display device 10 according to one or more embodiments may further include an optical device OPD disposed in the through hole TH. The electronic device according to one or more embodiments may be a device such as televisions, laptop computers, monitors, billboards and/or the Internet of Things (IOT) as well as portable electronic devices such as mobile phones, smart phones, tablet personal computer (tablet PC), smart watches, watch phones, mobile communication terminals, electronic notebooks, electronic books, portable multimedia players (PMPs), navigation systems and/or ultra mobile PCs (UMPC).

The optical device OPD may be spaced from the display panel 100, the panel bottom cover PB, and the polarizing film PF. The optical device OPD may be an optical sensor that detects light incident through the through hole TH, such as a proximity sensor, an illuminance sensor, and/or a camera sensor.

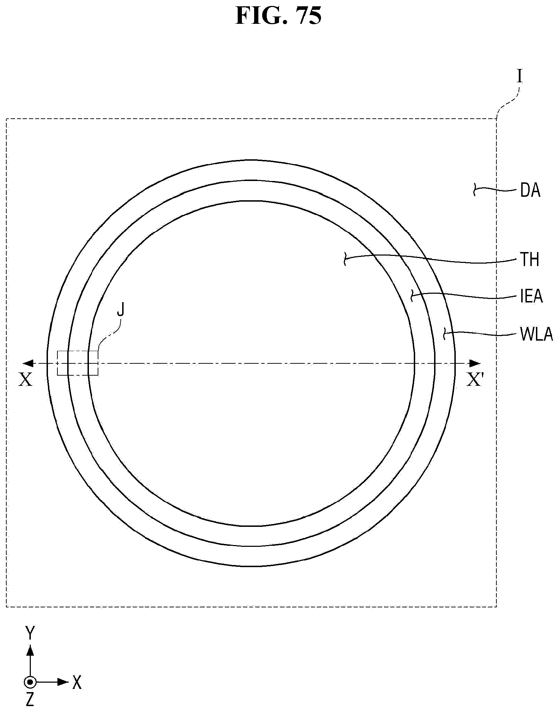

FIG. 75 is a layout diagram illustrating an example of a through hole, an inorganic encapsulation area, a line area, and a display area of a display panel according to one or more embodiments.

Referring to FIG. 75, the display panel 100 according to one or more embodiments includes an inorganic encapsulation area IEA surrounding the through hole TH and a line area WLA surrounding the inorganic encapsulation area IEA.

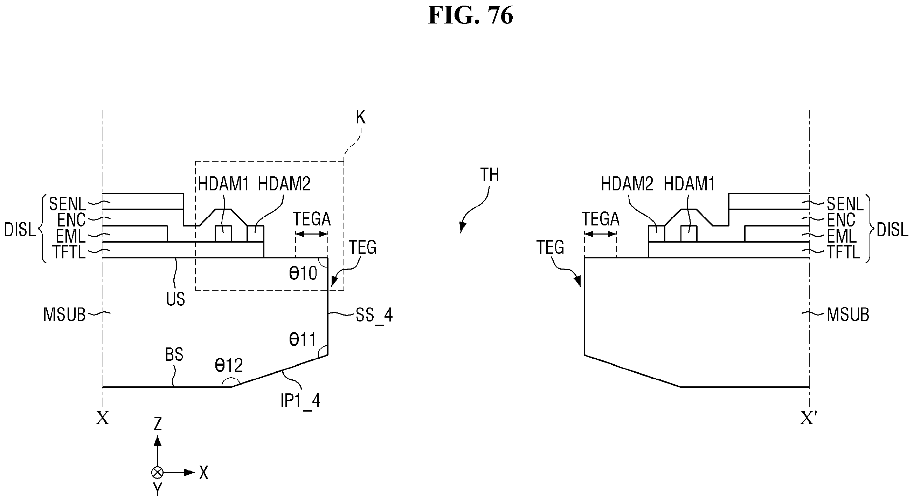

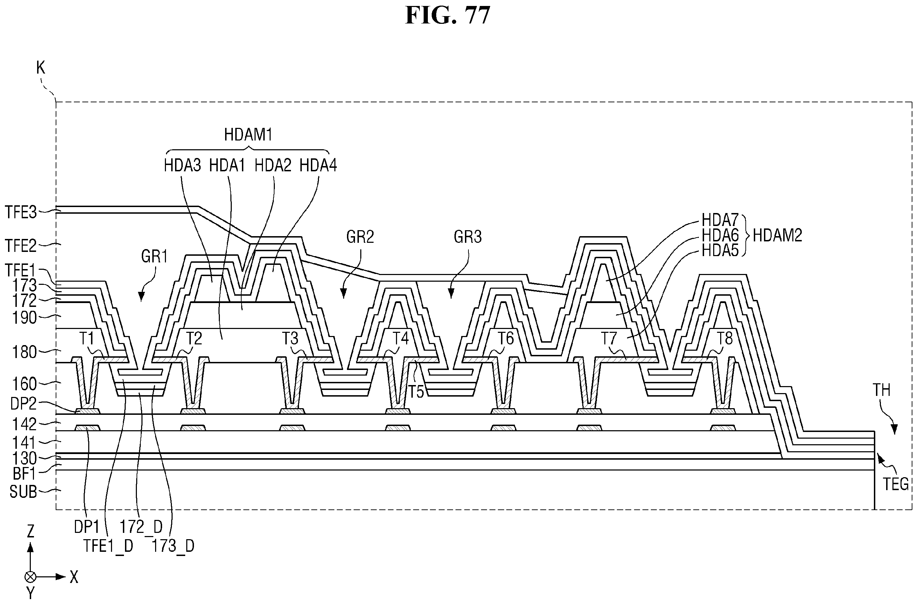

In the inorganic encapsulation area IEA, the first encapsulation inorganic layer TFE1 and the second encapsulation inorganic layer TFE3 of the encapsulation layer ENC contact each other (e.g., see FIGS. 76 and 77), and thus the inorganic encapsulation area IEA may be a layer for preventing oxygen or moisture from penetrating into the light emitting element layer EML of the display layer DISL due to the through hole TH.

The inorganic encapsulation area IEA may include at least one dam, at least one tip, and at least one groove. For example, the inorganic encapsulation area IEA may include a first dam HDAM1, a second dam HDAM2, first to eighth tips T1 to T8, and first to third grooves GR1 to GR3 as shown in FIG. 77.

The first tip T1 and the second tip T2 may be disposed closer to the line area WLA than the first dam HDAM1 is. The first tip T1 may be disposed closer to the line area WLA than the second tip T2 is. The second tip T2 may be disposed between the first tip T1 and the first dam HDAM1.

The third tip T3, the fourth tip T4, the fifth tip T5, and the sixth tip T6 may be disposed between the first dam HDAM1 and the second dam HDAM2. At least a portion of the third tip T3 may overlap the first dam HDAM1 in the third direction (Z-axis direction).

The seventh tip T7 and the eighth tip T8 may be disposed closer to the through hole TH than the second dam HDAM2 is. At least a portion of the seventh tip T7 may overlap the second dam HDAM2 in the third direction (Z-axis direction). A distance between the eighth tip T8 and the through hole TH may be approximately 50 µm.

The first groove GR1 may be disposed between the first tip T1 and the second tip T2. The second groove GR2 may be disposed between the third tip T3 and the fourth tip T4. The third groove GR3 may be disposed between the fifth tip T5 and the sixth tip T.

The line area WLA may be an area in which bypass lines due to the through hole TH are disposed. Some of the bypass lines may be connected to the data lines, and another portion of the bypass lines may be connected to a second power line to which a second power voltage higher than the first power voltage is applied. Still some of the bypass lines may be connected to the scan lines. The line area WLA may be surrounded by the display area DA.

FIG. 76 is a cross-sectional view illustrating an example of the display panel taken along the line X-X' of FIG. 75.

FIG. 76 illustrates a cross-section of the edge TEG of the through hole TH when the substrate SUB of the display panel 100 is cut by spraying the etchant after irradiating the laser.

Referring to FIG. 76, a through hole edge area TEGA is an area in which processing marks are formed on the upper surface US of the substrate SUB by the etchant when the substrate SUB is cut by spraying the etchant after irradiating the laser. The through hole edge area TEGA may be within about 30 µm as shown in FIG. 21.

The through hole edge area TEGA may include a first inclined surface IP1_4 formed by spraying the etchant after irradiating the laser. The first inclined surface

IP1 _4 may also be termed as a second inclined surface IP1_4 to distinguish it from the first inclined surface at the edge of the side surface of the substrate SUB. An angle θ10 between the side surface SS_4 of the edge TEG of the through hole TH and the upper surface US may be about 90 degrees. That is, the angle between the side surface SS_4 of the edge TEG of the through hole TH and the upper surface US may be substantially close to a ortogonal angle (e.g., a perpendicular angle). An angle θ11 formed between the side surface SS_4 of the edge TEG of the side through hole TH and the first inclined surface IP1_4 and an angle θ12 formed between the first inclined surface IP1_4 and the bottom surface BS may be obtuse angles. The processing mark formed on the upper surface US of the substrate SUB may overlap the first inclined surface IP1_4 in the third direction (Z-axis direction).

The angle θ11 between the side surface SS_4 of the edge TEG of the through hole TH and the first inclined surface IP1_4 and the angle θ12 between the first inclined surface IP1_4 and the bottom surface BS may vary depending on the depth of the laser irradiation area formed by the laser when the substrate SUB of the display panel 100 is cut by spraying the etching solution after irradiating the laser. The depth of the laser irradiation area formed by the laser to cut along the edge EG of the display panel 100 may be different from the depth of the laser irradiation area formed by the laser to cut along the edge TEG of the through hole TH.

Accordingly, the angle θ11 between the side surface SS_4 of the edge TEG of the through hole TH and the first inclined surface IP1_4 shown in FIG. 76 may be smaller than the angle θ6 between the side surface SS_1 and the first inclined surface IP1_1 shown in FIGS. 18 to 20. The angle θ12 between the first inclined surface IP1_4 and the bottom surface BS shown in FIG. 76 may be smaller than the angle θ7 between the first inclined surface IP1_1 and the bottom surface BS shown in FIGS. 18 to 20.

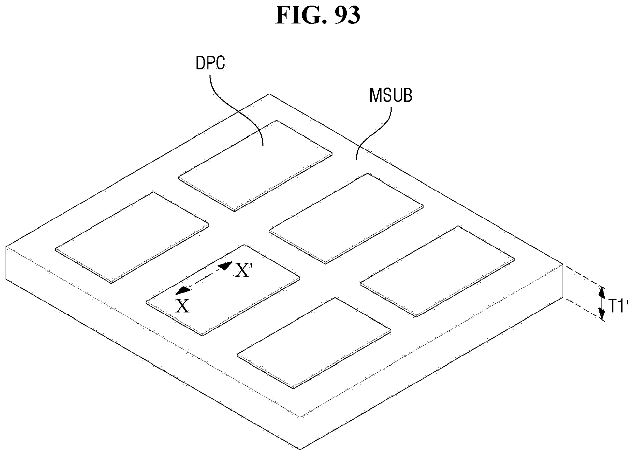

The depth of the laser irradiation area formed by the laser to cut along the edge EG of the display panel 100 and the depth of the laser irradiation area formed by the laser to cut along the edge TEG of the through hole TH will be described later with reference to FIG. 93.

FIG. 77 is an enlarged cross-sectional view illustrating an example of an area K of FIG. 76 in more detail.

Referring to FIG. 77, a first dummy pattern DP1 may include the same material as the second gate metal layer including the second capacitor electrode CAE2 of the capacitor Cst and may be disposed on (or at) the same layer as the second gate metal layer. For example, the first dummy pattern DP1 may be disposed on the first interlayer insulating layer 141. The first dummy pattern DP1 may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

A second dummy pattern DP2 may include the same material as the first data metal layer including the first connection electrode CE1 and the data lines and may be disposed on (or at) the same layer as the first data metal layer. For example, the second dummy pattern DP2 may be disposed on the second interlayer insulating layer 142. The second dummy pattern DP2 may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

The second dummy pattern DP2 may overlap the first dummy pattern DP1 in the third direction (Z-axis direction).

The first to eighth tips T1 to T8 may include the same material as the second data metal layer including the second connection electrode CE2 and may be disposed on (or at) the same layer as the second data metal layer. For example, the first to eighth tips T1 to T8 may be disposed on the first organic layer 160. The first to eighth tips T1 to T8 may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

Each of the first to eighth tips T1 to T8 may be connected to the second dummy pattern DP2 through the contact hole penetrating the first organic layer 160. Each of the first to eighth tips T1 to T8 may include an eaves structure in which the upper surface and the bottom surface are not covered by the first organic layer 160, the second organic layer 180, the first dam HDAM1, and the second dam HDAM2 and are exposed. The fourth tip T4 and the fifth tip T5 may be integrally formed. Each of the first to eighth tips T1 to T8 may be a protrusion pattern or a trench pattern for forming a groove (or trench). The eighth tip T8 is adjacent to the edge TEG of the through hole TH. In FIG. 77, the eighth tip T8 is shown for example as the outermost structure adjacent to the edge TEG of the through hole TH, but embodiments of the present invention are not limited thereto. For example, when the seventh tip T7 and the eighth tip T8 are omitted, the outermost structure adjacent to the edge TEG of the through hole TH may be the second dam HDAM2 for preventing the encapsulation organic layer TFE2 of the encapsulation layer ENC from overflowing. Alternatively, when the seventh tip T7 and the eighth tip T8 are omitted, the outermost structure adjacent to the edge TEG of the through hole TH may be the groove for separating the light emitting layer 172 and the common electrode 173.

A distance from the eighth tip T8 to the edge TEG of the through hole TH may be approximately 300 µm. The through hole edge area TEGA may be disposed between the eighth tip T8 and the edge TEG of the through hole TH.

The first groove GR1 may be formed between the first tip T1 and the second tip T2, the second groove GR2 may be formed between the third tip T3 and the fourth tip T4, and the third groove GR3 may be formed between the fifth tip T5 and the sixth tip T6. The first groove GR1 may have eaves structures formed by the first tip T1 and the second tip T2, the second groove GR2 may have eaves structures formed by the third tip T3 and the fourth tip T4, and the third groove GR3 may have eaves structures formed by the fifth tip T5 and the sixth tip T6.

According to one or more embodiments, the emission layer 172 is deposited by evaporation and the common electrode 173 is deposited by sputtering. As a result, a step coverage may be low, and thus the first to third grooves GR1, GR2, and GR3 may be disposed apart (or spaced) from each other. In contrast, the first encapsulation inorganic layer TFE1 and the third encapsulation inorganic layer TFE3 are deposited by chemical vapor deposition and atomic layer deposition. As a result, the step coverage may be high, and thus the first to third grooves GR1, GR2, and GR3 may be continuously connected without being cut off. The step coverage may refer to a ratio of the degree of coating the thin film on the inclined portion to the degree of coating the thin film on the flat portion. In each of the first to third grooves GR1, GR2, and GR3, the light emitting layer 172, a light emitting layer remnant 172_D, the common electrode 173, and the broken common electrode remnant 173_D may be disposed.

The first dam HDAM1 may include first to fourth sub-dams HDA1, HDA2, HDA3, and HDA4. The first sub-dam HDA1 may be disposed on the first organic layer 160 and may include the same material as the second organic layer 180. The first sub-dam HDA1 may be disposed on the second tip T2 and the third tip T3. The second sub-dam HDA2 may be disposed on the first sub-dam HDA1 and may include the same material as the bank 190. The third sub-dam HDA3 and the fourth sub-dam HDA4 may be disposed on the second sub-dam HDA2 and may include the same material as the spacer 191 but are not limited thereto. The fourth sub-dam HDA4 may be disposed closer to the through hole TH than the third sub-dam HDA3. A thickness of the fourth sub-dam HDA4 may be greater than a thickness of the third sub-dam HDA3.

The second dam HDAM2 may include fifth to seventh sub-dams HDA5, HDA6, and HDA7. The fifth sub-dam HDA5 may be disposed on the first organic layer 160 and may include the same material as the second organic layer 180. The fifth sub-dam HDA5 may be disposed on the seventh tip T7. The sixth sub-dam HDA6 may be disposed on the fifth sub-dam HDA5 and may include the same material as the bank 190. The seventh sub-dam HDA7 may be disposed on the sixth sub-dam HDA6 and may include the same material as the spacer 191 but is not limited thereto.

The first dam HDAM1 and the second dam HDAM2 may prevent the encapsulating organic layer TFE2 from overflowing into the through hole TH.

The light emitting layer remnant 172_D, the common electrode remnant 173_D, the first encapsulation inorganic layer TFE1, and a second encapsulating inorganic layer TFE3 may be extended to the edge TEG of the through hole TH. The end of the light emitting layer remnant 172_D, the end of the common electrode remnant 173_D, the end of the first encapsulation inorganic layer TFE1, or the end of the second encapsulation inorganic layer TFE3 may coincide with the edge TEG of the through hole TH.

As shown in FIG. 77, because the light emitting layer 172 and the common electrode 173 are cut off in each of the first to third grooves GR1, GR2, and GR3 formed by the first to eighth tips T1 to T8 it is possible to prevent the light emitting layer 172 and the common electrode 173 exposed to the through hole TH from becoming a path through which oxygen, moisture, and the like penetrate.

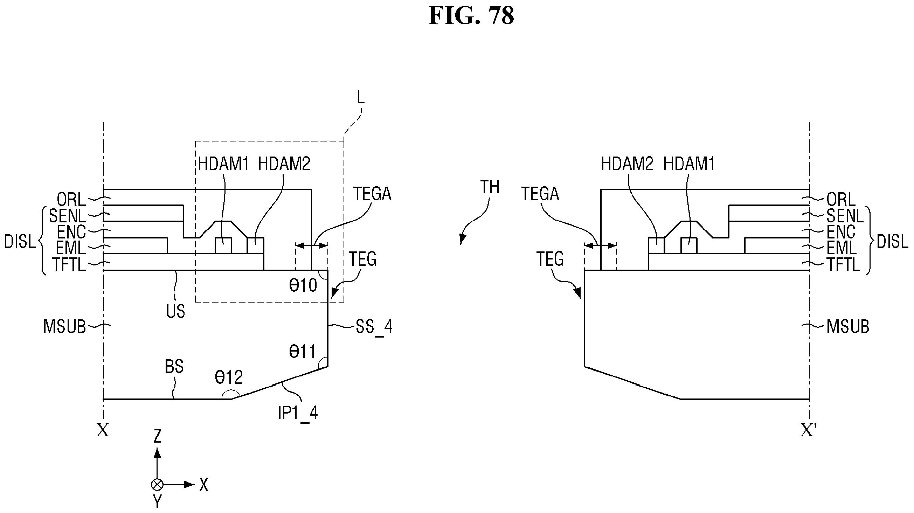

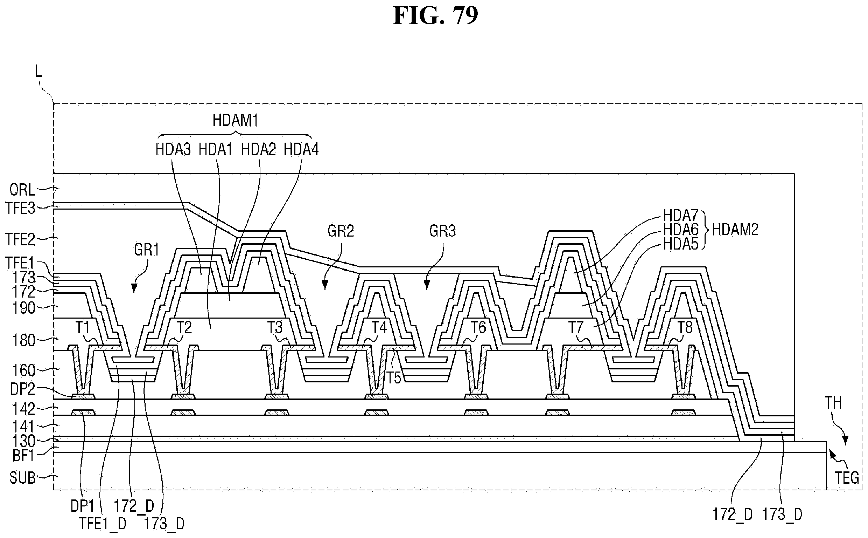

FIG. 78 is a cross-sectional view illustrating an example of the display panel taken along the line X-X' of FIG. 75. FIG. 79 is an enlarged cross-sectional view illustrating an example of an area L of FIG. 78 in more detail.

Referring to FIGS. 78 and 79, an organic planarization layer ORL may be disposed on the encapsulation layer ENC. The polarizing film PF may be easily attached on the organic planarization layer ORL due to the organic planarization layer ORL.

The organic planarization layer ORL may be disposed apart (or spaced) from the edge TEG of the through hole TH. For example, the substrate SUB (e.g., MSUB in FIG. 78) may protrude beyond the organic planarization layer ORL in the through hole TH. The organic planarization layer ORL may be disposed on at least a portion of the through hole edge area TEGA. The organic planarization layer ORL may cover at least a portion of the processing mark of the through hole edge area TEGA. The distance between the end of the organic planarization layer ORL and the eighth tip T8 may be about 100 µm or more. The distance between the organic planarization layer ORL and the edge TEG of the through hole TH may be within about 200 µm.

The organic planarization layer ORL may be formed of an organic film such as acryl resin, epoxy resin, phenolic resin, polyamide resin, or polyimide resin, etc. For example, the organic planarization layer ORL may include the same material as the second sensor insulating layer TINS2 illustrated in FIG. 5. The organic planarization layer ORL may be concurrently (e.g., simultaneously) formed in the same process as the second sensor insulating layer TINS2 illustrated in FIG. 5.

The organic planarization layer ORL may be disposed apart (or spaced) from the edge TEG of the through hole TH. For example, the substrate SUB may protrude beyond the organic planarization layer ORL in the through hole TH. The organic planarization layer ORL may cover at least a portion of the processing mark of the through hole edge area TEGA. The distance between the end of the organic planarization layer ORL and the eighth tip T8 may be about 100 µm or more. The distance between the organic planarization layer ORL and the edge TEG of the through hole TH may be within about 200 µm.

The light emitting layer remnant 172_D, the common electrode remnant 173_D, the first encapsulation inorganic layer TFE1, and the second encapsulation inorganic layer TFE3 may be disposed apart (or spaced) from the edge TEG of the through hole TH. For example, the substrate SUB may protrude in the through hole TH from the light emitting layer remnant 172_D, the common electrode remnant 173_D, the first encapsulation inorganic layer TFE1, and the second encapsulation inorganic layer TFE3. The light emitting layer remnant 172_D, the common electrode remnant 173_D, the first encapsulation inorganic layer TFE1, and the second encapsulation inorganic layer TFE3 may cover at least a portion of the processing marks of the through hole edge area TEGA.

The end of the light emitting layer remnant 172_D, the end of the common electrode remnant 173_D, the end of the first encapsulation inorganic layer TFE1, or the end of the second encapsulation inorganic layer TFE3 may coincide with the end of the organic planarization layer ORL. The distance between the end of the light emitting layer remnant 172_D, the end of the common electrode remnant 173_D, the end of the first encapsulation inorganic layer TFE1, or the end of the second encapsulation inorganic layer TFE3 and the eighth tip T8 may be approximately 100 µm or more. The distance between the light emitting layer remnant 172_D, the common electrode remnant 173_D, the first encapsulation inorganic layer TFE1, or the second encapsulation inorganic layer TFE3 and the edge TEG of the through hole TH may be approximately 200 µm or less.

Although FIG. 79 illustrates that the first buffer layer BF1 may be extended to the edge of the through hole TEG, embodiments of the present invention are not limited thereto. The first buffer layer BF1 may be disposed apart (or spaced) from the edge TEG of the through hole TH. For example, the substrate SUB may protrude beyond the first buffer layer BF1 in the through hole TH. The end of the first buffer layer BF1 may coincide with the end of the organic planarization layer ORL.

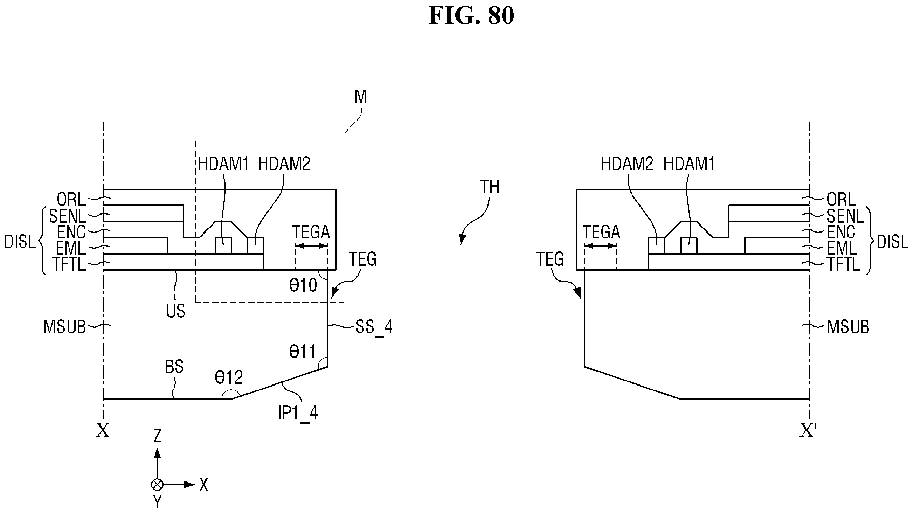

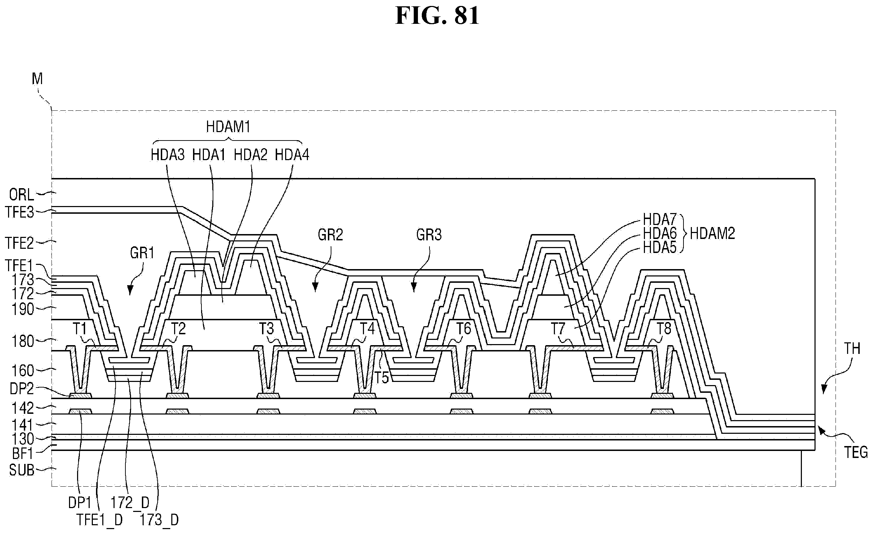

FIG. 80 is a cross-sectional view illustrating an example of the display panel taken along the line X-X' of FIG. 75. FIG. 81 is an enlarged cross-sectional view illustrating an example of an area M of FIG. 80 in more detail.

Referring to FIGS. 80 and 81, the organic planarization layer ORL may be disposed apart (or spaced) from the edge TEG of the through hole TH. For example, the organic planarization layer ORL may be formed to protrude in the through hole TH from the substrate SUB. The organic planarization layer ORL may be disposed in the through hole edge area TEGA. The organic planarization layer ORL may cover the processing marks of the through hole edge area TEGA.

In addition, the first buffer layer BF1, the gate insulating layer 130, the first interlayer insulating layer 141, and the second interlayer insulating layer 142 may be disposed apart (or spaced) from the edge TEG of the through hole TH. For example, the first buffer layer BF1, the gate insulating layer 130, the first interlayer insulating layer 141, and the second interlayer insulating layer 142 may protrude in the through hole TH from the substrate SUB. The first buffer layer BF1, the gate insulating layer 130, the first interlayer insulating layer 141, and the second interlayer insulating layer 142 may be disposed in the through hole edge area TEGA. The first buffer layer BF1, the gate insulating layer 130, the first interlayer insulating layer 141, and the second interlayer insulating layer 142 may cover the processing marks of the through hole edge area TEGA.

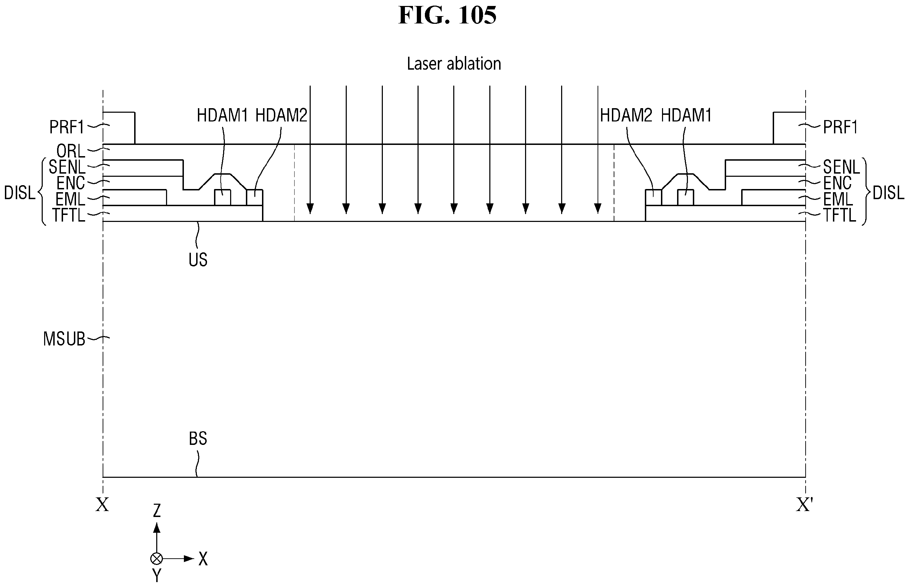

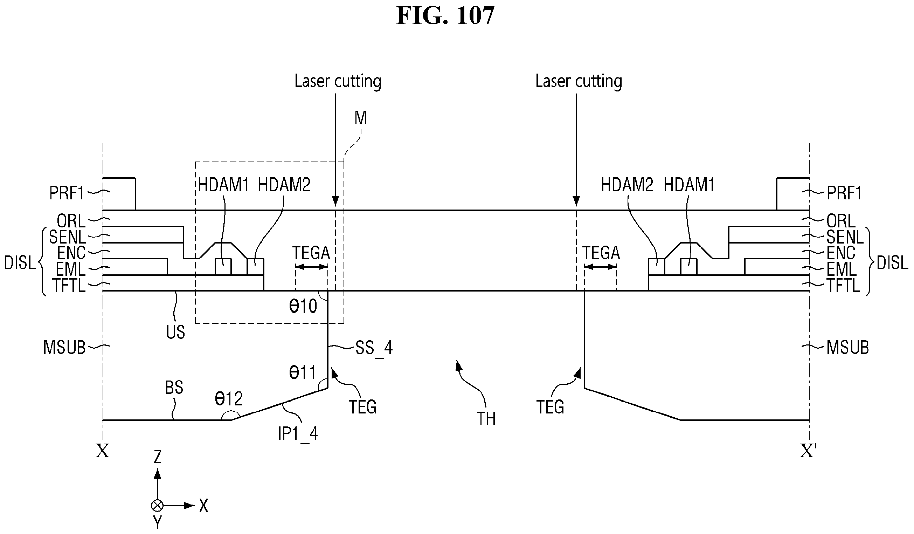

Whether the organic planarization layer ORL protrudes compared to the substrate SUB shown in FIGS. 78 and 80 may vary depending on a difference in the order of the removal of the organic planarization layer ORL and the laser process of the substrate SUB and will be described later with reference to FIGS. 105 and 107.

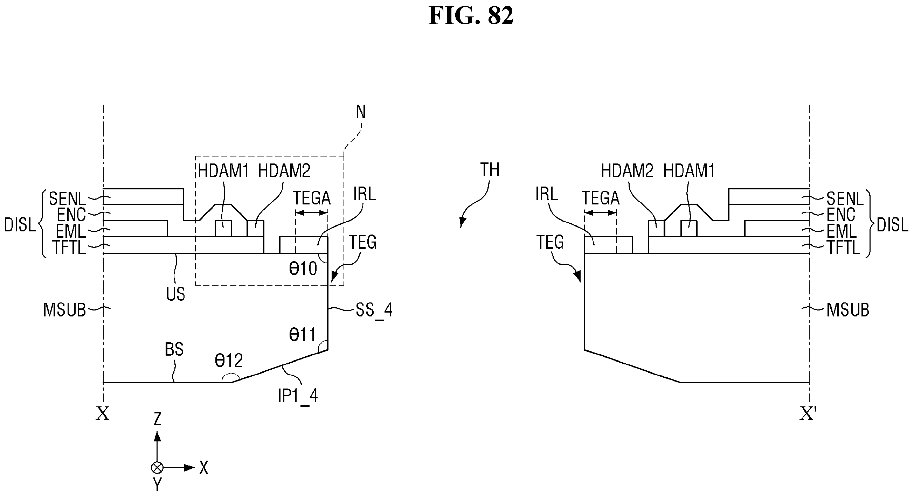

FIG. 82 is a cross-sectional view illustrating an example of the display panel taken along the line X-X of FIG. 75.

Referring to FIG. 82, the display panel 100 according to one or more embodiments may include the heat dissipation layer IRL disposed in the through hole edge area TEGA. The heat dissipation layer IRL may include the metal material having high thermal conductivity to dissipate heat generated when laser irradiation areas are formed with the laser in the cutting process. In addition, the heat dissipation layer IRL may include a material having a high infrared absorptivity to reduce or minimize the influence of the laser on the display panel 100 during the cutting process by increasing the infrared absorptivity. For example, the heat dissipation layer IRL may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

The length of the heat dissipation layer IRL in the first direction (X-axis direction) may be longer than a length of the through hole edge area TEGA in the first direction (X-axis direction). For example, the length of the heat dissipation layer IRL in the first direction (X-axis direction) may be approximately 50 µm to 300 µm.

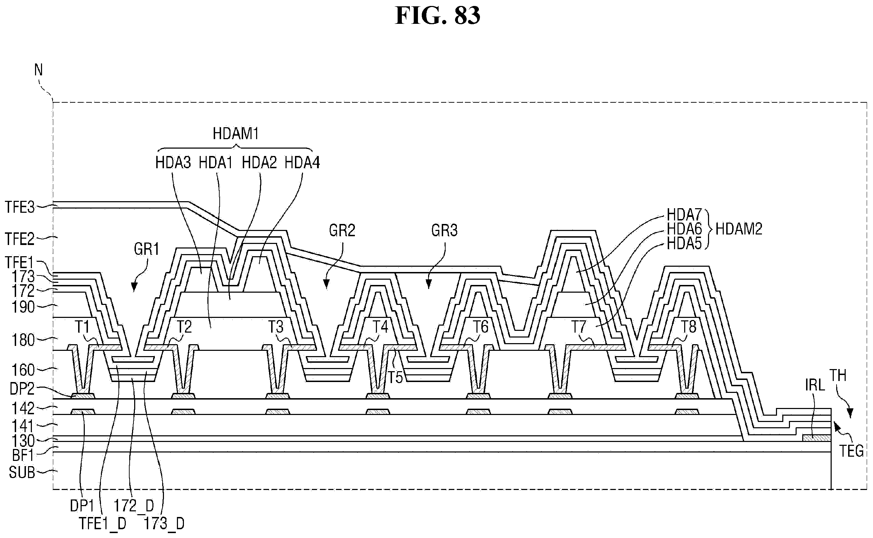

FIG. 83 is an enlarged cross-sectional view illustrating an example of an area N of FIG. 82 in more detail.

Referring to FIG. 83, the heat dissipation layer IRL may include the same material as the first data metal layer including the first connection electrode CE1 and the data lines and may be disposed on (or at) the same layer as the first data metal layer. The heat dissipation layer IRL may be disposed on the second interlayer insulating layer 142. In one or more embodiments, the heat dissipation layer IRL may be disposed on the buffer layer BF1. The heat dissipation layer IRL may be formed of a single layer or multiple layers made of any one or more selected from among molybdenum (Mo), aluminum (Al), chromium (Cr), gold (Au), titanium (Ti), nickel (Ni), neodymium (Nd), and copper (Cu), or an alloy thereof.

Alternatively, the heat dissipation layer IRL may include the same material as the second gate metal layer including the second capacitor electrode CAE2 of the capacitor Cst and be disposed on (or at) the same layer as the second gate metal layer. The heat dissipation layer IRL may be disposed on the first interlayer insulating layer 141.

Alternatively, the heat dissipation layer IRL may include the same material as the gate electrode TG of the thin film transistor TFT, the first capacitor electrode CAE1 of the capacitor Cst, and the first gate metal layer including the scan lines and may be disposed on (or at) the same layer as the gate electrode TG of the thin film transistor TFT, the first capacitor electrode CAE1 of the capacitor Cst, and/or the first gate metal layer including the scan lines. The heat dissipation layer IRL may be disposed on the gate insulating layer 130.

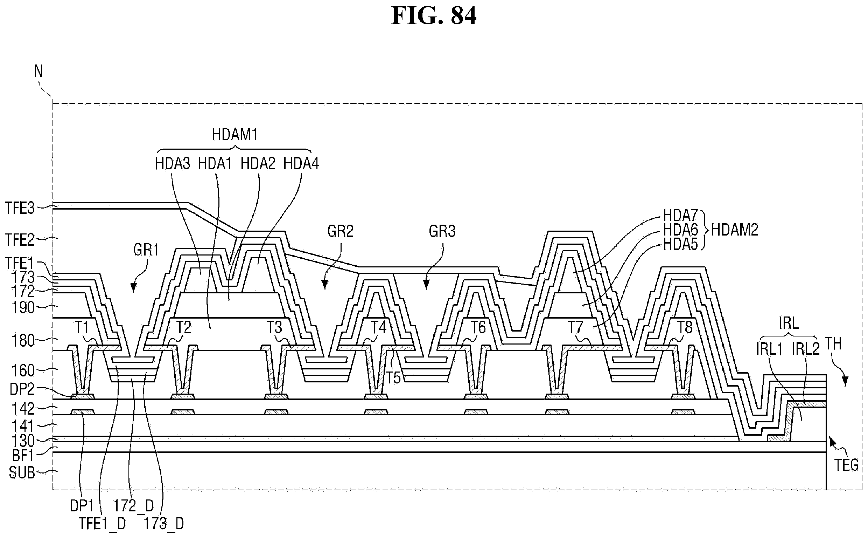

FIG. 84 is an enlarged cross-sectional view illustrating an example of the area N of FIG. 82 in more detail.

Referring to FIG. 84, the first heat dissipation layer IRL1 may include the same material as the first organic layer 160 and may be disposed on (or at) the same layer as the first organic layer 160. The first heat dissipation layer IRL1 may be disposed on the second interlayer insulating layer 142. In one or more embodiments, the first heat dissipation layer IRL1 may be disposed on the buffer layer BF1. The first heat dissipation layer IRL1 may be formed of the organic film such as acryl resin, epoxy resin, phenolic resin, polyamide resin, or polyimide resin, etc. The first heat dissipation layer IRL1 and the crack dam CRD may have trapezoidal cross-sections.

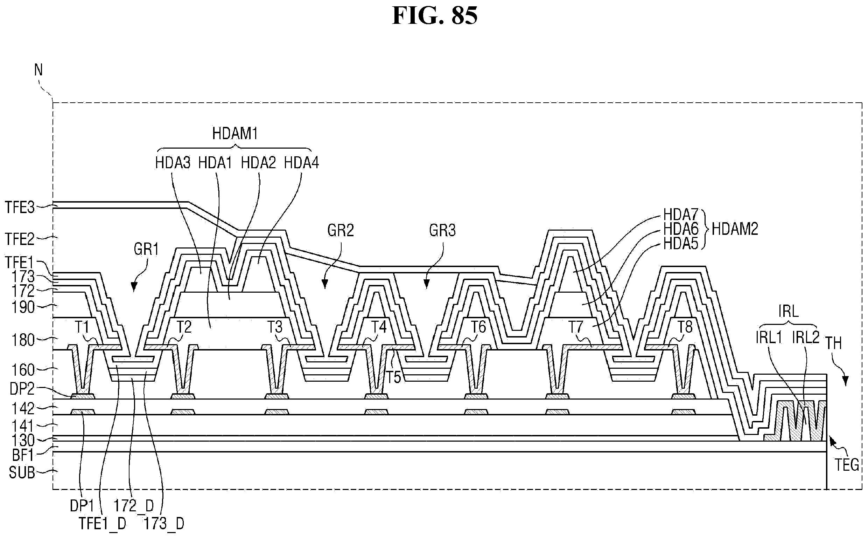

FIG. 85 is an enlarged cross-sectional view illustrating an example of the area N of FIG. 82 in more detail.

Referring to FIG. 85, the heat dissipation layer IRL may include the plurality of first heat dissipation layers IRL1 and the second heat dissipation layer IRL2. The plurality of first heat dissipation layers IRL1 may be disposed to be spaced from each other in one direction.

The plurality of first heat dissipation layers IRL1 may include the same material as the first organic layer 160 and may be disposed on (or at) the same layer as the first organic layer 160. The plurality of first heat dissipation layers IRL1 may be disposed on the second interlayer insulating layer 142. In one or more embodiments, the plurality of first heat dissipation layers IRL1 may be disposed on the buffer layer BF1. The plurality of first heat dissipation layers IRL1 may be formed of the organic film such as acrylic resin, epoxy resin, phenolic resin, polyamide resin, or polyimide resin. The plurality of first heat dissipation layers IRL1 and the crack dam CRD may have the trapezoidal cross-section.

However, a portion of the first heat dissipation layer IRL1 closest to the edge TEG of the through hole TH may be cut by the laser process in the cutting process of the substrate SUB. Therefore, the first heat dissipation layer IRL1 closest to the edge TEG of the through hole TH may have a cross section in which a portion of the trapezoid is cut off.

The second heat dissipation layer IRL2 may cover the plurality of first heat dissipation layers IRL1. Therefore, a length in one direction of the second heat dissipation layer IRL2 may be longer than a length in one direction of the plurality of first heat dissipation layers IRL1. The second heat dissipation layer IRL2 may also be disposed on the upper surface of the substrate SUB exposed between the plurality of first heat dissipation layers IRL1. The area of the second heat dissipation layer IRL2 may increase due to the plurality of first heat dissipation layers IRL1 so that the heat dissipation effect may be increased.

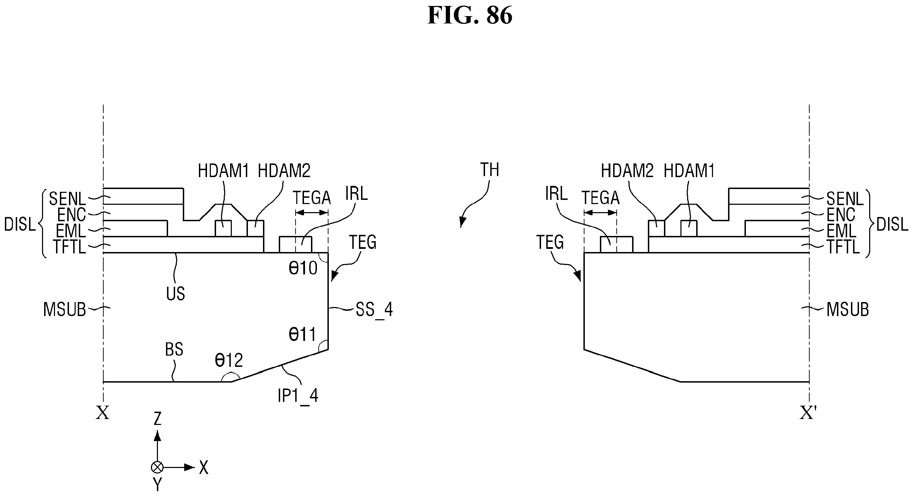

FIG. 86 is a cross-sectional view illustrating an example of the display panel taken along the line X-X of FIG. 75.

Referring to FIG. 86, the heat dissipation layer IRL may be disposed apart (or spaced) from the edge TEG of the through hole TH in one direction. That is, the heat dissipation layer IRL may be disposed while avoiding an area to which the laser is directly irradiated. To this end, the heat dissipation layer IRL may be disposed approximately 1 µm to 50 µm apart (or spaced) from the edge TEG of the through hole TH.

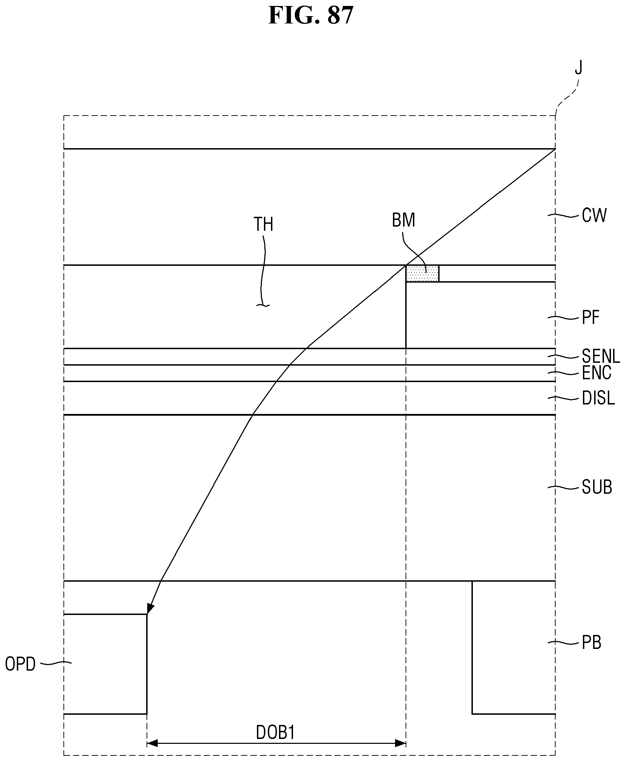

FIG. 87 is an example diagram illustrating a minimum distance between an optical device and a black matrix when a through hole is not formed in the display panel.

Referring to FIG. 87, when the through hole TH is not formed in the display panel 100, the optical device OPD may be disposed under the substrate SUB. In this case, the thin film transistors TFT, the light emitting elements 170, and the sensor electrodes TE and RE of the display panel 100 may not be disposed in an area overlapping the optical device OPD in the path of the light incident on the optical to block light incident on the optical device OPD. That is, materials that transmit light, such as inorganic layers and/or organic layers of the display panel 100, may be disposed in a path of light incident on the optical device OPD.

Light incident on the optical device OPD may be refracted by a difference in refractive index in each of the air layers on the upper surfaces of the substrate SUB, the display layer DISL, the encapsulation layer ENC, the sensor electrode layer SENL, the through hole TH of the polarizing film PF, and the cover window CW. Accordingly, when the through hole TH is not formed in the display panel 100, a distance DOB1 between the optical device OPD and a black matrix BM of the cover window CW may increase in the horizontal direction parallel to the substrate SUB (eg, the first direction (X-axis direction) or the second direction (Y-axis direction)).

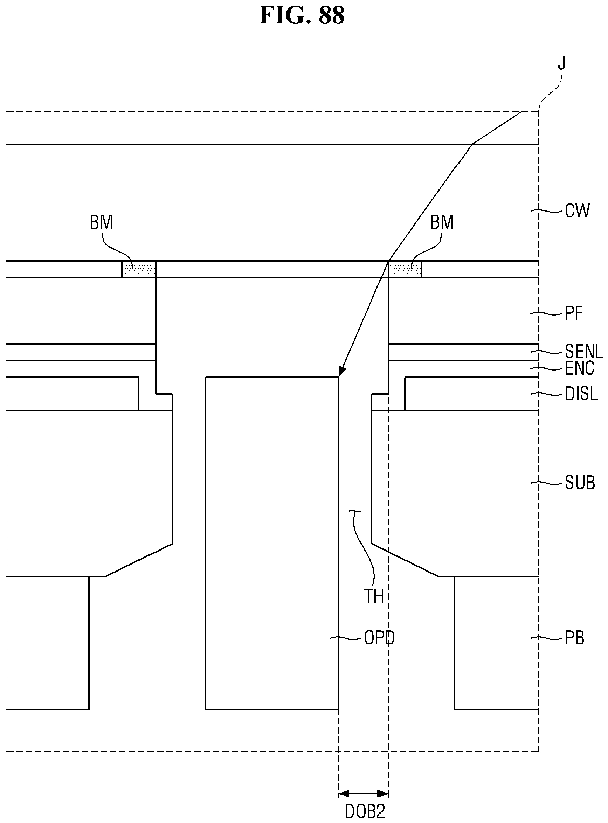

FIG. 88 is an example diagram illustrating a minimum distance between an optical device and a black matrix when a through hole is formed in a display panel.

Referring to FIG. 88, when the through hole TH is formed in the display panel 100, the light incident on the optical device OPD may be refracted by a difference in refractive index between the cover window CW and the air layer on the upper surface of the cover window CW. That is, the number of times that light incident on the optical device OPD is refracted may be reduced (e.g., greatly reduced).

Accordingly, when the through hole TH is formed in the display panel 100, a distance DOB2 between the optical device OPD and the black matrix BM of the cover window CW in the horizontal direction parallel to the substrate SUB may be smaller (e.g., significantly smaller) than the distance DOB1 between the optical device OPD and the black matrix BM of the cover window CW in the horizontal direction parallel to the substrate SUB (eg, the first direction (X-axis direction) or the second direction (Y-axis direction)) when the through hole TH is not formed in the display panel 100. Therefore, when the through hole TH is formed in the display panel 100, the size of the through hole TH may be reduced (e.g., greatly reduced) in comparison to the size of the through hole TH when the through hole TH is not formed in the display panel 100.

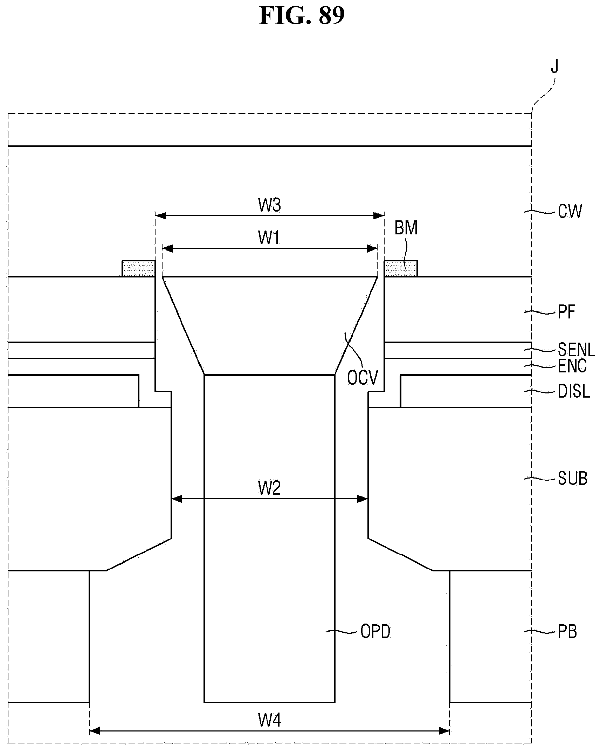

FIG. 89 is a cross-sectional view illustrating an example of an electronic device including a display panel and an optical device disposed in a through hole according to one or more embodiments. FIG. 89 is a cross-sectional view illustrating an example of an area J of FIG. 73 in more detail according to one or more embodiments.

Referring to FIG. 89, the electronic device according to one or more embodiments may further include an upper optical cover OCV disposed on the optical device OPD. The upper optical cover OCV may have a funnel or cone shape. The width of the upper optical cover OCV may gradually increase from the optical device OPD to the cover window CW. The upper optical cover OCV may be integrally formed with the optical device OPD or may be configured (or located) separately from the optical device OPD. Because the optical device OPD detects light passing through the upper optical cover OCV, noise light incident on the optical device OPD may be reduced or minimized.

A width W1 of the upper optical cover OCV is greater than a minimum width W2 of the through hole TH, but an upper width W3 of the through hole TH may be smaller than a lower width W4 of the through hole TH. The minimum width W2 of the through hole TH may be the width of the through hole TH in the substrate SUB. The upper width W3 of the through hole TH may be the width of the through hole TH in the polarizing film PF. The lower width W4 of the through hole TH may be the width of the through hole TH in the panel bottom cover PB. Therefore, the upper optical cover OCV may be inserted into the through hole TH through the upper portion of the through hole TH.

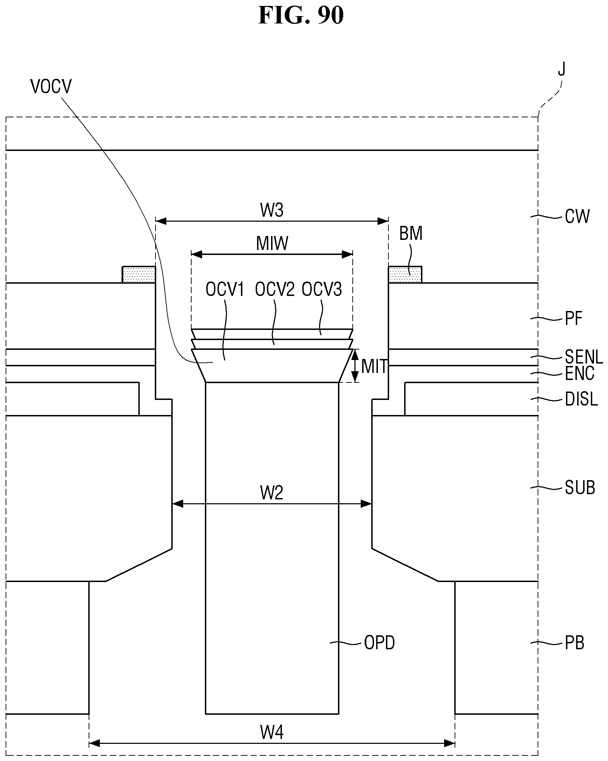

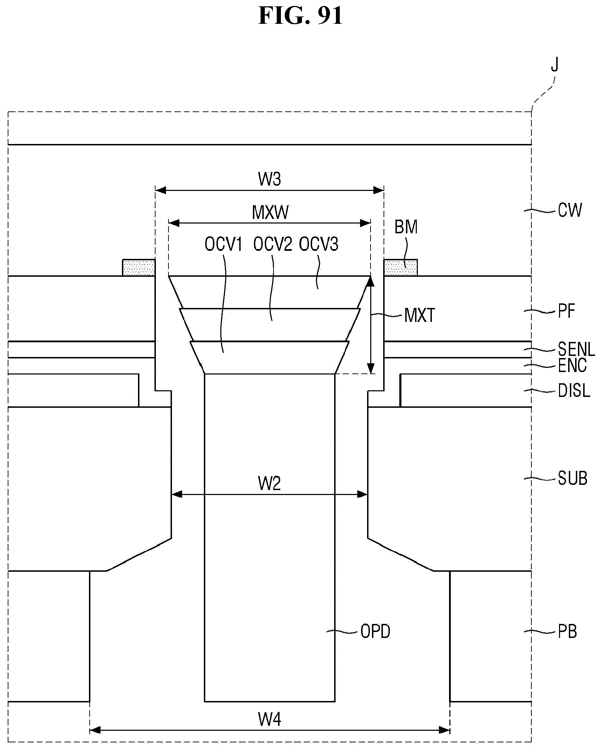

FIGS. 90 and 91 are cross-sectional views illustrating an example of an electronic device including a display panel and an optical device disposed in a through hole according to one or more embodiments. FIGS. 90 and 91 are cross-sectional views illustrating an example of the area J of FIG. 73 in more detail according to one or more embodiments. FIG. 90 illustrates a variable optical cover VOCV in a reduced state, and FIG. 91 illustrates the variable optical cover VOCV in an expanded state.

Referring to FIGS. 90 and 91, the electronic device according to one or more embodiments may include the variable optical cover VOCV disposed on the optical device OPD. The width and height of the variable optical cover VOCV may be adjusted. For example, a minimum width MIW of the variable optical cover VOCV may be smaller than the minimum width W2 of the through hole TH as shown in FIG. 90. As shown in FIG. 91, a maximum width MXW of the variable optical cover VOCV is greater than the minimum width W2 of the through hole TH, but the upper width W3 of the through hole TH may be smaller than the lower width W4 of the through hole TH. Due to this, the variable optical cover VOCV may be inserted into the through hole TH through any one of the upper and lower portions of the through hole TH in a reduced state, and may be extended while being disposed in the through hole TH.

The variable optical cover VOCV may include first to third optical covers OCV1, OCV2, and OCV3.

In a state in which the variable optical cover VOCV is reduced, at least a portion of the second optical cover OCV2 is retracted into the first optical cover OCV1, and at least a portion of the third optical cover OCV3 may be retreated into the second optical cover OCV2. The first optical cover OCV1 has a thickness of MIT, which may be a thickness of the variable optical cover VOCV when the second optical cover OCV2 and the third optical cover OCV3 are completely retracted into the first optical cover OCV2, but the present invention is not limited thereto. In a state in which the variable optical cover VOCV is expanded, the second optical cover OCV2 may be extracted from the first optical cover OCV1, and the third optical cover OCV3 may be extracted from the second optical cover OCV2. In a state in which the variable optical cover VOCV is expanded, the width of the second optical cover OCV2 is greater than the width of the first optical cover OCV1, and the width of the third optical cover OCV3 may be greater than a width of the second optical cover OCV2. In the state in which the variable optical cover VOCV is fully expanded, the variable optical cover VOCV may have a thickness of MXT, which is greater than MIT.

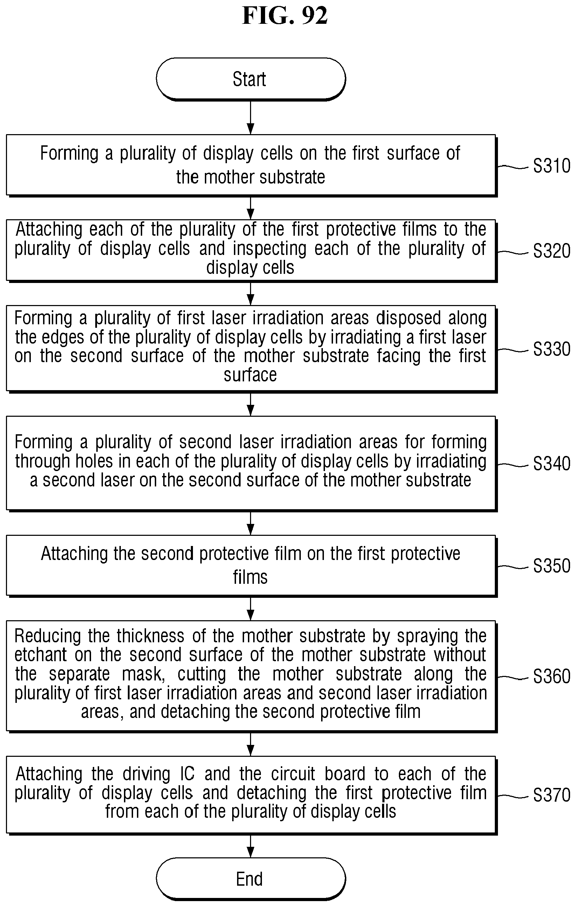

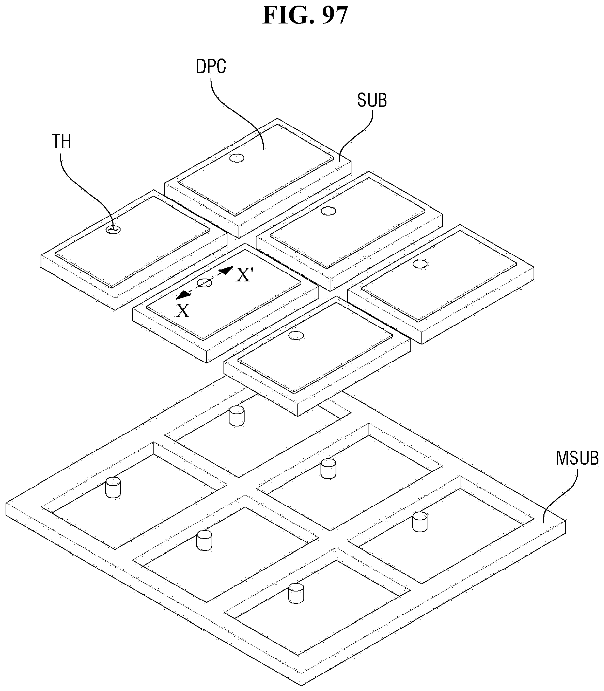

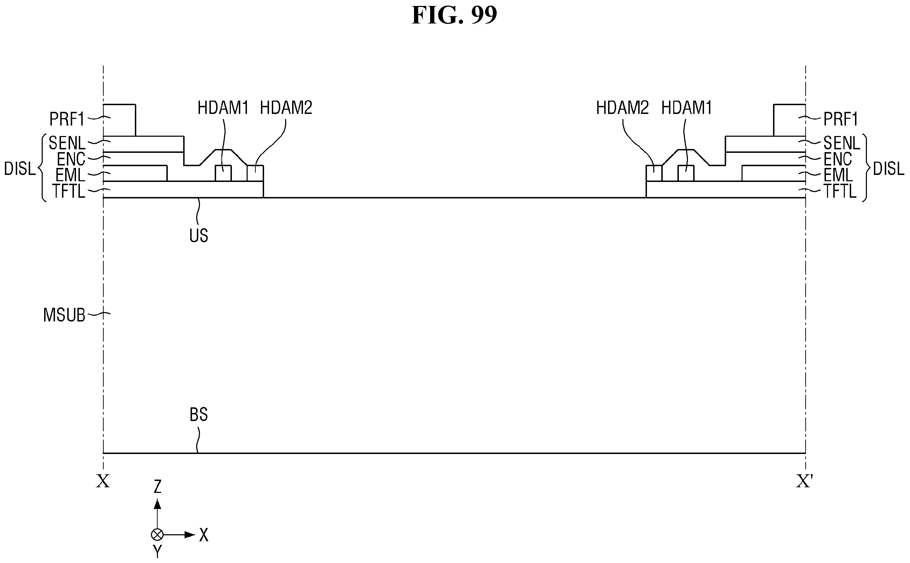

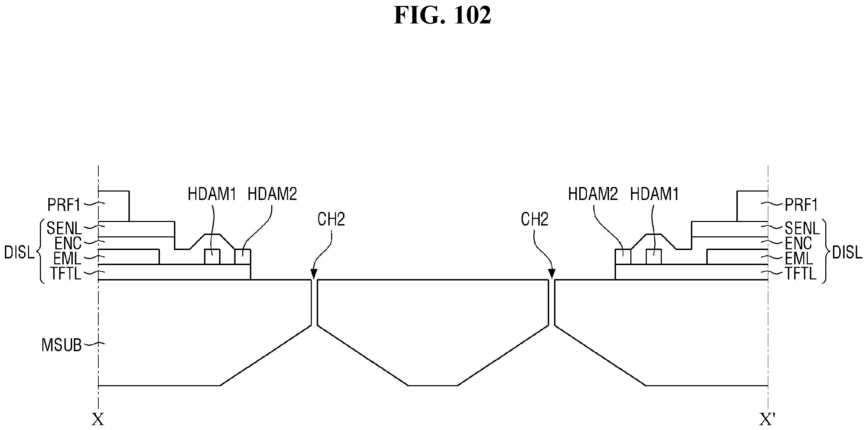

FIG. 92 is a flowchart illustrating a method of manufacturing a display device according to one or more embodiments. FIGS. 93 to 98 are perspective views illustrating a method of manufacturing a display device according to one or more embodiments. FIGS. 99 to 103 are cross-sectional views illustrating a method of manufacturing a display device according to one or more embodiments.

First, as shown in FIGS. 93 and 99, the plurality of display cells DPC is formed on the first surface of the mother substrate MSUB. (S310 in FIG. 92)

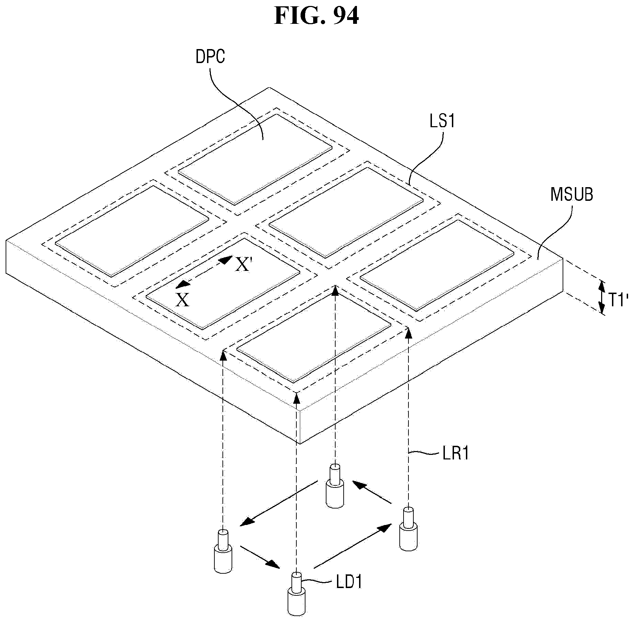

Second, as shown in FIG. 94, the plurality of first protective films PRF1 are attached on the plurality of display cells DPC, and the plurality of display cells DPC is inspected. (S320 in FIG. 92)

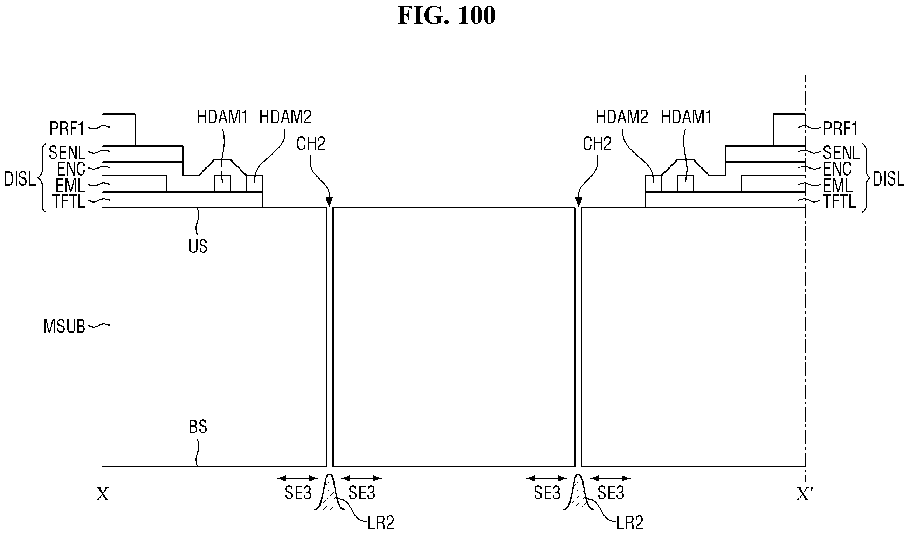

Third, as shown in FIGS. 94 and 100, the plurality of first laser irradiation areas CH1 disposed along edges of the plurality of display cells DPC are formed by irradiating a first laser LR1 from a first laser device LD1 on the second side facing the first side of the mother substrate MSUB. (S330 in FIG. 92)

Various laser devices may be used as the laser device LD according to one or more embodiments, but by way of example, the first laser LD1 may generate an infrared beam Bessel beam having the wavelength of approximately 1030 nm as the first laser LR1 according to one or more embodiments of the present invention.

A first cutting line CL1 may be defined as the virtual line connecting the plurality of first laser irradiation areas CH1. The first cutting line CL1 may be formed by irradiating the first laser LR1 to form the plurality of first laser irradiation areas CH1 along the edges of the plurality of display cells DPC.

When the first laser LR1 is irradiated on the second surface of the mother substrate MSUB, the depth (or sketch length) TCH1 of each of the plurality of first laser irradiation areas CH1 formed by the laser LR may be adjusted as shown in FIG. 69 by adjusting the repetition rate, processing speed, and pulse energy. For example, the depth TCH1 of each of the plurality of first laser irradiation areas CH1 may be about 50 µm or more from the first surface of the mother substrate MSUB as shown in FIG. 69 (a). In addition, because the thickness of the mother substrate MSUB is approximately 500 µm, the depth TCH1 of each of the plurality of first laser irradiation areas CH1 may be up to 500 µm as shown in FIG. 69 (b). That is, the depth TCH1 of each of the plurality of first laser irradiation areas CH1 may be approximately 50 µm to 500 µm from the first surface of the mother substrate MSUB.

The laser LR for forming the first laser irradiation areas CH1 may be irradiated with the repetition rate of 10 kHz to 250 kHz, the processing speed of 10 mm/s to 250 mm/s, and the pulse energy of 10 µJ to 300 µJ. However, it is preferred to irradiate with the repetition rate of approximately 17.5 kHz to 125 kHz, the processing speed of 17.5 mm/s to 125 mm/s, and the pulse energy of 25 µJ to 178 µJ in order for the laser LR to have the depth of approximately 225 µm from the first surface of the mother substrate MSUB.

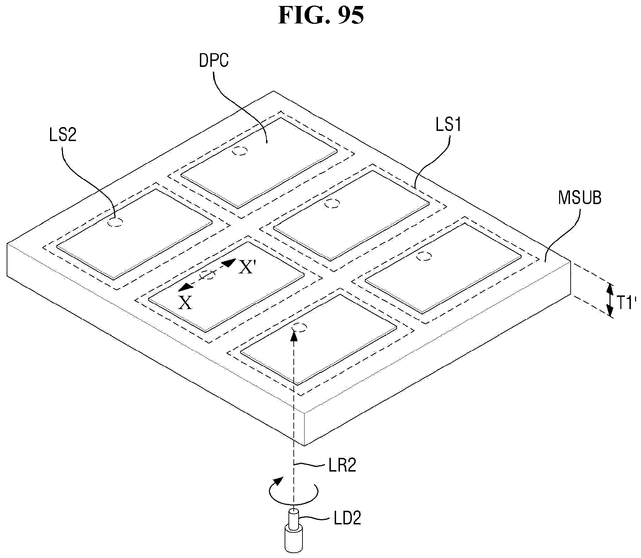

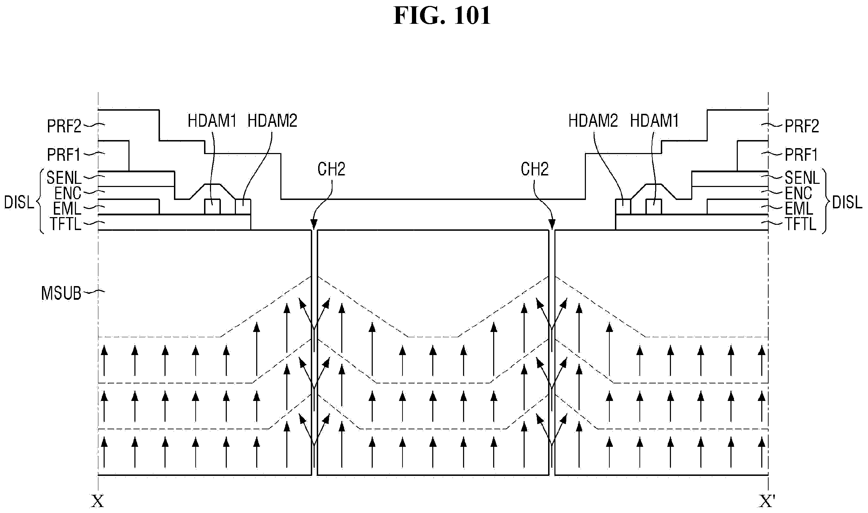

Fourth, as shown in FIGS. 95 and 101, a plurality of second laser irradiation areas CH2 are irradiated with a second laser LR2 from a second laser device LD2 on the second surface of the mother substrate MSUB to form through holes in each of the plurality of display cells. (S340 of FIG. 92)

FIG. 92 illustrates that step S340 is performed after step S330 is performed, but embodiments of the present invention are not limited thereto. Steps S330 and S340 may be concurrently (e.g., simultaneously) performed through the plurality of laser devices LD to shorten the process time.

A second cutting line CL2 may be defined as the virtual line connecting the plurality of second laser irradiation areas CH2. The second cutting line CL2 may be formed by irradiating the second laser LR2 to form the plurality of second laser irradiation areas CH2 along the edge of the through hole TH. The second cutting line CL2 may depend on the shape of the through hole. For example, when the through hole TH has a circular planar shape, the second cutting line CL2 may be formed in a circular shape.

Various laser devices may be used to generate the first laser LR1 and the second laser LR2 according to one or more embodiments, but by way of example, the first laser device LD1 and the second laser device LD2 may generate infrared beams having the wavelength of approximately 1030 nm as the first laser LR1 and the second laser LR2, respectively, according to one or more embodiments of the present invention.

A depth of each of the plurality of first laser irradiation areas CH1 formed by the first laser LR1 and a depth of each of the plurality of second laser irradiation areas CH2 formed by the second laser LR2 (or sketch length) may be different. The depth of the first laser irradiation area CH1 may be defined as the depth (or sketch length) of the first laser irradiation area CH1, and the depth of the second laser irradiation area CH2 may be defined as the depth (or sketch length) of the second laser irradiation area CH2.

Each of the plurality of first laser irradiation areas CH1 may have a depth of about 50 µm or more from the first surface of the mother substrate MSUB. Because the thickness of the mother substrate MSUB may be approximately 500 µm, the depth (or sketch length) of each of the plurality of first laser irradiation areas CH1 may be approximately 50 µm to 500 µm from the first surface of the mother substrate MSUB. Also, the depth (or sketch length) of each of the plurality of second laser irradiation areas CH2 may be approximately 50 µm to 500 µm from the first surface of the mother substrate MSUB.

A depth (or sketch length) of each of the plurality of second laser irradiation areas CH2 may be longer than a depth (or a sketch length) of each of the plurality of first laser irradiation areas CH1. As shown in FIG. 69, the depth (or sketch length) of the laser irradiation area may be adjusted according to the repetition rate, the processing speed, and the pulse energy of the first laser LR1 and the second laser LR2. Because the depth (or sketch length) of the first laser irradiation area CH1 formed by the first laser LR1 is different from the depth (or sketch length) of the second laser irradiation area CH2, the first laser LR1 and the second laser LR2 have differences in the repetition rate, the processing speed, the pulse energy, and the like.

For example, the first laser LR1 may be irradiated with the repetition rate of 10 kHz to 250 kHz, the processing speed of 10 mm/s to 250 mm/s, and the pulse energy of 10 µJ to 300 µJ. However, it is preferred to irradiate with the repetition rate of approximately 17.5 kHz to 125 kHz, the processing speed of 17.5 mm/s to 125 mm/s, and the pulse energy of 25 µJ to 178 µJ in order for the first laser LR1 to have the depth of about 225 µm or more from the first surface of the mother substrate MSUB.

In addition, the second laser LR2 may be irradiated with the repetition rate of 1 kHz to 50 kHz, the processing speed of 1 mm/s to 50 mm/s, and the pulse energy of 10 µJ to 300 µJ. However, the repetition rate of about 10 kHz, the processing speed of 10 mm/s, and the pulse of 60 µJ to 178 µJ energy may be irradiated in order for the second laser LR2 to have the depth of about 400 µm to 500 µm from the first surface of the mother substrate MSUB. For example, while the second laser LR2 forms the circular second cutting line CL2, the processing speed of the second laser LR2 may be lower than the processing speed of the first laser LR1. Because the first laser LR1 forms the first cutting line CL1 along the edges of each of the plurality of display cells DPC.

The one-sided tolerance SE3 of the second laser LR2 may be within approximately 50 µm, and the double-sided tolerance of the second laser LR2 may be within approximately 100 µm. The one-sided tolerance SE2 of the second laser LR2 may be a cutting error in one direction (eg, the X-axis direction) when forming the plurality of second laser irradiation areas CH2 with the second laser LR2.

The distance from the second dam HDAM2 to the edge TEG of the through hole TGH may vary according to the one-sided tolerance SE3 of the second laser LR2. When the second laser LR is correctly irradiated to a position to be irradiated, the distance from the second dam HDAM2 to the second laser irradiation area CH2 is defined as "HDCH".

When the second laser LR2 is irradiated to the left by the maximum value of the one-sided tolerance SE3 of the second laser LR2, the distance from the second dam HDAM2 to the second laser irradiation area CH2 may be "HDCH- SE3". In contrast, when the second laser LR2 is irradiated to the right by the maximum value of the one-sided tolerance SE3 of the second laser LR2, the distance from the second dam HDAM2 to the second laser irradiation area CH2 may be "HDCH+SE3".

Because the substrate SUB of the display cell DPC is separated from the mother substrate MSUB based on the second laser irradiation area CH2 in the etching process, the distance from the second dam HDAM2 to the second laser irradiation area CH2 may be substantially the same as the minimum distance from the second dam HDAM2 to the edge TEG of the through hole TH In the display panel 100 illustrated in FIG. 76. Accordingly, the minimum distance from the second dam HDAM2 to the edge TEG of the through hole TH in the display panel 100 may be a difference of 100 µm, which is a distance corresponding to "one-sided tolerance SE2×2" (or "double-sided tolerance") of the second laser LR2 in some cases.

That is, the minimum distance from the second dam HDAM2 to the edge TEG of the through hole TH in the display panel 100 illustrated in FIG. 76 may be "HDCH-SE2" to "HDCH+SE2". For example, when the distance from the second dam HDAM2 to the second laser irradiation area CH2 is 100 µm and the one-sided tolerance SE3 of the second laser LR2 is 50 µm, the minimum distance from the second dam HDAM2 to the edge TEG of the through hole TH may be at least 50 µm or at most 125 µm in the display panel 100 shown in FIG. 76.

As described above, the one-sided tolerance SE3 of the second laser LR2 is 50 µm, but the one-sided tolerance SE1 of the cutting member CWD such as the cutting wheel is 100 µm. That is, because the one-sided tolerance SE3 of the second laser LR2 is smaller than the one-sided tolerance SE1 of the cutting member CWD such as the cutting wheel, when cutting using the second laser LR2, the minimum distance from the second dam HDAM2 to the edge TEG of the through hole TH may be reduced compared to the case of cutting using the cutting member CWD such as the cutting wheel when cutting using the second laser LR2.

Fifth, as shown in FIG. 101, the second protective film PRF2 is attached on the plurality of first protective films PRF1. (S350 in FIG. 92)

The second protective film PRF2 may be attached on the exposed mother substrate MSUB without being covered by the plurality of first protective films PRF1 and on the plurality of first protective films PRF1. The second protective film PRF2 may cover the plurality of first laser irradiation areas CH1 and the plurality of second laser irradiation areas CH2. The second protective film PRF2 may be the acid-resistant film for protecting the plurality of display cells DPC from the etchant in the etching process of the mother substrate MSUB to be performed in the next step.

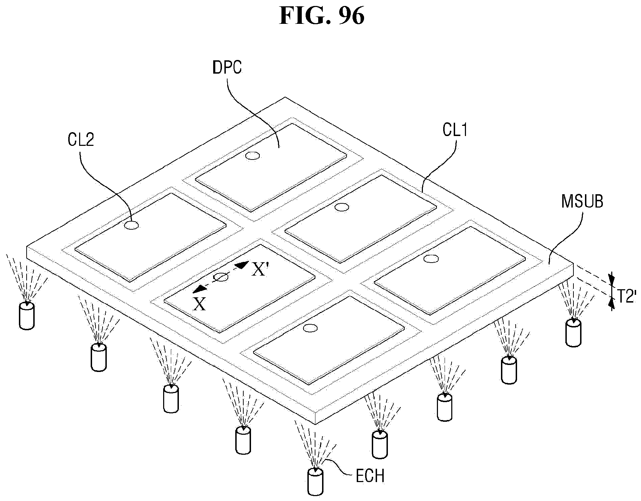

Sixth, as shown in FIGS. 96, 97, 101, and 102, while reducing the thickness of the mother substrate MSUB, the mother substrate is cut along the plurality of first laser irradiation aeas CH1 and the second laser irradiation areas CH2 by spraying the etchant on the second side of the mother substrate MSUB, and the second protective film PRF2 is detached without a separate mask. (S360 in FIG. 92)

When the etchant is sprayed on the second surface of the mother substrate MSUB, the mother substrate MSUB may be reduced from the first thickness T1' to the second thickness T2'. Because the mother substrate MSUB is etched without a separate mask, the mother substrate MSUB may be etched uniformly over the entire area of the second surface.

Each of the plurality of first laser irradiation areas CH1 is a physical hole formed by the first laser LR1 and a periphery of the physical hole and may include an area whose physical properties are changed by the laser. Alternatively, each of the plurality of first laser irradiation areas CH1 may be an area whose physical properties are changed by the first laser LR1 without the physical hole. For this reason, the etch rate in each of the plurality of first laser irradiation areas CH1 by the etchant may be higher than the etch rate in other areas of the mother substrate MSUB to which the laser is not irradiated.

Each of the plurality of second laser irradiation areas CH2 is formed as the physical hole formed by the second laser LR2 and the periphery of the physical hole and may include an area whose physical properties are changed by the laser. Alternatively, each of the plurality of second laser irradiation areas CH2 may be an area whose physical properties are changed by the second laser LR2 without the physical hole. For this reason, the etch rate in each of the plurality of second laser irradiation regions CH2 by the etchant may be higher than the etch rate in other areas of the mother substrate MSUB to which the laser is not irradiated.

At this time, as shown in FIGS. 65 and 100, because the depth of each of the plurality of second laser irradiation areas CH2 is greater than the depth of each of the plurality of first laser irradiation areas CH1, the etchant may first penetrate the plurality of second laser irradiation areas CH2 rather than the plurality of first laser irradiation areas CH1. That is, because the plurality of second laser irradiation areas CH2 is etched along with the slimming process in which the thickness of the mother substrate MSUB is reduced by the etchant, the substrate SUB forms a tapered cross section by isotropic etching in the through hole TH formed by the second laser irradiation area CH2. In contrast, etching is not performed on the plurality of first laser irradiation areas CH1 when slimming is performed. Therefore, the length and angle of the inclination direction of the first inclined surface IP1_1 at the edge of the substrate SUB formed by the plurality of first laser irradiation areas CH1 may be different from the length and the angle of the inclination direction of the first inclined surface IP1_4 in the through hole TH formed by the plurality of second laser irradiation areas CH2.

For example, as shown in FIG. 65, the length of the first inclined surface IP1_1 from the edge EG of the display panel 100 in the inclined direction may be shorter than a length of the first inclined surface IP1_4 at the edge TEG of the through hole TH in the inclined direction. The angle of the first inclined surface IP1_1 from the edge EG of the display panel 100 may be smaller than the angle of the first inclined surface IP1 _4 from the edge TEG of the through hole TH. The angle of the inclined surface IP1_1 at the edge EG of the display panel 100 may be the angle between the side surface SS_1 and the inclined surface IP1 _1. The inclined surface IP1_4 at the edge TEG of the through hole TH may be an angle between the side surface SS_4 of the edge TEG of the through hole TH and the first inclined surface IP1 _4.

After the etching process is completed, the second protective film PRF2 may be detached.

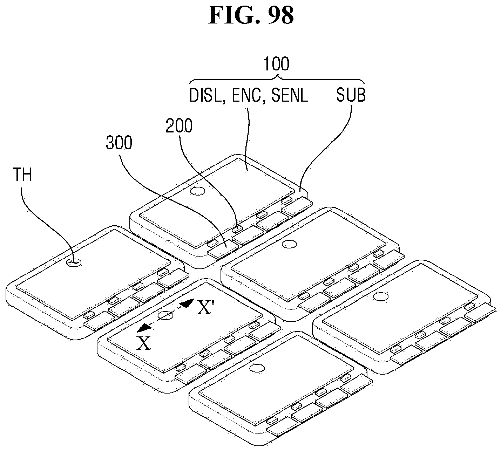

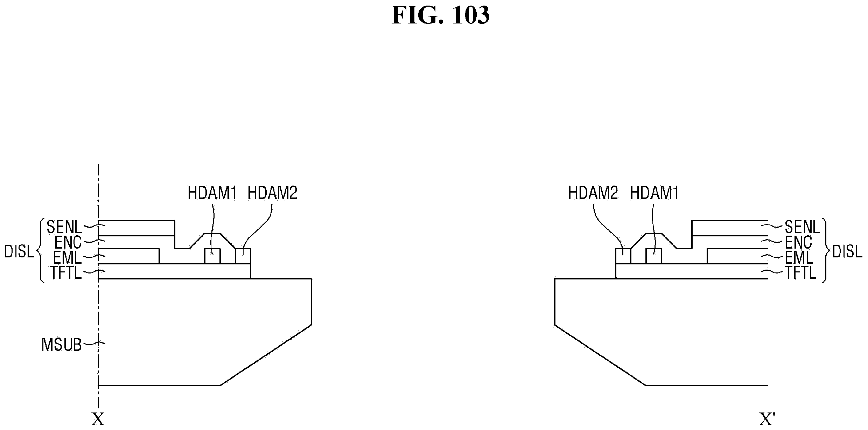

Seventh, as shown in FIGS. 98 and 103, the driving IC 200 and the circuit board 300 are attached to each of the plurality of display cells DPC, and the first protective film is detached from each of the plurality of display cells DPC. (S370 of FIG. 92)

As described above, the thickness of the mother substrate SUB may be reduced by using the laser and the etching process, and the substrate SUB of each of the plurality of display cells DPC may be separated from the mother substrate MSUB. Also, because the through hole TH may be formed, the efficiency of the manufacturing process may be improved.

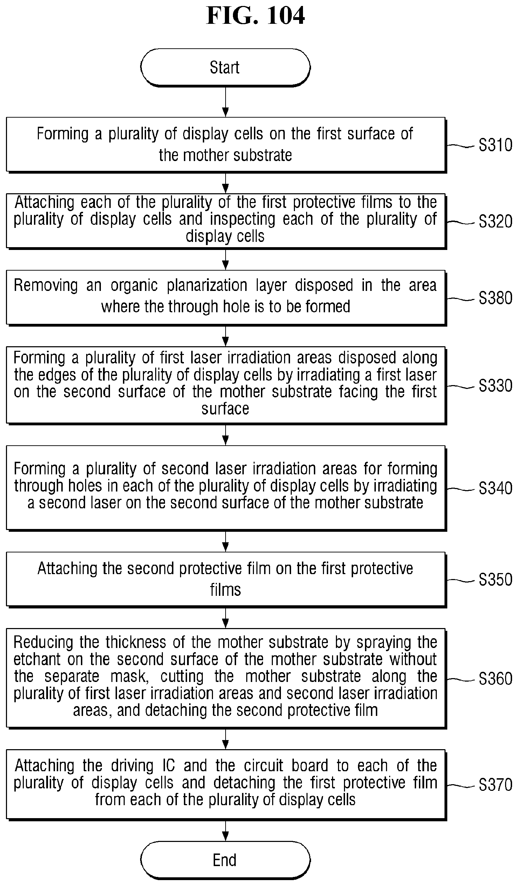

FIG. 104 is a flowchart illustrating a method of manufacturing a display device according to one or more embodiments. FIG. 105 is a cross-sectional view illustrating a method of manufacturing a display device according to one or more embodiments.

Because the embodiment of FIG. 104 is different from the embodiment of FIG. 92 in that the step S380 of removing the organic planarization layer ORL disposed in the area where the through hole TH is to be formed is added, hereinafter, step S380 will be described in more detail.

As shown in FIG. 105, the organic planarization layer ORL may be removed through laser ablation before irradiating the first laser LR1 and the second laser LR2 on the second surface of the mother substrate MSUB. In this case, inorganic layers of the first encapsulation inorganic layer TFE1, the second encapsulation inorganic layer TFE3, and the thin film transistor layer TFTL may also be removed.

When the organic planarization layer ORL is not removed before irradiating the first laser LR1 and the second laser LR2, the crack may be generated in the organic planarization layer ORL, or the foreign material detached from the organic planarization layer ORL may be generated as the organic planarization layer ORL is physically divided. In this case, as shown in FIGS. 78 and 79, the substrate SUB may protrude in the through hole TH from the organic planarization layer ORL.

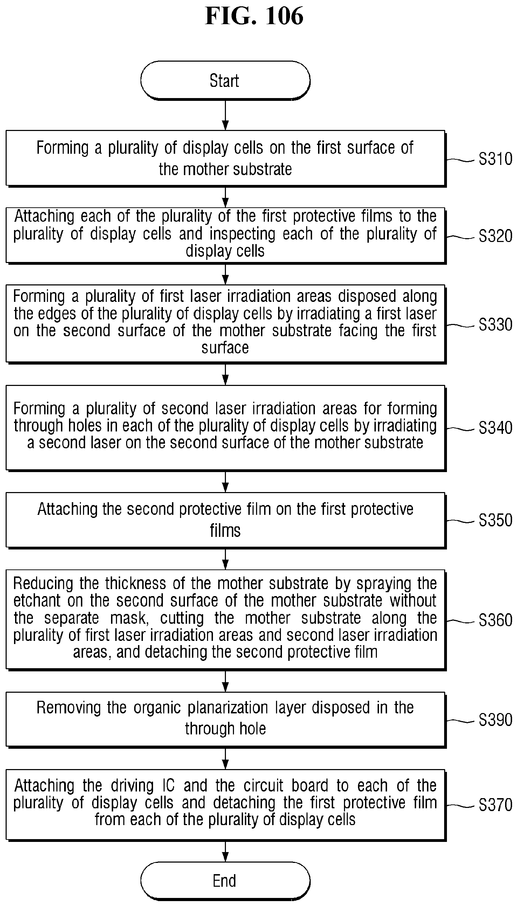

FIG. 106 is a flowchart illustrating a method of manufacturing a display device according to one or more embodiments. FIG. 107 is a cross-sectional view illustrating a method of manufacturing a display device according to one or more embodiments.

Because the embodiment of FIG. 106 is different from the embodiment of FIG. 92 in that the step S390 of removing the organic planarization layer ORL disposed in the area where the through hole TH is to be formed is added, hereinafter, step S390 will be described in more detail.

As shown in FIG. 107, the plurality of first laser irradiation areas CH1 and second laser irradiation areas CH2 are formed by irradiating the first laser LR1 and the second laser LR2 on the second surface of the mother substrate MSUB and the organic planarization layer ORL disposed on the through hole TH may be removed after dividing the plurality of display cells DPC having the through hole TH by spraying the etchant from the mother substrate MSUB. For example, the organic planarization layer ORL disposed on the through hole TH may be removed through the laser hole cutting process. The inorganic layers of the first encapsulation inorganic layer TFE1, the second encapsulation inorganic layer TFE3, and the thin film transistor layer TFTL disposed on the through hole TH may be removed together with the organic planarization layer ORL. In this case, as shown in FIGS. 80 and 81, the organic planarization layer ORL may protrude in the through hole TH from the substrate SUB.

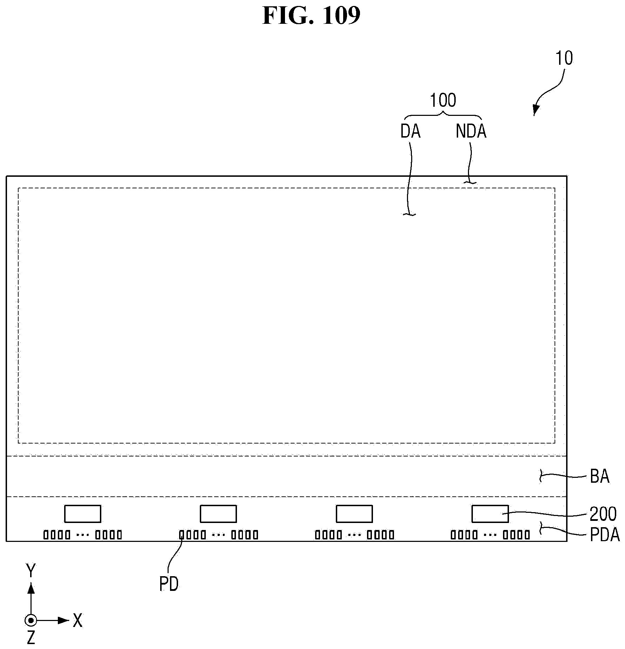

FIG. 108 is a perspective view illustrating a display device according to one or more embodiments. FIG. 109 is a plan view illustrating a display panel and a driving IC according to one or more embodiments.

Referring to FIGS. 108 and 109, the display device 10 according to one or more embodiments may include a bending area BA and a pad area PDA disposed in the non-display area NDA.

The bending area BA may be disposed between the display area DA and the pad area PDA in the second direction (Y-axis direction). The bending area BA may be extended in the first direction (X-axis direction). The bending area BA refers to an area bent downward of the display panel 100. When the bending area BA is bent under the display panel 100, the plurality of driving ICs 200 and the circuit board 300 may be disposed under the display panel 100.

The pad area PDA may be a lower edge area of the display panel 100. The pad area PDA may be an area in which the display pads PD connected to the circuit board 300 and the first and second driving pads DPD1 and DPD2 connected to the driving IC 200 are disposed.

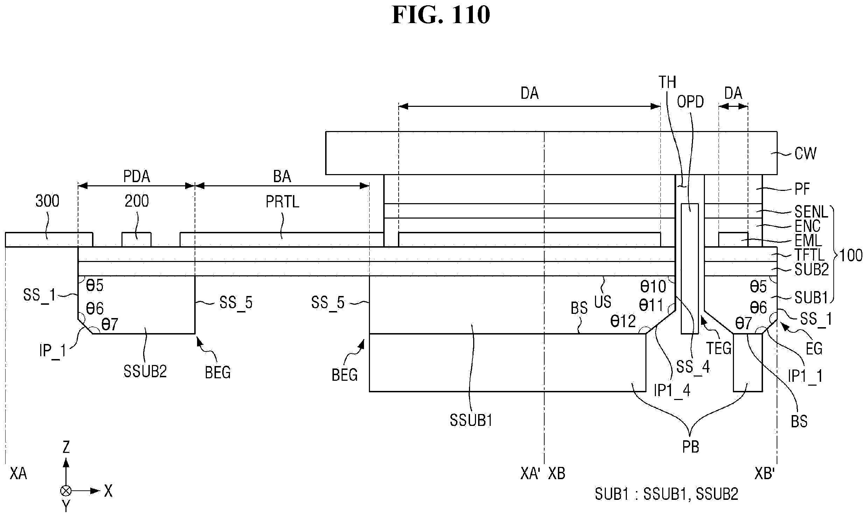

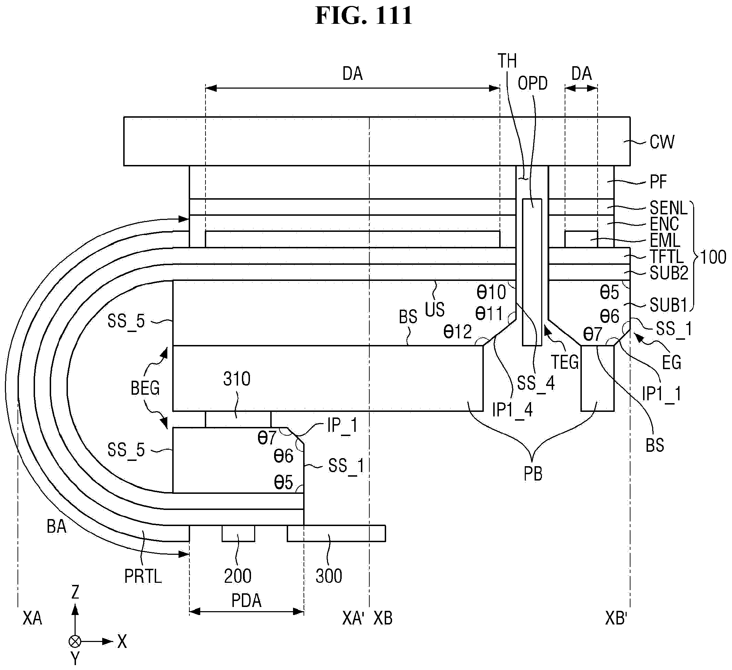

FIG. 110 is a cross-sectional view illustrating an example of the display device taken along the lines XA-XA' and XB-XB' of FIG. 108. FIG. 111 is a cross-sectional view illustrating an example of the display device in which the bending area of FIG. 110 is bent.

Referring to FIGS. 110 and 111, the display panel 100 may include a first substrate SUB1 having a rigid material and a second substrate SUB2 made of a polymer resin having a flexible material.

The first substrate SUB1 may be made of ultra-thin glass (UTG) having a thickness of about 500 µm or less, but embodiments of the present invention are not limited thereto. The first substrate SUB1 may include a first sub-substrate SSUB1 disposed in the display area DA and a second sub-substrate SSUB2 disposed in the pad area PDA.

A second substrate SUB2 may be made of the polymer resin having a thickness lower than that of the first substrate SUB1. For example, the second substrate SUB2 may be formed of an organic material such as an acrylic resin, an epoxy resin, a phenolic resin, a polyamide resin, or a polyimide resin, etc. Because the second substrate SUB2 is made of the polymer resin, it may be referred to as a plastic substrate. Alternatively, because the second substrate SUB2 is formed of the organic material, it may be referred to as the organic layer.

The first substrate SUB1 may not be disposed in the bending area BA. That is, because the second substrate SUB2 having the flexible material is included in the bending area BA, it may be easily bent.

The thin film transistor layer TFTL may be disposed in the display area DA, the bending area BA, and the pad area PDA.

A passivation layer PRTL may be disposed on the thin film transistor layer TFTL in the bending area BA. The passivation layer PRTL may be a layer for protecting the thin film transistor layer TFTL exposed to the outside in the bending area BA. The protective film PRTL may be formed of the organic material such as the acryl resin, the epoxy resin, the phenolic resin, the polyamide resin, or the polyimide resin, etc.

The cross-sectional shape of the substrate SUB at an edge BEG of the bending area BA may be different from the cross-sectional shape of the substrate SUB at the edge EG of the display panel 100. The cross-sectional shape of the substrate SUB at the edge BEG of the bending area BA may be different from the cross-sectional shape of the substrate SUB at the edge EG of the through hole TH. The cross-sectional shape of the substrate SUB at the edge EG of the display panel 100 may be different from the cross-sectional shape of the substrate SUB at the edge EG of the through hole TH.

As in step S330 of FIG. 92, when the edge EG of the display panel 100 is formed by irradiating the etchant after irradiating the first laser LR1, the first substrate SUB1 may include the side surface SS_1 and the first edge area IP1_1 at the edge EG of the display panel 100. The angle θ6 between the side surface SS_1 and the first inclined surface IP1_1 on the edge EG of the display panel 100 and the angle θ7 between the first inclined surface IP1_1 and the bottom surface BS may be obtuse angles.

As in step S340 of FIG. 92, when the edge TEG of the through hole TH is formed by irradiating the etchant after irradiating the second laser LR2, the first substrate SUB1 may include the side surface SS_4 and the first edge area IP1_4 at the edge TEG of the through hole TH. The angle 910 between the side surface SS_4 of the edge TEG of the through hole TH and the upper surface US may be about 90 degrees. The angle θ11 between the side surface SS_4 and the first inclined surface IP1_4 at the edge TEG of the through hole TH and the angle θ12 between the first inclined surface IP1_4 and the bottom surface BS may be obtuse angles.

As described in steps S330 and S340 of FIG. 92, because the depth (or sketch length) of each of the first laser irradiation areas CH1 formed by the first laser LR1 is different from the depth (or sketch length) of each of the second laser irradiation areas CH2 formed by the second laser LR2, the cross-sectional shapes of the side surface SS_1 of the edge EG of the display panel 100 and the first inclined surface IP1_1 may be different from the cross-sectional shape of the side surface SS_4 of the edge TEG of the through hole TH and the first inclined surface IP1_4.

For example, the length of the side surface SS_1 of the edge EG of the display panel 100 in the third direction (Z-axis direction) may be longer than the length of the side surface SS_4 of the edge TEG of the through hole TH in the third direction (Z-axis direction). The length of the first inclined surface IP1_1 of the edge EG of the display panel 100 in the inclined direction may be smaller than the length of the first inclined surface IP1_4 of the edge TEG of the through hole TH in the inclined direction.

In addition, the angle θ6 between the side surface SS_1 and the first inclined surface IP1_1 at the edge EG of the display panel 100 may be greater than the angle θ11 between the side surface SS_4 and the first inclined surface IP1_4 at the edge TEG of the through hole TH. Also, the angle θ7 between the first inclined surface IP1_1 and the bottom surface BS at the edge EG of the display panel 100 may be smaller than the angle θ12 between the first inclined surface IP1_4 and the bottom surface BS at the edge TEG of the through hole TH at the edge TEG of the through hole TH.

At the edge BEG of the bending area BA, the side surface SS_5 of the first substrate SUB1 may form a substantially 90 degree angle with the upper surface US and the bottom surface BS of the first substrate SUB1.

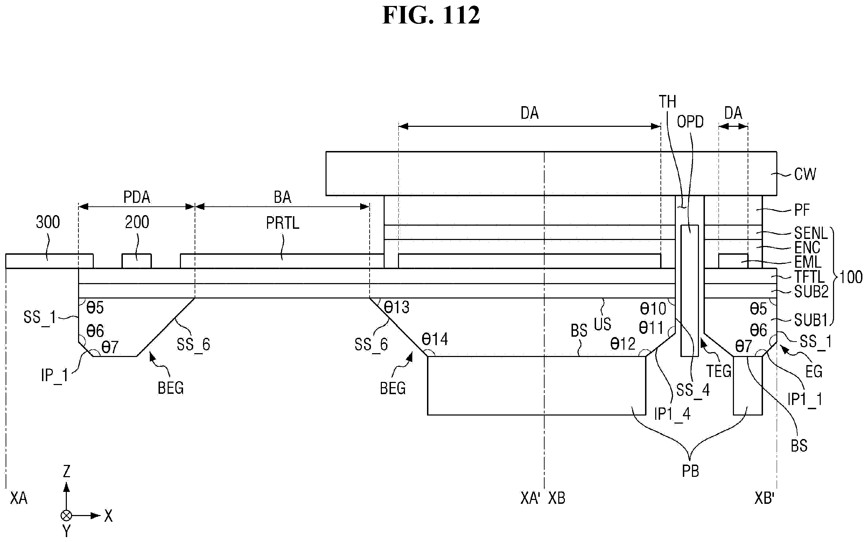

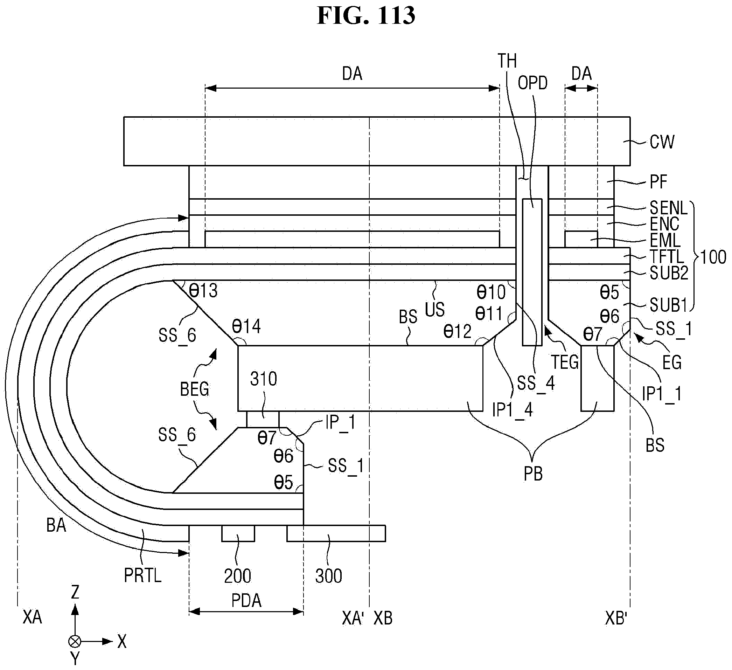

FIG. 112 is a cross-sectional view illustrating an example of the display device taken along the lines XA-XA' and XB-XB' of FIG. 108. FIG. 113 is a cross-sectional view illustrating an example of the display device in which the bending area of FIG. 112 is bent.

Referring to FIGS. 112 and 113, when the edge BEG of the bending area BA is formed by spraying the etchant, the side surface SS_6 of the first substrate SUB1 at the edge BEG of the bending area BA may be an inclined surface formed obliquely. An angle θ13 formed between the side surface SS_6 and the upper surface US of the first substrate SUB1 at the edge BEG of the bending area BA may be an acute angle, and an angle θ14 between the side surface SS_6 and the bottom surface BS of the first substrate SUB1 may be an obtuse angle.

A length of the side surface SS_6 of the first substrate SUB1 of the edge BEG of the bending area BA in the third direction (Z-axis direction) may be longer than a length of the side surface SS_1 of the edge EG of the display panel 100 in the third direction (Z-axis direction) and a length of the first inclined surface IP_1 in the inclination direction, and a length of the side surface SS_4 of the edge TEG of the through hole TH in the third direction (Z-axis direction) and the length of the first inclined surface IP_1 in the inclined direction. The angle θ13 between the side surface SS_6 and the top surface US of the first substrate SUB1 at the edge BEG of the bending area BA ma be smaller than the angle θ5 between the side surface SS_1 and the upper surface US of the first substrate SUB1 at the edge EG of the display panel 100, the angle θ6 between the side surface SS_1 of the first substrate SUB1 and the first inclined surface IP1_1, and an angle θ7 formed between the first inclined surface IP1_1 of the first substrate SUB1 and the bottom surface BS.

A method of forming the side surface SS_6 of the first substrate SUB1 as an obliquely inclined surface at the edge BEG of the bending area BA will be described later with reference to FIG. 126.

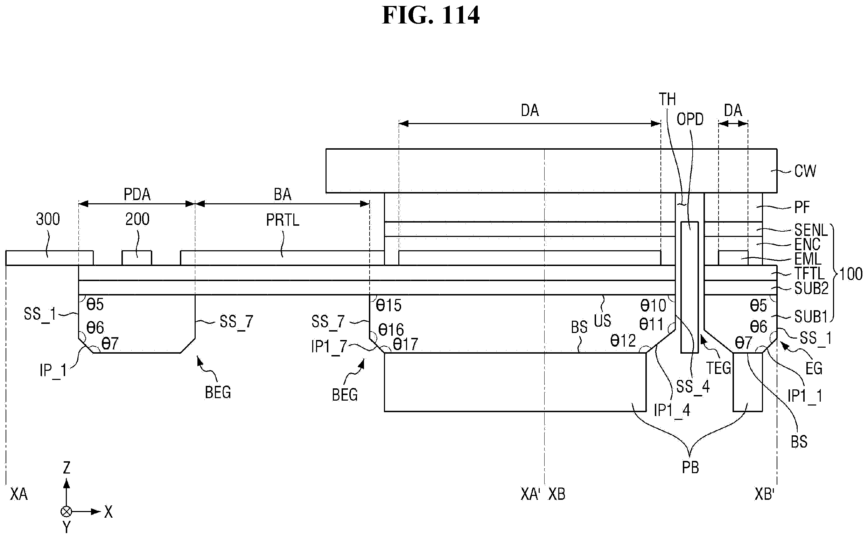

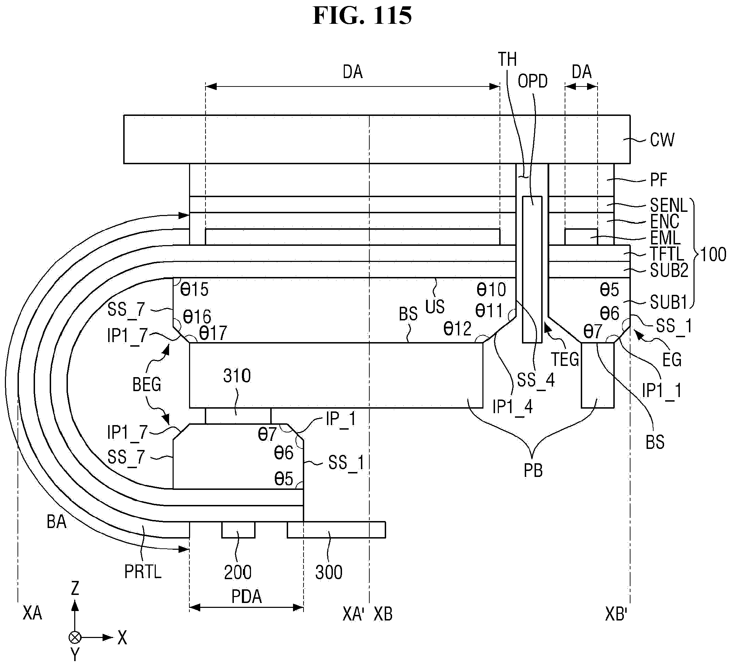

FIG. 114 is a cross-sectional view illustrating an example of the display device taken along the lines XA-XA' and XB-XB' of FIG. 108. FIG. 115 is a cross-sectional view illustrating an example of the display device in which the bending area of FIG. 114 is bent.

Referring to FIGS. 114 and 115, the cross-sectional shape of the substrate SUB at the edge BEG of the bending area BA may be substantially the same as the cross-sectional shape of the substrate SUB at the edge EG of the display panel 100. The cross-sectional shape of the substrate SUB at the edge BEG of the bending area BA may be different from the cross-sectional shape of the substrate SUB at the edge EG of the through hole TH.

The edge BEG of the bending area BA may be formed by the same manufacturing process as the edge EG of the display panel 100. That is, when the edge BEG of the bending area BA is formed by spraying the etchant after irradiating the first laser LR1, the first substrate SUB1 at the edge BEG of the bending area BA may include a side surface SS_7 and a first inclined surface IP1_7. An angle θ15 between the side surface SS_7 and the upper surface US at the edge BEG of the bending area BA may be about 90 degrees. An angle θ16 between the side surface SS_7 and the first inclined surface IP1_7 at the edge BEG of the bending area BA and an angle θ17 between the first inclined surface IP1_7 and the bottom surface BS may be obtuse angles.

In this case, the length of the side surface SS_7 of the edge BEG of the bending area BA in the third direction (Z-axis direction) may be substantially the same as the length of the side surface SS_1 of the edge EG of the display panel 100 in the third direction (Z-axis direction). The length of the first inclined surface IP1_7 of the edge BEG of the bending area BA in the inclined direction may be substantially the same as the length of the first inclined surface IP1_1 of the edge EG of the display panel 100 in the inclined direction.

In addition, the length of the side surface SS_7 of the edge BEG of the bending area BA in the third direction (Z-axis direction) may be longer than the length of the side surface SS_4 of the edge TEG of the through hole TH in the third direction (Z-axis direction). The length of the first inclined surface IP1_7 of the edge BEG of the bending area BA in the inclined direction may be smaller than the length of the first inclined surface IP1_4 of the edge TEG of the through hole TH in the inclined direction.

In addition, the angle θ16 between the side surface SS_7 and the first inclined surface IP1_7 at the edge BEG of the bending area BA may be substantially the same as the angle θ6 between the side surface SS_1 and the first inclined surface IP1_1 at the edge EG of the display panel 100. Also, the angle θ17 between the first inclined surface IP1_7 and the bottom surface BS at the edge BEG of the bending area BA may be substantially the same as the angle θ7 between the first inclined surface IP1_1 and the bottom surface BS at the edge EG of the display panel 100.

In addition, the angle θ16 between the side surface SS_7 and the first inclined surface IP1_7 at the edge BEG of the bending area BA may be greater than the angle θ11 between the side surface SS_4 and the first inclined surface IP1_4 at the edge TEG of the through hole TH. Also, the angle θ17 between the first inclined surface IP1_7 and the bottom surface BS at the edge BEG of the bending area BA may be smaller than the angle θ12 between the first inclined surface IP1_4 and the bottom surface BS at the edge TEG of the through hole TH.

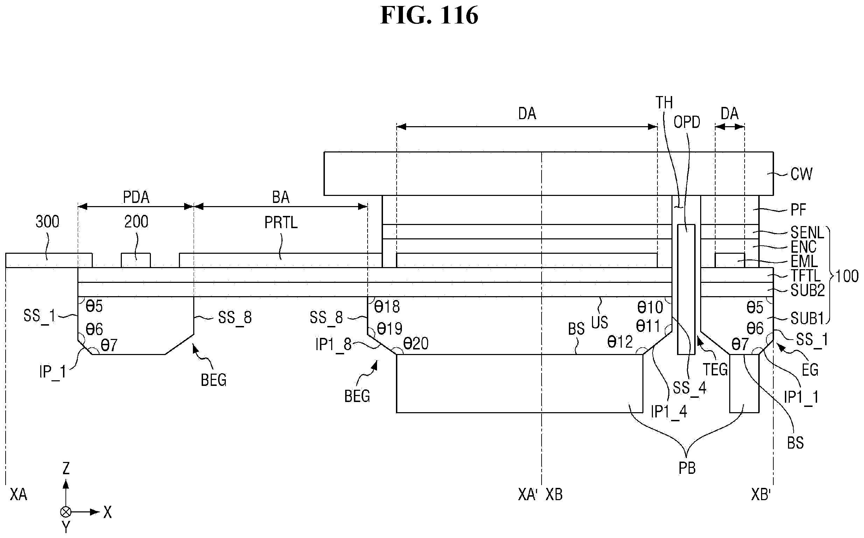

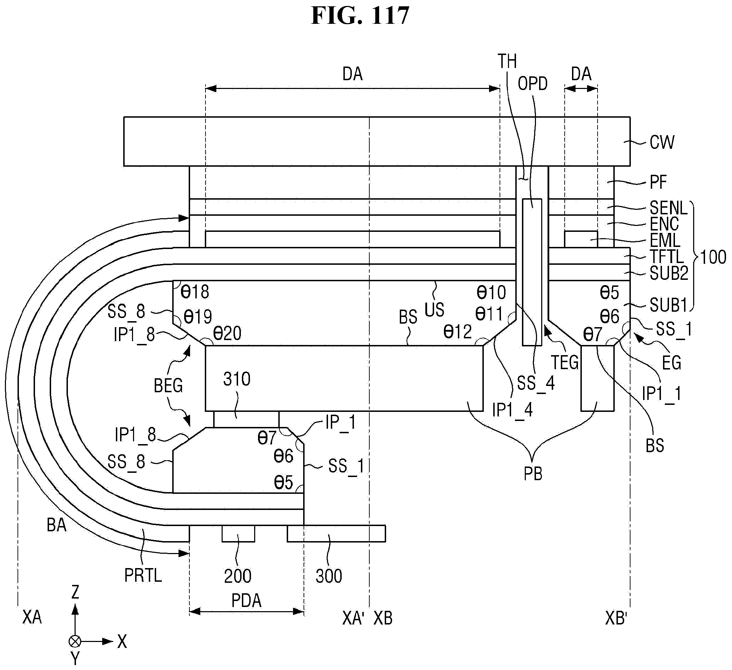

FIG. 116 is a cross-sectional view illustrating an example of the display device taken along the lines XA-XA' and XB-XB' of FIG. 108. FIG. 117 is a cross-sectional view illustrating an example of the display device in which the bending area of FIG. 116 is bent.

Referring to FIGS. 116 and 117, the cross-sectional shape of the substrate SUB at the edge BEG of the bending area BA may be different from the cross-sectional shape of the substrate SUB at the edge EG of the display panel 100. The cross-sectional shape of the substrate SUB at the edge BEG of the bending area BA may be substantially the same as the cross-sectional shape of the substrate SUB at the edge EG of the through hole TH.

The edge BEG of the bending area BA may be formed by the same manufacturing process as the edge TEG of the through hole TH. That is, when the edge BEG of the bending area BA is formed by spraying the etchant after irradiating the second laser LR2, the first substrate SUB1 may include a side surface SS_8 and a first edge area IP1_8 at the edge BEG of the bending area BA. An angle θ18 between the side surface SS_8 and the upper surface US at the edge BEG of the bending area BA may be about 90 degrees. An angle θ19 between the side surface SS_8 and the first inclined surface IP1_8 at the edge BEG of the bending area BA and an angle 920 between the first inclined surface IP1_8 and the bottom surface BS may be obtuse angles.

In this case, the length of the side surface SS_8 of the edge BEG of the bending area BA in the third direction (Z-axis direction) may be smaller than the length of the side surface SS_1 of the edge EG of the display panel 100 in the third direction (Z-axis direction). A length of the first inclined surface IP1_8 of the edge BEG of the bending area BA in the inclined direction may be longer than a length of the first inclined surface IP1_8 of the edge EG of the display panel 100 in the inclined direction.

In addition, the length of the side surface SS_8 of the edge BEG of the bending area BA in the third direction (Z-axis direction) may be substantially the same as a length of the side surface SS_4 of the edge TEG of the through hole TH in the third direction (Z-axis direction). The length of the first inclined surface IP1_8 of the edge BEG of the bending area BA in the inclined direction may be substantially the same as the length of the first inclined surface IP1 _4 of the edge TEG of the through hole TH in the inclined direction.

In addition, the angle θ19 between the side surface SS_8 and the first inclined surface IP1_8 at the edge BEG of the bending area BA may be smaller than the angle θ6 between the side surface SS_1 and the first inclined surface IP1_1 at the edge EG of the display panel 100. Also, the angle 920 between the first inclined surface IP1_8 and the bottom surface BS at the edge BEG of the bending area BA may be greater than the angle θ7 between the first inclined surface IP1_1 and the bottom surface BS at the edge EG of the display panel 100.

In addition, the angle θ19 between the side surface SS_8 and the first inclined surface IP1_8 at the edge BEG of the bending area BA may be substantially the same as the angle θ11 between the side surface SS_4 and the first inclined surface IP1_4 at the edge TEG of the through hole TH. Also, the angle θ20 between the first inclined surface IP1_8 and the bottom surface BS at the edge BEG of the bending area BA may be substantially the same as the angle θ12 between the first inclined surface IP1_4 and the bottom surface BS at the edge TEG of the through hole TH.

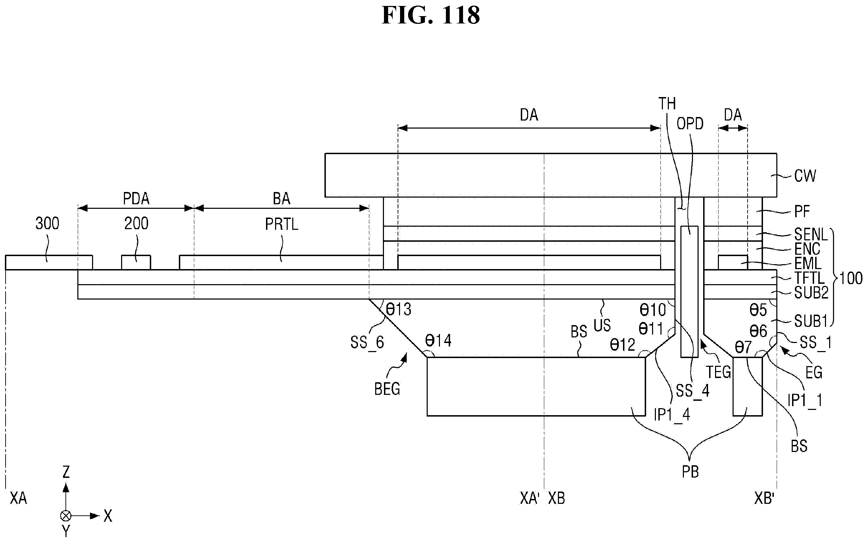

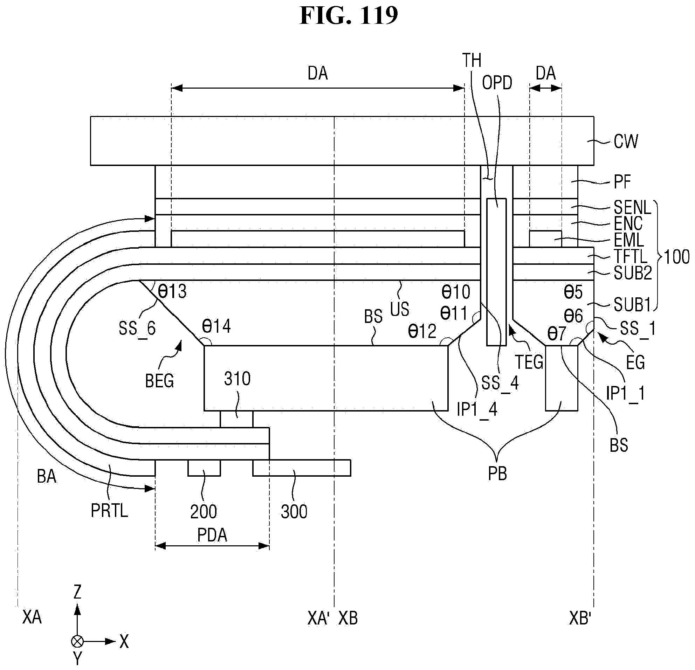

FIG. 118 is a cross-sectional view illustrating an example of the display device taken along the lines XA-XA' and XB-XB' of FIG. 108. FIG. 119 is a cross-sectional view illustrating an example of the display device in which the bending area of FIG. 118 is bent.

Referring to FIGS. 118 and 119, the first substrate SUB1 disposed in the pad area PDA may be removed. In this case, the second substrate SUB2 may be fixed to the bottom surface of the panel bottom cover PB by the adhesive member 310. The thickness of the display panel 100 may be reduced by removing the first substrate SUB1 from the pad area PDA.

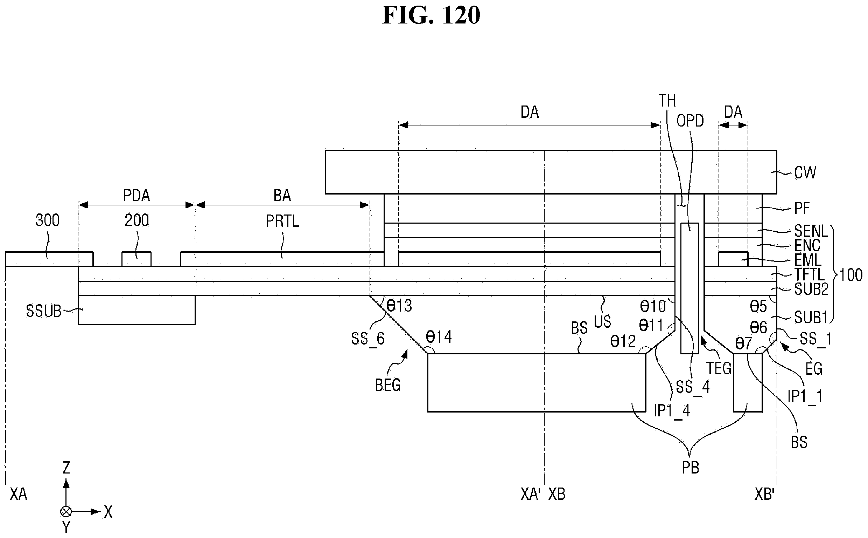

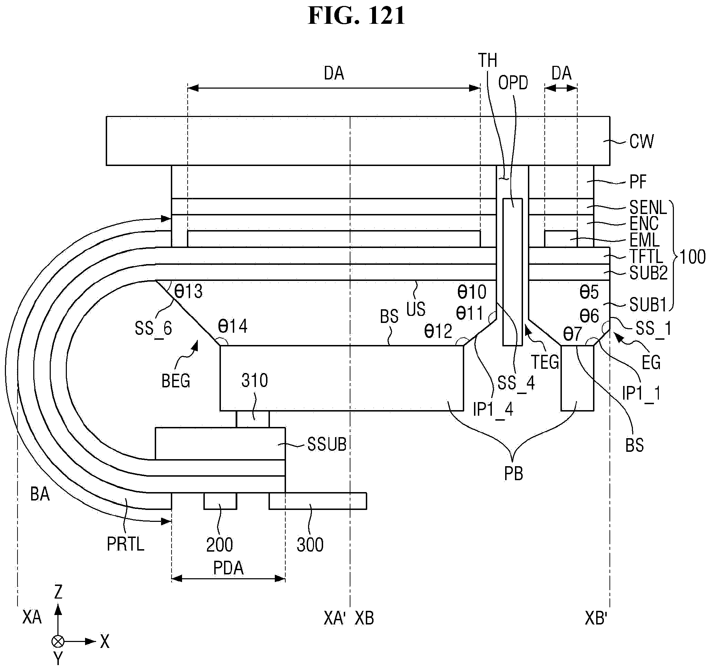

FIG. 120 is a cross-sectional view illustrating an example of the display device taken along the lines XA-XA' and XB-XB' of FIG. 108. FIG. 121 is a cross-sectional view illustrating an example of the display device in which the bending area is bent in FIG. 120.

Referring to FIGS. 120 and 121, the support substrate SSUB having a smaller thickness than the first substrate SUB1 may be included instead of removing the first substrate SUB1 disposed in the pad area PDA. The support substrate SSUB may be formed of a rigid material. For example, the support substrate SSUB may be a plastic film such as polycarbonate (PC) or polyethylene terephthalate (PET).

In this case, the support substrate SSUB may be fixed to the bottom surface of the panel bottom cover PB by an adhesive member 310. The thickness of the display panel 100 may be reduced by replacing the first substrate SUB1 in the pad area PDA with the support substrate SSUB having the thickness smaller than that of the first substrate SUB1.

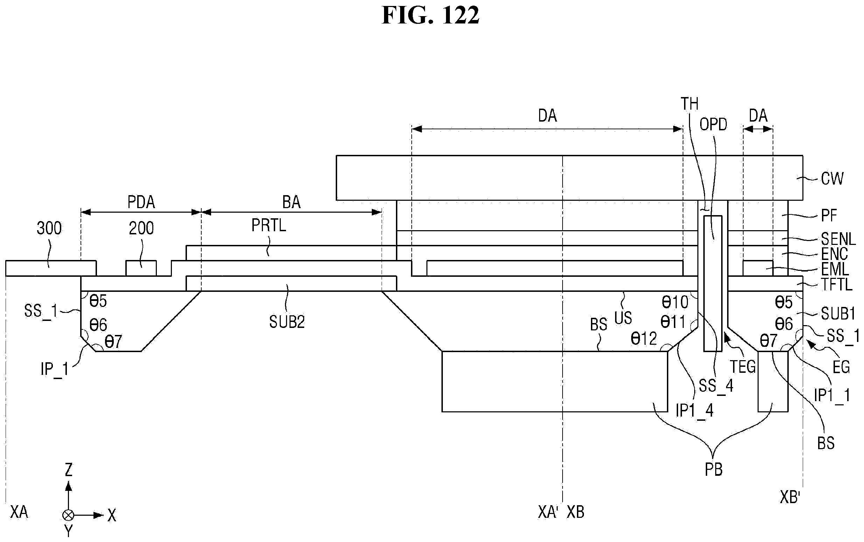

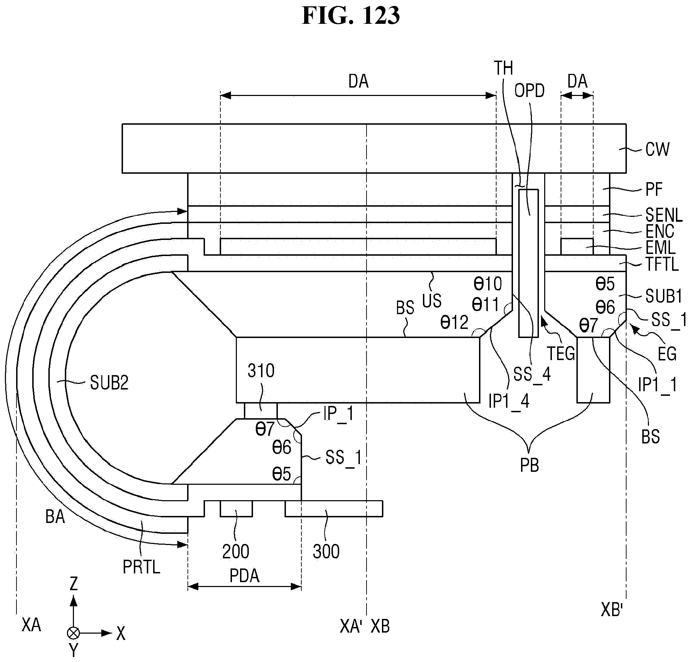

FIG. 122 is a cross-sectional view illustrating an example of the display device taken along the lines XA-XA' and XB-XB' of FIG. 108. FIG. 123 is a cross-sectional view illustrating an example of the display device in which the bending area of FIG. 122 is bent.

Referring to FIGS. 122 and 123, the second substrate SUB2 may be disposed in the bending area BA and may be deleted from the display area DA and the pad area PDA. In this case, the thin film transistor layer TFTL may be directly disposed on the first substrate SUB1 in the display area DA and the pad area PDA.

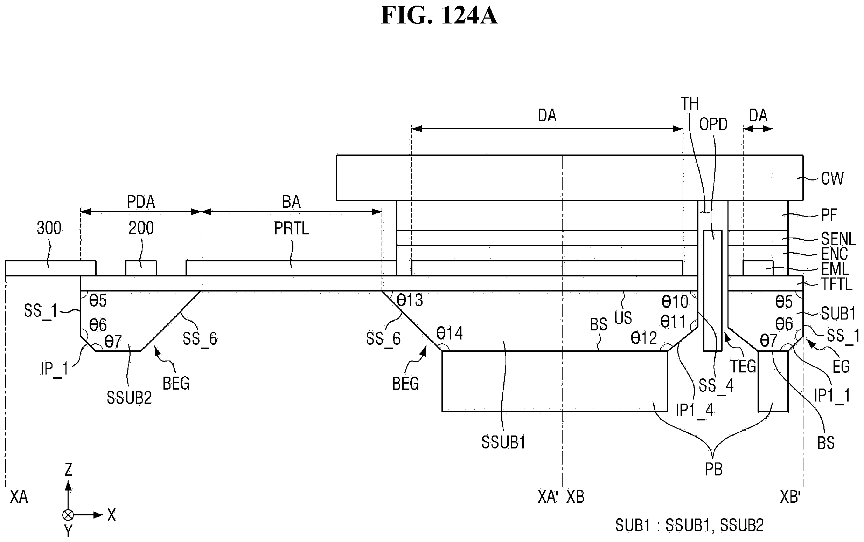

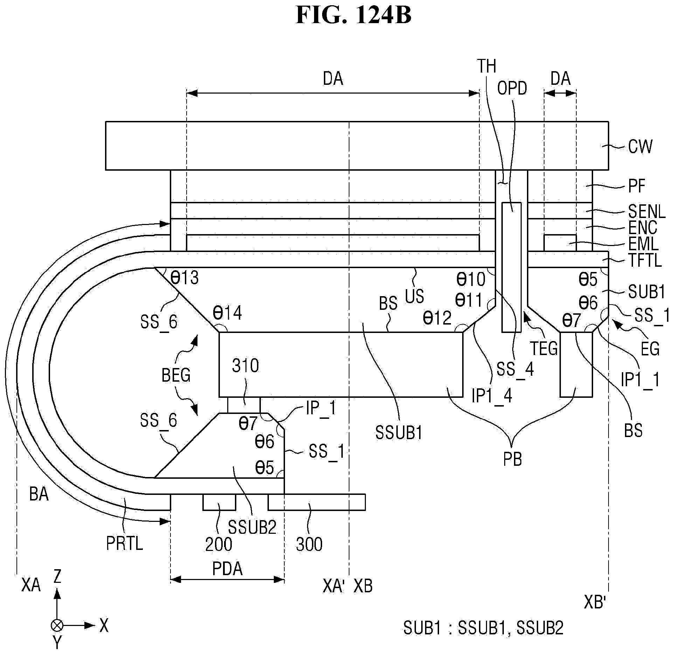

FIG. 124A is a cross-sectional view illustrating an example of the display device taken along the lines XA-XA' and XB-XB' of FIG. 108. FIG. 124B is a cross-sectional view illustrating an example of the display device in which the bending area of FIG. 124A is bent.

Referring to FIGS. 124A and 124B, the second substrate SUB2 may be omitted from the display panel 100. In this case, the organic layers of the thin film transistor layer TFTL may serve as the second substrate SUB2. The passivation layer PRTL may be disposed on the thin film transistor layer TFTL.

FIG. 125A is a cross-sectional view illustrating an example of the display device taken along the lines XA-XA' and XB-XB' of FIG. 108. FIG. 125B is a cross-sectional view illustrating an example of the display device in which the bending area of FIG. 125A is bent.

Referring to FIGS. 125A and 125B, the cross-sectional shape of the substrate SUB at the edge BEG of the bending area BA may be substantially the same as the cross-sectional shape of the substrate SUB at the edge EG of the display panel 100. The cross-sectional shape of the substrate SUB at the edge BEG of the bending area BA may be substantially the same as the cross-sectional shape of the substrate SUB at the edge EG of the through hole TH.

The edge BEG of the bending area BA and the edge TEG of the through hole TH may be formed by the same manufacturing process as the edge EG of the display panel 100.

Because the edge BEG of the bending area BA is substantially the same as that described with reference to FIGS. 114 and 115, the description of the edge BEG of the bending area BA will be omitted.

When the edge TEG of the through hole TH is formed by spraying the etchant after irradiating the first laser LR1, the first substrate SUB1 may include the side surface SS_8 and the first inclined surface IP1_8 at the edge TEG of the through hole TH. An angle θ21 between the side surface SS_8 and the upper surface US at the edge TEG of the through hole TH may be about 90 degrees. An angle θ22 between the side surface SS_8 and the first inclined surface IP1_8 at the edge TEG of the through hole TH and the angle θ22 between the first inclined surface IP1_8 and the bottom surface BS may be obtuse angles.

In this case, the length of the side surface SS_8 of the edge TEG of the through hole TH in the third direction (Z-axis direction) may be substantially the same as the length of the side surface SS_1 of the edge EG of the display panel 100 in the third direction (Z-axis direction). The length of the first inclined surface IP1_8 of the edge TEG of the through hole TH in the inclined direction may be substantially the same as the length of the first inclined surface IP1_1 of the edge EG of the display panel 100 in the inclined direction.

In addition, the angle θ22 between the side surface SS_8 and the first inclined surface IP1_8 at the edge TEG of the through hole TH may be substantially the same as the angle θ6 between the side surface SS_1 and the first inclined surface IP1_1 at the edge EG of the display panel 100. Also, an angle θ23 between the first inclined surface IP1_8 and the bottom surface BS at the edge TEG of the through hole TH may be substantially the same as the angle θ7 between the first inclined surface IP1_1 and the bottom surface BS at the edge EG of the display panel 100.

FIG. 125C is a cross-sectional view illustrating an example of the display device taken along the lines XA-XA' and XB-XB' of FIG. 108. FIG. 125D is a cross-sectional view illustrating an example of the display device in which the bending area of FIG. 125C is bent.

Referring to FIGS. 125C and 125D, the cross-sectional shape of the substrate SUB at the edge BEG of the bending area BA may be substantially different from the cross-sectional shape of the substrate SUB at the edge EG of the display panel 100. The cross-sectional shape of the substrate SUB at the edge BEG of the bending area BA may be substantially different from the cross-sectional shape of the substrate SUB at the edge EG of the through hole TH. The cross-sectional shape of the substrate SUB at the edge EG of the display panel 100 may be substantially the same as the cross-sectional shape of the substrate SUB at the edge EG of the through hole TH.

The edge TEG of the through hole TH may be formed by the same manufacturing process as the edge EG of the display panel 100. The edge BEG of the bending area BA may be formed by a different manufacturing process from the edge TEG of the through hole TH and the edge EG of the display panel 100.

Because the edge BEG of the bending area BA is substantially the same as that described with reference to FIGS. 116 and 117, the description of the edge BEG of the bending area BA will be omitted.

Because the edge TEG of the through hole TH is substantially the same as that described with reference to FIGS. 125A and 125B, the description of the edge TEG of the through hole TH will be omitted.

FIG. 125E is a cross-sectional view illustrating an example of the display device taken along the lines XA-XA' and XB-XB' of FIG. 108. FIG. 125F is a cross-sectional view illustrating an example of the display device in which the bending area of FIG. 125E is bent.

Referring to FIGS. 125E and 125F, the cross-sectional shape of the substrate SUB at the edge BEG of the bending area BA may be substantially different from the cross-sectional shape of the substrate SUB at the edge EG of the display panel 100. The cross-sectional shape of the substrate SUB at the edge BEG of the bending area BA may be substantially different from the cross-sectional shape of the substrate SUB at the edge EG of the through hole TH. The cross-sectional shape of the substrate SUB at the edge EG of the display panel 100 may be substantially the same as the cross-sectional shape of the substrate SUB at the edge EG of the through hole TH.

The edge TEG of the through hole TH may be formed by the same manufacturing process as the edge EG of the display panel 100. The edge BEG of the bending area BA may be formed by the different manufacturing process from the edge TEG of the through hole TH and the edge EG of the display panel 100.

Because the edge BEG of the bending area BA is substantially the same as that described with reference to FIGS. 118 and 119, the description of the edge BEG of the bending area BA will be omitted.

Because the edge TEG of the through hole TH is substantially the same as that described with reference to FIGS. 125A and 125B, the description of the edge TEG of the through hole TH will be omitted.

FIG. 125G is a cross-sectional view illustrating an example of the display device taken along the lines XA-XA' and XB-XB' of FIG. 108. FIG. 125H is a cross-sectional view illustrating an example of the display device in which the bending area of FIG. 125G is bent.

Referring to FIGS. 125G and 125H, the cross-sectional shape of the substrate SUB at the edge BEG of the bending area BA is substantially different from the cross-sectional shape of the substrate SUB at the edge EG of the display panel 100. The cross-sectional shape of the substrate SUB at the edge BEG of the bending area BA may be substantially the same as the cross-sectional shape of the substrate SUB at the edge EG of the through hole TH. The cross-sectional shape of the substrate SUB at the edge EG of the display panel 100 may be substantially different from the cross-sectional shape of the substrate SUB at the edge EG of the through hole TH.

Because the edge TEG of the through hole TH is formed by spraying an etchant, the side surface SS_10 of the first substrate SUB1 at the edge TEG of the through hole TH may be an inclined surface formed obliquely. An angle θ24 formed between the side surface SS_10 and the top surface US of the first substrate SUB1 at the edge TEG of the through hole TH may be an acute angle, and an angle 25 formed formed between the side surface SS_10 and the bottom surface of the first substrate SUB1 are at the edge TEG of the through hole TH may be an obtuse angle.

A length of of the side surface SS_10 of the first substrate SUB1 of the edge TEG of the through hole TH in the third direction (Z-axis direction) may be longer than a length of the the side surface SS_1 of the edge EG of the display panel 100 in the third direction (Z-axis direction) and a length of the first inclined surface IP_1 of the edge EG of the display panel 100 in the third direction (Z-axis direction). The angle θ24 formed between the upper surface US and the side surface SS_10 of the first substrate SUB1 at the edge TEG of the through hole TH is smaller than an angle the angle θ5 between the side surface SS_1 and the upper surface US of the first substrate SUB1 at the edge EG of the display panel 100, the angle θ6 between the side surface SS_1 of the first substrate SUB1 and the first inclined surface IP1_1, and an angle θ7 formed between the first inclined surface IP1_1 of the first substrate SUB1 and the bottom surface BS.

The edge TEG of the through hole TH may be formed in the same manufacturing process as the edge EG of the bending area BA. The edge EG of the display panel 100 may be formed in a different manufacturing process from the edge EG of the through hole TH and the edge EG of the bending area BA.

Because the edge BEG of the bending area BA is substantially the same as that described with reference to FIGS. 112 and 113, the description of the edge BEG of the bending area BA will be omitted.

FIG. 125I is a cross-sectional view illustrating an example of the display device taken along the lines XA-XA' and XB-XB' of FIG. 108. FIG. 125J is a cross-sectional view illustrating an example of the display device in which the bending area of FIG. 125I is bent.

Referring to FIGs. 125I and 125J, the cross-sectional shape of the substrate SUB at the edge BEG of the bending area BA, the cross-sectional shape of the substrate SUB at the edge EG of the display panel 100, and the cross-sectional shape of the substrate SUB at the edge EG of the through hole TH may be substantially the same.

Because the edge EG of the display panel 100 is formed by spraying an etchant, the side surface SS_11 of the first substrate SUB1 at the edge EG of the display panel 100 may be an inclined surface formed obliquely. An angle θ26 formed between the side surface SS_11 and the top surface US at the edge EG of the first substrate SUB1 is an acute angle, and an angle θ27 formed between the side surface SS_11 and the bottom surface of the first substrate SUB1 is an obtuse angle.

The angle θ26 formed between the upper surface US and the side surface SS_11 of the first substrate SUB1 at the edge EG of the display panel 100 may be substantially the same as the angle θ24 formed between the upper surface US and the side surface SS_10 of the first substrate SUB1 at the edge TEG of the through hole TH, and the angle θ13 formed between the upper surface US and the side surface SS_6 of the first substrate SUB1 at the edge TEG of the bending area BA. In addition, the angle θ27 between the side surface SS_11 of the first substrate SUB1 and the lower surface BS at the edge EG of the display panel 100 may be substantially the same as the angle θ25 formed between the side surface SS_10 of the first substrate SUB1 and the lower surface BS at the edge TEG of the through hole TH, and the angle θ14 formed between the lower surface BS and the side surface SS_6 of the first substrate SUB1 at the edge TEG of the bending area BA.

The edge EG of the display panel 100, the edge TEG of the through hole TH, and the edge EG of the bending area BA may be formed through the same manufacturing process.

Because the edge BEG of the bending area BA is substantially the same as that described with reference to FIGS. 112 and 113, the description of the edge BEG of the bending area BA will be omitted. Also, because the edge TEG of the through hole TH is substantially the same as that described with reference to FIGS. 125G and 125H, the description of the edge TEG of the through hole TH will be omitted.

FIG. 126 is a flowchart illustrating a method of manufacturing a display device according to one or more embodiments. FIGS. 127 to 133 are perspective views illustrating a method of manufacturing a display device according to one or more embodiments. FIGS. 134 to 138 are cross-sectional views illustrating a method of manufacturing a display device according to one or more embodiments.

First, as shown in FIG. 127, the plurality of display cells DPC are formed on the first surface of the mother substrate MSUB. (S410 in FIG. 126)

Second, the plurality of first protective films PRF1 are attached on the plurality of display cells DPC, and the plurality of display cells DPC is inspected. (S420 in FIG. 126)

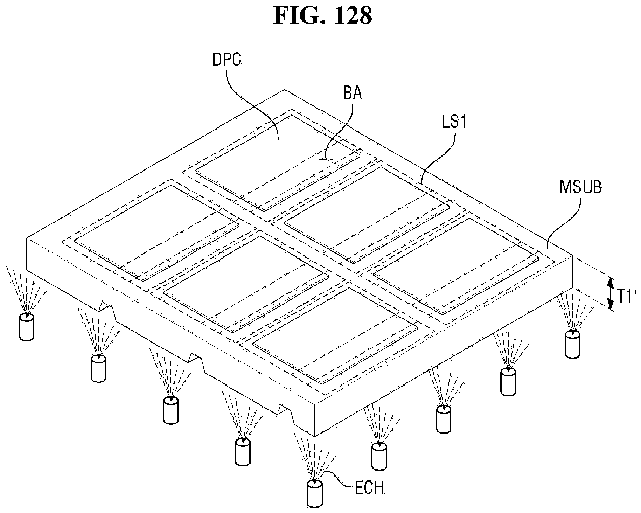

Third, as shown in FIGS. 128 and 134 to 137, the second protective film PRF2 is attached on the first surface of the mother substrate MSUB, and a third protective film PRF2 is attached on the second surface of the mother substrate MSUB, and a portion of the third protective film PRF3 disposed in the bending area BA is removed. Then, the etchant is sprayed on the second surface facing the first surface of the mother substrate MSUB to remove a portion of the mother substrate MSUB disposed in the bending area BA, and the third protective film PRF3 is removed. (S430 in FIG. 126)

First of all, as shown in FIG. 134, the second protective film PRF2 is attached on the first surface of the mother substrate MSUB, and the third protective film PRF3 is attached on the second surface of the mother substrate MSUB. The second protective film PRF2 may be attached on the exposed mother substrate MSUB without being covered by the plurality of first protective films PRF1 and the plurality of first protective films PRF1. The second protective film PRF2 and the third protective film PRF3 may be acid-resistant films for protecting the plurality of display cells DPC from the etchant in the etching process of the mother substrate MSUB to be performed in the next step.

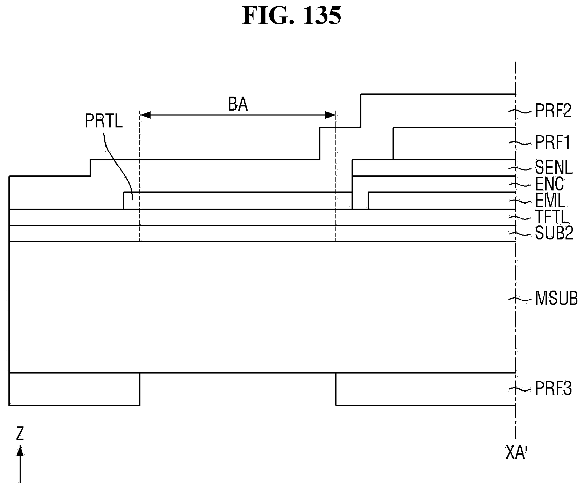

Then, as shown in FIG. 135, a portion of the third protective film PRF3 corresponding to the bending area BA is removed.

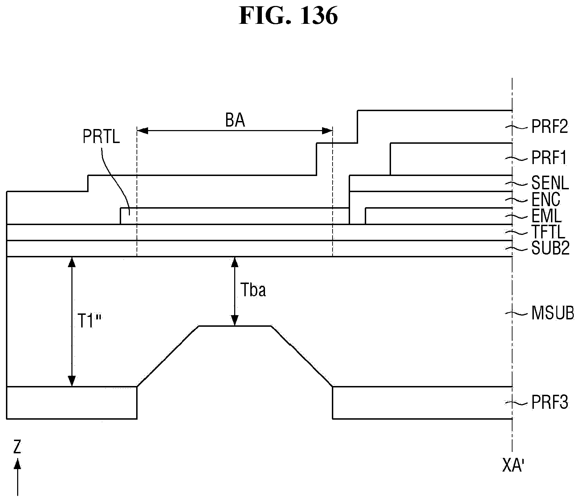

Then, as shown in FIG. 136, the exposed mother substrate MSUB is etched without being covered by the third protective film PRF3 by spraying the etchant ECH on the second surface of the mother substrate MSUB. Accordingly, a portion of the mother substrate MSUB disposed in the bending area BA may be removed. Accordingly, the thickness Tba of the mother substrate MSUB in the bending area BA may be smaller than the thickness T1" of the mother substrate MSUB in the remaining areas except for the bending area BA.

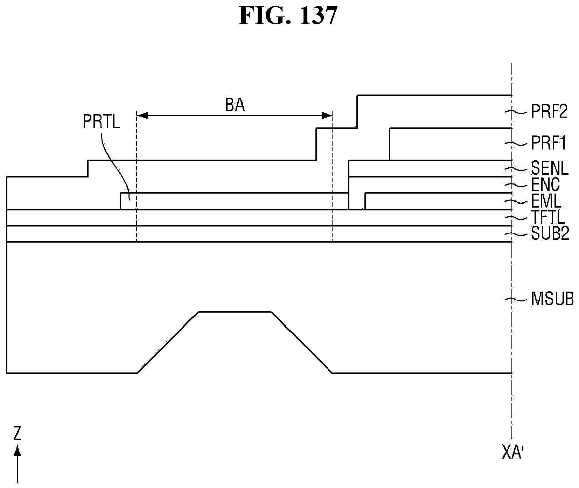

Then, as shown in FIG. 137, the third protective film PRF3 is detached from the second surface of the mother substrate MSUB.

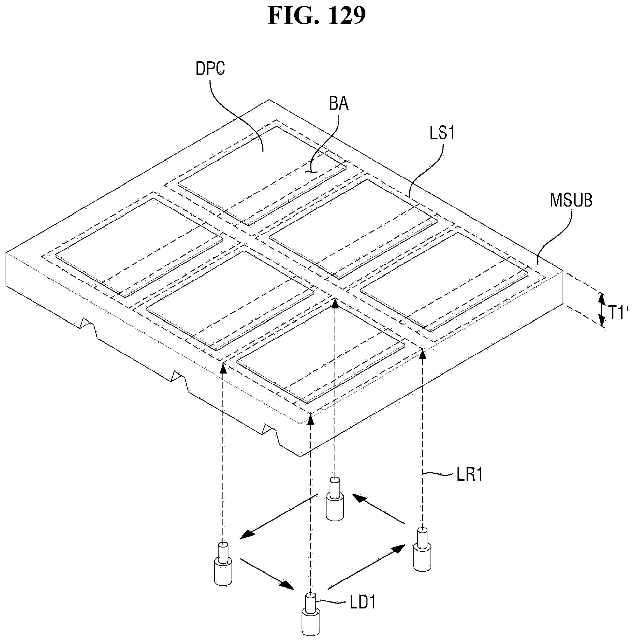

Fourth, as shown in FIG. 129, a plurality of first laser irradiation areas CH1 are formed along the edges EG of the plurality of display cells DPC by irradiating the first laser LR1 on the second surface of the mother substrate MSUB. (S440 in FIG. 126)

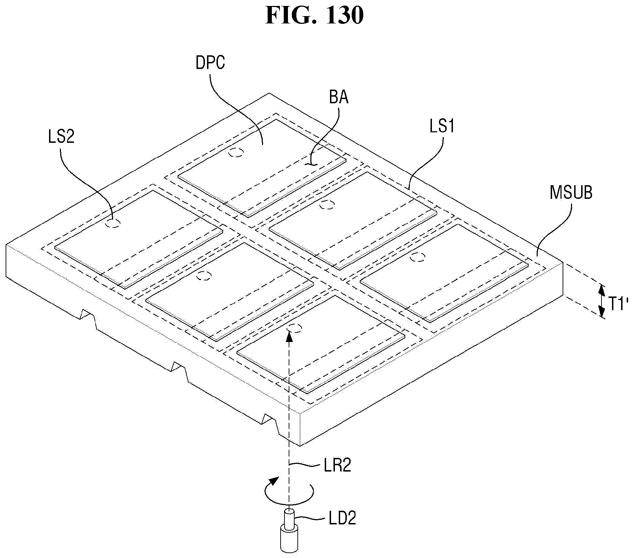

Fifth, as shown in FIG. 130, a plurality of second laser irradiation areas CH2 for forming the through hole TH in each of the plurality of display cells is formed by irradiating the second laser LR2 on the second surface of the mother substrate MSUB. (S450 in FIG. 126)

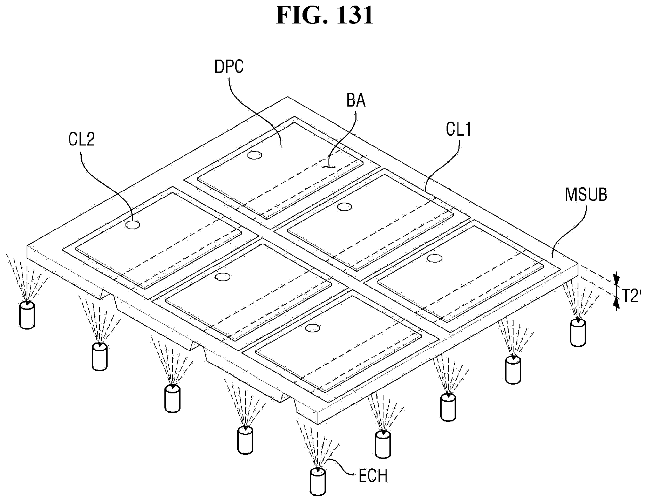

Sixth, as shown in FIGS. 131, 132, and 138, the etchant is sprayed on the second surface of the mother substrate MSUB without a separate mask to reduce the thickness of the mother substrate MSUB and at the same time the mother substrate is cut along the plurality of first laser irradiation areas CH1 and second laser irradiation areas CH2, and the second protective film PRF2 is detached. (S460 in FIG. 126)

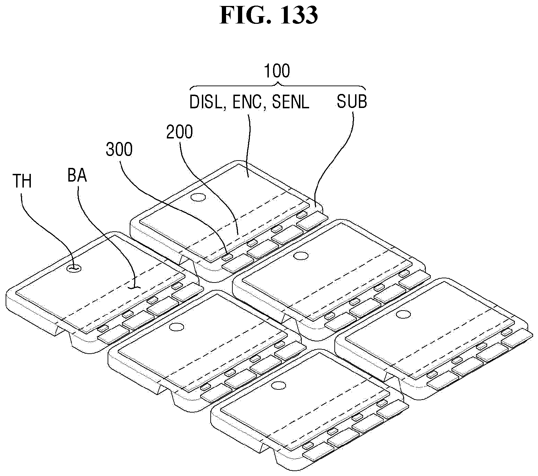

Seventh, as shown in FIG. 133, the driving IC 200 and the circuit board 300 are attached to each of the plurality of display cells DPC, and the first protective film PRF1 is detached from each of the plurality of display cells DPC. (S470 in FIG. 126)

FIG. 139 is a flowchart illustrating a method of manufacturing a display device according to one or more embodiments. FIGS. 140 to 145 are perspective views illustrating a method of manufacturing a display device according to one or more embodiments.

First, as shown in FIG. 140, the plurality of display cells DPC are formed on the first surface of the mother substrate MSUB. (S510 in FIG. 139)

Second, the plurality of first protective films PRF1 are attached on the plurality of display cells DPC, and the plurality of display cells DPC is inspected. (S520 of FIG. 139)

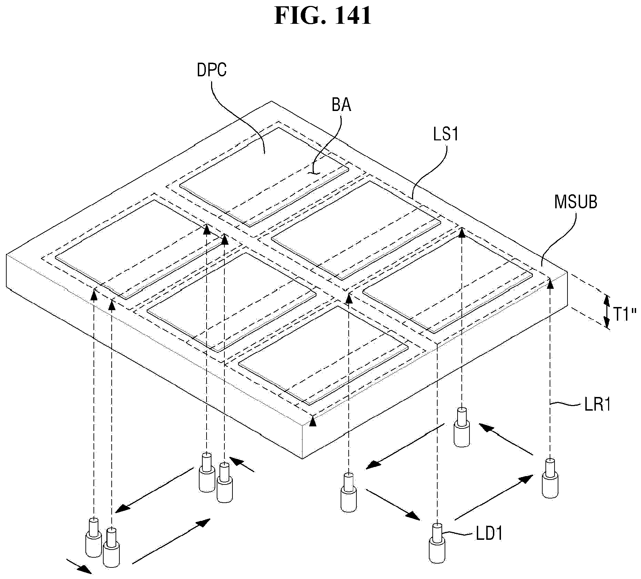

Third, as shown in FIG. 141, the plurality of first laser irradiation areas CH1 are formed along the edge EG of the plurality of display cells DPC and the edge BEG of the bending area BA by irradiating the first laser LR1 on the second surface of the mother substrate MSUB. (S530 in FIG. 139)

The first cutting line CL1 may be defined as the virtual line connecting the plurality of first laser irradiation areas CH1. The first cutting line CL1 may be formed by irradiating the first laser LR1 to form the plurality of first laser irradiation areas CH1 along the edge EG of the plurality of display cells DPC and the edge BEG of the bending area BA. The depth TCH1 of each of the plurality of first laser irradiation areas CH1 may be approximately 50 µm to 500 µm from the first surface of the mother substrate MSUB.

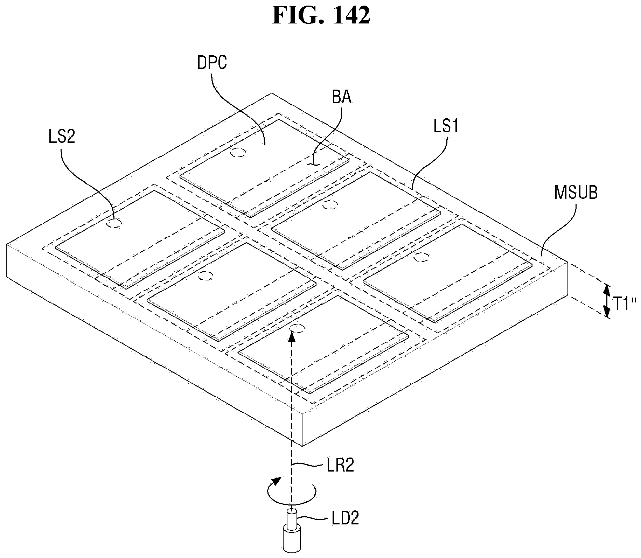

Fourth, as shown in FIG. 142, the plurality of second laser irradiation areas CH2 for forming the through hole TH in each of the plurality of display cells is formed by irradiating the second laser LR2 on the second surface of the mother substrate MSUB. (S540 of FIG. 139)

FIG. 139 illustrates that step S540 is performed after step S530 is performed, but embodiments of the present invention are not limited thereto. Steps S530 and S540 may be concurrently (e.g., simultaneously) performed through the plurality of laser devices LD.

Fifth, the second protective film PRF2 is attached on the plurality of first protective films PRF1 to shorten the process time. (S550 in FIG. 139)

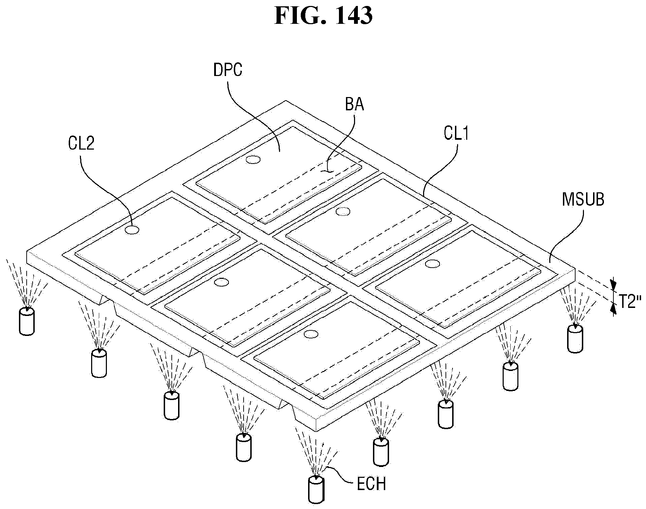

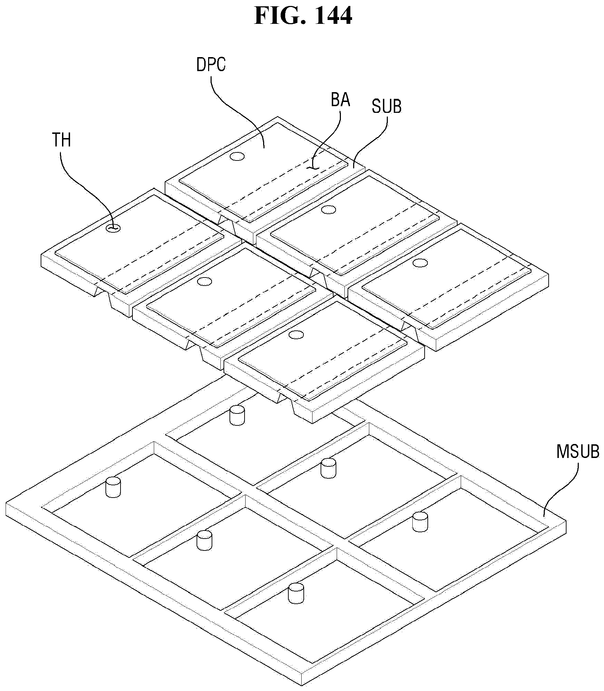

Sixth, as shown in FIGS. 143 and 144, the mother substrate is cut along the plurality of first laser irradiation areas CH1 and second laser irradiation areas CH2, and at the same time the second protective film PRF2 is detached by spraying the etchant on the second surface of the mother substrate MSUB, the thickness of the mother substrate MSUB is reduced without a separate mask. (S560 of FIG. 139)

Each of the plurality of display cells DPC is separated from the mother substrate MSUB, and the through hole TH is formed in each of the plurality of display cells DPC, and the mother substrate MSUB of the bending area BA may be removed by the etching process.

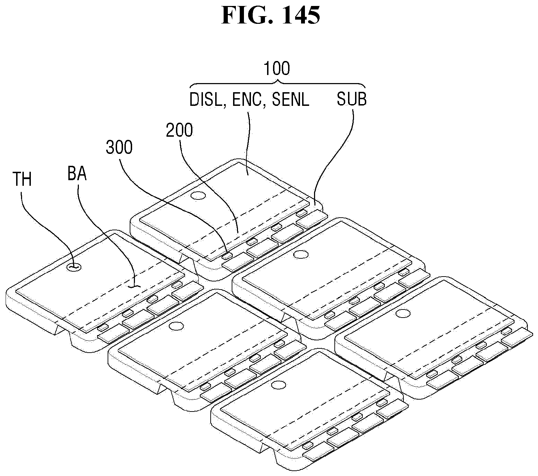

Seventh, as shown in FIG. 145, the driving IC 200 and the circuit board 300 are attached to each of the plurality of display cells DPC, and the first protective film PRF1 is detached from each of the plurality of display cells DPC. (S570 in FIG. 139)

As described above, the thickness of the mother substrate SUB may be reduced by using the laser and the etching process, and the substrate SUB of each of the plurality of display cells DPC may be separated from the mother substrate MSUB. In addition, because the through hole TH may be formed and the substrate SUB of the bending area BA may be removed, the efficiency of the manufacturing process may be increased.

FIG. 146 is a flowchart illustrating a method of manufacturing a display device according to one or more embodiments. FIGS. 147 to 152 are perspective views illustrating a method of manufacturing a display device according to one or more embodiments.

First, as shown in FIG. 147, the plurality of display cells DPC is formed on the first surface of the mother substrate MSUB. (S610 of FIG. 146)

Second, the plurality of first protective films PRF1 are attached on the plurality of display cells DPC, and the plurality of display cells DPC is inspected. (S620 of FIG. 146)

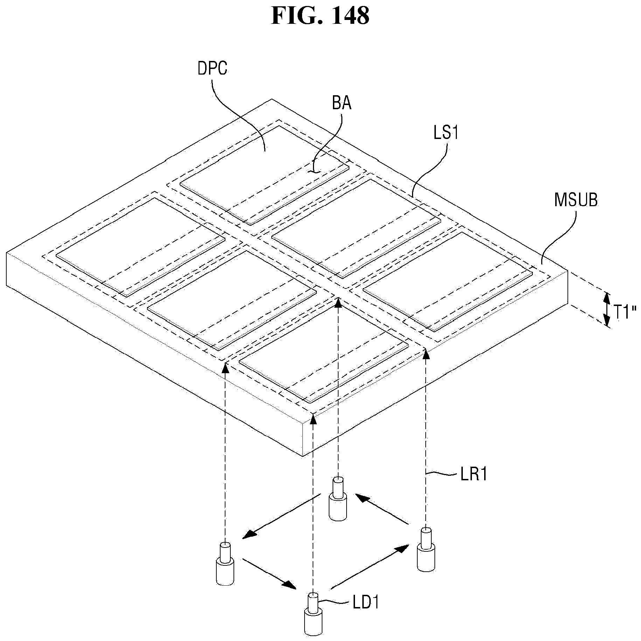

Third, as shown in FIG. 148, the plurality of first laser irradiation areas CH1 is formed along the edges EG of the plurality of display cells DPC by irradiating the first laser LR1 on the second surface of the mother substrate MSUB. (S630 of FIG. 146)

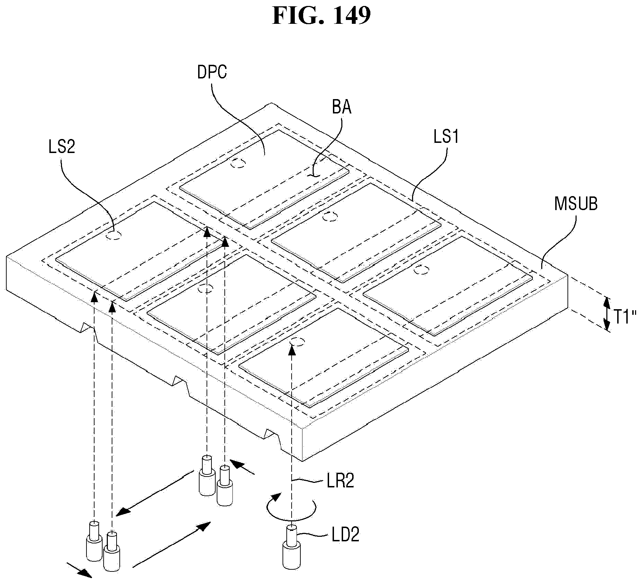

Fourth, as shown in FIG. 149, the plurality of second laser irradiation areas CH2 is formed in each of the plurality of display cells along the edge TEG of the through hole TH and the edge BEG of the bending area BA by irradiating the second laser LR2 on the second surface of the mother substrate MSUB. (S640 of FIG. 146)

FIG. 146 illustrates that step S640 is performed after step S630 is performed, but embodiments of the present invention are not limited thereto. Steps S630 and S640 may be concurrently (e.g., simultaneously) performed through the plurality of laser devices LD to shorten the process time.

The second cutting line CL2 may be defined as the virtual line connecting the plurality of first laser irradiation areas CH1. The second cutting line CL2 may be formed by irradiating the second laser LR2 to form the plurality of second laser irradiation areas CH2 along the edge of the through hole TH and the edge of the bending area BA. The depth (or sketch length) of each of the plurality of second laser irradiation areas CH2 may be approximately 50 µm to 500 µm from the first surface of the mother substrate MSUB. The depth (or sketch length) of each of the plurality of second laser irradiation areas CH2 may be longer than the depth (or a sketch length) of each of the plurality of first laser irradiation areas CH1.

Fifth, the second protective film PRF2 is attached on the plurality of first protective films PRF1. (S650 in FIG. 146)

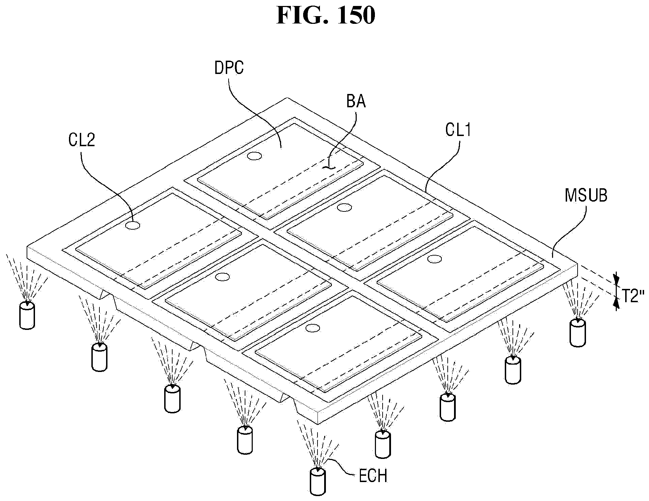

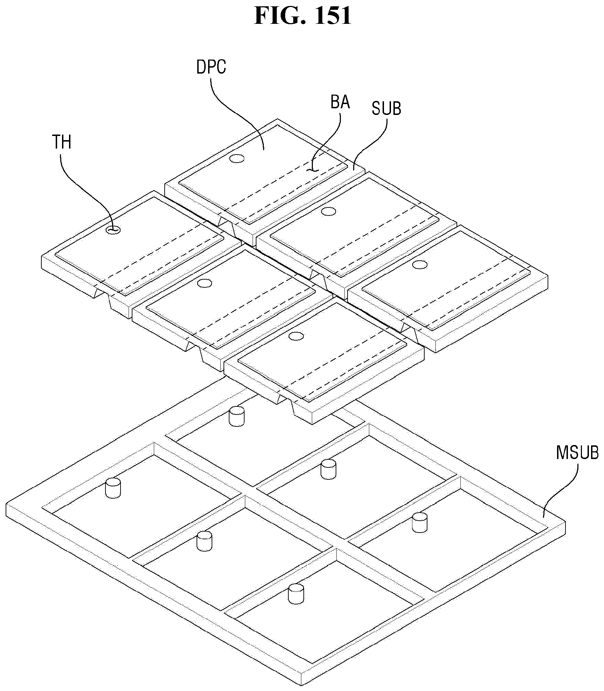

Sixth, as shown in FIGS. 150 and 151, the etchant is sprayed on the second surface of the mother substrate MSUB without the separate mask to reduce the thickness of the mother substrate MSUB and at the same time the mother substrate is cut along the plurality of first laser irradiation areas CH1 and second laser irradiation areas CH2, and the second protective film PRF2 is detached. (S660 in FIG. 146)

Each of the plurality of display cells DPC is separated from the mother substrate MSUB, the through hole TH is formed in each of the plurality of display cells DPC, and the mother substrate MSUB of the bending area BA may be removed by the etching process.

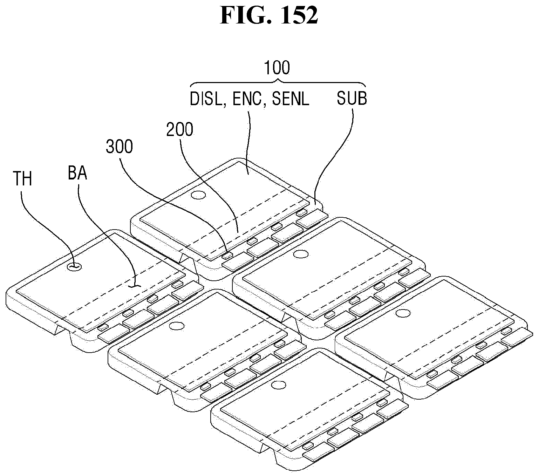

Seventh, as shown in FIG. 152, the driving IC 200 and the circuit board 300 are attached to each of the plurality of display cells DPC, and the first protective film PRF1 is formed in each of the plurality of display cells DPC is removed. (S670 in FIG. 146)

As described above, the thickness of the mother substrate SUB may be reduced by using the laser and the etching process, and the substrate SUB of each of the plurality of display cells DPC may be separated from the mother substrate MSUB. In addition, because the through hole TH may be formed and the substrate SUB of the bending area BA may be removed, the efficiency of the manufacturing process may be increased.

FIG. 153 is an example diagram illustrating an electronic device including a display device according to one or more embodiments. FIG. 153 illustrates a tablet to which the display device 10 according to one or more embodiments is applied as an example of an electronic device.

FIG. 154 is an example diagram illustrating an electronic device including a display device according to one or more embodiments. FIG. 154 illustrates a smartphone to which the display device 10 according to one or more embodiments is applied as an example of an electronic device.

FIG. 155 is an example diagram illustrating an electronic device including a display device according to one or more embodiments. FIG.155 illustrates a TV to which a display device according to one or more embodiments is applied as an example of an electronic device.

FIG. 156 is an example diagram illustrating an electronic device including a display device according to one or more embodiments. FIG.156 illustrates a monitor to which a display device according to one or more embodiments is applied as an example of an electronic device.

FIG. 157 is an example diagram illustrating an electronic device including a display device according to one or more embodiments.

Referring to FIG. 157, a display device 10_1 according to one or more embodiments may be applied to a smart watch 1 that is one of smart devices. The flat shape of the watch display unit of the smart watch 1 may follow the flat shape of the display device 10_1. For example, when the display device 10_1 according to one or more embodiments has a rectangular flat shape, the watch display unit of the smart watch 1 may have a rectangular flat shape as shown in FIG. 91. Alternatively, when the display device 10_1 according to one or more embodiments has a circular or oval flat shape, the watch display unit of the smart watch 1 may have a circular or oval flat shape. However, embodiments of the present invention are not limited thereto, and the watch display unit of the smart watch 1 may not follow the flat shape of the display device 10_1.

FIG. 158 is an example diagram illustrating an electronic device including a display device according to one or more embodiments. FIG. 158 illustrates an example of the virtual reality device 1 to which a display device 10_2 according to one or more embodiments is applied.

Referring to FIG. 158, the virtual reality device 1 according to one or more embodiments may be a device in the form of glasses. The virtual reality device 1 according to one or more embodiments may include the display device 10_2, a left eye lens 10a, a right eye lens 10b, a support frame 20, eyeglass frames legs 30a and 30b, and a display device accommodating unit 50.

FIG. 158 exemplifies a virtual reality apparatus 1 including the eyeglass frame legs 30a and 30b, the virtual reality apparatus 1 according to one or more embodiments may be applied to a head mounted display including a head mounted band that may be mounted on the head instead of the eyeglass frame legs 30a and 30b.

The display device accommodating unit 50 of may include the display device 10_2 and a reflective member 40. The image displayed on the display device 10_2 may be reflected by the reflective member 40 and provided to the user's right eye through the right eye lens 10b. Accordingly, the user may view the virtual reality image displayed on the display device 10_2 through the right eye.

FIG. 158 illustrates that the display device accommodating unit 50 is disposed at the right end of the support frame 20, but embodiments of the present invention are not limited thereto. For example, the display device accommodating unit 50 may be disposed at the left end of the support frame 20. In this case, the image displayed on the display device 10_2 may be reflected by the reflective member 40 and provided to the user's left eye through the left eye lens 10a. Accordingly, the user may view the virtual reality image displayed on the display device 10_2 through the left eye. Alternatively, the display device accommodating unit 50 may be disposed at both the left and right ends of the support frame 20. In this case, the user may watch the virtual reality image displayed on the display device 10_2 through both the left eye and the right eye.

FIG. 159 is an example view illustrating a vehicle instrument panel and a center fascia to which an electronic device including a display device is applied, according to one or more embodiments. FIG. 159 illustrates a vehicle to which display devices 10_a, 10_b, 10_c, 10_d, and 10_e is applied according to one or more embodiments.

Referring to FIG. 159, display devices 10_a, 10_b, and 10_c according to one or more embodiments may be applied to an instrument panel of a vehicle, applied to a center fascia of a vehicle, or a Center Information Display (CID) disposed on a dashboard of the vehicle. Also, the display devices 10_d and 10_e according to one or more embodiments may be applied to a room mirror display instead of a side mirror of a vehicle.

FIG. 160 is an example diagram illustrating an electronic device including a display device according to one or more embodiments.

Referring to FIG. 160, a display device 10_3 according to one or more embodiments may be applied to a transparent display device. The transparent display device may transmit light while displaying the image IM. Therefore, the user located on the front of the transparent display device may not only view the image IM displayed on the display device 10_3 but also view the object RS or the background displayed on the rear side of the transparent display device 10_3. When the display device 10_3 is applied to the transparent display device, the substrate SUB of the display device 10_3 may include a light-transmitting portion capable of transmitting light or may be formed of a material capable of transmitting light.

## Claims

1. A display device (10) comprising:
a glass substrate (SUB) including a first surface (US), a second surface (BS) opposite the first surface (US), and a side surface (SS) between the first surface (US) and the second surface (BS);
a first outermost structure on the first surface (US) of the glass substrate (SUB) and located adjacent to an edge of one side of the glass substrate (SUB); and
a display area (DA) including a plurality of light emitting areas (EA) on the first surface (US) of the glass substrate (SUB) and located farther from the edge of the one side of the glass substrate (SUB) than the first outermost structure is,
wherein a distance from the side surface (SS) of the glass substrate (SUB) to the first outermost structure is equal to 130 µm or less; and/or
wherein a distance from the first outermost structure to the side surface (SS) of the glass substrate (SUB) is smaller than a distance from a second outermost structure on the first surface (US) of the glass substrate (SUB) located adjacent to the edge of a through hole penetrating the first surface (US) and the second surface (BS).

2. The display device (10) of claim 1, wherein the first surface (US) of the glass substrate (SUB) includes a processing mark located closer than the first outermost structure from the edge of the one side of the glass substrate (SUB),
wherein a width of the processing mark in the direction from the first outermost structure to the edge of the one side of the glass substrate (SUB) is 50 µm or less, wherein in particular a distance between the first outermost structure and the processing mark is 30 µm or less.

3. The display device (10) of claim 1 or 2, wherein the glass substrate (SUB) further comprises a first inclined surface (IP1_1, IP1_2) between the side surface (SS) and the second surface (BS),
wherein an angle between the side surface (SS) and the first inclined surface (IP1_1, IP1_2) and an angle between the first inclined surface (IP1_1, IP1_2) and the second surface (BS) are obtuse angles.

4. The display device (10) of at least one of the claims 1 to 3 , wherein the glass substrate (SUB) further comprises a first inclined surface (IP1_1, IP1_2) between the side surface (SS) and the second surface (BS), and a second inclined surface (IP1_4) between a side surface (SS) of the through hole and the second surface (BS); optionally wherein a length of the first inclined surface (IP1_1,IP1_2) is smaller than a length of the second inclined surface (IP1_4), and/or
wherein an angle between the side surface (SS) and the first inclined surface (IP1_1, IP1_2) is greater than an angle between the side surface (SS) of the through hole and the second inclined surface (IP1_4), and/or wherein an angle between the second surface (BS) and the first inclined surface (IP1_1, IP1_2) is smaller than an angle between the second surface (BS) and the second inclined surface (IP1_4).

5. The display device (10) of at least one of claims 1 to 4, wherein the first outermost structure and/or the second outermost structure comprises a crack dam (CRD) between one side and another side of the display area (DA) and extended along an edge of the glass substrate (SUB).

6. The display device (10) of at least one of the claims 1 to 5, wherein the first outermost structure and/or the second outermost structure comprises a display pad (CD) electrically connected to a circuit board (300) through a conductive adhesive member (CAD).

7. The display device (10) of claim 6, further comprising an electrostatic protection line (ESL) between the display pad (CD) and one edge of the glass substrate (SUB).

8. The display device (10) of claim 7, wherein the electrostatic protection line (ESL) comprises,
a main path area (MP1, MP2) extending from the display pad (CD) to one edge of the glass substrate (SUB); and
an auxiliary path area (AP1-AP8) protruding from the main path area (MP1, MP2).

9. The display device (10) of claim 8, further comprising a dam (DAM3) intersecting the main path area (MP1, MP2).

10. The display device (10) of at least one of the claims 1 to 9, wherein a distance from a sub-pixel (SPX1, SPX2, SPX3) closest to the side surface (SS) of the glass substrate (SUB), from among a plurality of sub-pixels (SPX1, SPX2, SPX3), to the side surface (SS) of the glass substrate (SUB) is 2.24 mm, especially 1.8 mm.

11. The display device (10) of at least one of the claims 1 to 10, wherein the side surface (SS) has a curved cross-section.

12. The display device (10) of at least one of the claims 1 to 11, further comprising a heat dissipation layer (IRL) on the first surface (US) of the glass substrate (SUB) and located closer to the edge of one side of the glass substrate (SUB) than the first outermost structure and/or located closer to the edge of the through hole than the second outermost structure.

13. The display device (10) of claim 12, wherein the first surface (US) of the glass substrate (SUB) further comprises a processing mark located closer to the edge of the one side of the glass substrate (SUB) than the first outermost structure and/or located closer to the edge of the through hole than the second outermost structure ,
wherein the heat dissipation layer (IRL) overlaps the processing mark in a thickness direction of the glass substrate (SUB).

14. The display device (10) of claim 13, wherein a width of the heat dissipation layer (IRL) is greater than a width of the processing mark.

15. A method for fabricating a display device (10), the method comprising:
forming a plurality of display cells (DPC) on a first surface (US) of a mother substrate (MSUB);
forming a plurality of first laser irradiation areas (CH1) along edges of the plurality of display cells (DPC) by irradiating a first laser on a second surface (BS) of the mother substrate (MSUB) opposite the first surface (US); and
cutting the mother substrate (MSUB) along the plurality of first laser irradiation areas (CH1) while reducing a thickness of the mother substrate (MSUB) by spraying an etchant on a second surface (BS) of the mother substrate (MSUB) without a mask.
